# EUROPEAN PATENT SPECIFICATION

(11) **EP 4 186 913 B1**
(45) Date of publication and mention of the grant of the patent: **27.11.2024**
(21) Application number: 22183307.2
(22) Date of filing: 06.07.2022
(51) Int. Cl.: C07F 15/00, C09K 11/06, H10K 50/11, H10K 85/30, H10K 101/00

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 25.11.2021 KR 20210164867
(43) Date of publication of application: 31.05.2023
(73) Proprietor: Samsung Electronics Co., Ltd., Suwon-si, Gyeonggi-do 16677 (KR)
(72) Inventor: BAE, Hyejin, 16678 Suwon-si (KR); KIM, Hwang Suk, 16678 Suwon-si (KR); MIN, Minsik, 16678 Suwon-si (KR); PARK, Sangho, 16678 Suwon-si (KR); JEON, Soonok, 16678 Suwon-si (KR); CHOI, Hyesung, 16678 Suwon-si (KR); KANG, Hosuk, 16678 Suwon-si (KR); KIM, Jong Soo, 16678 Suwon-si (KR); KIM, Joonghyuk, 16678 Suwon-si (KR); NAM, Sungho, 16678 Suwon-si (KR)
(74) Representative: Elkington and Fife LLP

(56) References cited:
- US-A1- 2016 260 914

## Description

### FIELD OF THE INVENTION

One or more embodiments relate to an organometallic compound and an organic light-emitting device including the same.

### BACKGROUND OF THE INVENTION

Organic light-emitting devices (OLEDs) are self-emissive devices, which have improved characteristics in terms of viewing angles, response time, brightness, driving voltage, and response speed. OLEDs may also produce full-color images.

For example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light Compounds used for OLEDs are disclosed in US 2016/260914 A1.

### SUMMARY OF THE INVENTION

One or more embodiments include an organometallic compound and an organic light-emitting device using the same.

Additional aspects will be set forth in part in the detailed description which follows and, in part, will be apparent from the detailed description, or may be learned by practice of the presented exemplary embodiments herein.

According to an aspect, provided is an organometallic compound represented by Formula 1:

Formula 1 M₁(L₁₁)ₙ₁₁(L₁₂)ₙ₁₂

wherein, in Formula 1,
   M₁ is a first-row transition metal of the Periodic Table of Elements, a second-row transition metal of the Periodic Table of Elements, or a third-row transition metal of the Periodic Table of Elements,
   L₁₁ is a ligand represented by Formula 1-1,
   L₁₂ is a monodentate ligand or a bidentate ligand,
   n11 is 1,
   n12 is 0, 1, or 2, 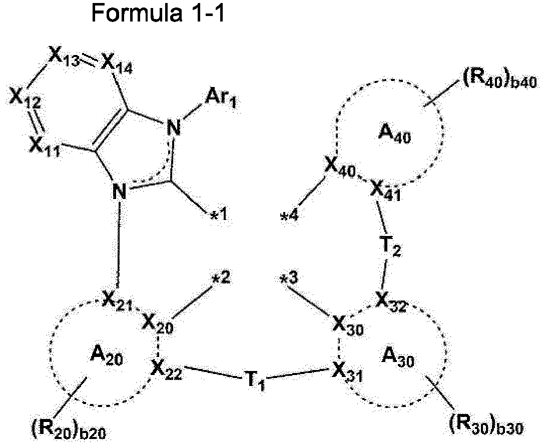
wherein, in Formula 1-1,
   *¹ to *⁴ each indicates a binding site to M₁,
   ring A₂₀, ring A₃₀, and ring A₄₀ are each independently a C₅-C₃₀ carbocyclic group or a C₁-C₃₀ heterocyclic group,
   T₁ is a single bond, *-N(R₁)-*', *-B(R₁)-*', *-P(R₁)-*', *-C(R₁)(R₂)-*', *-Si(R₁)(R₂)-*', *-Ge(R₁)(R₂)-*', *-S-*', *-Se-*', *-O-*', *-C(=O)-*', *-S(=O)-*', *-S(=O)₂-*', *-C(R₁)=C(R₂)-*', *-C(=S)-*',or *-C=C-*',
   T₂ is a single bond, *-N(R₃)-*', *-B(R₃)-*', *-P(R₃)-*', *-C(R₃)(R₄)-*', *-Si(R₃)(R₄)-*', *-Ge(R₃)(R₄)-*', *-S-*', *-Se-*', *-O-*', *-C(=O)-*', *-S(=O)-*', *-S(=O)₂-*', *-C(R₃)=C(R₄)-*', *-C(=S)-*', or *-C=C-*',
   X₁₁ is C(R₁₁) or N, X₁₂ is C(R₁₂) or N, X₁₃ is C(R₁₃) or N, and X₁₄ is C(R₁₄) or N,
   X₂₀ is C or N, X₂₁ is C or N, and X₂₂ is C or N,
   X₃₀ is C or N, X₃₁ is C or N, and X₃₂ is C or N,
   X₄₀ is C or N, and X₄₁ is C or N, and
   Ar1 is a group represented by Formula 2, 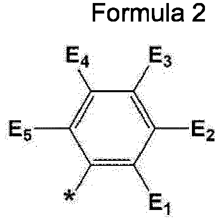
wherein, in Formula 2,
E₁ is a C₁-C₆₀ alkyl group substituted with deuterium, or a substituted or unsubstituted C₁-C₆₀ aryl group,
   E₂ to E₅ are each independently hydrogen, deuterium, -F, -Cl, -Br, -I, - SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), - P(Q₈)(Q₉), or -P(=O)(Q₈)(Q₉),
   at least one of E₂ to E₅ is not hydrogen,
   with the proviso that when E₁ is a C₁-C₆₀ alkyl group substituted with deuterium and E₅ is a C₁-C₆₀ alkyl group substituted with deuterium, at least one of E₂ to E₄ is not hydrogen,
   with the proviso that when E₁ is a substituted or unsubstituted C₁-C₆₀ aryl group, Ar₁ has an asymmetric structure,
   * and *' each indicates a binding site to a neighboring atom,
   R₁ to R₄, R₁₁ to R₁₄, R₂₀, R₃₀, and R₄₀ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₈)(Q₉), or -P(=O)(Q₈)(Q₉),
   neighboring two or more of R₁ to R₄, R₁₁ to R₁₄, R₂₀, R₃₀, or R₄₀ are optionally linked together to form a substituted or unsubstituted C₅-C₃₀ carbocyclic group or a substituted or unsubstituted C₁-C₃₀ heterocyclic group,
   two or more of R₂₀ in the number of b20 are optionally linked together to form a substituted or unsubstituted C₅-C₃₀ carbocyclic group or a substituted or unsubstituted C₁-C₃₀ heterocyclic group,
   two or more of R₃₀ in the number of b30 are optionally linked together to form a substituted or unsubstituted C₅-C₃₀ carbocyclic group or a substituted or unsubstituted C₁-C₃₀ heterocyclic group,
   two or more of R₄₀ in the number of b40 are optionally linked together to form a substituted or unsubstituted C₅-C₃₀ carbocyclic group or a substituted or unsubstituted C₁-C₃₀ heterocyclic group,
   b20, b30, and b40 are each independently 1, 2, 3, 4, 5, 6, 7, 8, 9, or 10,
   when b20 is 2 or greater, two or more of R₂₀ are identical to or different from each other, when b30 is 2 or greater, two or more of R₃₀ are identical to or different from each other, and when b40 is 2 or greater, two or more of R₄₀ are identical to or different from each other.
   at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
      deuterium, -F, -Cl, -Br, -I, -SF₅, -CD₃, -CD₂H, -CDH₂, -CF₃, -CF₂H, - CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), -P(Q₁₈)(Q₁₉), -P(=O)(Q₁₈)(Q₁₉), or a combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), -P(Q₂₈)(Q₂₉), -P(=O)(Q₂₈)(Q₂₉), or a combination thereof; or
   -N(Q₃₁)(Q₃₂), -Si(Q₃₃)(Q₃₄)(Q₃₅), -B(Q₃₆)(Q₃₇), -P(Q₃₈)(Q₃₉), or - P(=O)(Q₃₈)(Q₃₉), and
   Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group.

According to another aspect, provided is an organic light-emitting device including: a first electrode; a second electrode; and an organic layer located between the first electrode and the second electrode, wherein the organic layer includes an emission layer, and wherein the organic layer further inlcudes at least one of the organometallic compound.

The organometallic compound may be included in the emission layer of the organic layer, and the organometallic compound included in the emission layer may act as a dopant.

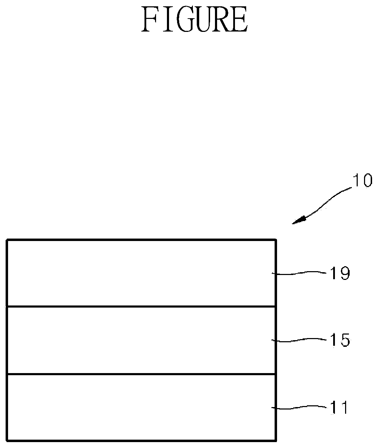

### BRIEF DESCRIPTION OF THE DRAWING

The above and other aspects, features, and advantages of one or more exemplary embodiments will be more apparent from the following detailed description taken in conjunction with the FIGURE, which is a schematic cross-sectional view showing an organic light-emitting device according to one or more embodiments.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (*i.e.,* the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 eV" of the vacuum level, while when the work function or the HOMO energy level is referred to be "shallow," "low," or "small," the work function or HOMO energy level has a small absolute value based on "0 eV" of the vacuum level.

An aspect provides an organometallic compound represented by Formula 1:

Formula 1 M1(L₁₁)ₙ₁₁(L₁₂)ₙ₁₂

wherein, in Formula 1, M₁ may be a first-row transition metal of the Periodic Table of Elements, a second-row transition metal of the Periodic Table of Elements, or a third-row transition metal of the Periodic Table of Elements.

In one or more embodiments, M₁ in Formula 1 may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In one or more embodiments, M₁ may be Pd, Pt, or Au.

In one or more embodiments, M₁ in Formula 1 may be Pt or Pd.

In one or more embodiments, M₁ in Formula 1 may be Pt.

L₁₁ in Formula 1 is a ligand represented by Formula 1-1: 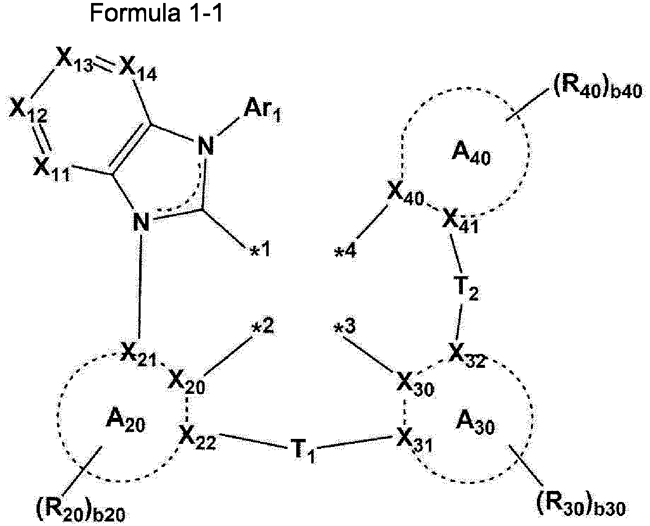 wherein, in Formula 1-1, *¹ to *⁴ are each independently a binding site to M₁.

Ring A₂₀ and ring A₃₀ in Formula 1 are each independently a C₅-C₃₀ carbocyclic group or a C₁-C₃₀ heterocyclic group.

In one or more embodiments, ring A₂₀ and ring A₃₀ may each independently be:
a phenyl group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, an indazole group, a benzoxazole group, a benzothiazole group, a benzoxadiazole group, a benzothiadiazole group, a benzotriazole group, a diazaindene group, a triazaindene group, a 5,6,7,8-tetrahydroisoquinoline group, or a 5,6,7,8-tetrahydroquinoline group.

In one or more embodiments, A₄₀ may be a phenyl group, a naphthalene group, an anthracene group, a phenanthrene group, a triphenylene group, a pyrene group, a chrysene group, a cyclopentadiene group, a 1,2,3,4-tetrahydronaphthalene group, a fluorene group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a triazaindene group, a 5,6,7,8-tetrahydroisoquinoline group, or a 5,6,7,8-tetrahydroquinoline group.

In one or more embodiments, A₄₀ may be a pyridine group, a pyrimidine group, a pyrazine group, a pyridazine group, a triazine group, a quinoline group, an isoquinoline group, a quinoxaline group, a quinazoline group, a phenanthroline group, a pyrrole group, an azafluorene group, an azacarbazole group, an azadibenzofuran group, an azadibenzothiophene group, an azadibenzosilole group, a 5,6,7,8-tetrahydroisoquinoline group, or a 5,6,7,8-tetrahydroquinoline group.

In one or more embodiments, ring A₂₀ may be a group represented by one of Formulae A20-1 to A20-13: 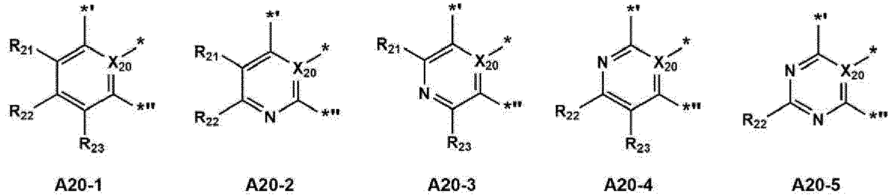 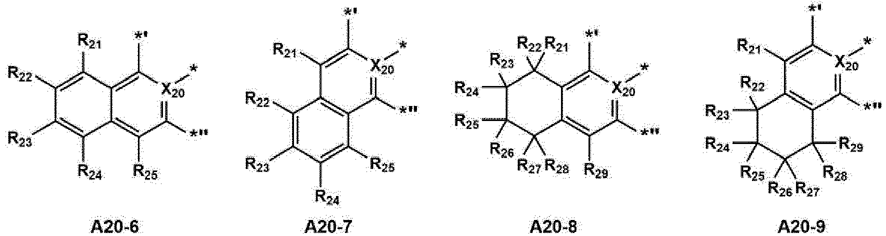 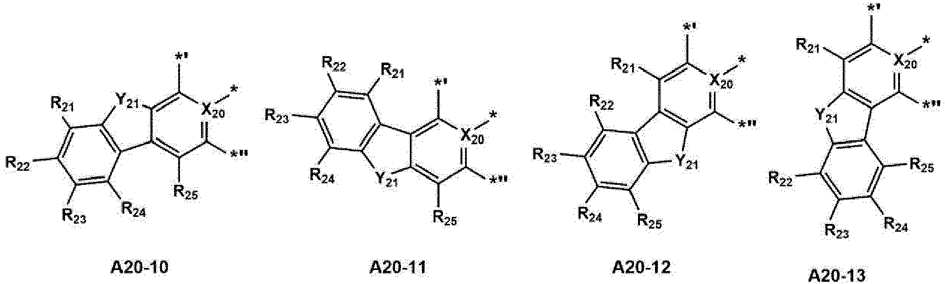 wherein, in Formulae A20-1 to A20-13,
X₂₀ is as described in the present specification,
Y₂₁ may be a single bond, O, S, N(R₂₆), C(R₂₆)(R₂₇), or Si(R₂₆)(R₂₇),
R₂₁ to R₂₉ are each independently as described in connection with R₂₀, and
* indicates a binding site to M₁, and is the as described in connection with *²,
*' and *" each indicates a binding site to a neighboring atom.

In one or more embodiments, A₃₀ may be a group represented by one of Formulae A30-1 to A30-12: 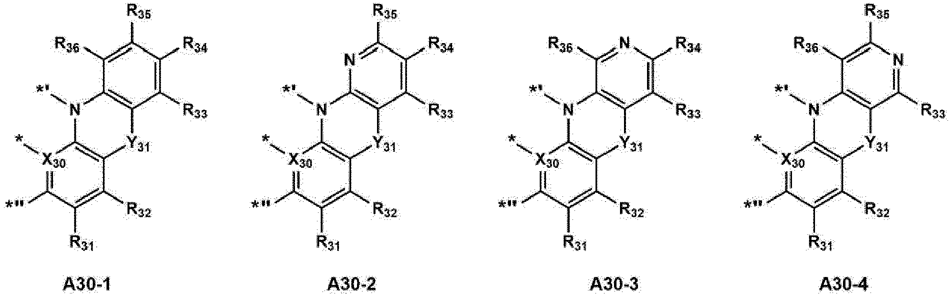 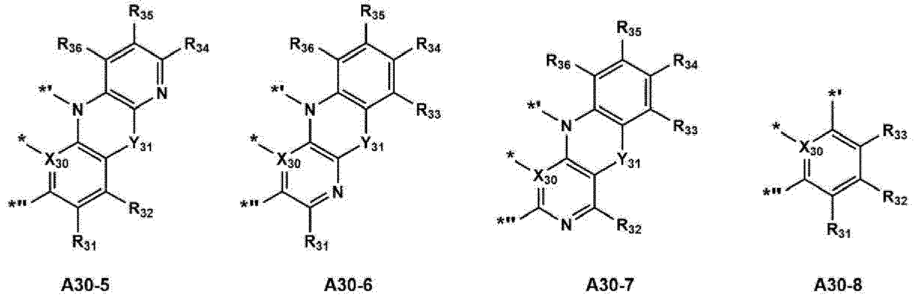 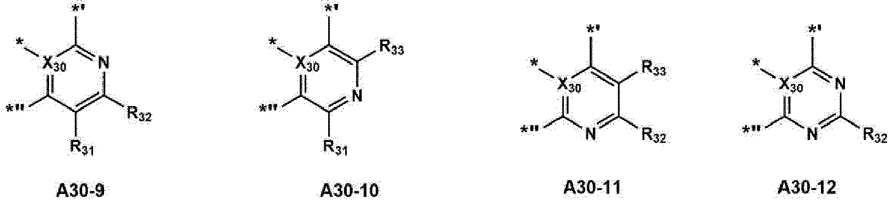 wherein, in Formulae A30-1 to A30-12,
X₃₀ is as described in the present specification,
Y₃₁ may be a single bond, O, S, N(R₃₇), C(R₃₇)(R₃₈), or Si(R₃₇)(R₃₈),
R₃₁ to R₃₈ are each independently as described in connection with R₃₀, and
* indicates a binding site to M₁, and is as described in connection with *³, and
*' and *" each indicates a binding site to a neighboring atom.

In one or more embodiments, A₄₀ may be a group represented by one of Formulae A40-1 to A40-16: 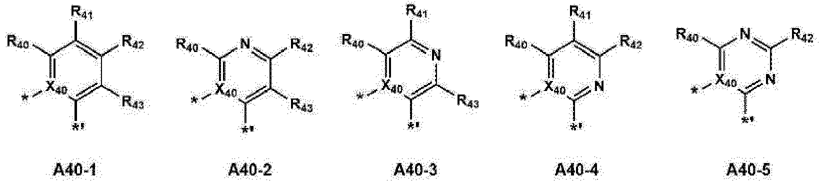 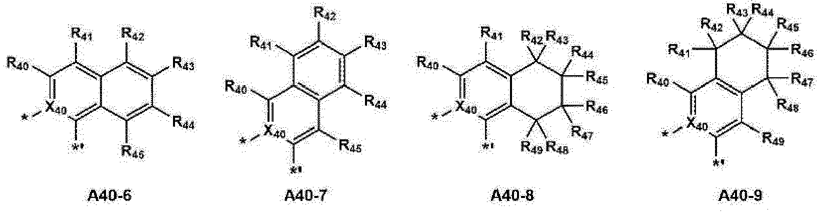 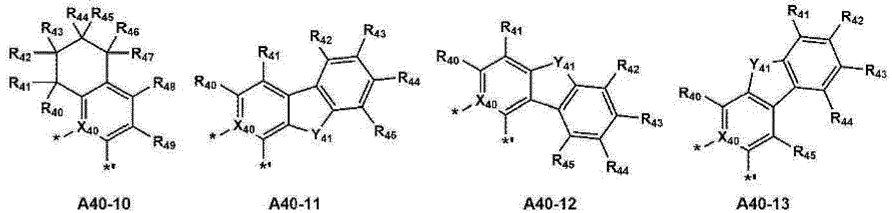 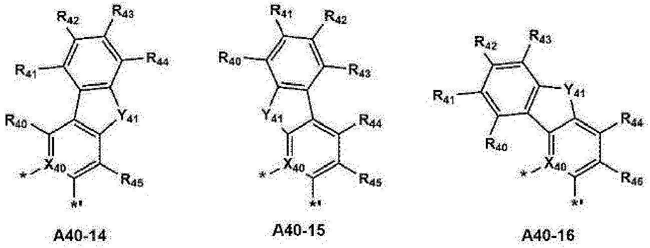 wherein, in Formulae A40-1 to A40-16,
X₄₀ and R₄₀ are each as described in the present specification,
Y₄₁ may be a single bond, O, S, N(R₄₆), C(R₄₆)(R₄₇), or Si(R₄₆)(R₄₇),
R₄₁ to R₄₉ are each independently as described in connection with R₄₀, and
* indicates a binding site to M₁, as described in connection with *⁴, and
*' indicates a binding site to a neighboring atom.

Ar₁ in Formula 1-1 is a group represented by Formula 2: 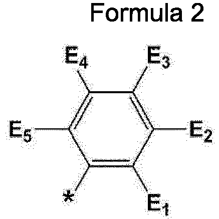
wherein, in Formula 2, E₁ is a C₁-C₆₀ alkyl group substituted with deuterium, or a substituted or unsubstituted C₁-C₆₀ aryl group.
* in Formula 2 indicates a binding site to a neighboring atom.

E₂ to E₅ in Formula 2 are each independently hydrogen, deuterium, -F, -Cl, - Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -B(Q₆)(Q₇), -P(Q₈)(Q₉), or -P(=O)(Q₃)(Q₉), and
at least one of E₂ to E₅ is not hydrogen.

In Formula 2, when E₁ is a C₁-C₆₀ alkyl group substituted with deuterium and E₅ is a C₁-C₆₀ alkyl group substituted with deuterium, at least one of E₂ to E₄ is not hydrogen.

In Formula 2, when E₁ is a substituted or unsubstituted C₁-C₆₀ aryl group, Ar₁ has an asymmetric structure.

In one or more embodiments, E₁ may be:
a C₁-C₃₀ alkyl group substituted with deuterium;
a C₁-C₆₀ aryl group; or
a C₁-C₆₀ aryl group substituted with at least one of deuterium, -F, -Cl, - Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof.

In one or more embodiments, E₁ may be:
a methyl group, an ethyl group, an n-propyl group, an isopropyl group, an n-butyl group, an isobutyl group, a sec-butyl group, a tert-butyl group, a neo-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with at least one deuterium;
a phenyl group, a naphthyl group, a fluorenyl group, a phenanthrenyl group, an anthracenyl group, a fluoranthenyl group, a triphenylenyl group, a pyrenyl group, or a chrysenyl group; or
a phenyl group, a naphthyl group, a fluorenyl group, a phenanthrenyl group, an anthracenyl group, a fluoranthenyl group, a triphenylenyl group, a pyrenyl group, or a chrysenyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof.

In one or more embodiments, E₂ to E₅ may each independently be:
hydrogen, deuterium, -F, -Cl, -Br, -I, or -SF₅;
a C₁-C₃₀ alkyl group;
a C₁-C₃₀ alkyl group substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof.

In one or more embodiments, E₂ to E₅ may each independently be:
hydrogen, deuterium, -F, -Cl, -Br, -I, -SF₅, a cyano group, a methyl group, an ethyl group, an n-propyl group, an isopropyl group, an n-butyl group, an isobutyl group, a sec-butyl group, a tert-butyl group, a neo-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or
a methyl group, an ethyl group, an n-propyl group, an isopropyl group, an n-butyl group, an isobutyl group, a see-butyl group, a tert-butyl group, a neo-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof.

In one or more embodiments, Ar1 may be a group represented by one of Formulae Ar1-1 to Ar1-14: 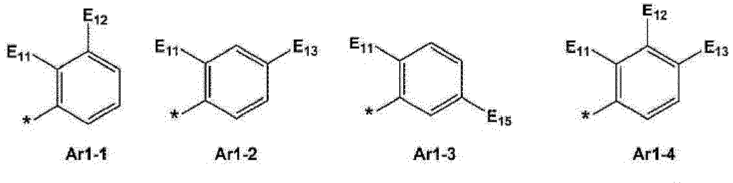 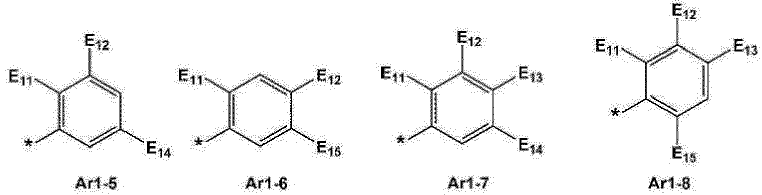 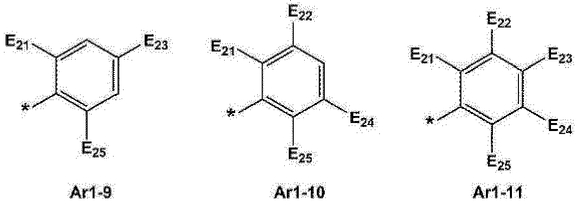 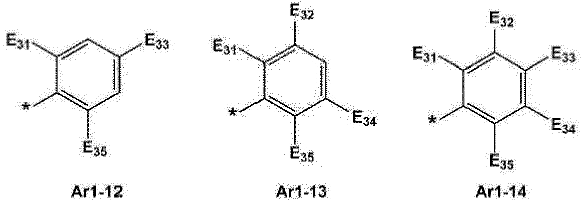 wherein, in Formulae Ar1-1 to Ar1-14,
E₁₁ may be a C₁-C₆₀ alkyl group substituted with deuterium, or a substituted or unsubstituted C₁-C₆₀ aryl group,
E₂₁ may be a C₁-C₆₀ alkyl group substituted with deuterium, or a substituted or unsubstituted C₁-C₆₀ aryl group,
E₂₁ and E₂₅ may be different from each other,
E₃₁ and E₃₅ may each independently be a C₁-C₆₀ alkyl group substituted with deuterium,
E₁₂ to E₁₅, E₂₂ to E₂₅, and E₃₂ to E₃₄ may each independently be deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - B(Q₆)(Q₇), -P(Q₈)(Q₉), or -P(=O)(Q₈)(Q₉), and
* indicates a binding site to a neighboring atom.

In one or more embodiments, E₁₁, E₂₁, and E₃₁ in Formulae Ar1-1 to Ar1-14 are each independently as described in connection with E₁ in Formula 2.

In one or more embodiments, E₁₂ to E₁₅, E₂₂ to E₂₅, and E₃₂ to E₃₅ in Formulae Ar1-1 to Ar1-14 are each independently as described in connection with E₂ to E₅ in Formula 2.

In one or more embodiments, Ar1 may be a group represented by one of Formulae Ar1(1) to Ar1(104): 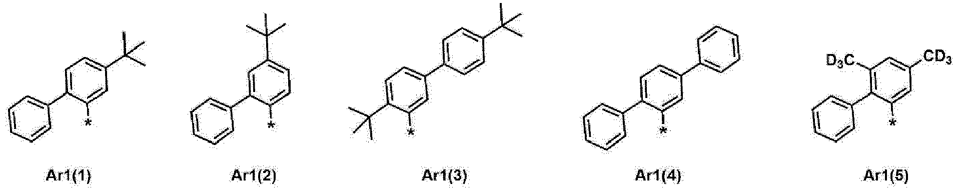 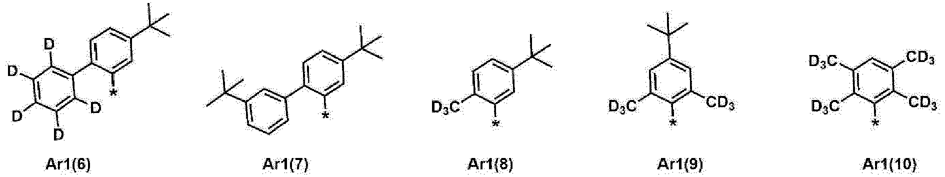 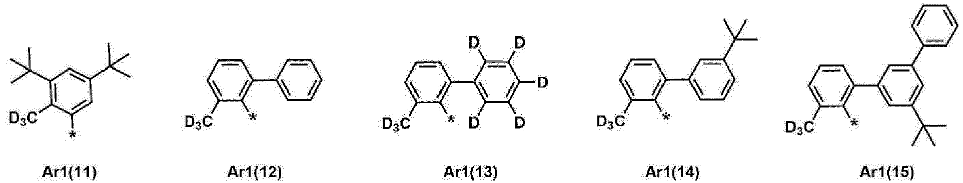 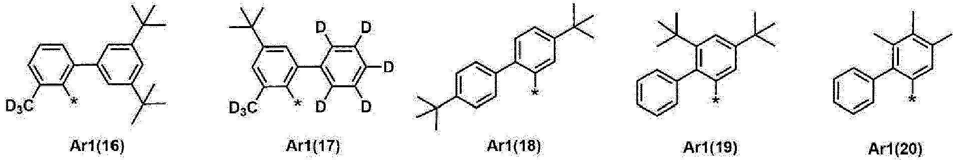 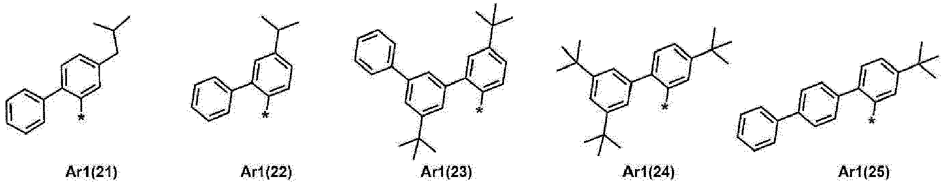 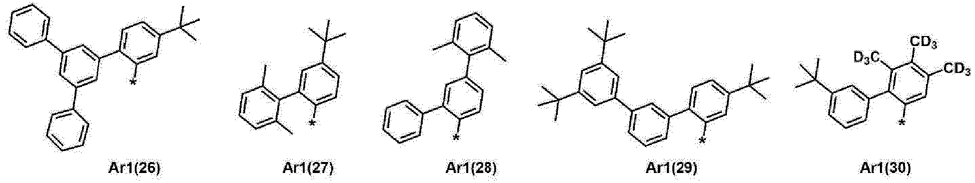 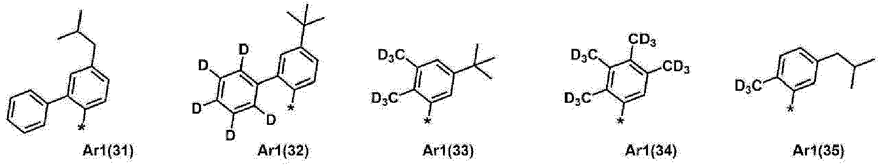 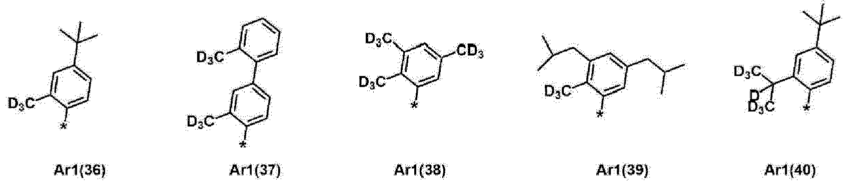 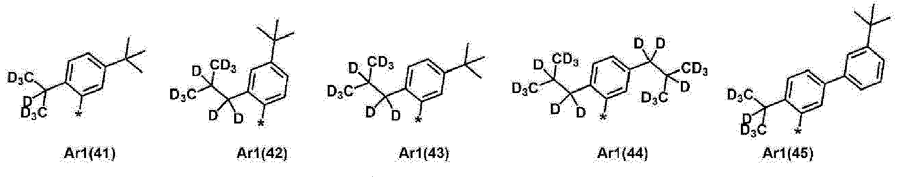 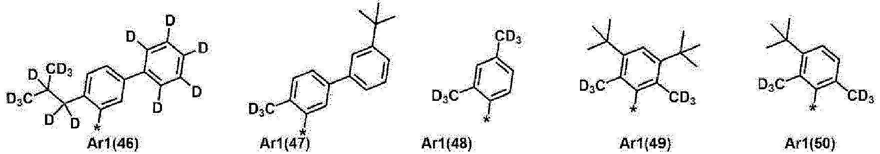 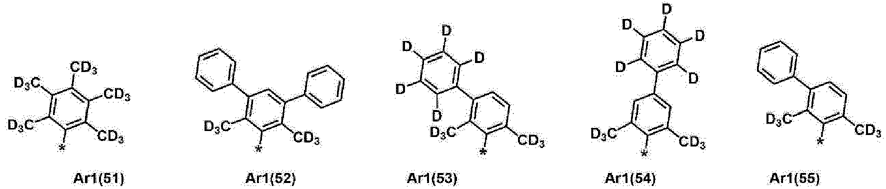 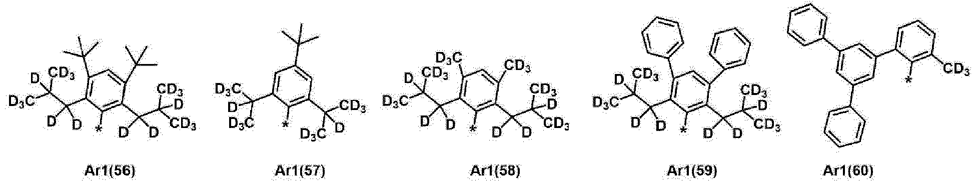 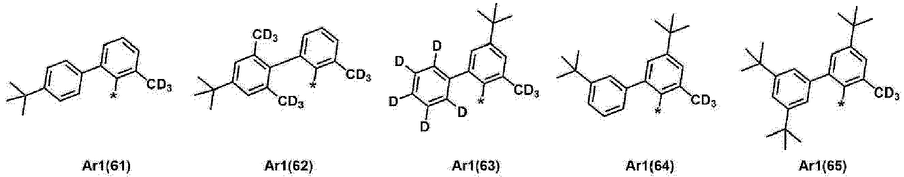 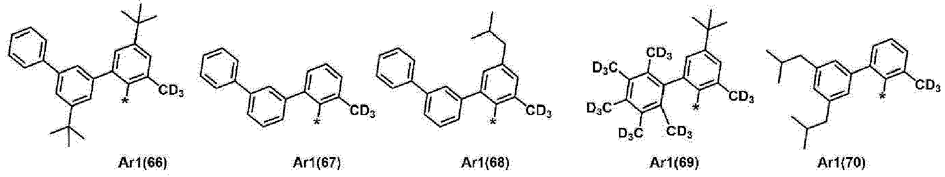 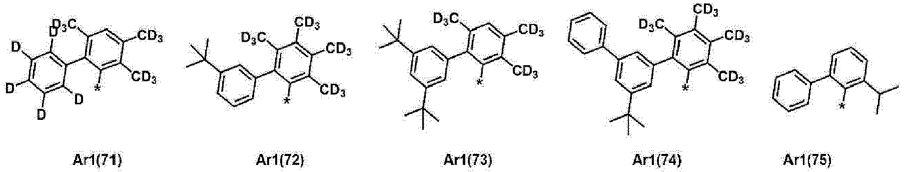 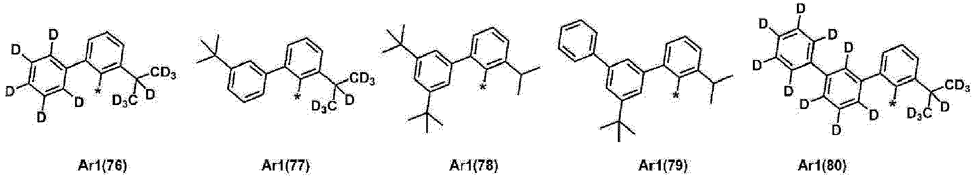 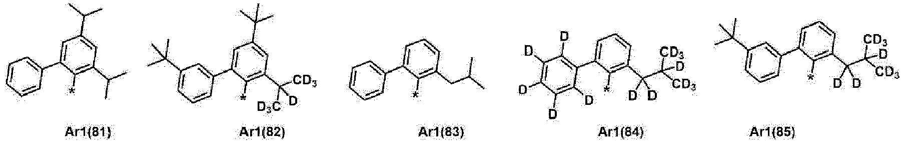 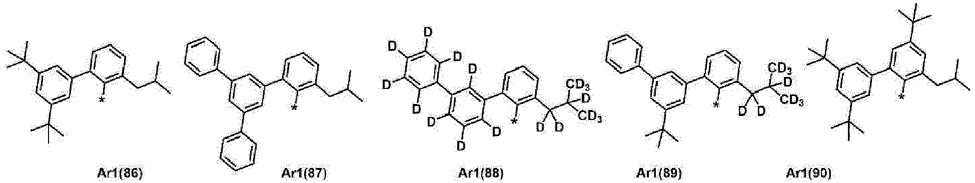 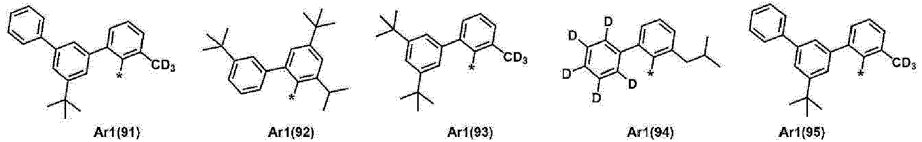 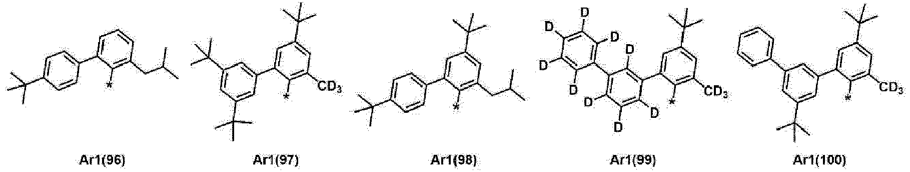 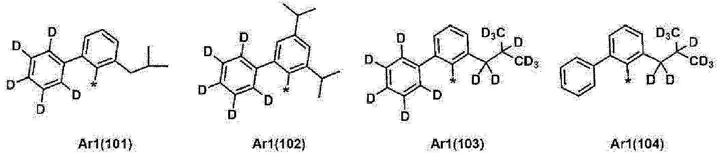 wherein, in Formulae Ar1(1) to Ar1(104),
* indicates a binding site to a neighboring atom.

In one or more embodiments, Ar1 may be a group having an asymmetric structure. As used herein, the term "asymmetric structure" means that the group Ar₁ includes substituent groups that are arranged in an asymmetric manner to provide asymmetry to the Ar₁ group.

R₁ to R₄, R₁₁ to R₁₄, R₂₀, R₃₀, and R₄₀ in Formula 1-1 are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₈)(Q₉), or -P(=O)(Q₈)(Q₉), and
neighboring two or more of R₁ to R₄, R₁₁ to R₁₄, R₂₀, R₃₀, or R₄₀ are optionally linked together to form a substituted or unsubstituted C₅-C₃₀ carbocyclic group or a substituted or unsubstituted C₁-C₃₀ heterocyclic group.
two or more of R₂₀ in the number of b20 are optionally linked together to form a substituted or unsubstituted C₅-C₃₀ carbocyclic group or a substituted or unsubstituted C₁-C₃₀ heterocyclic group,
two or more of R₃₀ in the number of b30 are optionally linked together to form a substituted or unsubstituted C₅-C₃₀ carbocyclic group or a substituted or unsubstituted C₁-C₃₀ heterocyclic group,
two or more of R₄₀ in the number of b40 are optionally linked together to form a substituted or unsubstituted C₅-C₃₀ carbocyclic group or a substituted or unsubstituted C₁-C₃₀ heterocyclic group,
b20, b30, and b40 in Formula 1-1 are each independently 1, 2, 3, 4, 5, 6, 7, 8, 9, or 10, and
when b20 is 2 or greater, two or more of R₂₀ are identical to or different from each other, when b30 is 2 or greater, two or more of R₃₀ are identical to or different from each other, and when b40 is 2 or greater, two or more of R₄₀ are identical to or different from each other.

In one or more embodiments, R₁ to R₄, R₁₁ to R₁₄, R₂₀, R₃₀, and R₄₀ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
-N(Q₁)(Q₂), -Si(Q₃)(Q₄)(Q₅), -B(Q₆)(Q₇), -P(Q₈)(Q₉), or -P(=O)(Q₈)(Q₉), and
Q₁ to Q₉ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂;
   an n-propyl group, an isopropyl group, an n-butyl group, an isobutyl group, a see-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a see-butyl group, a tert-butyl group, an n-pentyl group, an isopentyl group, a sec-pentyl group, a tert-pentyl group, a phenyl group, or a naphthyl group, each substituted with deuterium, a C₁-C₁₀ alkyl group, a phenyl group, or a combination thereof.

In one or more embodiments, R₁ to R₄, R₁₀, R₂₀, R₃₀, and R₄₀ may each independently be hydrogen, deuterium, -F, a cyano group, a nitro group, -SF₅, -CH₃, - CD₃, -CD₂H, -CDH₂, -CF₃, -CF₂H, -CFH₂, a group represented by one of Formulae 9-1 to 9-61, or a group represented by one of Formulae 10-1 to 10-359: 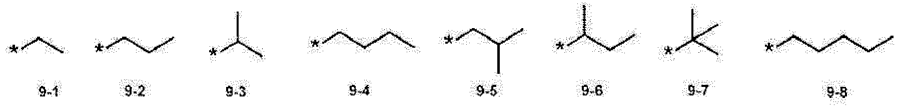 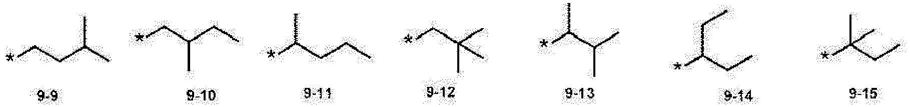 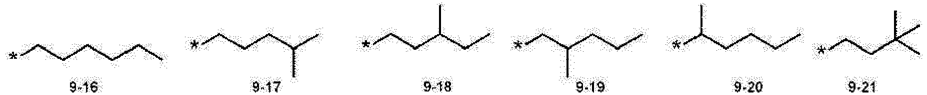 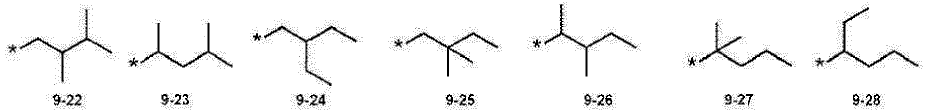 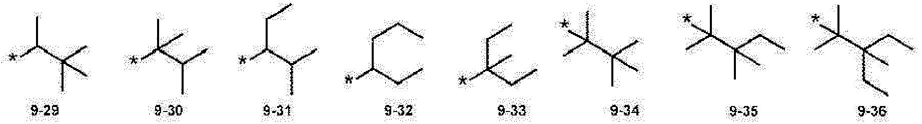 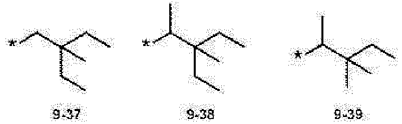 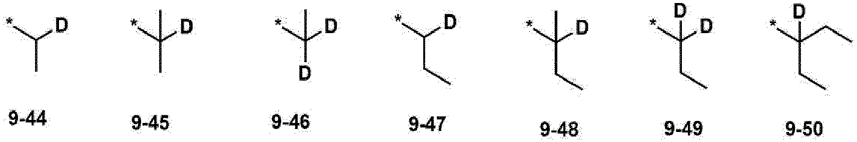 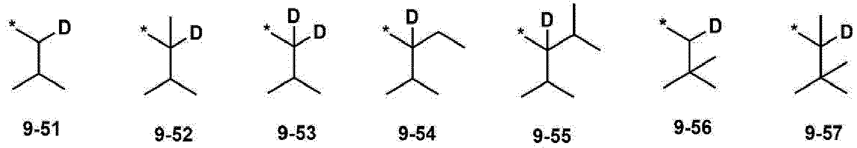 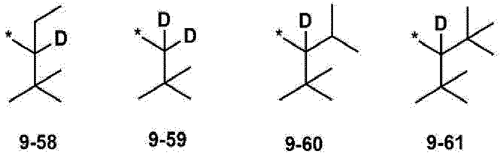 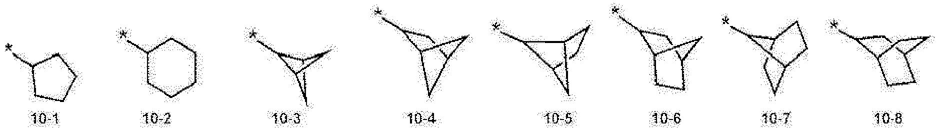 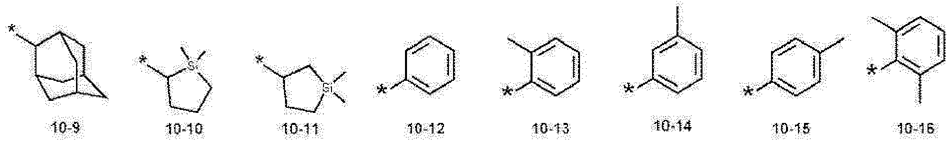 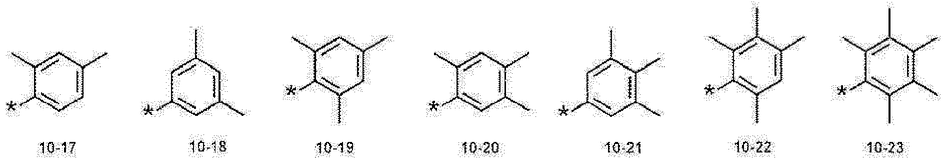 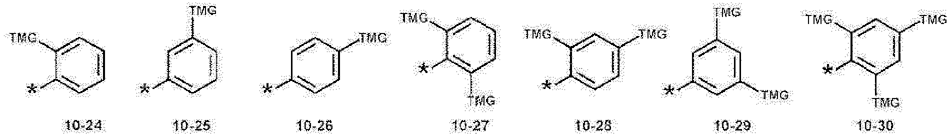 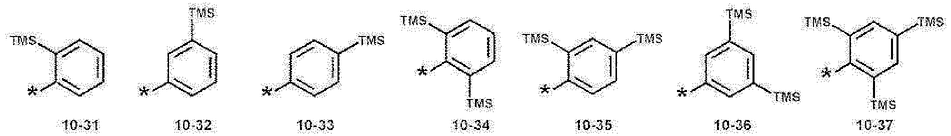 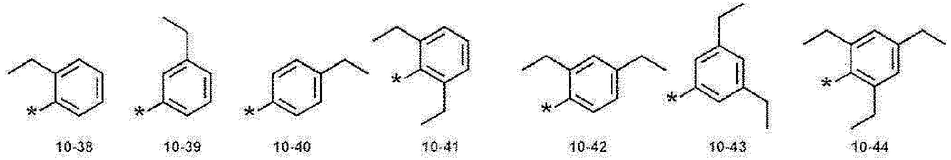 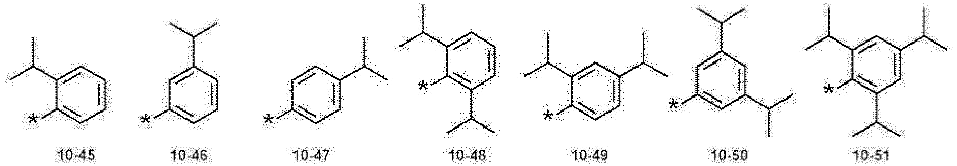 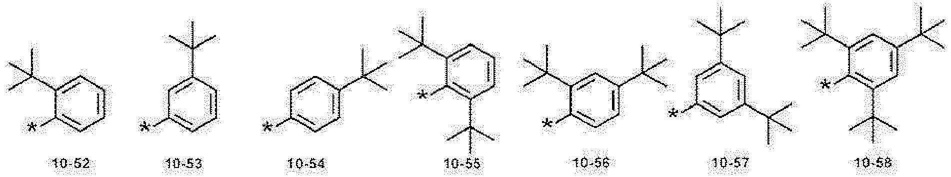 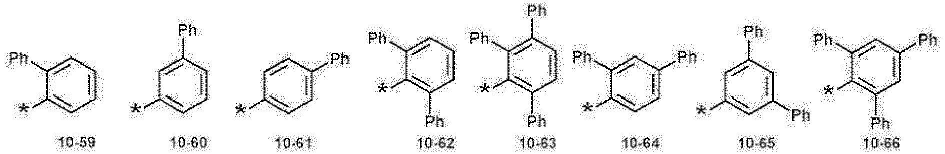 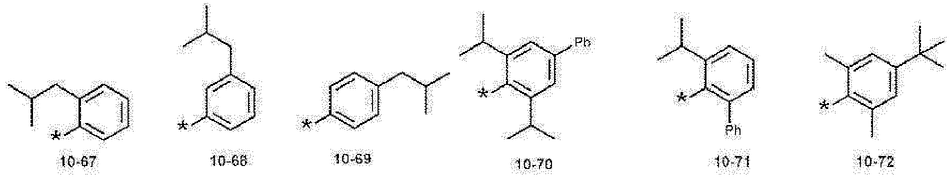 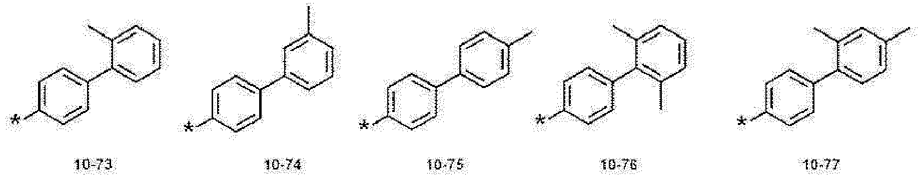 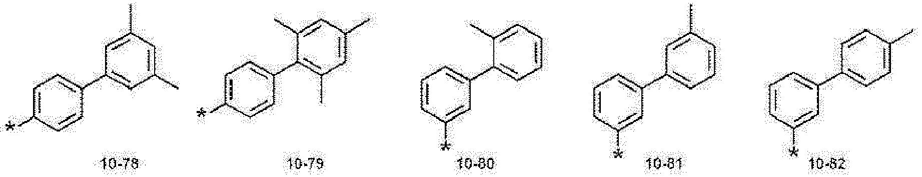 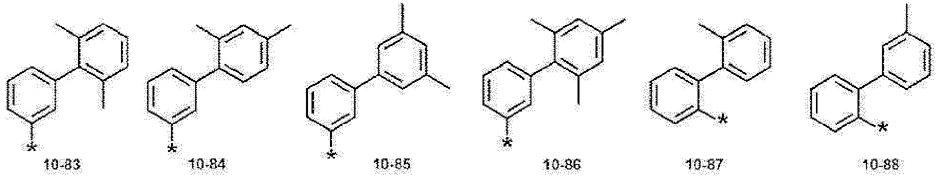 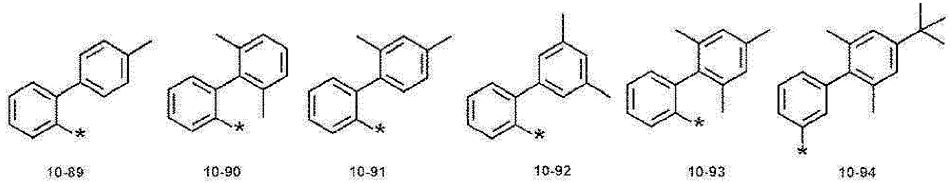 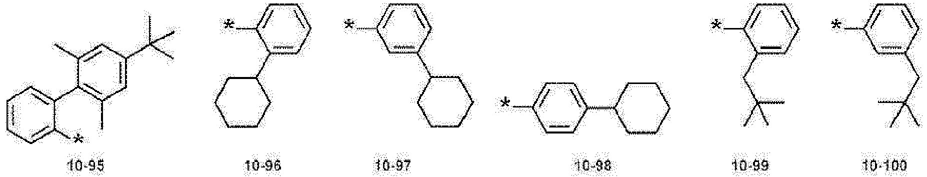 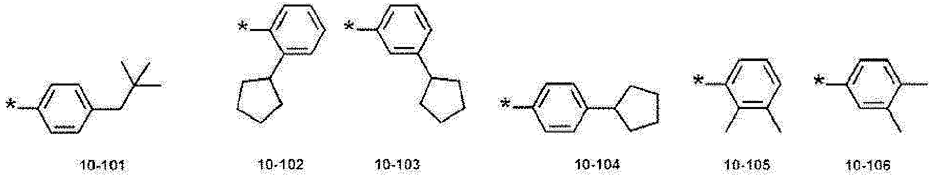 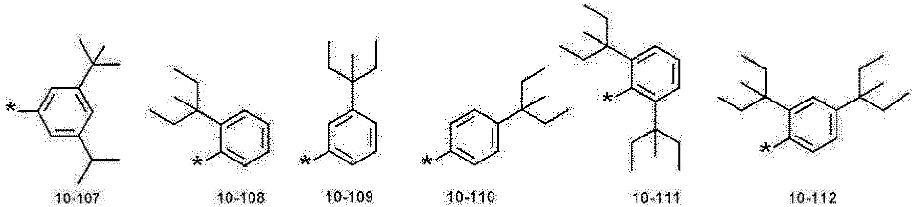 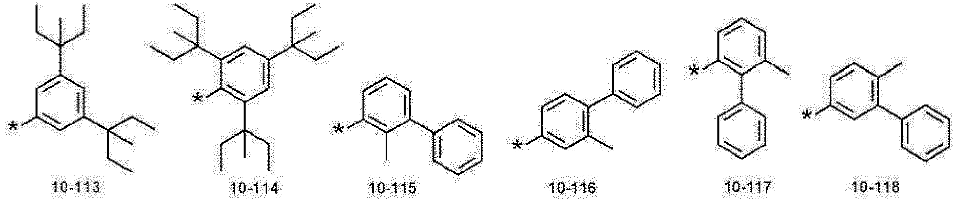 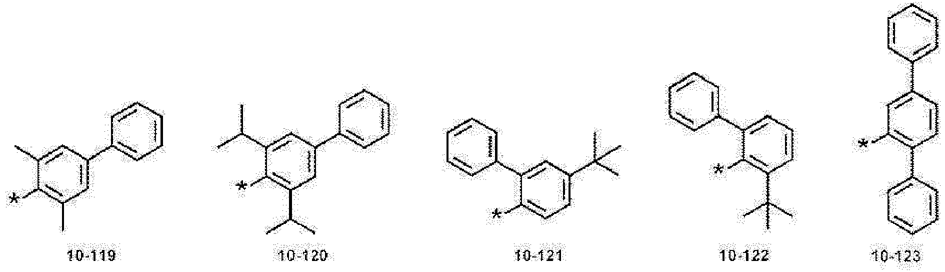 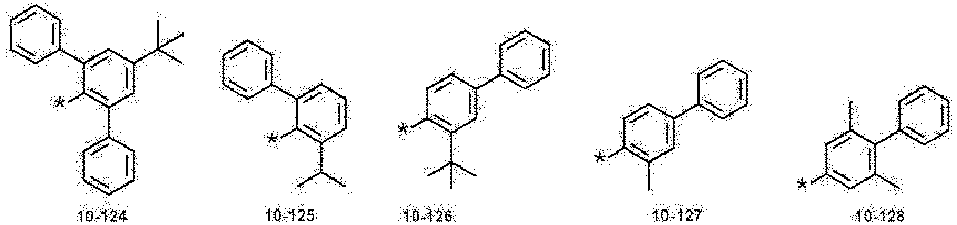 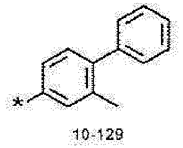 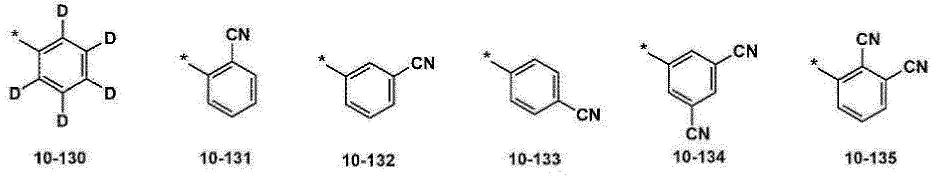 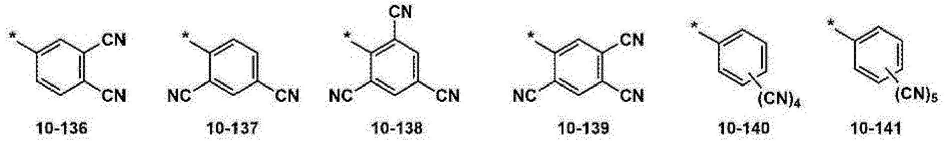 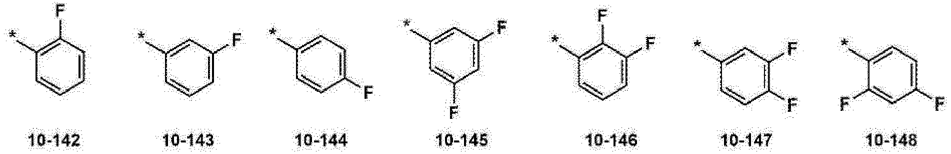 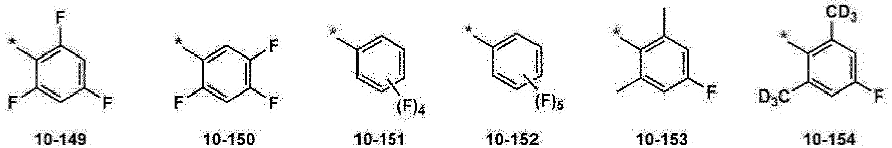 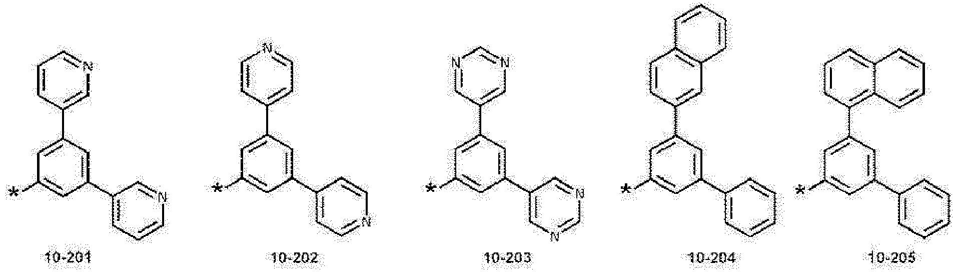 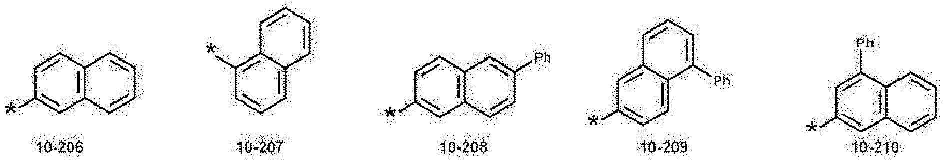 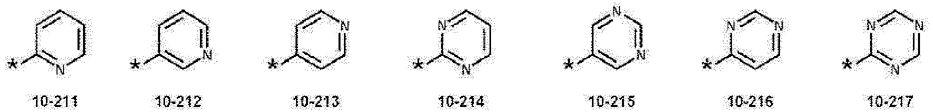 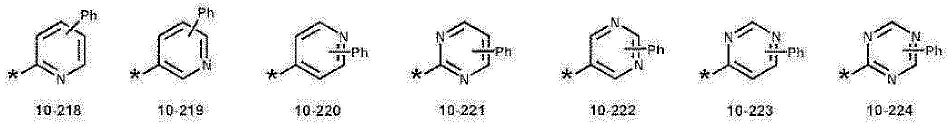 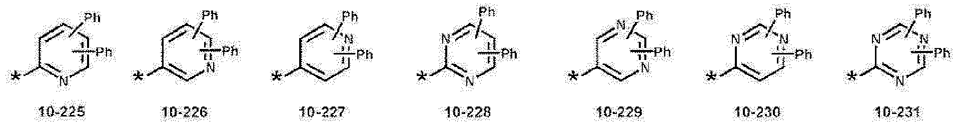 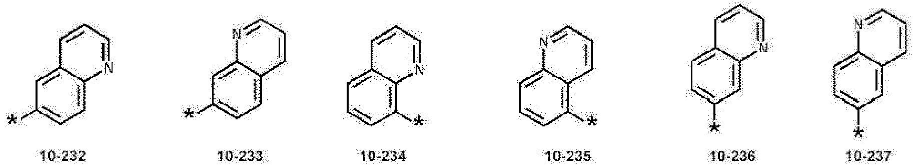 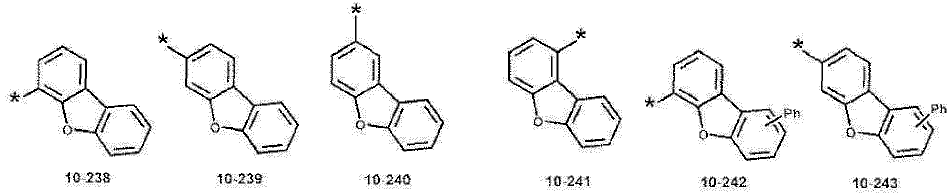 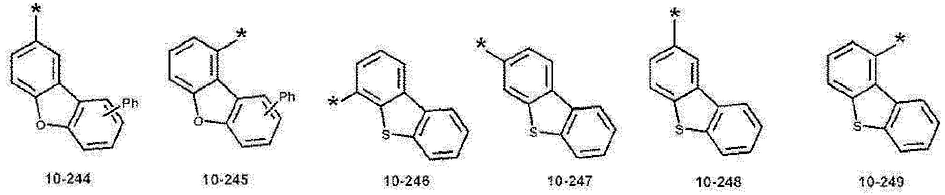 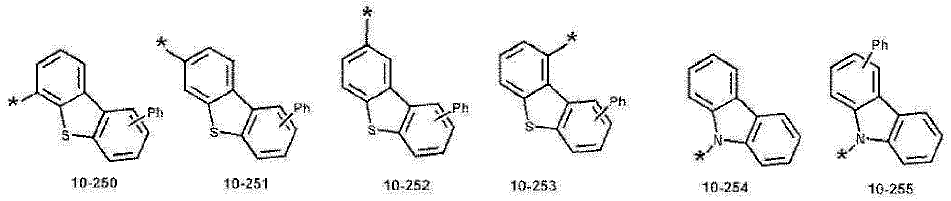 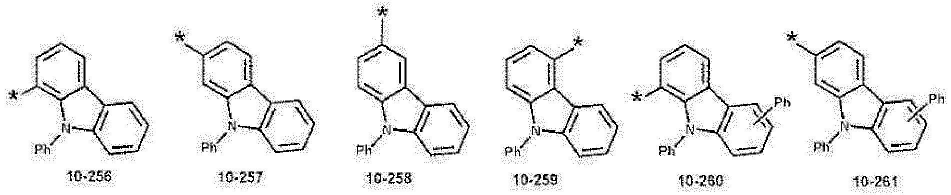 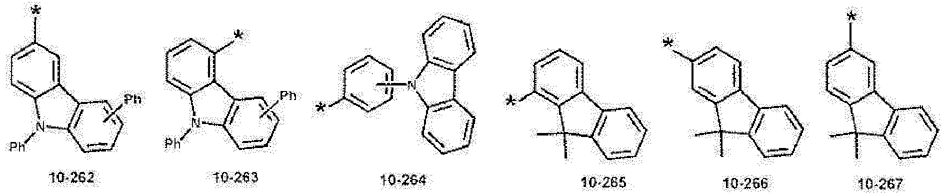 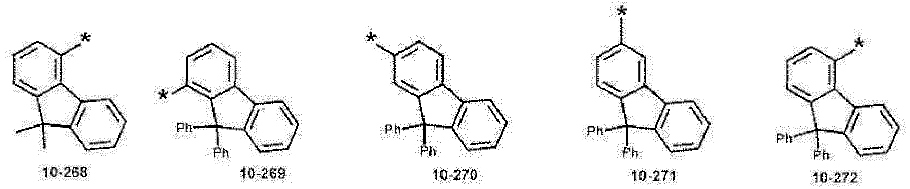 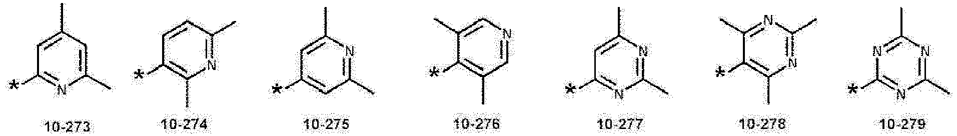 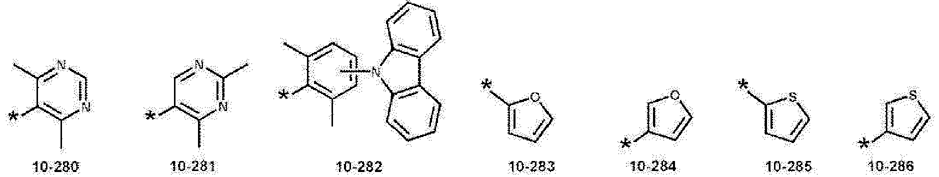 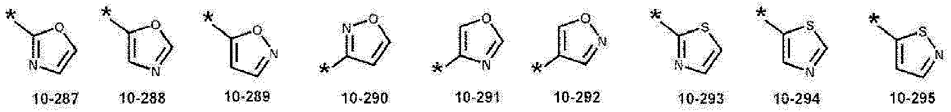 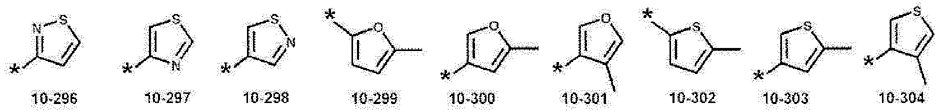 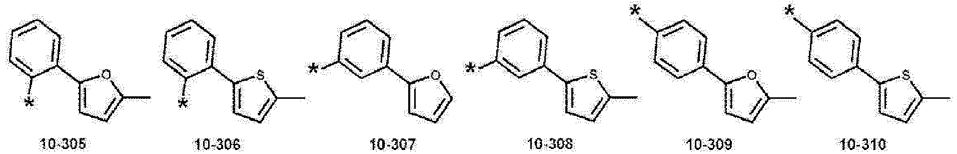 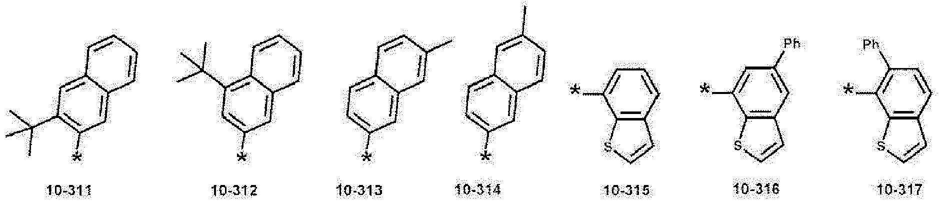 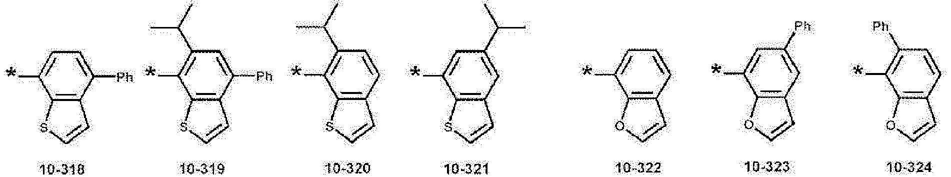 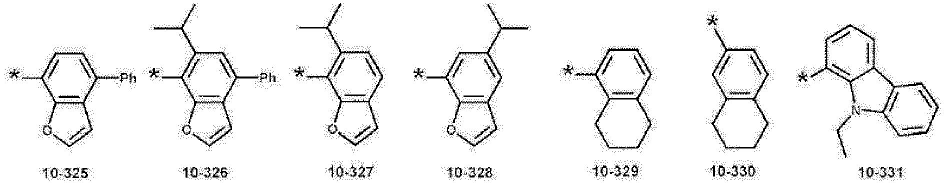 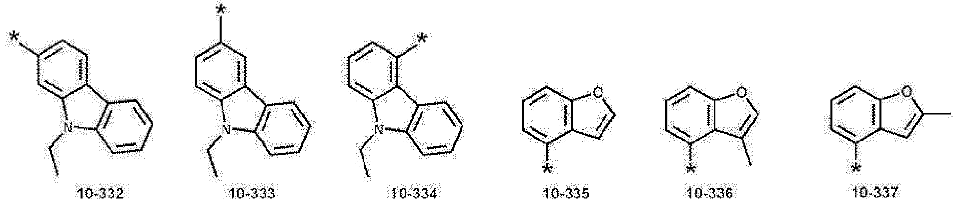 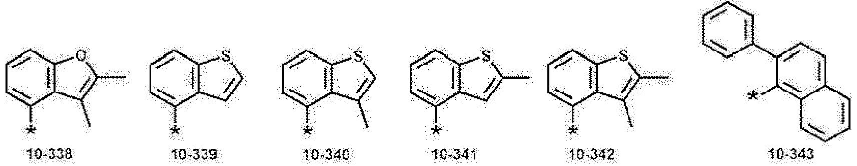 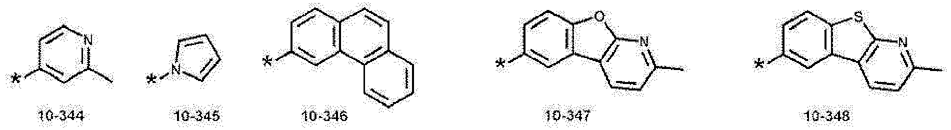 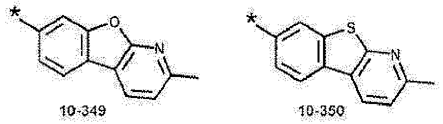 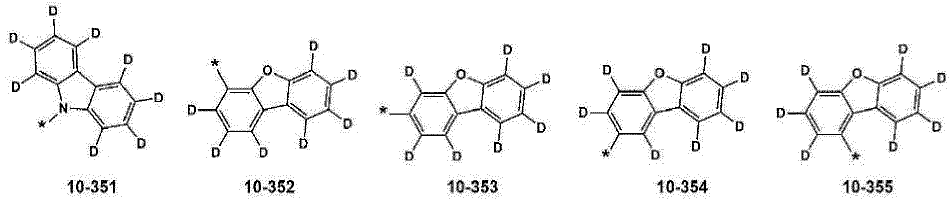 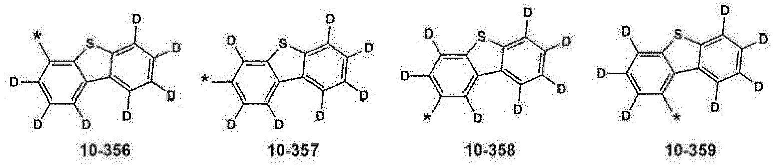 wherein, in Formulae 9-1 to 9-61 and 10-1 to 10-359, * indicates a binding site to a neighboring atom, "Ph" indicates a phenyl group, "TMS" indicates a trimethylsilyl group, and "TMG" indicates a trimethylgermyl group.

When b10 is 2, two of R₁₀ may be identical to or different from each other, and when b20 is 2 or more, two or more of R₂₀ may be identical to each other or different from each other.

In Formula 1-1, two or more of a plurality of R₁₀; two or more of a plurality of R₂₀; or neighboring two or more of R₁₀, R₂₀ to R₂₂, or R₃₁ to R₃₇ are optionally linked together to form a substituted or unsubstituted C₅-C₃₀ carbocyclic group or a substituted or unsubstituted C₁-C₃₀ heterocyclic group.

In one or more embodiments, two or more of a plurality of R₁₀; two or more of a plurality of R₂₀; or neighboring two or more of R₁₀, R₂₀ to R₂₂, or R₃₁ to R₃₇ may optionally be linked together via a single bond, a double bond, or a first linking group to form a C₅-C₃₀ carbocyclic group unsubstituted or substituted with at least one R₁₀ₐ or a C₁-C₃₀ heterocyclic group unsubstituted or substituted with at least one R₁₀ₐ (for example, a fluorene group, a xanthene group, or an acridine group, each unsubstituted or substituted with at least one R₁₀ₐ). R₁₀ₐ is as described in connection with R₁₀.

The first linking group may be *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*¹, *-C(=O)-*', *-S(=O)-*', *-S(=O)₂-*', *-C(R₈)=*', *=C(R₈)-*', *-C(R₈)=C(R₉)-*', *-C(=S)-*', or *-C=C-*', R₈ and R₉ are each as described in connection with R₁₀, and each of * and *' indicates a binding site to a neighboring atom.

In one or more embodiments, Q₁ to Q₉, Q₁₁ to Q₁₉, Q₂₁ to Q₂₉ and Q₃₁ to Q₃₉ described herein may each independently be:
deuterium, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, - CD₂CD₂H, or -CD₂CDH₂;
an n-propyl group, an isopropyl group, an n-butyl group, an isobutyl group, a see-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, a neo-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

In one or more embodiments, the organometallic compound represented by Formula 1 may be represented by Formula 11: 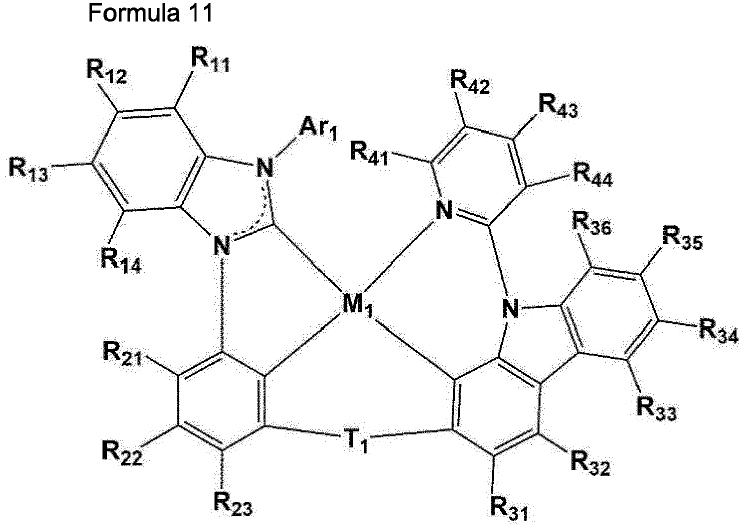 wherein, in Formula 11,
M₁, Ar1, T₁, and R₁₁ to R₁₄ are respectively as those described in the present specification,
R₂₁ to R₂₃ are each independently as described in connection with R₂₀,
R₃₁ to R₃₆ are each independently as described in connection with R₃₀, and
R₄₁ to R₄₄ are each independently as described in connection with R₄₀.

In Formula 1-1, X₂₀ is C or N, X₂₁ is C or N, and X₂₂ is C or N.

In Formula 1-1, X₃₀ is C or N, X₃₁ is C or N, and X₃₂ is C or N.

In Formula 1-1, X₄₀ is C or N, and X₄₁ is C or N.

For example, X₂₀ may be C. In one or more embodiments, X₂₀ may be N.

For example, X₃₀ may be C. In one or more embodiments, X₃₀ may be N.

For example, X₄₀ may be C. In one or more embodiments, X₄₀ may be N.

In Formula 1-1, X₂₀ is C or N, X₂₁ is C or N, X₂₂ is C or N, X₃₁ is C or N, X₃₂ is C or N, and X₄₁ is C or N.

For example, X₂₁ may be C. In one or more embodiments, X₂₁ may be N.

For example, X₂₂ may be C. In one or more embodiments, X₂₂ may be N.

For example, X₃₁ may be C. In one or more embodiments, X₃₁ may be N.

For example, X₃₂ may be C. In one or more embodiments, X₃₂ may be N.

For example, X₄₁ may be C. In one or more embodiments, X₄₁ may be N.

In Formula 1-1, a bond between M₁ and a moiety represented by 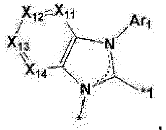
a bond between M₁ and ring A₂₀,
a bond between M₁ and ring A₃₀, and
a bond between M₁ and ring A₄₀
may each independently be a covalent bond or a coordinate bond.

In one or more embodiments, two bonds of
a bond between M₁ and 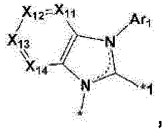
a bond between M₁ and ring A₂₀,
a bond between M₁ and ring A₃₀, and
a bond between M₁ and ring A₄₀ may each be a covalent bond, and
the other two bonds may each be a coordinate bond.

In one or more embodiments,
a bond between M₁ and 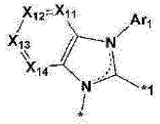 may be a coordinate bond,
a bond between M₁ and ring A₂₀ may be a covalent bond,
a bond between M₁ and ring A₃₀ may be a covalent bond, and
a bond between M₁ and ring A₄₀ may be a coordinate bond.

In one or more embodiments, the organometallic compound may be electrically neutral.

L₁₂ in Formula 1 may be a monodentate ligand or a bidentate ligand.

For example, L₁₂ in Formula 1 may be a ligand represented by one of Formulae 7-1 to 7-11, but embodiments are not limited thereto: 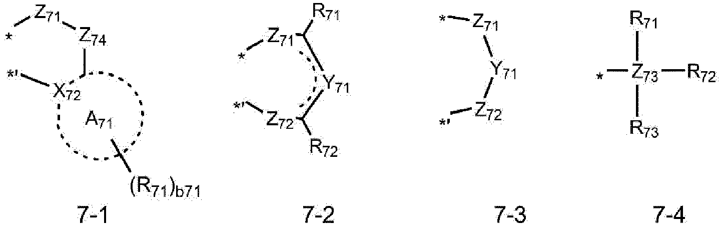 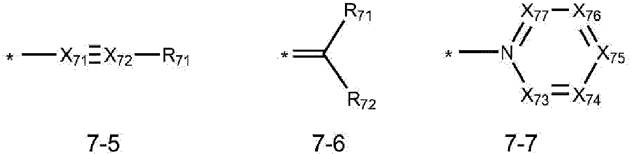 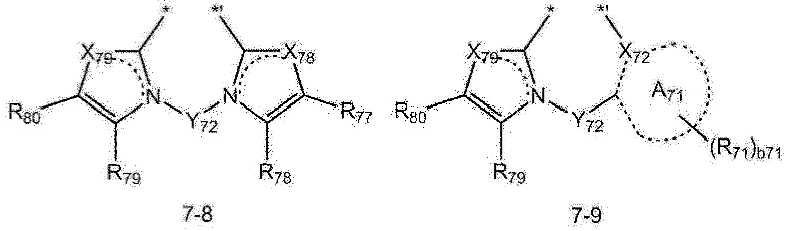 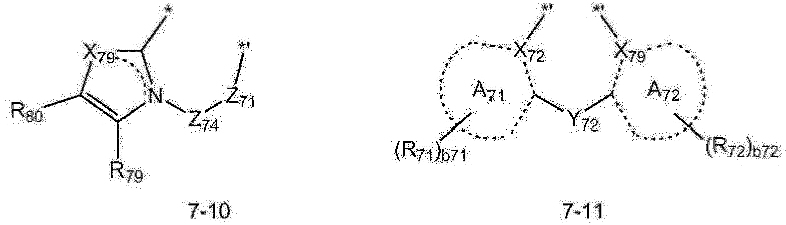 wherein, in Formulae 7-1 to 7-11,
ring A₇₁ and ring A₇₂ may each independently be a C₅-C₂₀ carbocyclic group or a C₁-C₂₀ heterocyclic group,
X₇₁ and X₇₂ may each independently be C or N,
X₇₃ may be N or C(Q₇₃), X₇₄ may be N or C(Q₇₄), X₇₅ may be N or C(Q₇₅), X₇₆ may be N or C(Q₇₆), and X₇₇ may be N or C(Q₇₇),
X₇₈ may be O, S, or N(Q₇₈), and X₇₉ may be O, S, or N(Q₇₉),
Y₇₁ and Y₇₂ may each independently be a single bond, a double bond, a substituted or unsubstituted C₁-C₅ alkylene group, a substituted or unsubstituted C₂-C₅ alkenylene group, or a substituted or unsubstituted C₆-C₁₀ arylene group,
Z₇₁ and Z₇₂ may each independently be N, O, N(R₇₄), P(R₇₅)(R₇₆), or As(R₇₅)(R₇₆),
Z₇₃ may be P or As,
Z₇₄ may be CO or CH₂,
R₇₁ to R₈₀ and Q₇₃ to Q₇₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group, wherein R₇₁ and R₇₂ may optionally be linked together to form a ring, R₇₇ and R₇₈ may optionally be linked together to form a ring, R₇₈ and R₇₉ may optionally be linked together to form a ring, and R₇₉ and R₈₀ may optionally be linked together to form a ring,
b71 and b72 may each independently be 1, 2, or 3, and
* and *' each indicate a binding site to M₁.

For example, A₇₁ and A₇₂ in Formula 7-1 may each independently be a phenyl group, a naphthalene group, an imidazole group, a benzimidazole group, a pyridine group, a pyrimidine group, a triazine group, a quinoline group, or an isoquinoline group, but embodiments are not limited thereto.

For example, X₇₂ and X₇₉ in Formula 7-1 may each be N, but embodiments are not limited thereto.

For example, in Formula 7-7, X₇₃ may be C(Q₇₃), X₇₄ may be C(Q₇₄), X₇₅ may be C(Q₇₅), X₇₆ may be C(Q₇₆), and X₇₇ may be C(Q₇₇), but embodiments are not limited thereto.

For example, in Formula 7-8, X₇₃ may be N(Q₇₈), and X₇₉ may be N(Q₇₉), but embodiments are not limited thereto.

For example, Y₇₁ and Y₇₂ in Formulae 7-2, 7-3, and 7-8 may each independently be a substituted or unsubstituted methylene group or a substituted or unsubstituted phenylene group, but embodiments are not limited thereto.

For example, Z₇₁ and Z₇₂ in Formulae 7-1 and 7-2 may each be O, but embodiments are not limited thereto.

For example, Z₇₃ in Formula 7-4 may be P, but embodiments are not limited thereto.

For example, R₇₁ to R₈₀ and Q₇₃ to Q₇₉ in Formulae 7-1 to 7-11 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a (C₁-C₂₀ alkyl)phenyl group, a naphthyl group, a pyridinyl group, a pyrimidinyl group, or a combination thereof;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a (C₁-C₂₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, -Si(Q₁₁)(Q₁₂)(Q₁₃), - B(Q₁₁)(Q₁₂), -N(Q₁₁)(Q₁₂), or a combination thereof; or
-Si(Q₁)(Q₂)(Q₃), -B(Q₁)(Q₂), or -N(Q₁)(Q₂), and
Q₁ to Q₃ and Q₁₁ to Q₁₃ may each independently be:
   a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, a biphenyl group, a C₁-C₂₀ alkylphenyl group, or a naphthyl group; or
   a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, or a naphthyl group, each substituted with deuterium, a phenyl group, or a combination thereof, but embodiments are not limited thereto.

L₁₂ in Formula 1 may be a ligand represented by one of Formulae 5-1 to 5-116 or Formulae 8-1 to 8-23, but embodiments are not limited thereto: 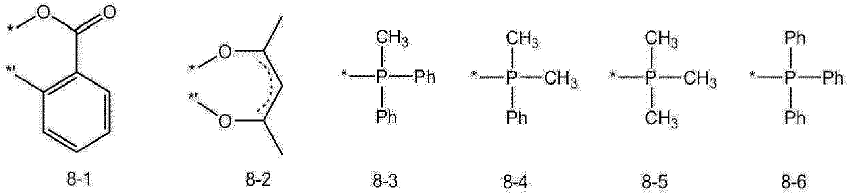 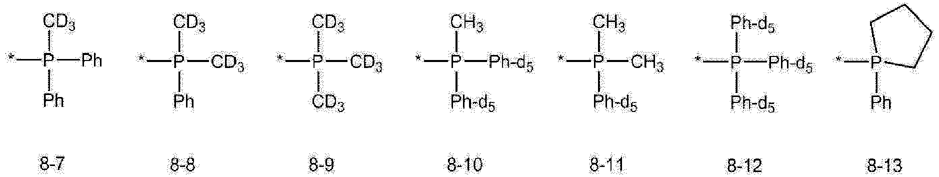 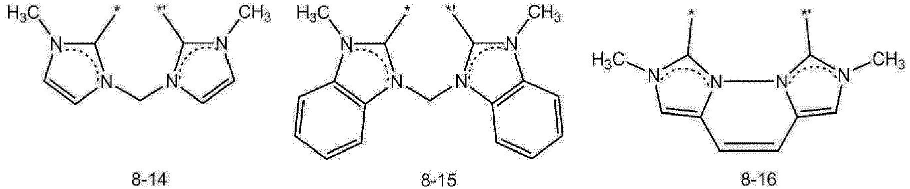 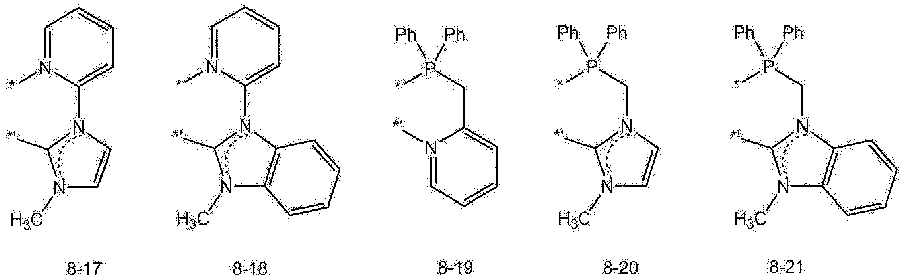 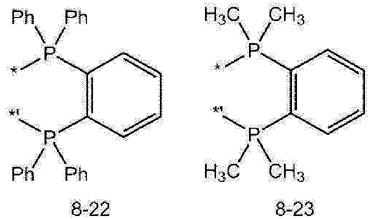 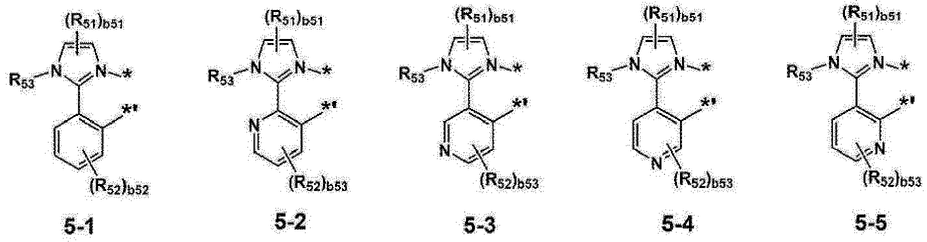 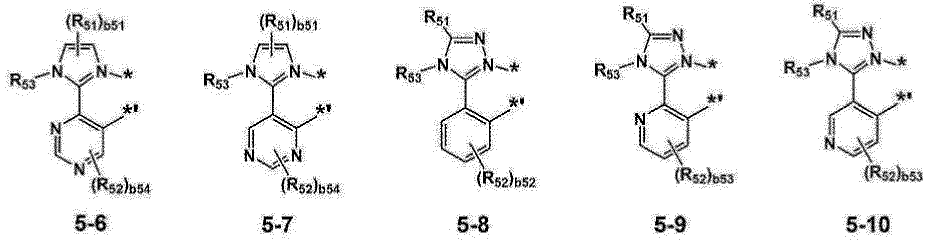 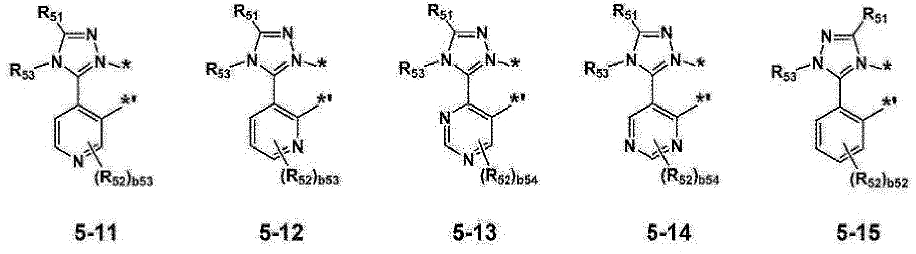 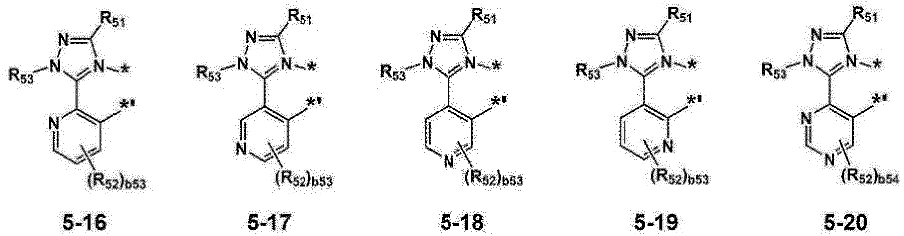 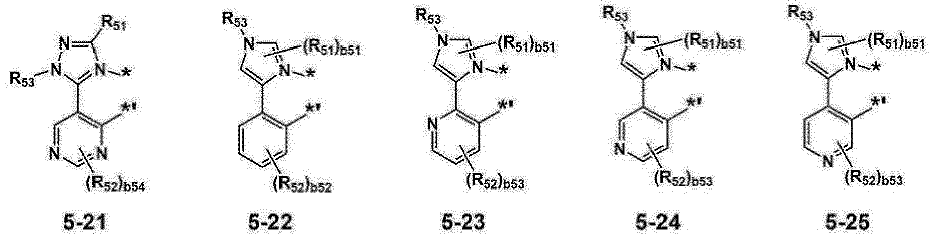 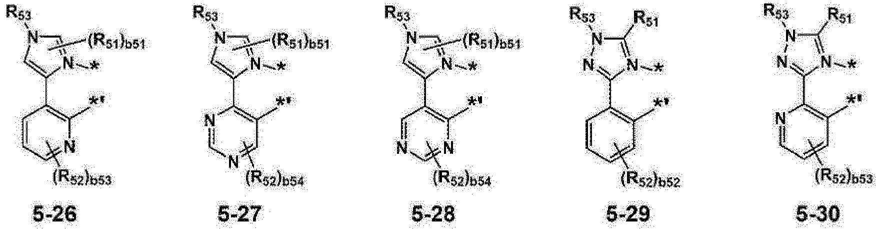 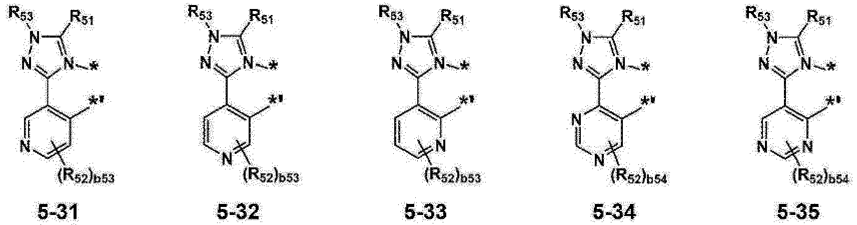 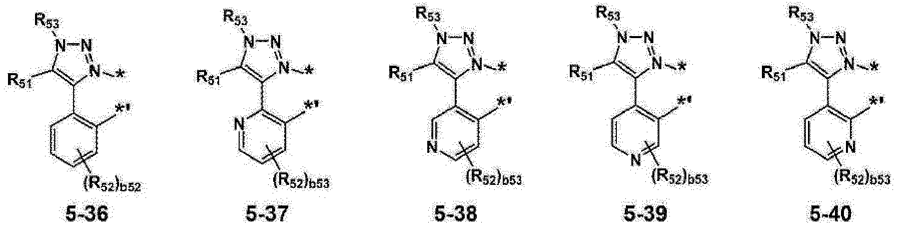 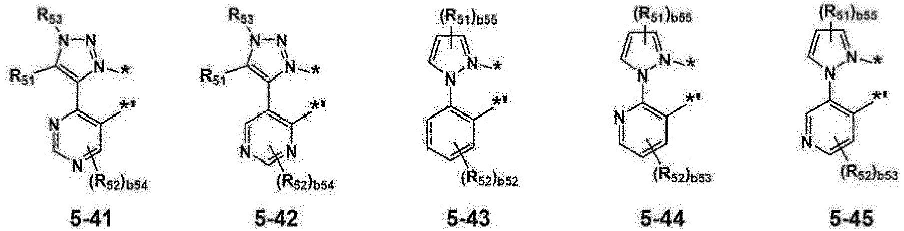 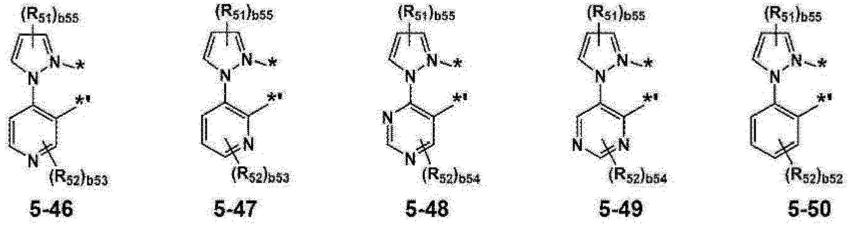 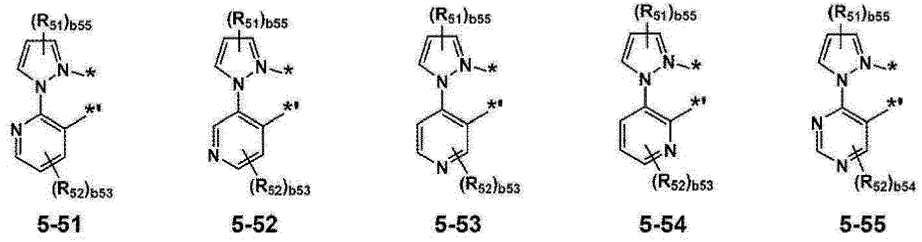 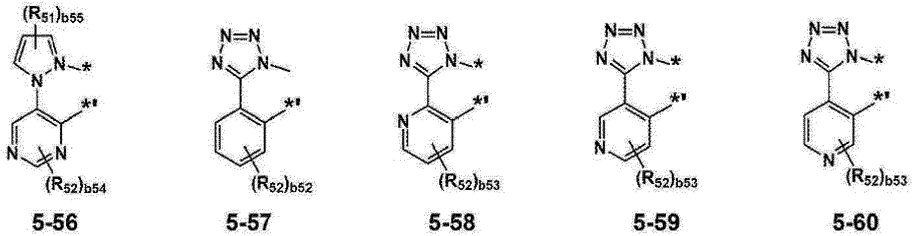 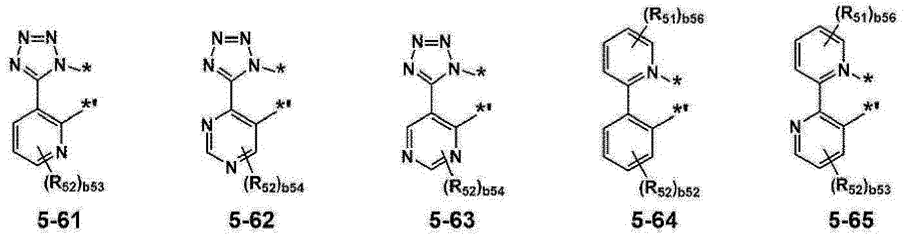 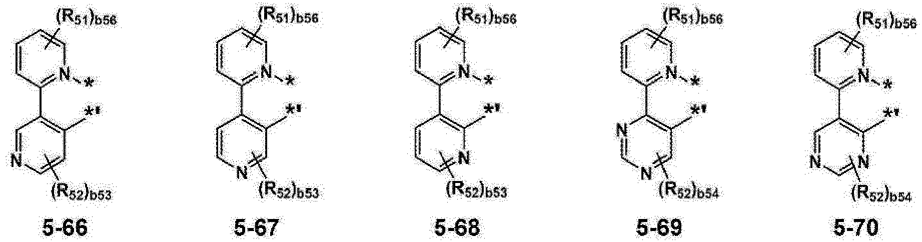 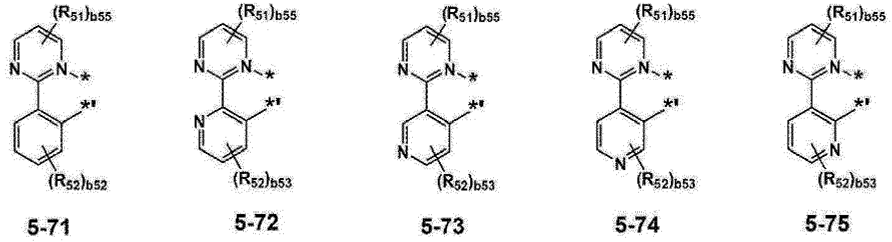 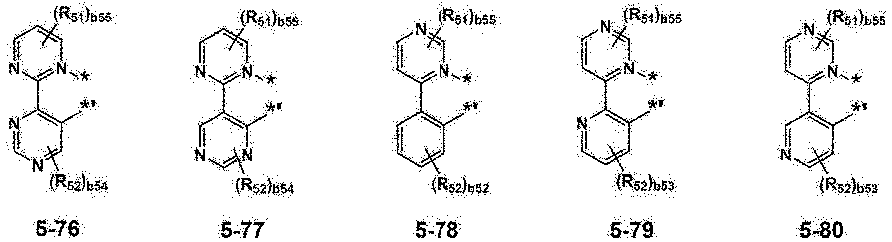 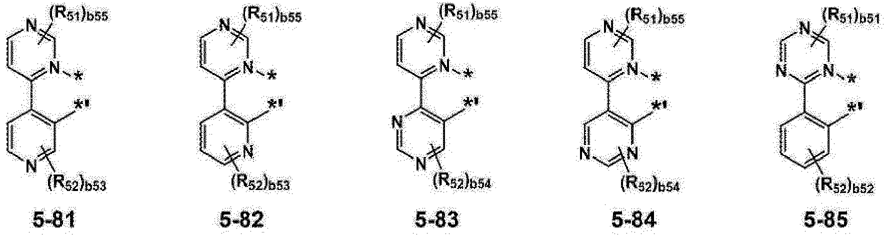 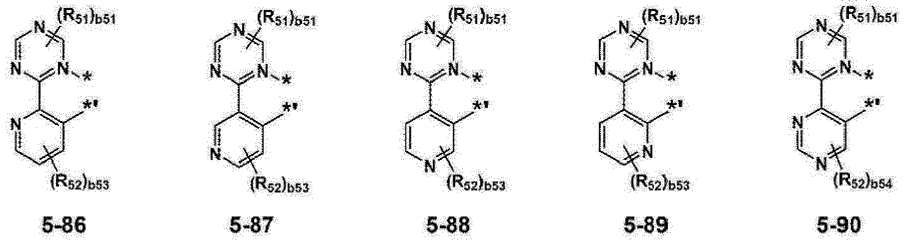 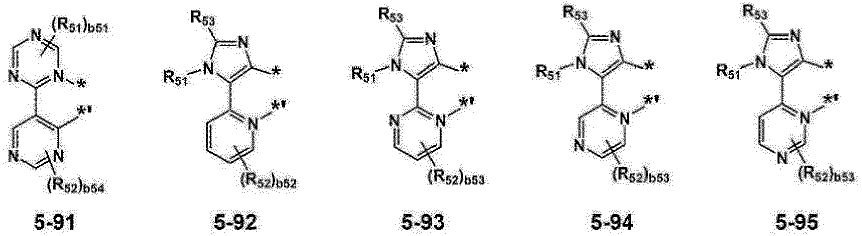 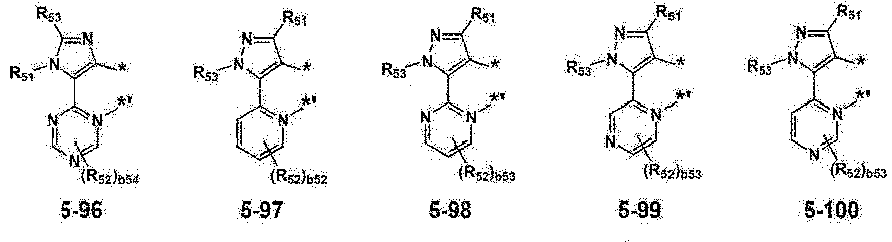 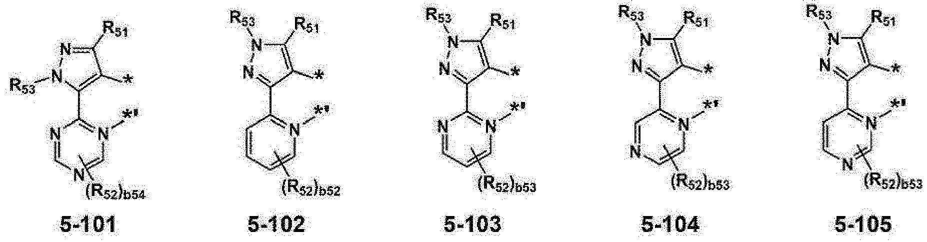 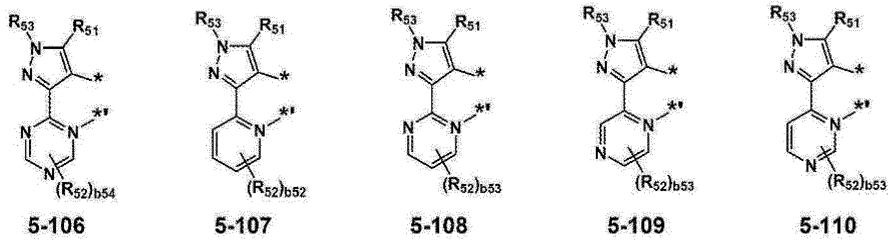 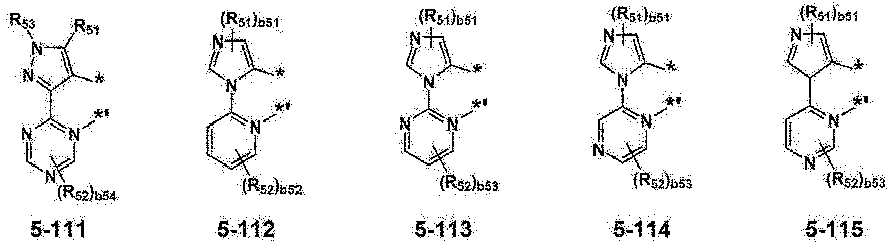 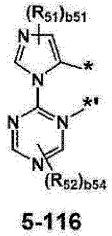 wherein, in Formulae 5-1 to 5-116 and 8-1 to 8-23,
R₅₁ to R₅₃ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a C₁-C₂₀ alkylphenyl group, a naphthyl group, a pyridinyl group, a pyrimidinyl group, or a combination thereof;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a (C₁-C₂₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a (C₁-C₂₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a (C₁-C₂₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, -Si(Q₁₁)(Q₁₂)(Q₁₃), - B(Q₁₁)(Q₁₂), -N(Q₁₁)(Q₁₂), or a combination thereof; or
-Si(Q₁)(Q₂)(Q₃), -B(Q₁)(Q₂), or-N(Q₁)(Q₂),
Q₁ to Q₃ and Q₁₁ to Q₁₃ may each independently be:
   a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, a biphenyl group, a C₁-C₂₀ alkylphenyl group, or a naphthyl group; or
   a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, or a naphthyl group, each substituted with at least one of deuterium, a phenyl group, or a combination thereof,
   b51 and b54 may each independently be 1 or 2,
   b53 and b55 may each independently be 1, 2, or 3,
   b52 may be 1, 2, 3, or 4,
   "Ph" represents a phenyl group,
   "Ph-d5" represents a phenyl group wherein five hydrogen atoms on the phenyl group are substituted with deuterium, and
   * and *' each indicate a binding site to M₁.

In Formula 1, n11 is 1, and n12 is 0, 1, or 2.

In one or more embodiments, in Formula 1, M₁ may be Pt, n11 may be 1, and n12 may be 0, but embodiments are not limited thereto.

In one or more embodiments, the organometallic compound may be represented by one of Compounds 1 to 229:

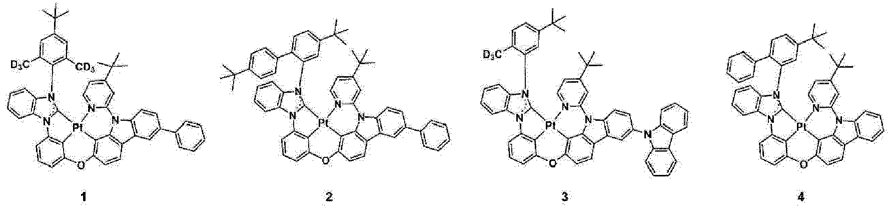

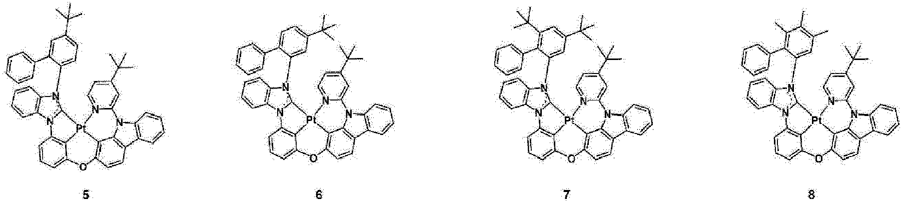

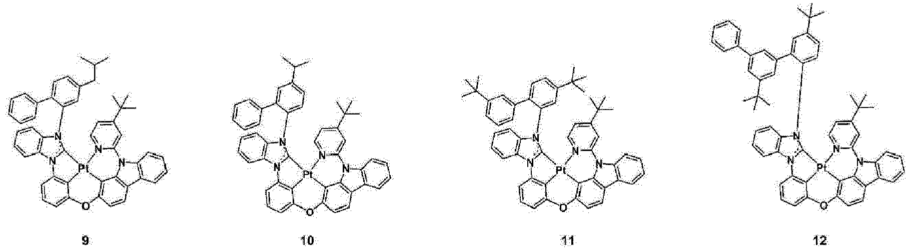

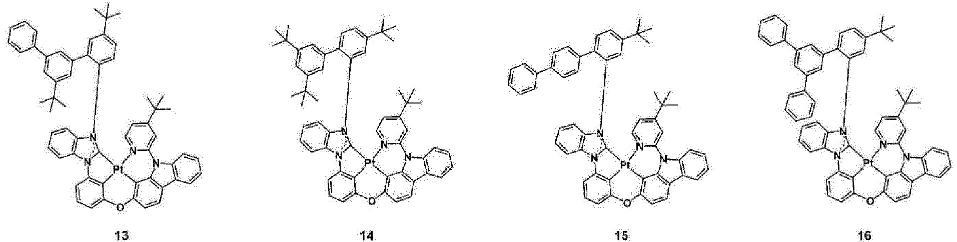

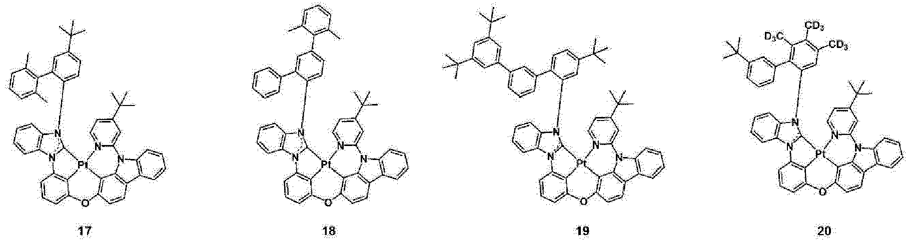

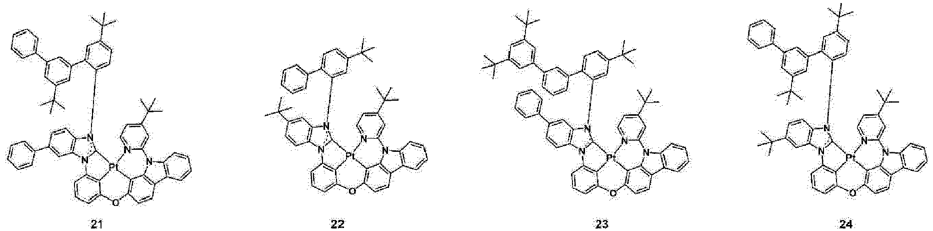

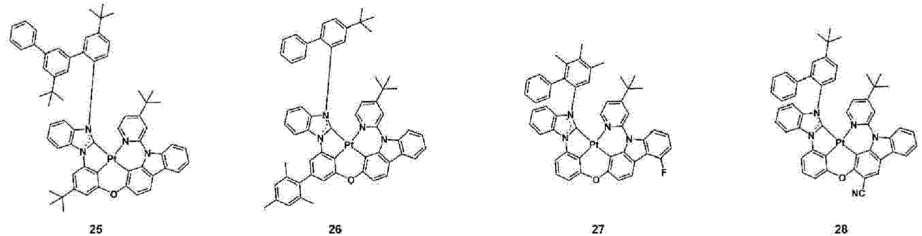

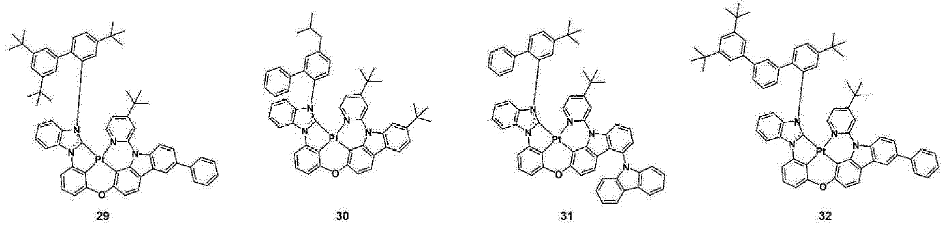

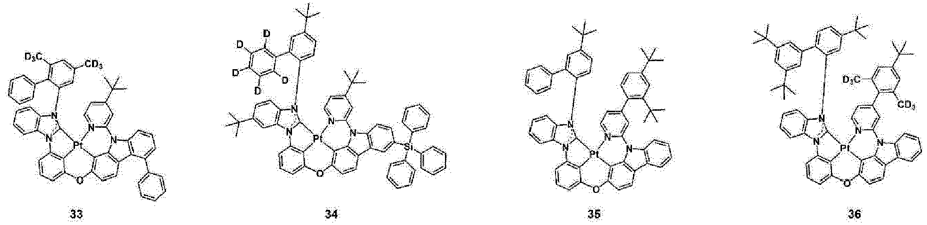

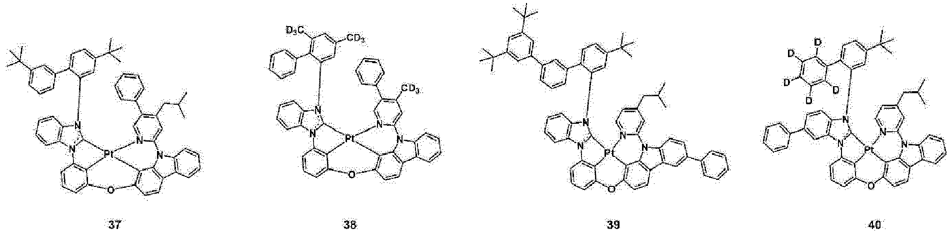

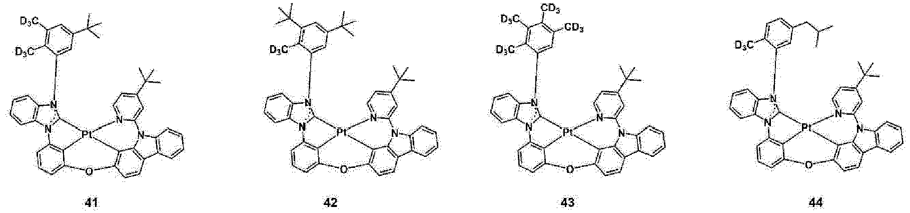

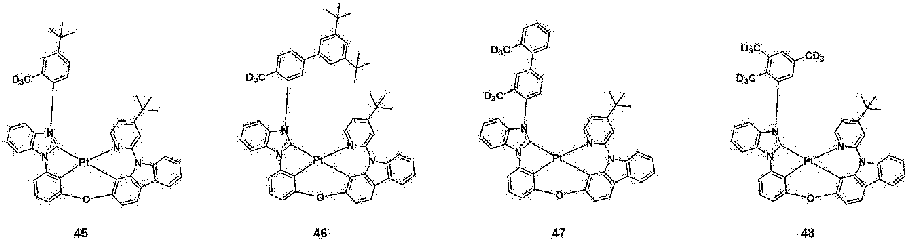

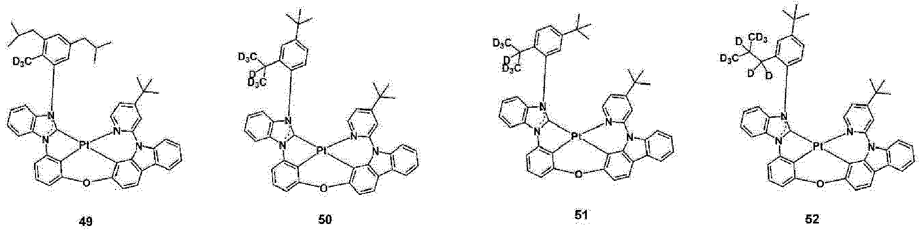

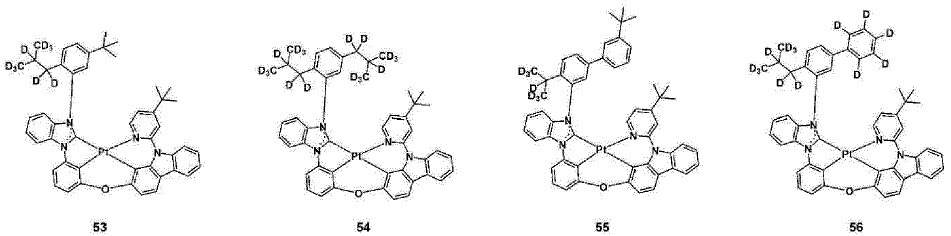

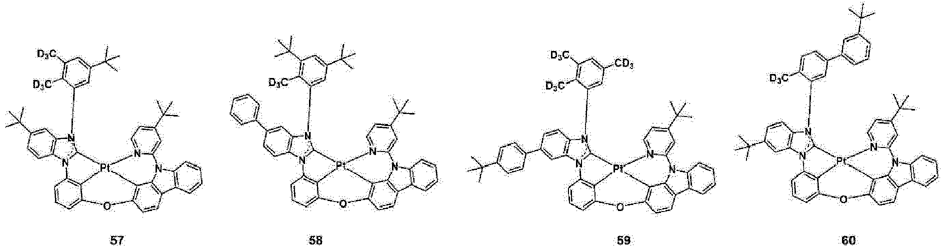

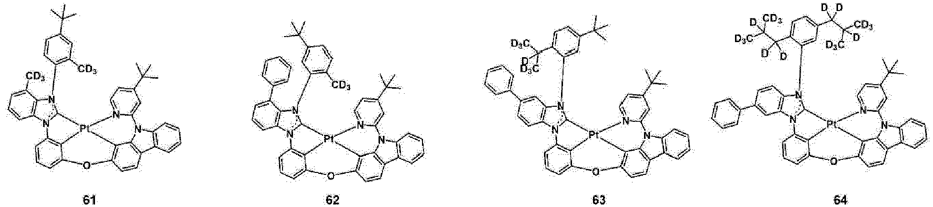

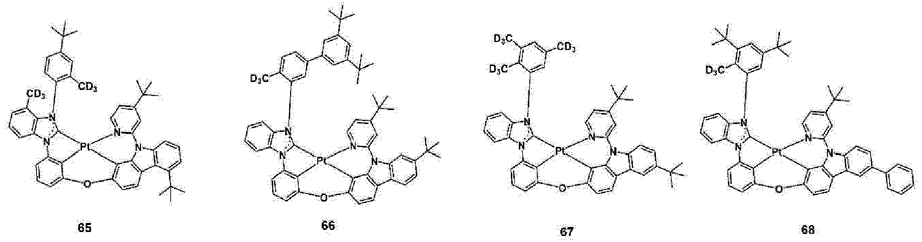

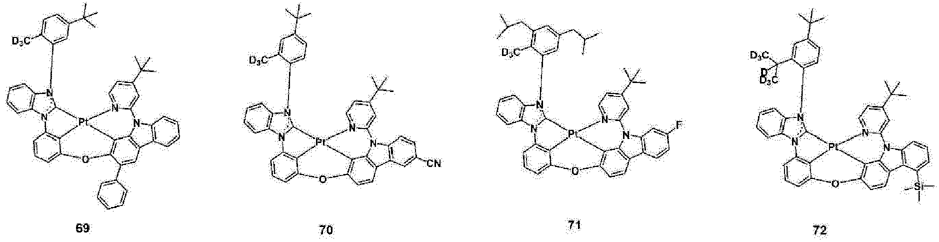

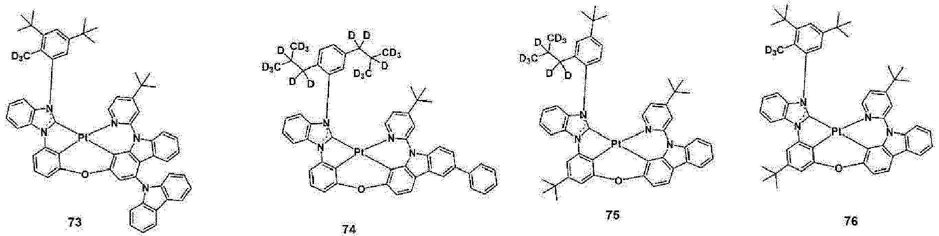

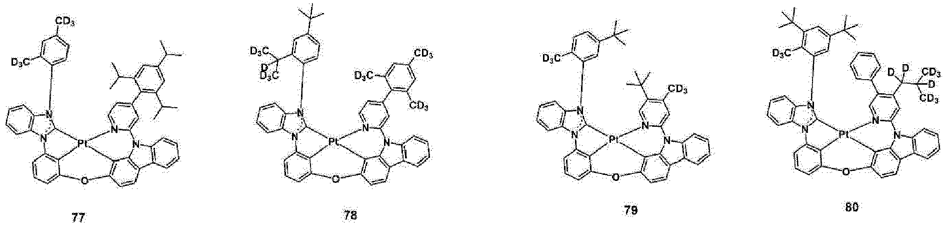

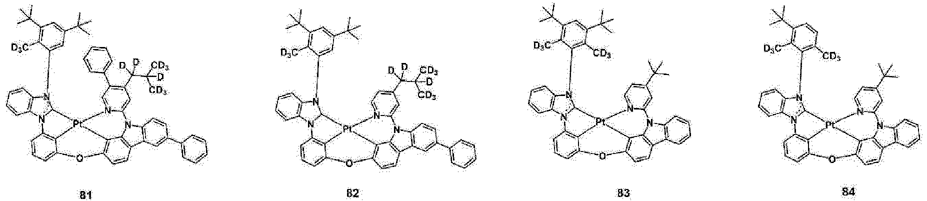

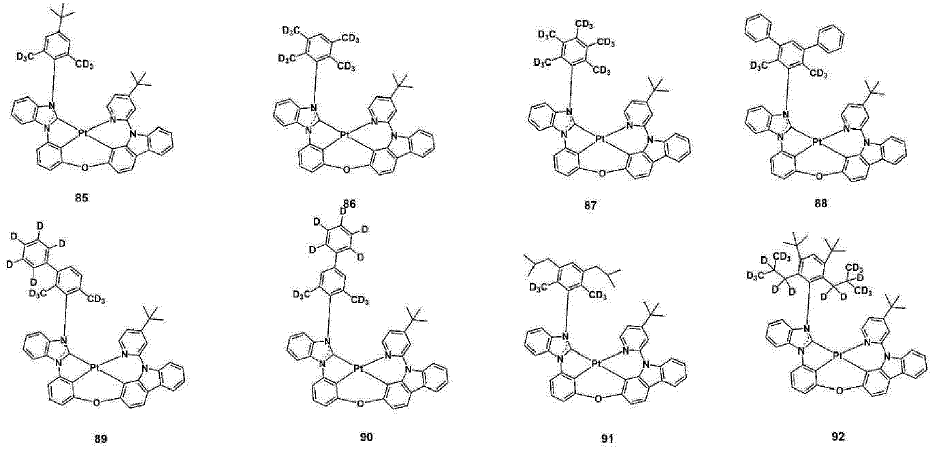

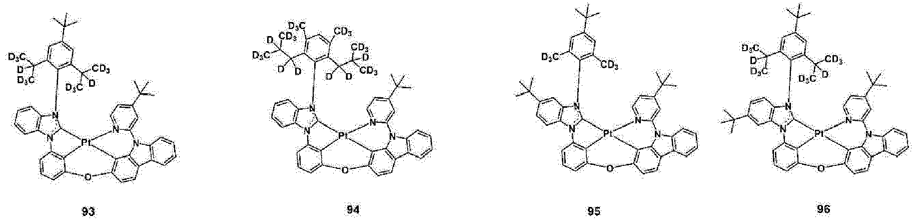

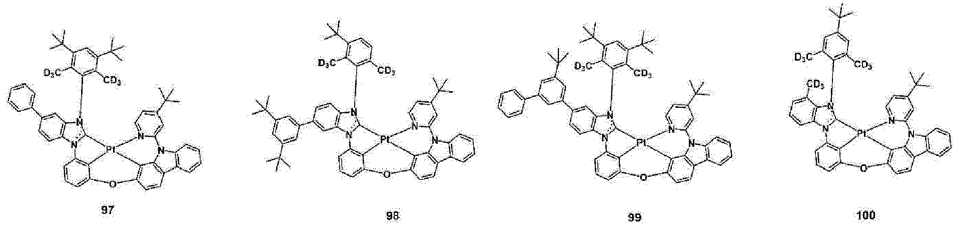

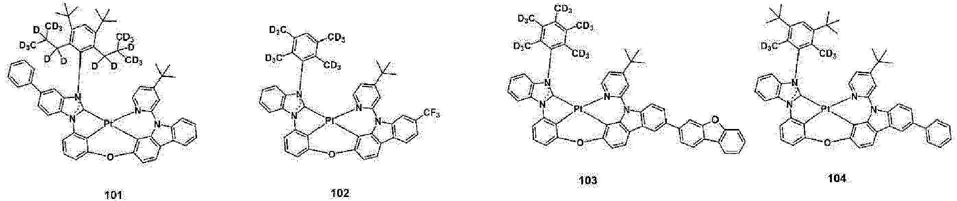

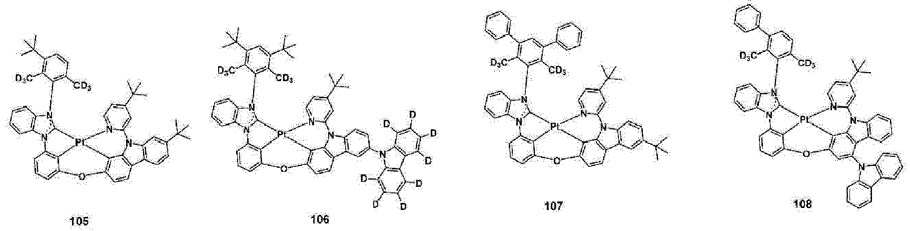

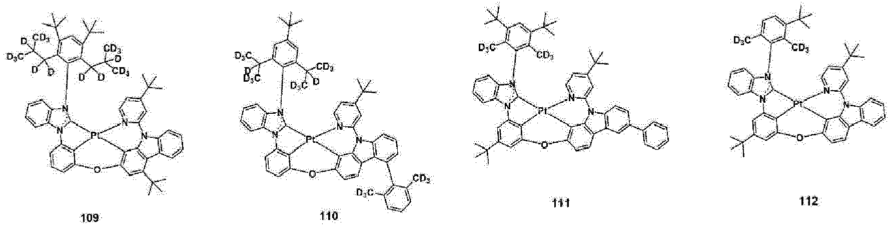

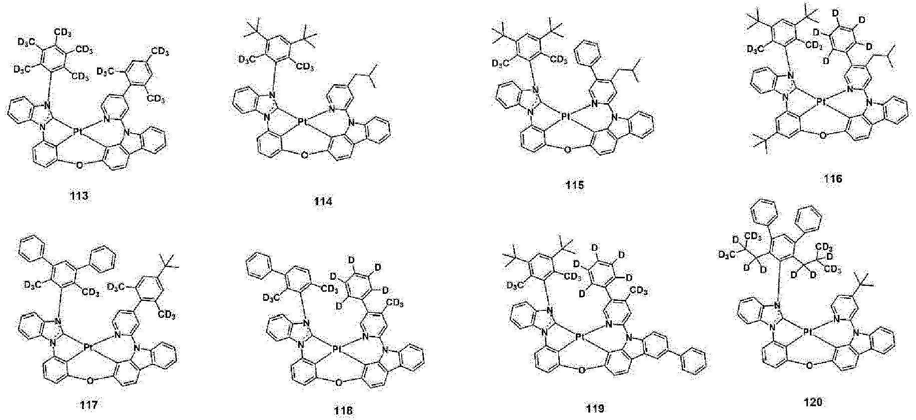

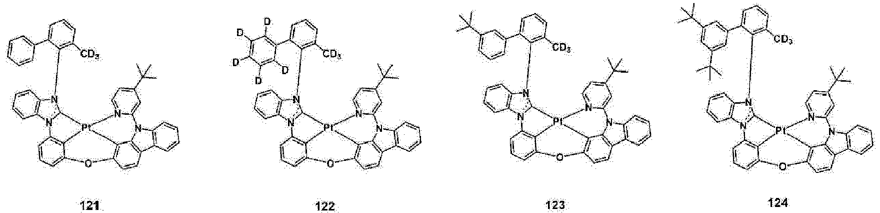

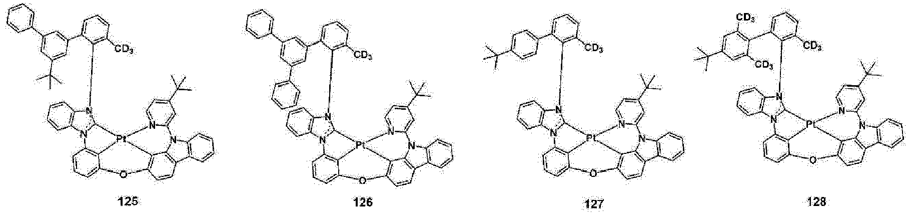

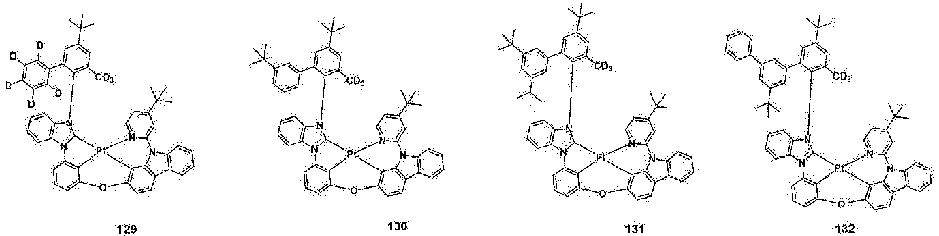

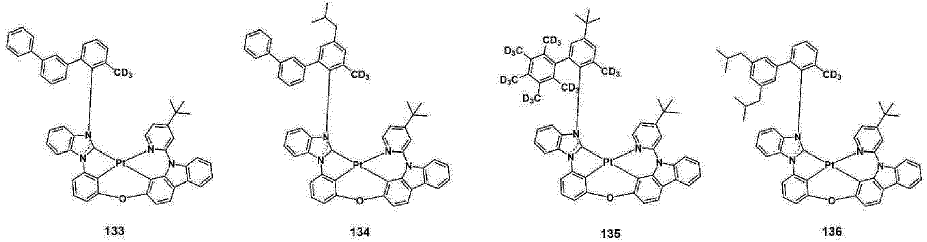

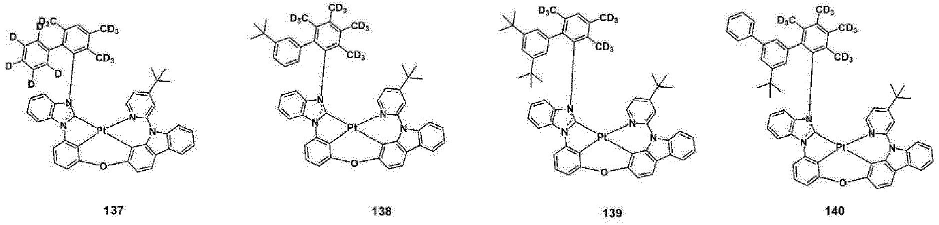

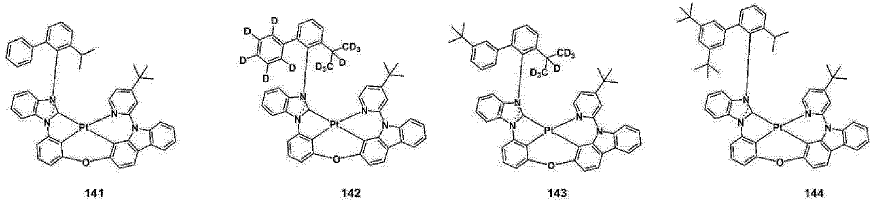

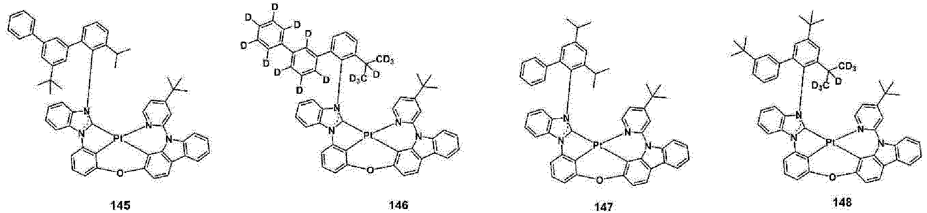

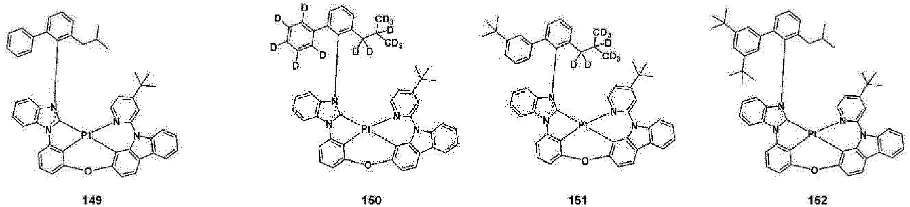

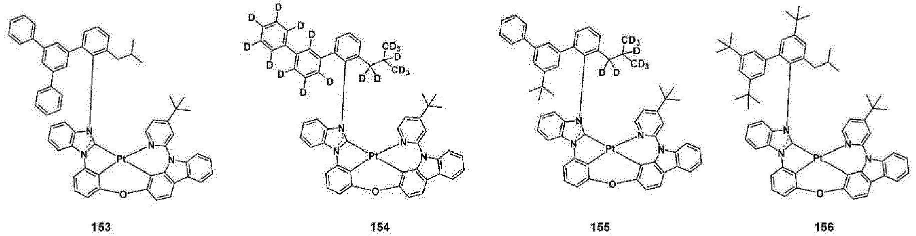

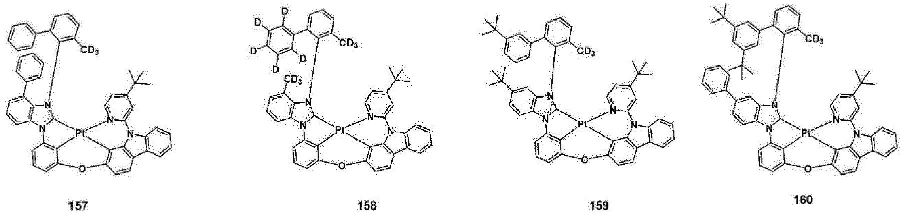

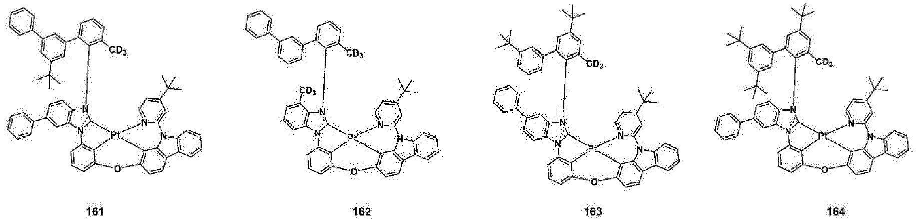

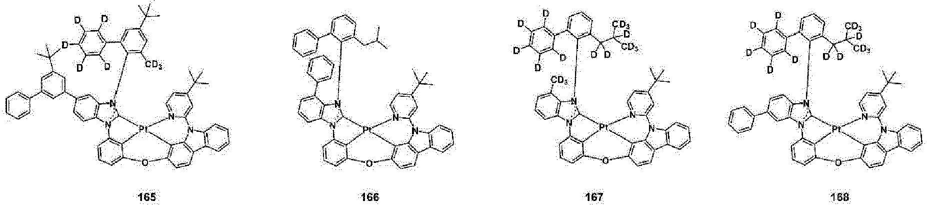

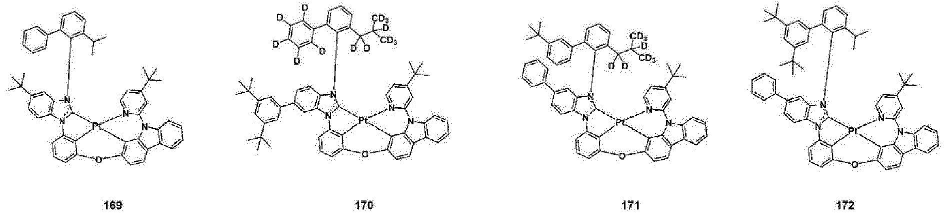

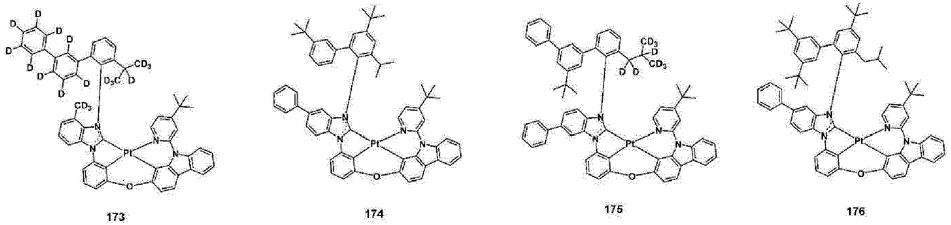

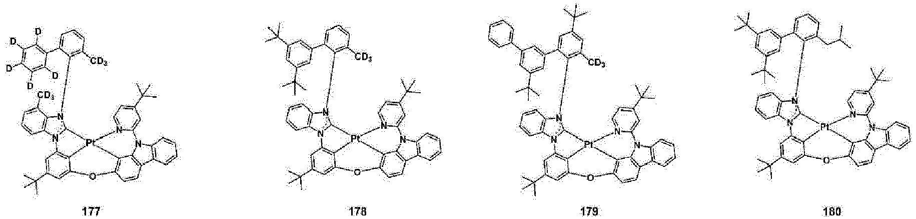

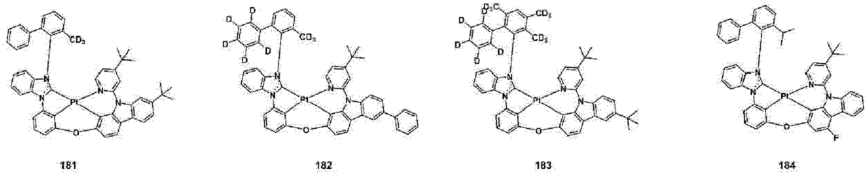

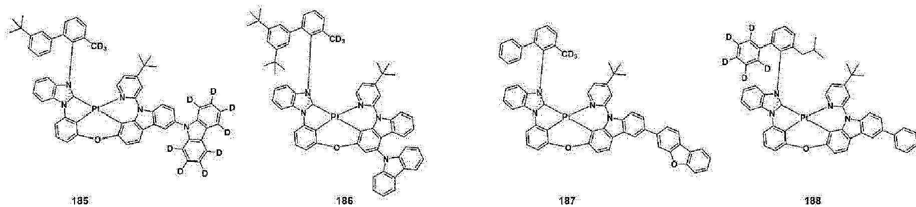

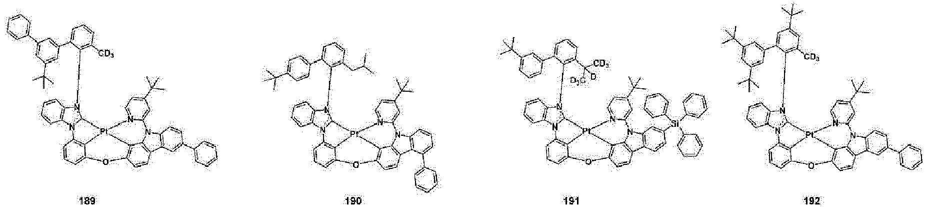

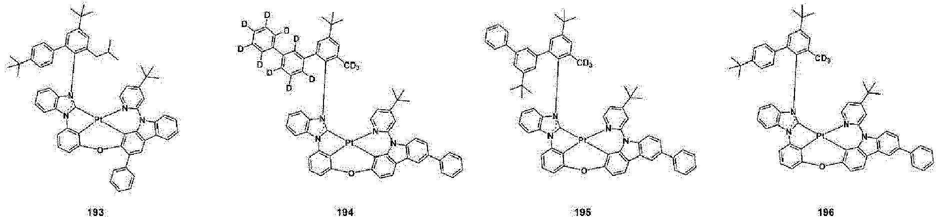

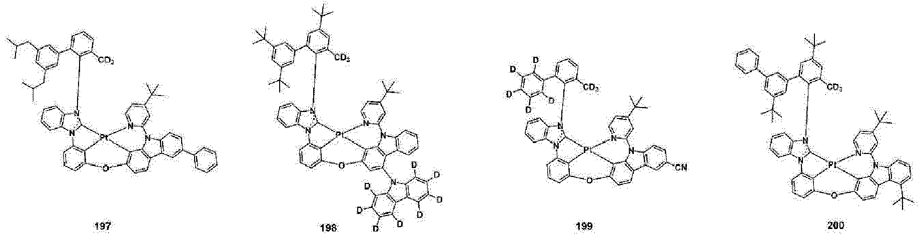

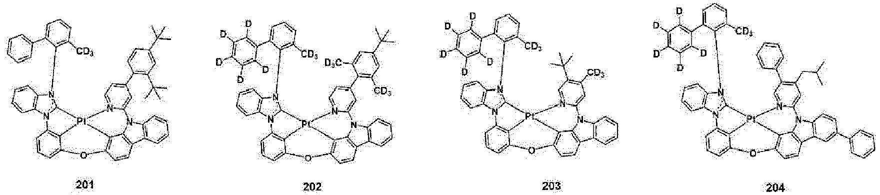

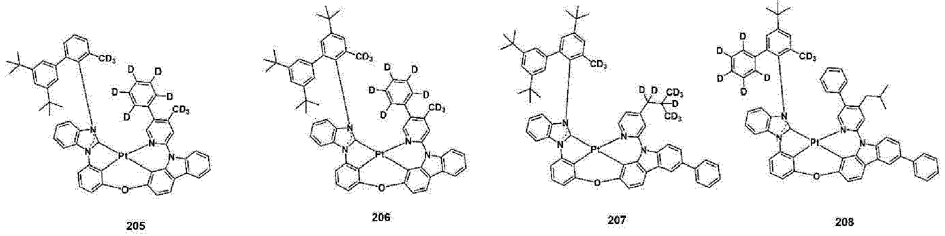

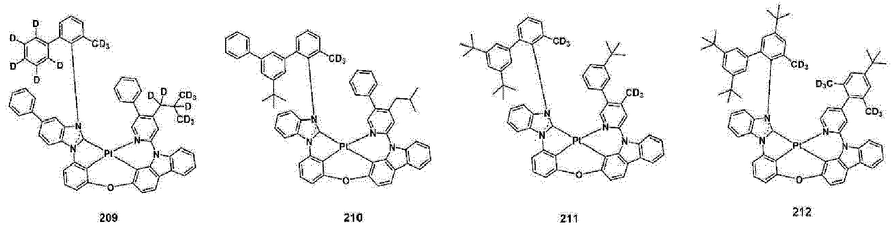

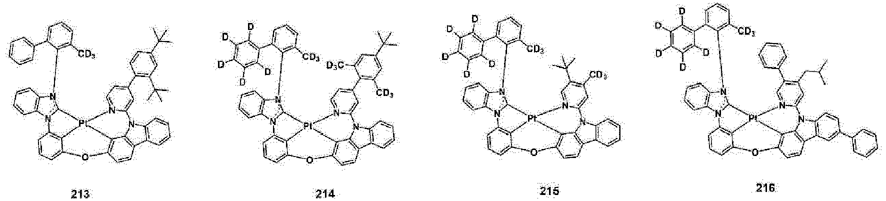

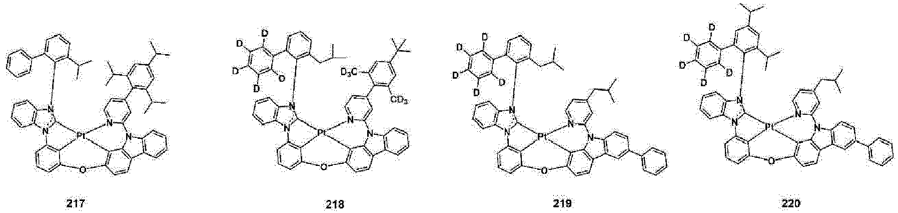

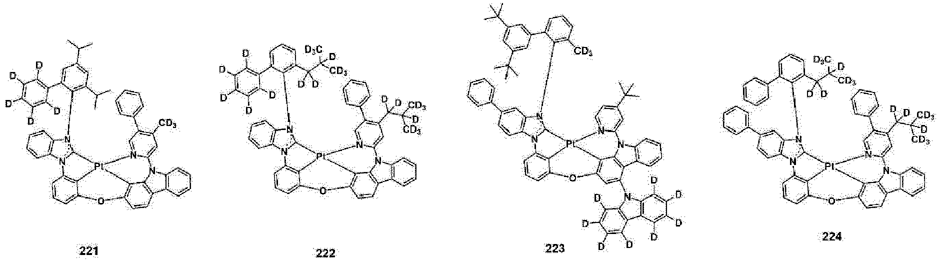

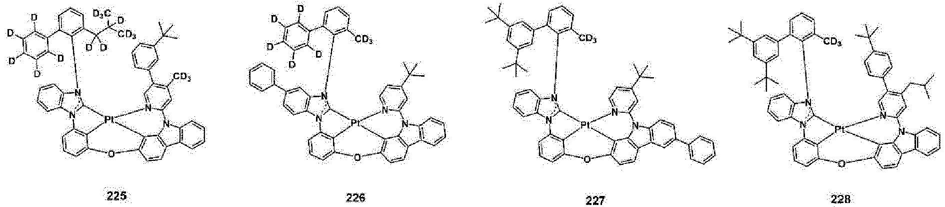

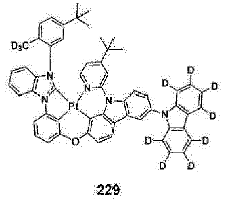

The organometallic compound represented by Formula 1 may satisfy the structure of Formula 1 described above, and a moiety represented by 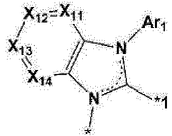 in the L₁₁ ligand represented by Formula 1-1 may include Ar₁ which is a phenyl group substituted with a specific substituent. Without wishing to be bound to theory, due to such a structure, the organometallic compound may have improved photochemical stability, and may be suitable for deep blue light emission. Accordingly, an electronic device, for example, an organic light-emitting device, using the organometallic compound represented by Formula 1 may exhibit excellent luminescence efficiency, lifespan, and color purity.

Although not limited by a specific theory, the electron donating characteristics of L₁₁ ligand may be enhanced by Ar₁, and thus, the charge transfer may be improved, thereby improving the structural stability of the organometallic compound. Accordingly, by using the organometallic compound, the efficiency and lifespan of an organic light-emitting device may be improved.

The highest occupied molecular orbital (HOMO) energy level, lowest unoccupied molecular orbital (LUMO) energy level, energy gap, the lowest excitation triplet (T₁) energy level, and the lowest excitation singlet (S₁) energy levels of the organometallic compound represented by Formula 1 were evaluated using a density functional theory (DFT) method of the Gaussian 09 program with the molecular structure optimization obtained at the B3LYP level, and results thereof are shown in Table 1. The energy levels are expressed in electron volts (eV).

**Table 1**

| Compound | HOMO (eV) | LUMO (eV) | T₁ (eV) |
|---|---|---|---|
| Compound 1 | -4.69 | -1.23 | 2.68 |
| Compound 2 | -4.64 | -1.19 | 2.65 |
| Compound 3 | -4.80 | -1.33 | 2.67 |

Referring to Table 1, it was confirmed that the organometallic compound represented by Formula 1 has suitable electrical characteristics for use as a dopant in an electronic device, for example, an organic light-emitting device.

In one or more embodiments, the full width at half maximum (FWHM) of an emission peak of an emission spectrum or an electroluminescence (EL) spectrum of the organometallic compound may be about 75 nanometers (nm) or less. For example, the FWHM of the emission peak of the emission spectrum or the EL spectrum of the organometallic compound may be in a range of about 30 nm to about 75 nm, about 40 nm to about 70 nm, or about 45 nm to about 60 nm.

In one or more embodiments, a maximum emission wavelength (also referred to as an emission peak wavelength, λₘₐₓ) of the emission peak of the emission spectrum or the EL spectrum of the organometallic compound may be in a range of about 410 nm to about 490 nm.

Synthesis methods of the organometallic compound represented by Formula 1 may be recognizable by one of ordinary skill in the art and by referring to Synthesis Examples described herein.

Accordingly, the organometallic compound represented by Formula 1 may be suitable for use as a dopant in an organic layer, for example, an emission layer, of an organic light-emitting device. Thus, another aspect provides an organic light-emitting device including: a first electrode; a second electrode; and an organic layer that is located between the first electrode and the second electrode, wherein the organic layer includes an emission layer, and wherein the organic layer further includes at least one organometallic compound represented by Formula 1.

Since the organic light-emitting device includes the organic layer including the organometallic compound represented by Formula 1 as described above, excellent characteristics in terms of driving voltage, current efficiency, external quantum efficiency, roll-off ratio, and lifespan, and relatively narrow FWHM of the emission peak of the EL spectrum may be exhibited.

The organometallic compound represented by Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 in the emission layer is smaller than an amount of the host).

In one or more embodiments, the emission layer may emit blue light. For example, the emission layer may emit blue light having a maximum emission wavelength in a range of about 410 nm to about 490 nm.

The expression "(an organic layer) includes at least one of organometallic compounds" used herein may include a case in which "(an organic layer) includes identical organometallic compounds represented by Formula 1" and a case in which "(an organic layer) includes two or more different organometallic compounds represented by Formula 1."

For example, the organic layer may include, as the organometallic compound, only Compound 1. In this regard, Compound 1 may be included in the emission layer of the organic light-emitting device. In one or more embodiments, the organic layer may include, as the organometallic compound, Compound 1 and Compound 2. In this regard, Compound 1 and Compound 2 may be present in an identical layer (for example, both Compound 1 and Compound 2 may be present in the same emission layer).

The first electrode may be an anode, which is a hole injection electrode, and the second electrode may be a cathode, which is an electron injection electrode. Alternatively, the first electrode may be a cathode, which is an electron injection electrode, and the second electrode may be an anode, which is a hole injection electrode.

For example, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" used herein refers to a single layer and/or a plurality of layers located between the first electrode and the second electrode of the organic light-emitting device. The "organic layer" may include, in addition to an organic compound, an organometallic complex including a metal.

The FIGURE is a schematic cross-sectional view of an organic light-emitting device 10 according to one or more embodiments. Hereinafter, the structure and manufacturing method of the organic light-emitting device 10 according to one or more embodiments will be described in connection with the FIGURE. The organic light-emitting device 10 includes a first electrode 11, an organic layer 15, and a second electrode 19, which are sequentially stacked.

A substrate may be additionally located under the first electrode 11 or on the second electrode 19. For use as the substrate, any substrate that is used in organic light-emitting devices and including those available in the art may be used, and for example, a glass substrate or a transparent plastic substrate, each having excellent mechanical strength, thermal stability, transparency, surface smoothness, ease of handling, and/or water resistance, may be used.

The first electrode 11 may be produced by depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a semi-transmissive electrode, or a transmissive electrode. The material for forming the first electrode 11 may be at least one of indium tin oxide (ITO), indium zinc oxide (IZO), tin oxide (SnO₂), or zinc oxide (ZnO). In one or more embodiments, the material for forming the first electrode 11 may be metal, such as at least one of magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. For example, the first electrode 11 may have a three-layered structure of ITO/Ag/ITO, but embodiments are not limited thereto.

The organic layer 15 may be located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr (wherein 1 torr = 133.322 Pa), and a deposition rate of about 0.01 angstroms per second (Å /sec) to about 100 Å /sec, but embodiments are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C, but embodiments are not limited thereto.

Conditions for forming the hole transport layer and the electron blocking layer may respectively be as the conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris(N-(2-naphthyl)-N-phenylaminol-triphenylamine (2-TNATA) N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented by Formula 201, or a compound represented by Formula 202: 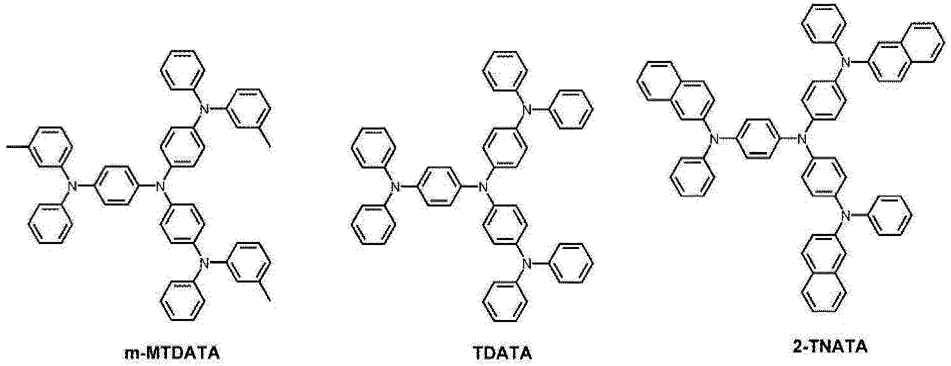 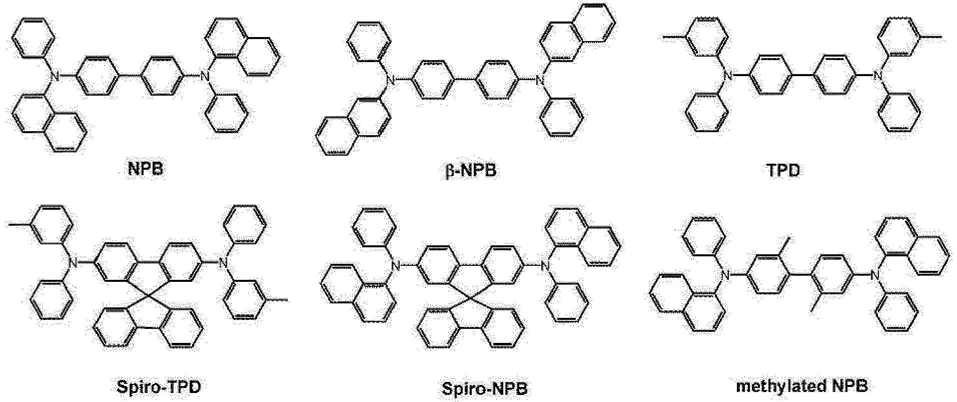 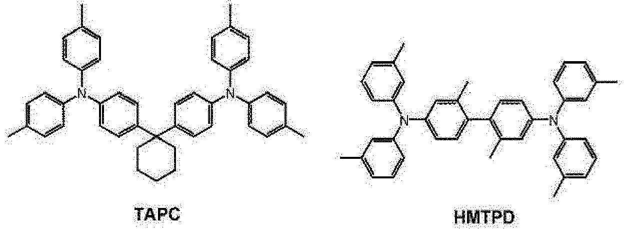 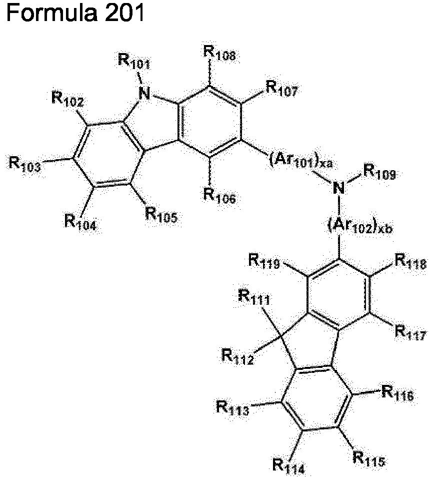 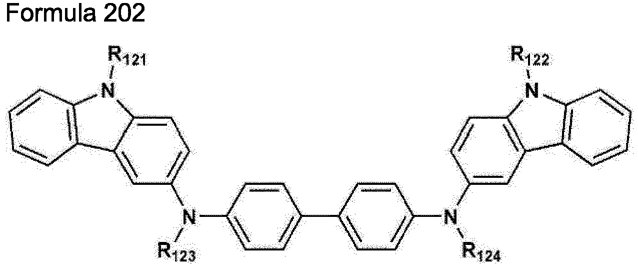 wherein, in Formula 201, Ar₁₀₁ and Ar₁₀₂ may each independently be:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₅₀ alkoxy group, a C₁-C₅₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a monovalent non-aromatic condensed polycyclic group, or a monovalent non-aromatic condensed heteropolycyclic group.

In Formula 201, xa and xb may each independently be an integer from 0 to 5, or may each independently be 0, 1, or 2. For example, xa may be 1, and xb may be 0, but embodiments are not limited thereto.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), a C₁-C₁₀ alkoxy group (for example, a methoxy group, an ethoxy group, a propoxy group, a butoxy group, a pentoxy group, etc.), or a C₁-C₁₀ alkylthio group;
a C₁-C₁₀ alkyl group, a C₁-C₁₀ alkoxy group, or a C₁-C₁₀ alkylthio group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof; or a combination thereof,
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof,
but embodiments are not limited thereto.

R₁₀₉ in Formula 201 may be:
a phenyl group, a naphthyl group, an anthracenyl group, or a pyridinyl group; or
a phenyl group, a naphthyl group, an anthracenyl group, or a pyridinyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a C₁-C₂₀ alkyl group, a C₁-C₂₀ alkoxy group, a C₁-C₂₀ alkylthio group, a phenyl group, a naphthyl group, an anthracenyl group, or a pyridinyl group.

In one or more embodiments, the compound represented by Formula 201 may be represented by Formula 201A, but embodiments are not limited thereto: 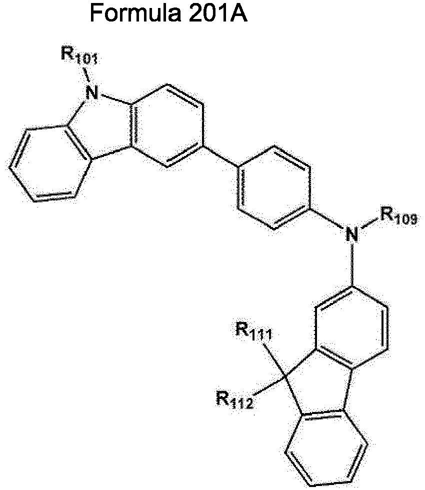 wherein, in Formula 201A, R₁₀₁, R₁₁₁, R₁₁₂, and R₁₀₉ are respectively as those described herein.

For example, the compounds represented by Formulae 201 and 202 may include one or more of Compounds HT1 to HT20, but embodiments are not limited thereto:

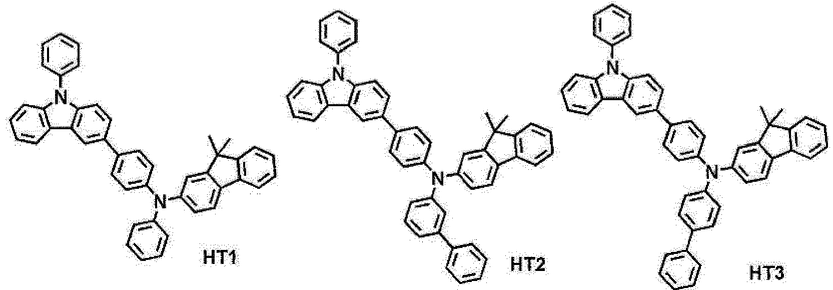

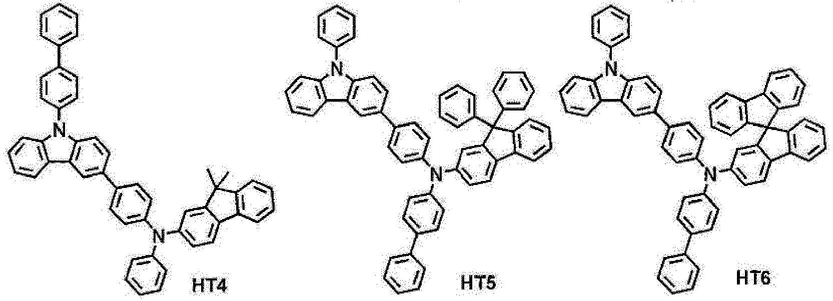

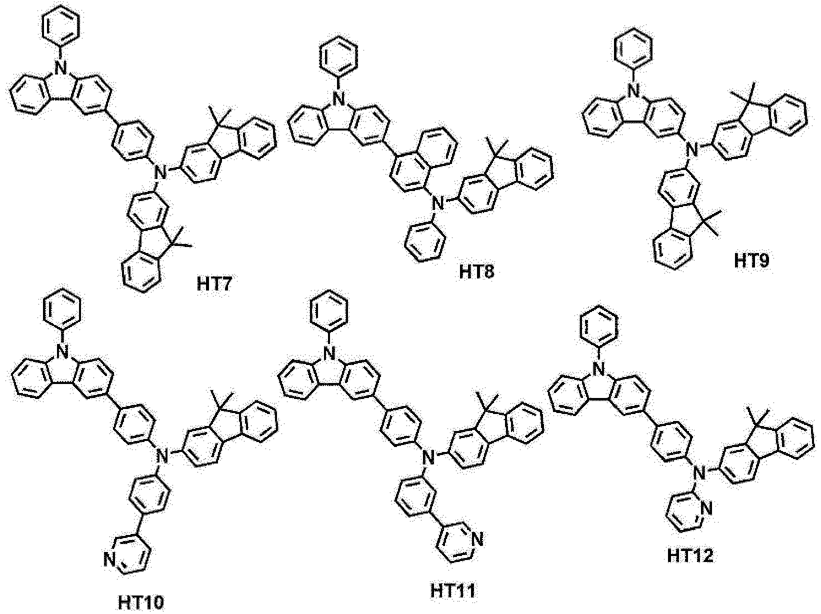

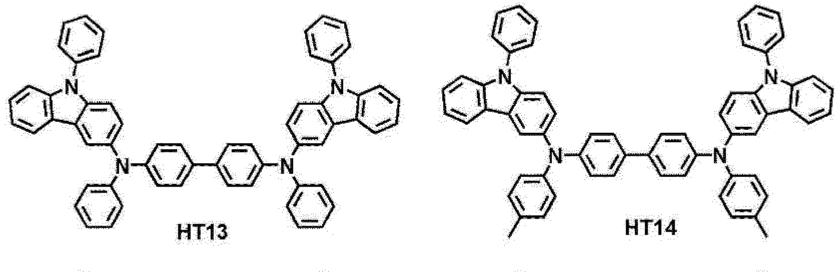

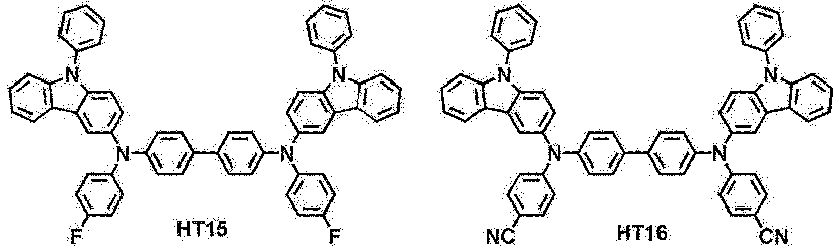

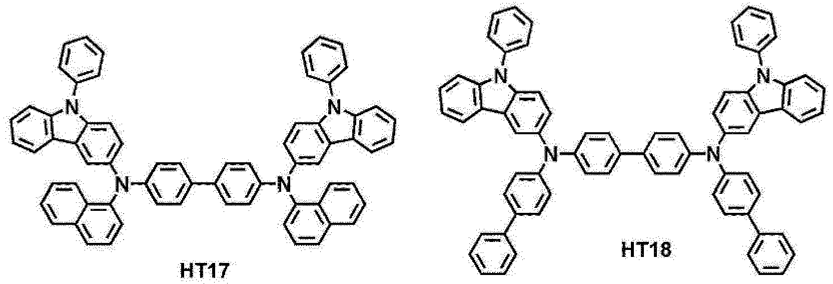

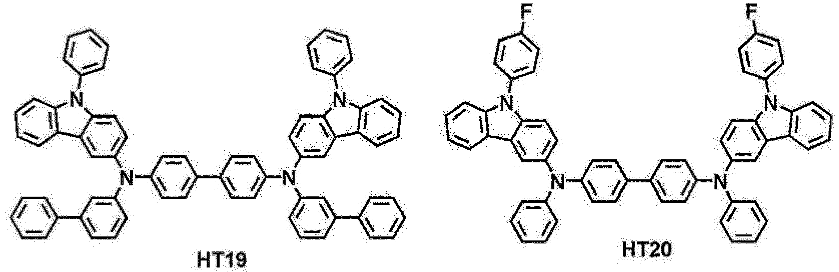

A thickness of the hole transport region may be in a range of about 100 angstroms (Å) to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to the materials as described above, a charge-generation material for improving conductive properties. The charge-generation material may be homogeneously or non-homogeneously dispersed in the hole transport region.

The charge-generation material may be, for example, a p-dopant. The p-dopant may be one of a quinone derivative, a metal oxide, or a cyano group-containing compound, but embodiments are not limited thereto. For example, non-limiting examples of the p-dopant include: a quinone derivative, such as tetracyanoquinodimethane (TCNQ), 2,3,5,6-tetrafluoro-tetracyano-1,4-benzoquinonedimethane (F4-TCNQ), or F6-TCNNQ; a metal oxide, such as a tungsten oxide or a molybdenum oxide; or a compound containing a cyano group, such as Compound HT-D1 or Compound F12, but embodiments are not limited thereto:

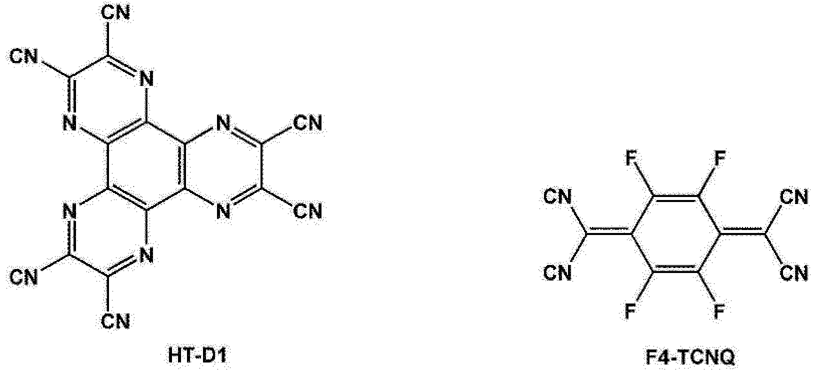

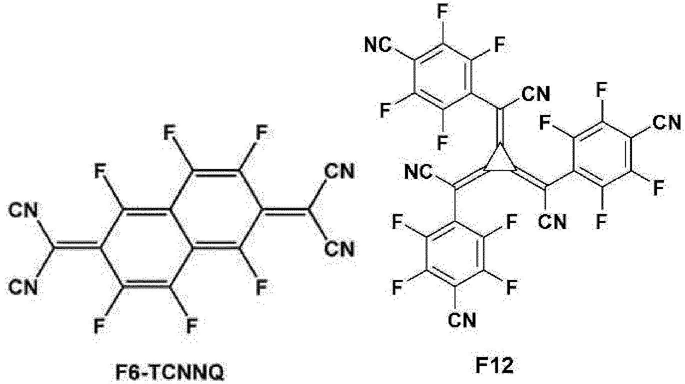

The hole transport region may further include a buffer layer.

The buffer layer may compensate for an optical resonance distance according to a wavelength of light emitted from the emission layer, and thus, efficiency of the light-emitting device may be improved.

An emission layer may be formed on the hole transport region by using one or more suitable methods, such as vacuum deposition, spin coating, casting, or LB deposition. When the emission layer is formed by vacuum deposition or spin coating, the deposition or coating conditions may be similar to those applied in forming the hole injection layer, though the deposition or coating conditions may vary according to a material that is used.

Meanwhile, when the hole transport region includes an electron blocking layer, a material for forming the electron blocking layer may be selected from materials for the hole transport region described above and host materials to be described below, but embodiments are not limited thereto. For example, when the hole transport region includes an electron blocking layer, the material for forming the electron blocking layer may be mCP, which will be described below.

The emission layer may include a host and a dopant, and the dopant may include the organometallic compound represented by Formula 1.

The host may include at least one selected from 1,3,5-tri(1-phenyl-1H-benzo[d]imidazol-2-yl)phenyl (TPBi), 3-tert-butyl-9,10-di(naphth-2-yl)anthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethylbiphenyl (CDBP), 1,3,5-tris(carbazole-9-yl)benzene (TCP), 1,3-bis(N-carbazolyl)benzene (mCP), Compound H50, or Compound H51:

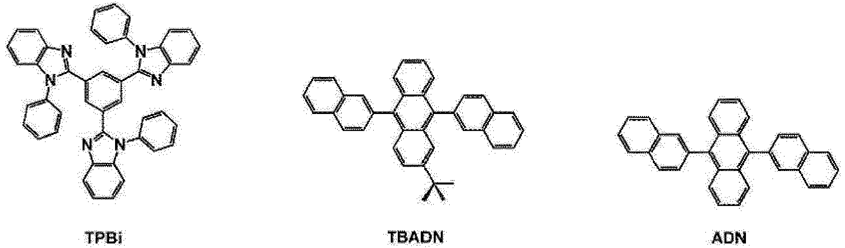

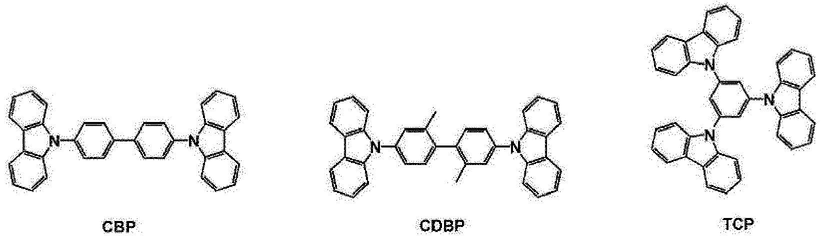

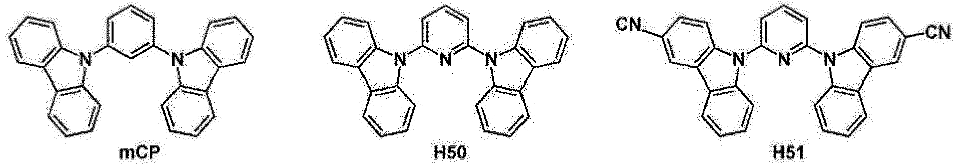

In one or more embodiments, the host may include a compound represented by Formula 301: 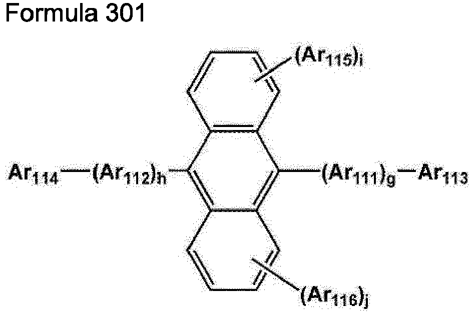 wherein, in Formula 301, Ar₁₁₁ and Ar₁₁₂ may each independently be :
a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, an anthracenyl group, or a combination thereof. Ar₁₁₃ to Ar₁₁₆ in Formula 301 may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

g, h, i, and j in Formula 301 may each independently be an integer from 0 to 4, and may be, for example, 0, 1, or 2.

Ar₁₁₃ and Ar₁₁₆ in Formula 301 may each independently be:
a C₁-C₁₀ alkyl group substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or
a group represented by formula: 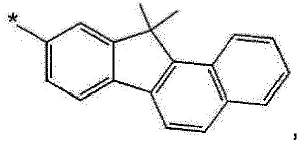
but embodiments are not limited thereto.

In one or more embodiments, the host may include a compound represented by Formula 302: 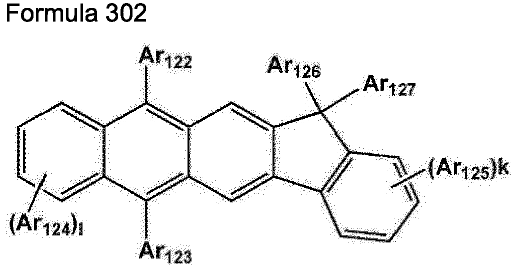 wherein, in Formula 302, Ar₁₂₂ to Ar₁₂₅ are each as described in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

k and I in Formula 302 may each independently be an integer from 0 to 4. For example, k and I may each be 0, 1, or 2.

When the organic light-emitting device 10 is a full-color organic light-emitting device 10, the emission layer may be patterned into a red emission layer, a green emission layer, and a blue emission layer. In one or more embodiments, due to a stacked structure including a red emission layer, a green emission layer, and/or a blue emission layer, the emission layer may emit white light, and various modifications are possible.

When the emission layer includes a host and a dopant, an amount of the dopant may be in a range of about 0.01 part by weight to about 15 parts by weight based on 100 parts by weight of the host, but embodiments are not limited thereto.

In one or more embodiments, the organic layer in organic light-emitting device may further include, in addition to the organometallic compound represented by Formula 1, a fluorescent dopant.

For example, the fluorescent dopant may be a condensed polycyclic compound, a styryl-based compound, or a combination thereof.

For example, the fluorescent dopant may include a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a naphthacene-containing core, a picene-containing core, a perylene-containing core, a pentaphene-containing core, an indenoanthracene-containing core, a tetracenecontaining core, a bisanthracene-containing core, or one of cores represented by Formulae 501-1 to 501-18, but embodiments are not limited thereto:

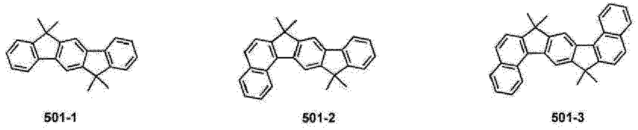

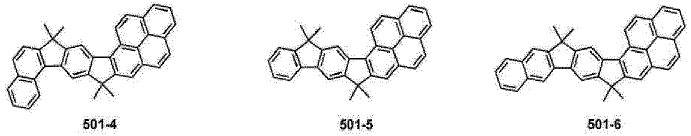

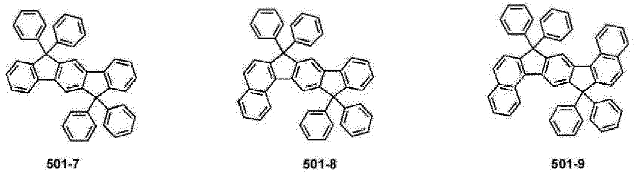

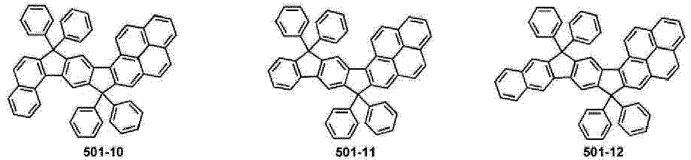

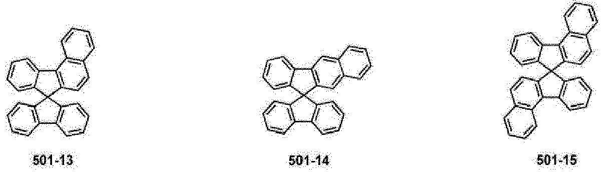

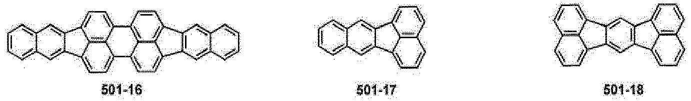

In one or more embodiments, the fluorescent dopant may be a styryl-aminecontaining compound, a styryl-carbazole-containing compound, or a combination thereof, but embodiments are not limited thereto.

In one or more embodiments, the fluorescent dopant may be a compound represented by Formula 501: 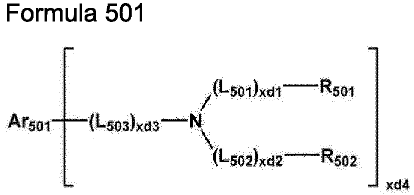 wherein, in Formula 501,
Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501 - 18; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501 - 18, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a monovalent non-aromatic condensed polycyclic group, a monovalent non-aromatic condensed heteropolycyclic group, or -Si(Q₅₀₁)(Q₅₀₂)(Q₅₀₃),
wherein Q₅₀₁ to Q₅₀₃ may each independently be hydrogen, a C₁-C₆₀ alkyl group, a C₁-C₆₀ alkoxy group, a C₁-C₆₀ alkylthio group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or a combination thereof,
L₅₀₁ to L₅₀₃ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
R₅₀₁ and R₅₀₂ may each independently be:
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd1 to xd3 may each independently be 0, 1, 2, or 3, and
   xd4 may be 0, 1, 2, 3, 4, 5, or 6.

For example, in Formula 501,
Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501 - 18; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501 - 18, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group, or -Si(Q₅₀₁)(Q₅₀₂)(Q₅₀₃),
wherein Q₅₀₁ to Q₅₀₃ may each independently be hydrogen, a C₁-C₂₀ alkyl group, a C₁-C₂₀ alkoxy group, a C₁-C₂₀ alkylthio group, a phenyl group, a biphenyl group, a terphenyl group or a naphthyl group, or a combination thereof,
L₅₀₁ to L₅₀₃ are each as described in connection with L₂₁,
xd1 to xd3 may be each independently 0, 1, or 2, and
xd4 may be 0, 1, 2, or 3, but embodiments are not limited thereto.

In one or more embodiments, the fluorescent dopant may include a compound represented by one of Formulae 502-1 to 502-5: 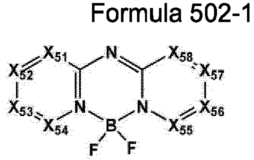 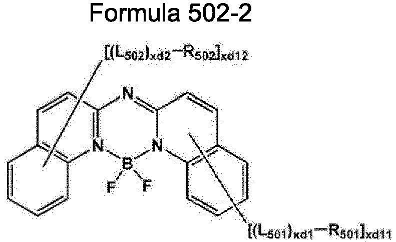 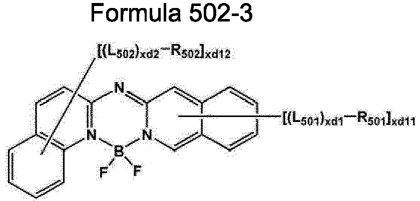 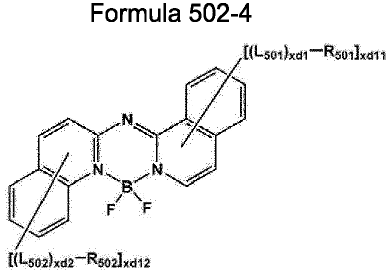 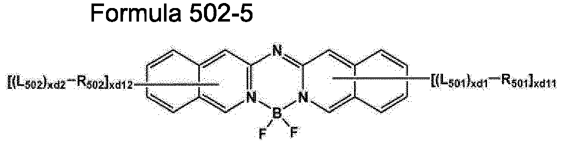 wherein, in Formulae 502-1 to 502-5,
X₅₁ may be N or C-[(L₅₀₁)_{xd1}-R₅₀₁], X₅₂ may be N or C-[(L₅₀₂)_{xd2}-R₅₀₂], X₅₃ may be N or C-[(L₅₀₃)_{xd3}-R₅₀₃], X₅₄ may be N or C-[(L₅₀₄)_{xd4}-R₅₀₄], X₅₅ may be N or C-[(L₅₀₅)_{xd5}-R₅₀₅], X₅₆ may be N or C-[(L₅₀₆)_{xd6}-R₅₀₆], X₅₇ may be N or C-[(L₅₀₇)_{xd7}-R₅₀₇], and X₅₈ may be N or C-[(L₅₀₈)_{xd8}-R₅₀₈],
L₅₀₁ to L₅₀₈ are each as described in connection with L₅₀₁ in Formula 501,
xd1 to xd8 are each as described in connection with xd1 in Formula 501,
R₅₀₁ to R₅₀₈ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd11 and xd12 may each independently be 0, 1, 2, 3, 4, or 5,
   two of R₅₀₁ to R₅₀₄ may optionally be linked together to form a saturated or unsaturated ring, and
   two of R₅₀₅ to R₅₀₈ may optionally be linked together to form a saturated or unsaturated ring.

In one or more embodiments, the fluorescent dopant may be a delayed fluorescence dopant that emits delayed fluorescence based on a delayed fluorescence emission mechanism.

For example, the delayed fluorescence dopant may be (i) a compound having a D-A structure (wherein D indicates an electron donor group, and A indicates an electron acceptor group) or (ii) a condensed cyclic compound containing boron (B).

In one or more embodiments, the delayed fluorescence dopant may include a compound represented by Formula 503-1 or 503-2: 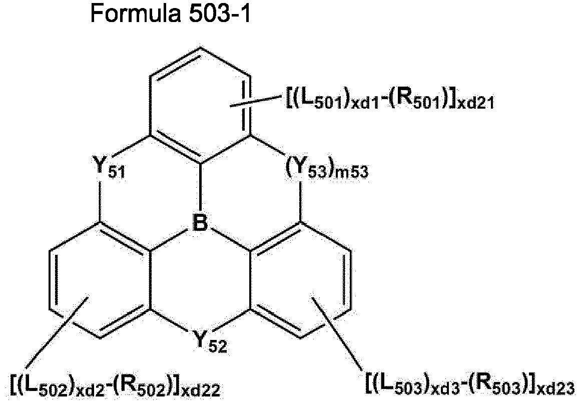 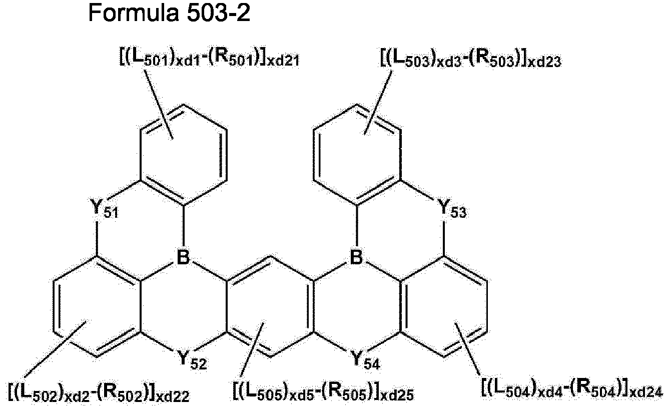 wherein, in Formulae 503-1 and 503-2,
Y₅₁ to Y₅₄ may each independently be a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₅₀₆)_{xd6}-R₅₀₆][(L₅₀₇)_{xd7}-R₅₀₇],
m31 may be 0 or 1,
L₅₀₁ to L₅₀₇ are each as described in connection with L₅₀₁ in Formula 501,
xd1 to xd7 are each as described in connection with xd1 in Formula 501,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd21 and xd23 may each independently be 0, 1, 2, 3, or 4,
   xd22 and xd24 may each independently be 0, 1, 2, or 3,
   xd25 may be 0, 1, or 2, and
   two of R₅₀₁ to R₅₀₇ may optionally be linked together to form a saturated ring or an unsaturated ring.

The fluorescent dopant may include, for example, Compounds FD(1) to FD(16), or Compounds FD1 to FD14, or a combination thereof:

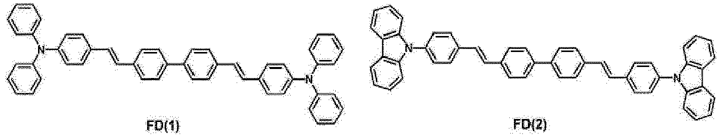

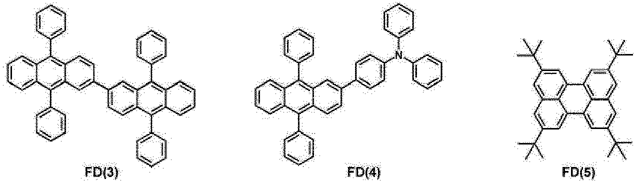

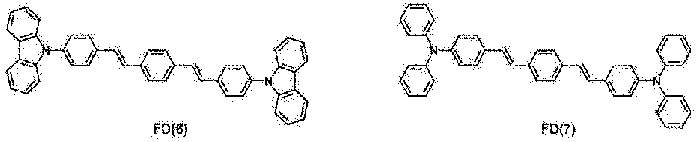

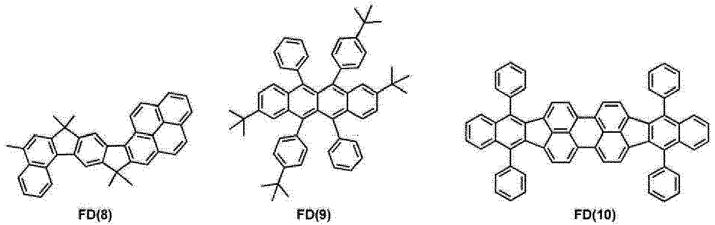

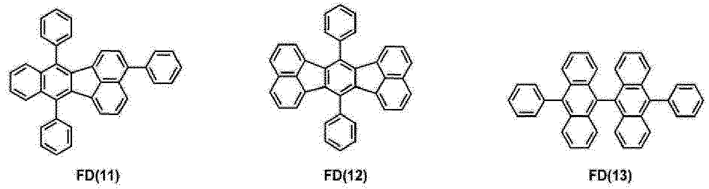

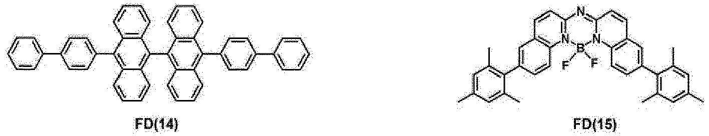

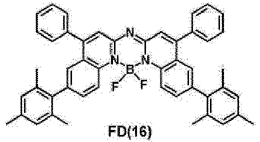

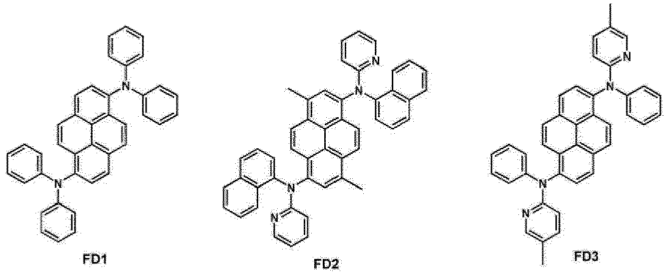

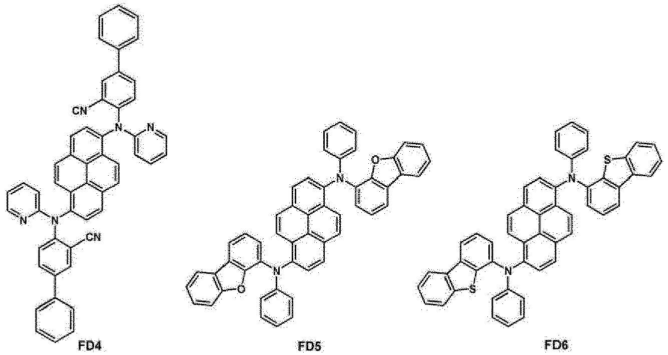

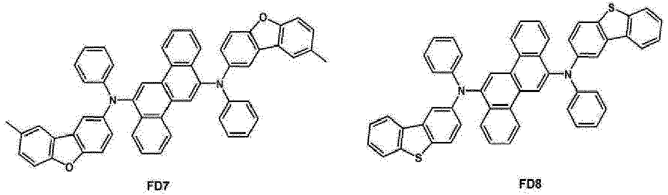

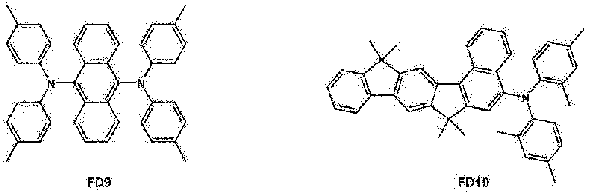

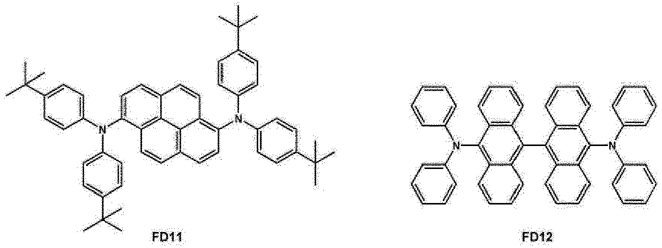

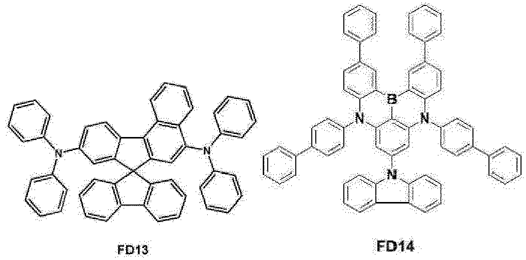

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

Next, the electron transport region may be located on the emission layer.

The electron transport region may include a hole blocking layer, an electron transport layer, an electron injection layer, or a combination thereof.

For example, the electron transport region may have a hole blocking layer/an electron transport layer/an electron injection layer structure or an electron transport layer/an electron injection layer structure, but embodiments are not limited thereto. The electron transport layer may have a single-layered structure or a multi-layered structure including two or more different materials.

Conditions for forming the hole blocking layer, the electron transport layer, and the electron injection layer which constitute the electron transport region may be similar to or the same as the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), or bis(2-methyl-8-quinolinolato-N1,O8)-(1,1'-biphenyl-4-olato)aluminum (BAlq), but embodiments are not limited thereto:

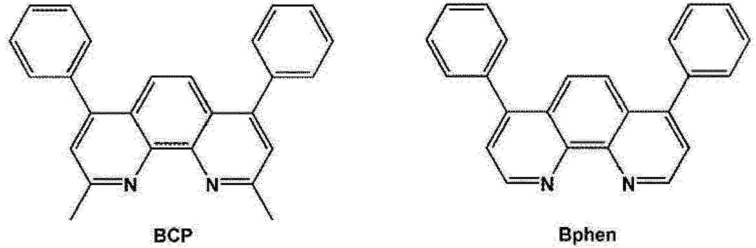

A thickness of the hole blocking layer may be in a range of about 20 Å to about 1,000 Å, for example, about 30 Å to about 300 Å. When the thickness of the hole blocking layer is within these ranges, excellent hole blocking characteristics may be obtained without a substantial increase in driving voltage.

The electron transport layer may further include at least one of BCP, Bphen, tris(8-hydroxy-quinolinato)aluminum (Alq₃), BAlq, 3-(4-biphenylyl)-4-phenyl-5-tert-butylphenyl-1,2,4-triazole (TAZ), or4-(naphthalen-1-yl)-3,5-diphenyl-4H-1,2,4-triazole (NTAZ):

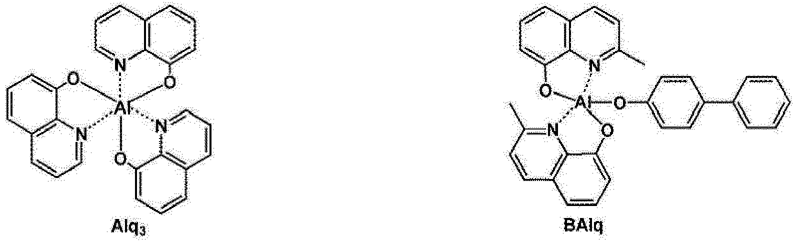

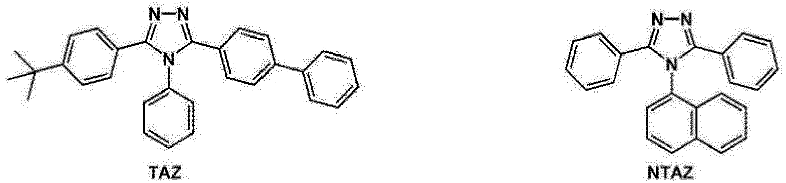

In one or more embodiments, the electron transport layer may include at least one of Compounds ET1 to ET25, but embodiments are not limited thereto:

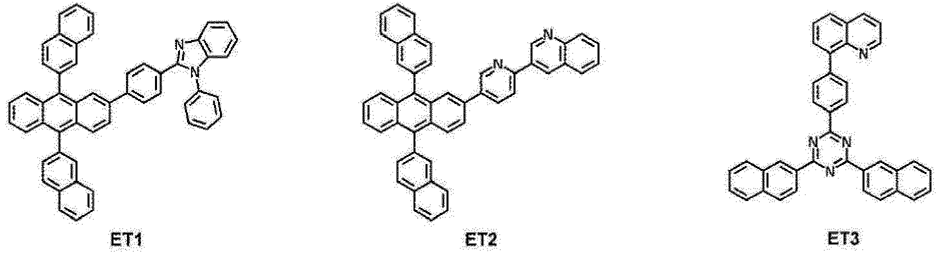

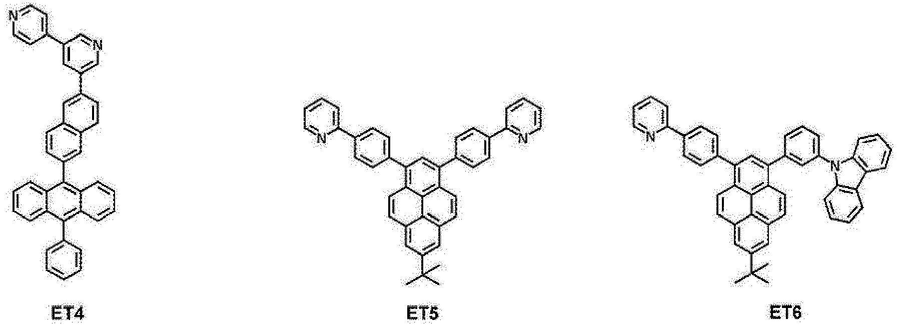

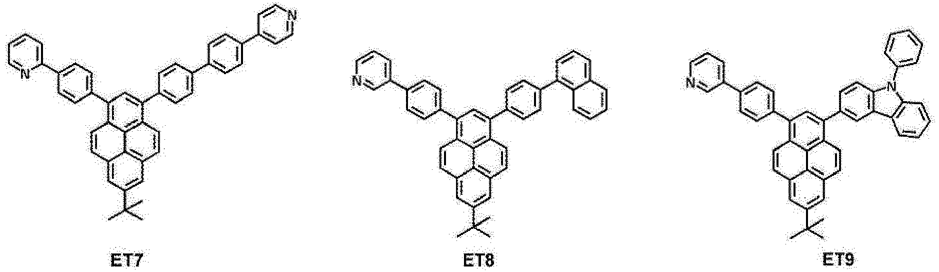

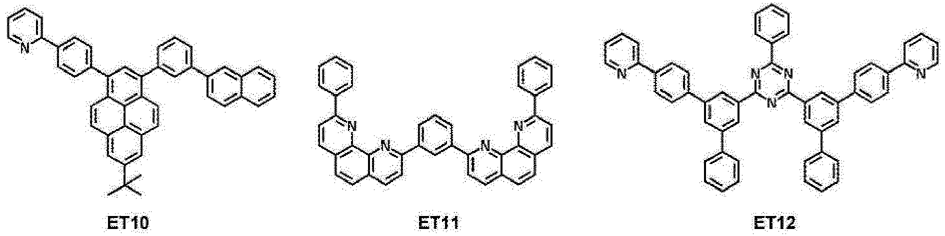

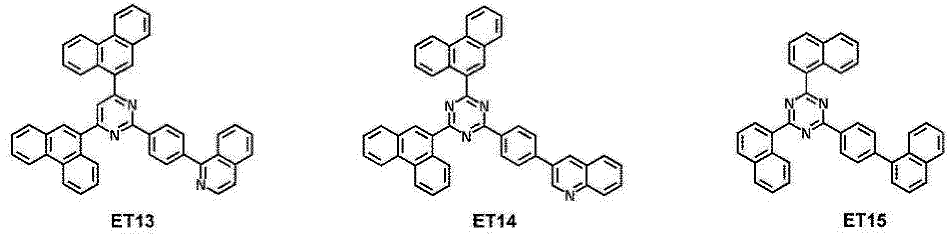

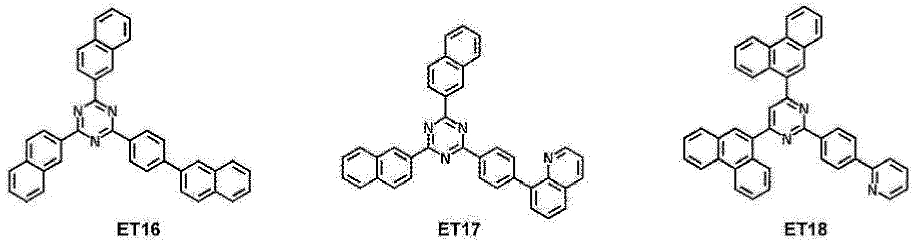

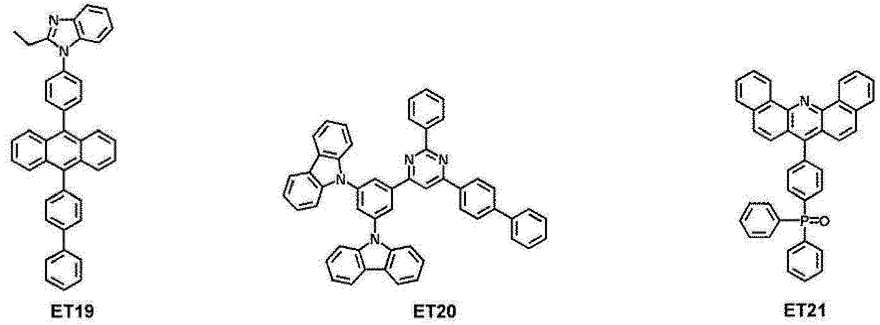

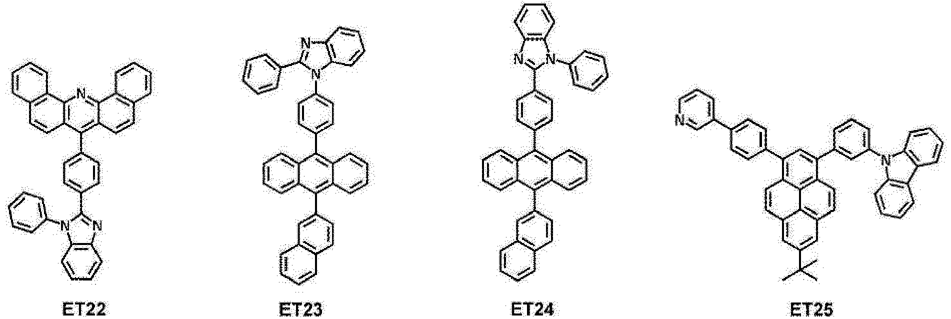

A thickness of the electron transport layer may be in a range of about 100 Å to about 1,000 Å, for example, about 150 Å to about 500 Å. When the thickness of the electron transport layer is within these ranges, excellent electron transport characteristics may be obtained without a substantial increase in driving voltage.

The electron transport layer may include, in addition to the materials described above, a metal-containing material.

The metal-containing material may include a Li complex. The Li complex may include, for example, Compound ET-D1 (lithium quinolate, LiQ) or ET-D2:

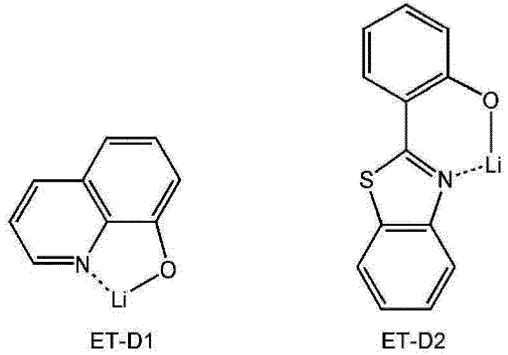

The electron transport region may include an electron injection layer that facilitates electron injection from the second electrode 19.

The electron injection layer may include at least one of LiF, NaCl, CsF, Li₂O, or BaO.

A thickness of the electron injection layer may be in a range of about 1 Å to about 100 Å, for example, about 3 Å to about 90 Å. When the thickness of the electron injection layer is within these ranges, satisfactory electron injection characteristics may be obtained without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which has a relatively low work function. Examples of the material for forming the second electrode 19 may include one or more of lithium (Li), magnesium (Mg), aluminum (Al), silver (Ag), aluminum-lithium (Al-Li), calcium (Ca), magnesium-indium (Mg-In), or magnesium-silver (Mg-Ag). In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but the exemplary embodiments are not limited thereto.

Another aspect provides a diagnostic composition including at least one organometallic compound represented by Formula 1.

The organometallic compound represented by Formula 1 provides high luminescence efficiency. Accordingly, a diagnostic composition including the organometallic compound may have high diagnostic efficiency.

The diagnostic composition may be applied in various ways, such as in a diagnostic kit, a diagnostic reagent, a biosensor, or a biomarker.

The term "C₁-C₆₀ alkyl group" as used herein refers to a linear or branched saturated aliphatic hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is a C₁-C₆₀ alkyl group). Examples thereof include a methoxy group, an ethoxy group, and an isopropyloxy group.

The term "C₁-C₆₀ alkylthio group" used herein refers to a monovalent group represented by -SA_{101'} (wherein A_{101'} is the C₁-C₆₀ alkyl group).

The term "C₂-C₆₀ alkenyl group" as used herein refers to a group formed by including at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a group formed by including at least one carbon-carbon triple bond in the middle or at the terminus of the C₂-C₆₀ alkyl group. Examples thereof include an ethenyl group and a propenyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group including at least one heteroatom selected from N, O, P, Ge, Se, Si, and S as a ring-forming atom and 1 to 10 carbon atoms. Examples thereof include a tetrahydrofuranyl group and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group including 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group including at least one heteroatom selected from N, O, P, Ge, Se, Si, and S as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having a heterocyclic aromatic system having at least one heteroatom selected from N, O, P, Ge, Se, Si, and S as a ring-forming atom and 1 to 60 carbon atoms. The term "C₁-C₆₀ heteroarylene group" as used herein refers to a divalent group having a heterocyclic aromatic system having at least one heteroatom selected from N, O, P, Ge, Se, Si, and S as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the two or more rings may be fused to each other.

The term "C₂-C₆₀ alkylheteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₁-C₆₀ heteroaryloxy group" as used herein indicates -OA₁₀₄ (wherein A₁₀₄ is a C₁-C₆₀ heteroaryl group), and the term "C₁-C₆₀ heteroarylthio group" as used herein indicates -SA₁₀₅ (wherein A₁₀₅ is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed with each other, at least one heteroatom selected from N, O, P, Ge, Se, Si, and S, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group.

The term "C₁-C₃₀ heterocyclic group" as used herein refers to saturated or unsaturated cyclic group including 1 to 30 carbon atoms and at least one heteroatom selected from N, O, P, Ge, Se, Si, and S as ring-forming atoms. The C₁-C₃₀ heterocyclic group may be a monocyclic group or a polycyclic group.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₇-C₆₀ aryl alkyl group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), -P(Q₁₈)(Q₁₉), - P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), -P(=O)(Q₂₈)(Q₂₉), or a combination thereof; or
-N(Q₃₁)(Q₃₂), -Si(Q₃₃)(Q₃₄)(Q₃₅), -B(Q₃₆)(Q₃₇), -P(Q₃₈)(Q₃₉), or - P(=O)(Q₃₈)(Q₃₉), and
Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

Hereinafter, a compound and an organic light-emitting device according to one or more exemplary embodiments will be described in further detail with reference to Synthesis Examples and Examples. However, the exemplary embodiments are not limited thereto. The wording "'B' was used instead of 'A'" as used in describing Synthesis Examples means that an amount of 'A' used was identical to an amount of 'B' used, in terms of a molar equivalent.

### EXAMPLES

### Synthesis Example 1: Synthesis of Compound 1

### (1) Synthesis of Intermediate 1(1)

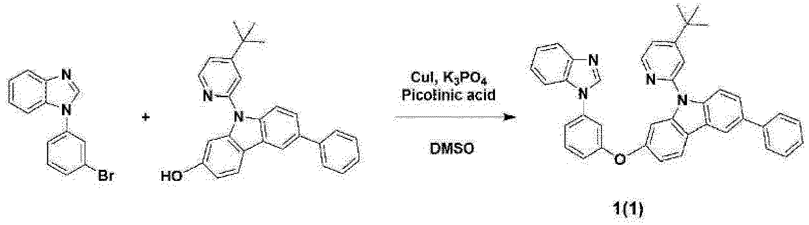

10 grams (g) (36.6 millimoles (mmol)) of 1-(3-bromophenyl)-1H-benzo[d]imidazole and 18.7 g (47.6 mmol) of 9-(4-(tert-butyl)pyridin-2-yl)-6-phenyl-9H-carbazol-2-ol were dissolved in 360 milliliters (mL) of dimethyl sulfoxide (DMSO). Then, 2.1 g (11.0 mmol) of Cul, 31.1 g (146.4 mmol) of potassium phosphate (K₃PO₄), and 6.8 g (54.9 mmol) of picolinic acid were added thereto, followed by heating at reflux at a temperature of 100°C for 12 hours. After completion of the reaction, the resultant was allowed to cool to room temperature, and an organic layer was extracted therefrom using a mixture of ethyl acetate and deionized (DI) water, the extracted organic layer was washed three times with DI water, the organic layer was then isolate dried using magnesium sulfate. Then, a solvent was removed therefrom under a reduced pressure to obtain a crude product. The crude product was purified by silica gel column flash chromatography (eluent: ethyl acetate and hexane) to obtain Intermediate 1(1) in a yield of 73 %.

High performance liquid chromatograph-mass spectrometry (HPLC-MS): 585.24 [M+H]⁺.

### (2) Synthesis of Intermediate 1(2)

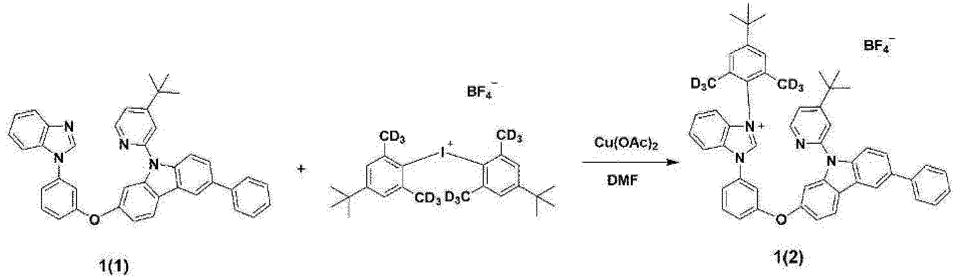

7.0 g (12.0 mmol ) of Intermediate 1(1), 16.4 g (30.0 mmol) of (bis(4-(t-butyl)-2,6-bis(methyl-d3)phenyl)iodonium tetrafluoroborane, and 1.1 g (6.0 mmol) of copper acetate (Cu(OAc)₂) were added to 50 mL of DMF, followed by heating at reflux at a temperature of 130°C for 12 hours. The reaction was allowed to cool to room temperature and then a crude product was obtained by removing a solvent therefrom under a reduced pressure. The crude product was purified by silica gel flash column chromatography (eluent: dichloromethane and acetone) to obtain Intermediate 1(2) in a yield of 14%.

HPLC-MS: 751.41 [M-BF_{4]}⁺.

### (3) Synthesis of compound 1

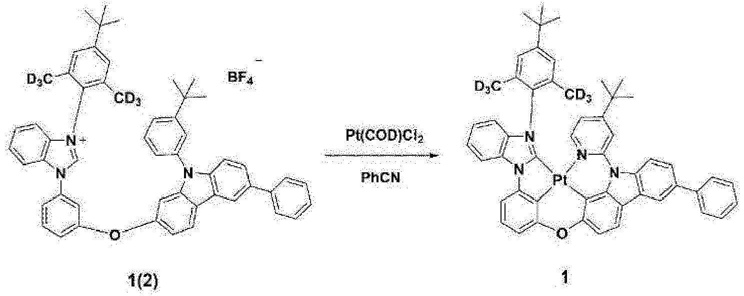

0.6 g (1.7 mmol) of dichloro(1,5-cyclooctadiene)platinum(II) (Pt(COD)Cl₂), 1.4 g (1.7 mmol) of Intermediate 1(2), and 0.4 g (5.0 mmol) of sodium acetate (NaOAc) were added to 30 mL of benzonitrile, followed by heating at reflux at a temperature of 180°C for 12 hours. After completion of the reaction, the resultant was allowed to cool to room temperature, and a solvent was removed therefrom under a reduced pressure to obtain a crude product. The crude product was purified by silica gel flash column chromatography (eluent: dichloromethane and hexane) to obtain Compound 1 in a yield of 30 %.

HPLC-MS: 944.35 [M+H]⁺.

### Synthesis Example 2: Synthesis of Compound 2

### (1) Synthesis of Intermediate 2(1)

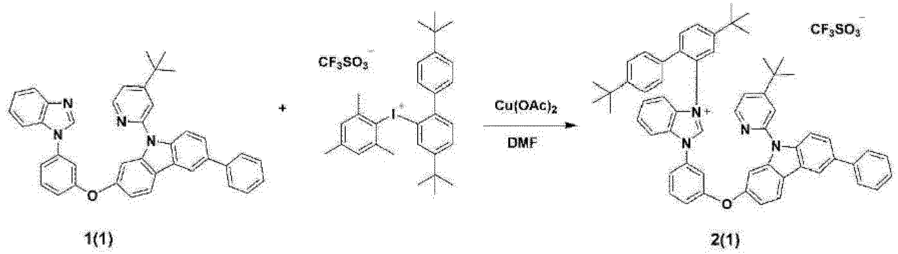

4.0 g (6.8 mmol) of Intermediate 1(1), 6.8 g (10.3 mmol) of (4,4'-di-t-butyl- [1,1'-biphenyl]-2-yl)(mesityl)iodonium trifluoromethane sulfonate, and 0.13 g (0.7 mmol) of copper acetate (Cu(OAc)₂) were added to 35 mL of DMF, followed by heating at reflux at a temperature of 130°C for 12 hours. A crude product was obtained by removing a solvent therefrom under a reduced pressure. The crude product was purified by silica gel flash column chromatography (eluent: dichloromethane and acetone) to obtain Intermediate 2(1) in a yield of 51 %.
HPLC-MS: 849.43 [M-OTt]⁺.

### (2) Synthesis of Compound 2

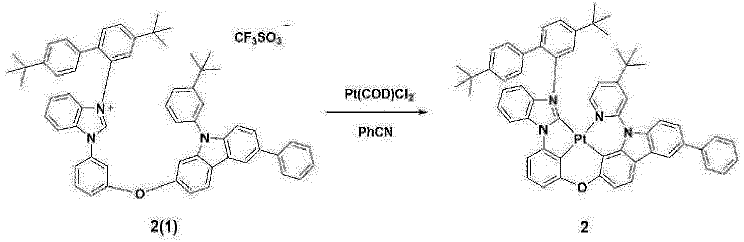

3.5 g (3.5 mmol) of Pt(COD)Cl₂, 1.3 g (3.5 mmol) of Intermediate 2(1), and 0.9 g (5.0 mmol) of NaOAc were added to 60 mL of benzonitrile, followed by heating at reflux at a temperature of 180°C for 12 hours. After completion of the reaction, the resultant was allowed to cool to room temperature, and a solvent was removed therefrom under a reduced pressure to obtain a crude product. The crude product was subjected to silica gel column chromatography (eluent: dichloromethane and hexane) to obtain Compound 2 in a yield of 38 %.

HPLC-MS: 1042.37 [M+H]⁺.

### Synthesis Example 3: Synthesis of Compound 3

### (1) Synthesis of Intermediate 3(1)

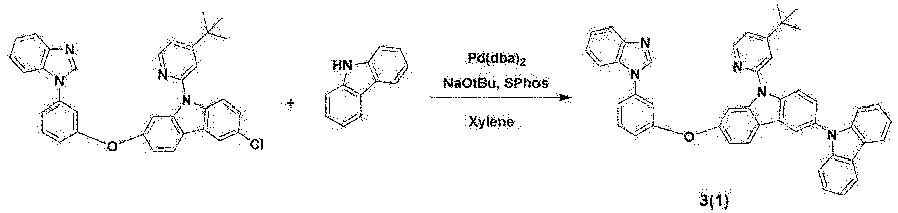

5.0 g (9.2 mmol) of 2-(3-(1H-benzo[d]imidazole-1-yl)phenoxy)-9-(4-(t-butyl)pyridine-2-yl)-6-chloro-9H-carbazole and 1.8 g (11.0 mmol) of 9H-carbazole were dissolved in 45 mL of xylene. Then, 0.5 g (0.9 mmol) of bis(dibenzylideneacetone)palladium(0) (Pd(dba)₂), 1.8 g (18.4 mmol) of sodium tert-butoxide (NaO^{t}Bu), and 0.4 g (1.0 mmol) of 2-dicyclohexylphosphino-2',6'-dimethoxybiphenyl (SPhos) were added thereto, followed by heating at reflux at a temperature of 110°C for 12 hours. After completion of the reaction, the resultant was allowed to cool to room temperature, and an organic layer was extracted therefrom using a mixture of ethyl acetate and water. The organic layer was washed three times with DI water, isolated, and then dried using magnesium sulfate. Then, a solvent was removed therefrom under a reduced pressure to obtain a crude product. The crude product was purified by silica gel flash column chromatography (eluent: ethyl acetate and hexane) to obtain Intermediate 3(1) in a yield of 60 %.

HPLC-MS: 674.28 [M+H]⁺.

### (2) Synthesis of Intermediate 3(2)

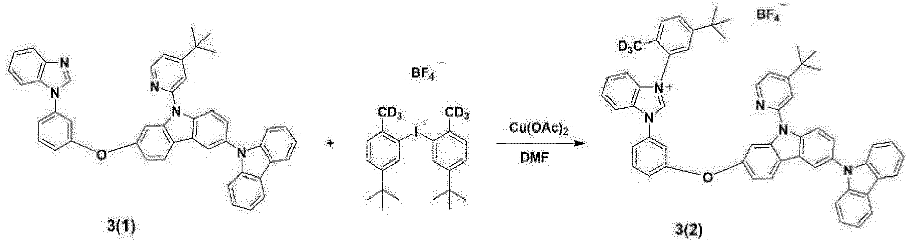

Intermediate 3(2) (yield of 30%) was synthesized in a similar manner as was used to synthesize Intermediate 1 (2) in Synthesis Example 1, except that Intermediate 3(1) was used instead of Intermediate 1(1), and bis(5-(t-butyl)-2-(methyl-d3)phenyl)iodonium tetrafluoro-borane was used instead of bis(4-(t-butyl)-2,6-bis(methyl-d3)phenyl)iodonium tetrafluoro-borane.

HPLC-MS: 823.34 [M-BF₄]⁺.

### (3) Synthesis of Compound 3

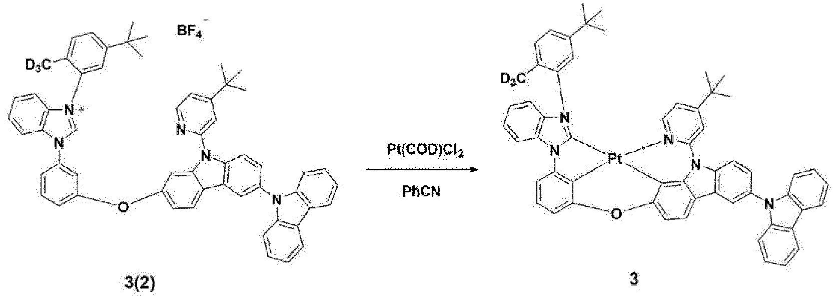

Compound 3 (yield of 26%) was synthesized in a similar manner as was used to synthesize Compound 1 in Synthesis Example 1, except that Intermediate 3(2) was used instead of Intermediate 1(2).

HPLC-MS: 1015.42 [M+H]⁺.

### Example 1

An ITO glass substrate was cut to a size of 50 millimeters (mm) x 50 mm x 0.5 mm, sonicated in acetone, isopropyl alcohol, and DI water, each for 15 minutes, and then exposed to UV irradiation and ozone for 30 minutes.

Then, a layer of m-MTDATA was deposited on an ITO electrode (anode) on the glass substrate at a deposition rate of 1 Å/sec to form a hole injection layer having a thickness of 600 Å, and then, a layer of α-NPD was deposited on the hole injection layer at a deposition speed of 1 Å/sec to form a hole transport layer having a thickness of 250 Å.

A layer of 10 wt% of Compound 1 (dopant) and CBP (host) were co-deposited on the hole transport layer at a deposition rate of 0.1 Å/sec and a deposition rate of 1 Å/sec, respectively, to form an emission layer having a thickness of 400 Å.

A layer of BAIq was deposited on the emission layer at a deposition rate of 1 Å/sec to form a hole blocking layer having a thickness of 50 Å, a layer of Alq₃ was deposited on the hole blocking layer to form an electron transport layer having a thickness of 300 Å, a layer of LiF was deposited on the electron transport layer to form an electron injection layer having a thickness of 10 Å, and then, a layer of Al was vacuum deposited on the electron injection layer to form a second electrode (cathode) having a thickness of 1,200 Å, thereby completing the manufacture of an organic light-emitting device having a structure of ITO / m-MTDATA (600 Å) / α-NPD (250 Å) / CBP + Compound 1 (10 wt%) (400 Å) / BAIq (50 Å) / Alq₃ (300 Å) / LiF (10 Å) / Al (1,200 Å).

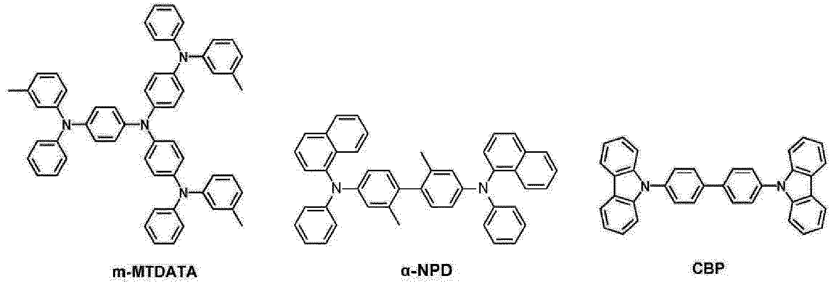

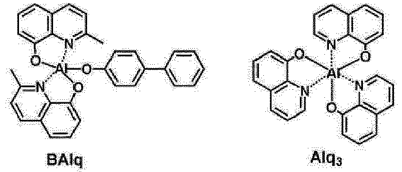

### Examples 2 and 3 and Comparative Examples 1 and 2

Organic light-emitting devices were manufactured in a similar manner as in Example 1, except that Compounds shown in Table 2 were each used instead of Compound 1 as a dopant in forming an emission layer.

### Evaluation Example 1: Evaluation of characteristics of organic light-emitting devices

For each of the organic light-emitting devices manufactured according to Examples 1 to 3 and Comparative Examples 1 and 2, the maximum emission wavelength (λₘₐₓ, nm), luminescence quantum efficiency (PLQY), and external quantum efficiency (EQE, %) were evaluated. The results are shown in Table 2. As evaluation apparatuses, a current-voltage meter (Keithley 2400) and a luminance meter (Minolta CS-1000A) were used.

**Table 2**

| | Dopant in emission layer | λₘₐₓ (nm) | PLQY | EQE (%) |
|---|---|---|---|---|
| Example 1 | Compound 1 | 461 | 0.622 | 15.6 |
| Example 2 | Compound 2 | 462 | 0.671 | 16.6 |
| Example 3 | Compound 3 | 461 | 0.671 | 16.7 |
| Comparative Example 1 | Compound A | 462 | 0.653 | 14.8 |
| Comparative Example 2 | Compound B | 462 | 0.609 | 14.5 |

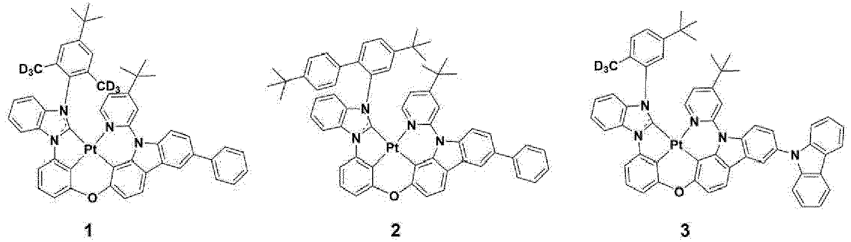

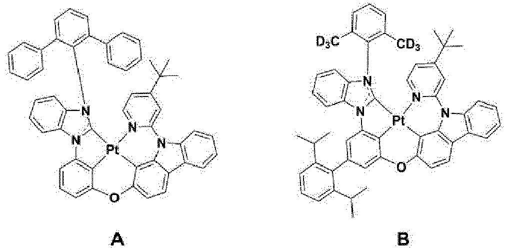

From Table 2, it was confirmed that the organic light-emitting devices of Examples 1 to 3 had excellent luminescence quantum efficiency and external quantum efficiency, and were suitable for deep blue light emission. In particular, the organic light-emitting devices of Examples 1 to 3 had significantly greater external quantum efficiency compared to the organic light-emitting devices of Comparative Examples 1 and 2.

### Example 4

An organic light-emitting device was manufactured in a similar manner as in Example 1, except that, in forming an emission layer, Compound CBP was used as a host at a weight ratio of 88.5 wt%, and Compound 3 and Compound FD14 were used as dopants at weight ratios of 10 wt% and1.5 wt%, respectively, each based on the total weight of the emission layer.

### Comparative Example 3

An organic light-emitting device was manufactured in a similar manner as in Example 1, except that Compound FD14 was used as a dopant in forming an emission layer.

### Evaluation Example 2: Evaluation of characteristics of organic light-emitting devices

For each of the organic light-emitting devices manufactured according to Example 4 and Comparative Example 3, the maximum emission wavelength (λₘₐₓ, nm), external quantum efficiency (EQE, %, relative value), and lifespan characteristics (T₉₅, %, relative value) were evaluated. The results are shown in Table 3. As evaluation apparatuses, a current-voltage meter (Keithley 2400) and a luminance meter (Minolta Cs-1000A) were used. The EQE are expressed as relative values based on Comparative Example 5 as 100%. The lifespan characteristics (T₉₅) were evaluated by measuring the amount of time that elapsed until luminance was reduced to 95% of the initial luminance of 100%(at 1,000 nits (wherein 1 nit = 1 cd/m²)) and the results are expressed as relative values based on Comparative Example 5 as 100%.

**Table 3**

| No. | Dopant compound | λₘₐₓ (nm) | EQE (relative values) | Lifespan (T₉₅) (relative values) |
|---|---|---|---|---|
| Example 4 | Compound 3 + Compound FD14 | 462 | 182% | 741% |
| Comparative Example 5 | Compound FD14 | 462 | 100% | 100% |

From Table 3, it was confirmed that the organic light-emitting device of Example 4 had significantly improved external quantum efficiency and lifespan characteristics compared to the organic light-emitting device of Comparative Example 3.

The organometallic compound has excellent photochemically stability, and an organic light-emitting device using the organometallic compound may have improved efficiency and lifespan. Accordingly, by using the organometallic compound, a high-quality organic light-emitting device may be realized.

It should be understood that the exemplary embodiments described herein should be considered in a descriptive sense and not for purposes of limitation. Descriptions of exemplary features or aspects within each exemplary embodiment should typically be considered as available for other similar features or aspects in other exemplary embodiments. While one or more exemplary embodiments have been described with reference to the figure, it will be understood by those of ordinary skill in the art that various changes in form and details may be made therein without departing from the scope as defined by the following claims.

## Claims

1. An organometallic compound represented by Formula 1:
Formula 1 M₁(L₁₁)n₁₁(L₁₂)n₁₂
wherein, in Formula 1,
M₁ is a first-row transition metal of the Periodic Table of Elements, a second-row transition metal of the Periodic Table of Elements, or a third-row transition metal of the Periodic Table of Elements,
L₁₁ is a ligand represented by Formula 1-1,
L₁₂ is a monodentate ligand or a bidentate ligand,
n11 is 1,
n12 is 0, 1, or 2, 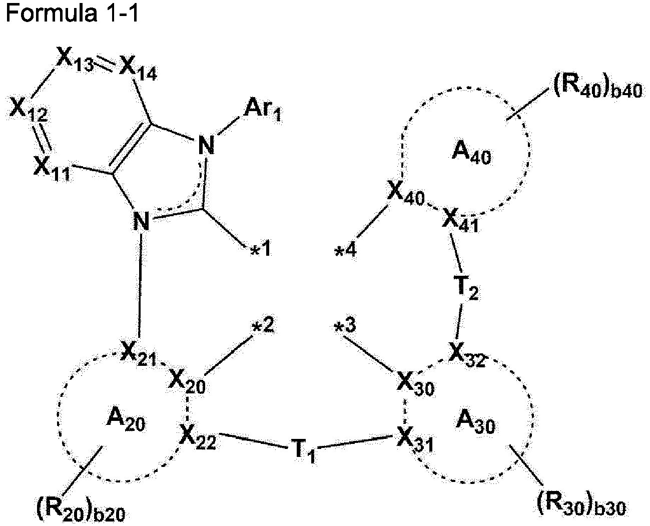
wherein, in Formula 1-1,
*¹ to *⁴ each indicates a binding site to M₁,
ring A₂₀, ring A₃₀, and ring A₄₀ are each independently a C₅-C₃₀ carbocyclic group or a C₁-C₃₀ heterocyclic group,
T₁ is a single bond, *-N(R₁)-*', *-B(R₁)-*', *-P(R₁)-*', *-C(R₁)(R₂)-*', *-Si(R₁)(R₂)-*', *-Ge(R₁)(R₂)-*', *-S-*', *-Se-*', *-O-*', *-C(=O)-*', *-S(=O)-*', *-S(=O)₂-*', *-C(R₁)=C(R₂)-*', *-C(=S)-*', or *-C=C-*',
T₂ is a single bond, *-N(R₃)-*', *-B(R₃)-*', *-P(R₃)-*', *-C(R₃)(R₄)-*', *-Si(R₃)(R₄)-*', *-Ge(R₃)(R₄)-*', *-S-*', *-Se-*', *-O-*', *-C(=O)-*', *-S(=O)-*', *-S(=O)₂-*', *-C(R₃)=C(R₄)-*', *-C(=S)-*', or *-C=C-*',
X₁₁ is C(R₁₁) or N, X₁₂ is C(R₁₂) or N, X₁₃ is C(R₁₃) or N, and X₁₄ is C(R₁₄) or N,
X₂₀ is C or N, X₂₁ is C or N, and X₂₂ is C or N,
X₃₀ is C or N, X₃₁ is C or N, and X₃₂ is C or N,
X₄₀ is C or N, and X₄₁ is C or N, and
Ar₁ is a group represented by Formula 2, 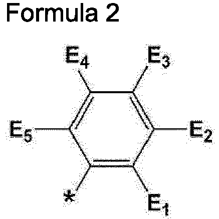
wherein, in Formula 2,
E₁ is a C₁-C₆₀ alkyl group substituted with deuterium, or a substituted or unsubstituted C₁-C₆₀ aryl group,
E₂ to E₅ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - B(Q₆)(Q₇), -P(Q₈)(Q₉), or -P(=O)(Q₈)(Q₉),
at least one of E₂ to E₅ is not hydrogen,
with the proviso that when E₁ is a C₁-C₆₀ alkyl group substituted with deuterium and E₅ is a C₁-C₆₀ alkyl group substituted with deuterium, at least one of E₂ to E₄ is not hydrogen,
with the proviso that when E₁ is a substituted or unsubstituted C₁-C₆₀ aryl group, Ar₁ has an asymmetric structure,
* and *' each indicates a binding site to a neighboring atom,
R₁ to R₄, R₁₁ to R₁₄, R₂₀, R₃₀, and R₄₀ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₈)(Q₉), or -P(=O)(Q₈)(Q₉),
neighboring two or more of R₁ to R₄, R₁₁ to R₁₄, R₂₀, R₃₀, or R₄₀ are optionally linked together to form a substituted or unsubstituted C₅-C₃₀ carbocyclic group or a substituted or unsubstituted C₁-C₃₀ heterocyclic group,
two or more of R₂₀ in the number of b20 are optionally linked together to form a substituted or unsubstituted C₅-C₃₀ carbocyclic group, or a substituted or unsubstituted C₁-C₃₀ heterocyclic group,
two or more of R₃₀ in the number of b30 are optionally linked together to form a substituted or unsubstituted C₅-C₃₀ carbocyclic group, or a substituted or unsubstituted C₁-C₃₀ heterocyclic group,
two or more of R₄₀ in the number of b40 are optionally linked together to form a substituted or unsubstituted C₅-C₃₀ carbocyclic group, or a substituted or unsubstituted C₁-C₃₀ heterocyclic group,
b20, b30, and b40 are each independently 1, 2, 3, 4, 5, 6, 7, 8, 9, or 10,
when b20 is 2 or greater, two or more of R₂₀ are identical to or different from each other, when b30 is 2 or greater, two or more of R₃₀ are identical to or different from each other, and when b40 is 2 or more, two or more of R₄₀ are identical to or different from each other,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the a substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), -P(Q₁₈)(Q₁₉), or -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), -P(Q₂₈)(Q₂₉), or-P(=O)(Q₂₈)(Q₂₉), or a combination thereof; or
-N(Q₃₁)(Q₃₂), -Si(Q₃₃)(Q₃₄)(Q₃₅), -B(Q₃₆)(Q₃₇), -P(Q₃₈)(Q₃₉), or - P(=O)(Q₃₈)(Q₃₉), and
Q1 to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein M₁ is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

3. The organometallic compound of claims 1 or 2, wherein ring A₂₀ and ring A₃₀ are each independently a phenyl group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, an indazole group, a benzoxazole group, a benzothiazole group, a benzoxadiazole group, a benzothiadiazole group, a benzotriazole group, a diazaindene group, a triazaindene group, a 5,6,7,8-tetrahydroisoquinoline group, or a 5,6,7,8-tetrahydroquinoline group, and
A₄₀ is a pyridine group, a pyrimidine group, a pyrazine group, a pyridazine group, a triazine group, a quinoline group, an isoquinoline group, a quinoxaline group, a quinazoline group, a phenanthroline group, a pyrrole group, an azafluorene group, an azacarbazole group, an azadibenzofuran group, an azadibenzothiophene group, an azadibenzosilole group, a 5,6,7,8-tetrahydroisoquinoline group, or a 5,6,7,8-tetrahydroquinoline group.

4. The organometallic compound of any of claims 1-3, wherein ring A₂₀ is a group represented by one of Formulae A20-1 to A20-13: 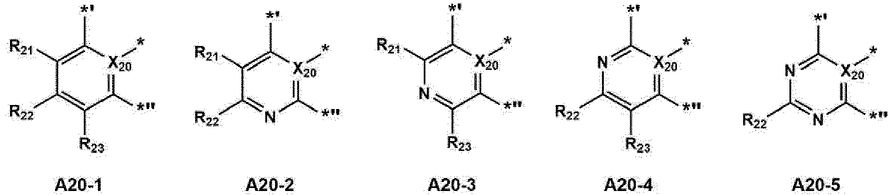 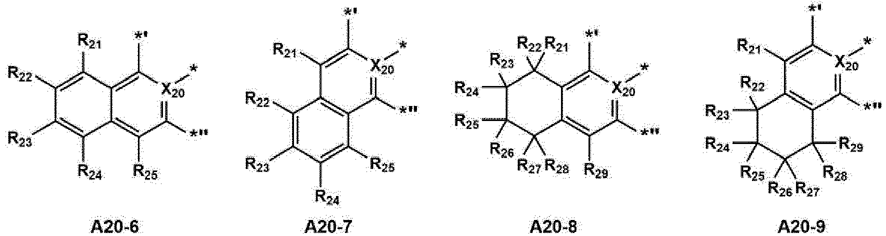 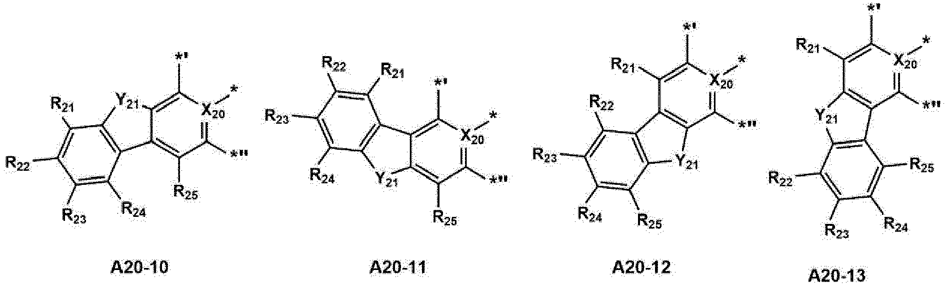 wherein, in Formulae A20-1 to A20-13,
X₂₀ is as described in claim 1,
Y₂₁ is a single bond, O, S, N(R₂₆), C(R₂₆)(R₂₇), or Si(R₂₆)(R₂₇),
R₂₁ to R₂₉ are each independently as described in connection with R₂₀ in claim 1,
* indicates a binding site to M₁, and
*', and *" each indicate a binding site to a neighboring atom; and/or
wherein A₃₀ is a group represented by one of Formulae A30-1 to A30-12: 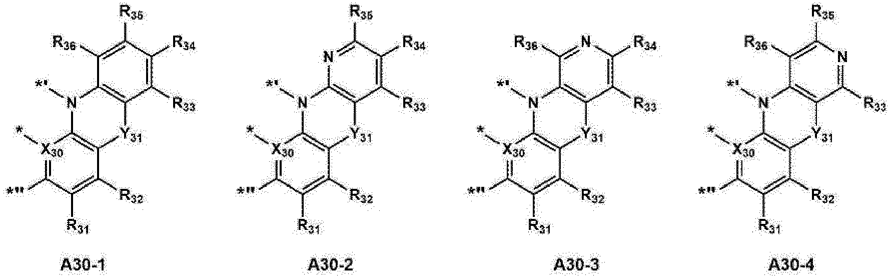 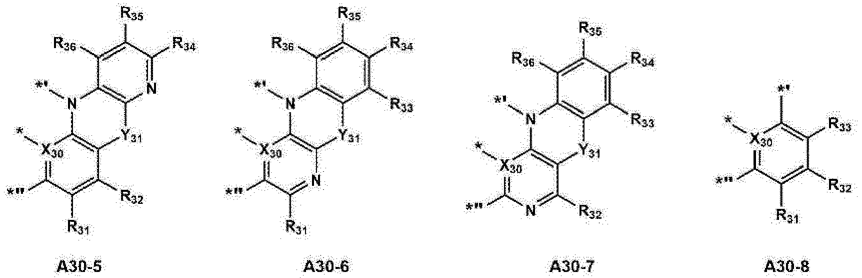 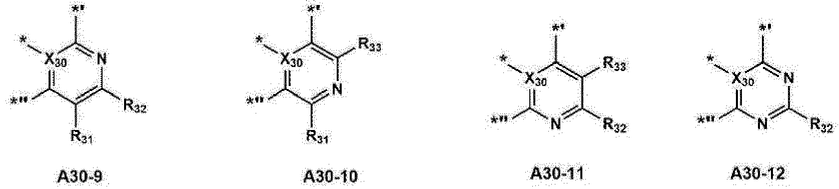
wherein, in Formulae A30-1 to A30-12,
X₃₀ is as described in claim 1,
Y₃₁ is a single bond, O, S, N(R₃₇), C(R₃₇)(R₃₈), or Si(R₃₇)(R₃₈),
R₃₁ to R₃₈ are each independently as described in connection with R₃₀ in claim 1,
* indicates a binding site to M₁, and
*' and *" each indicate a binding site to a neighboring atom.

5. The organometallic compound of any of claims 1-4, wherein A₄₀ is a group represented by one of Formulae A40-1 to A40-16: 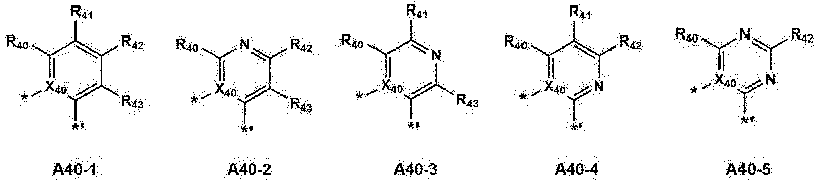 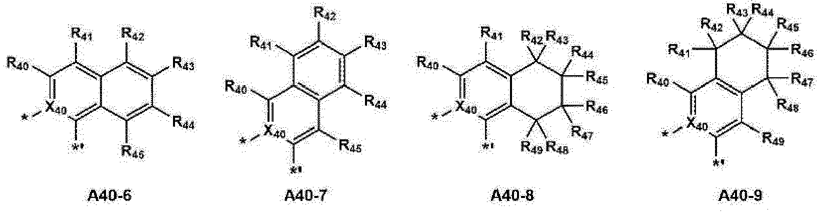 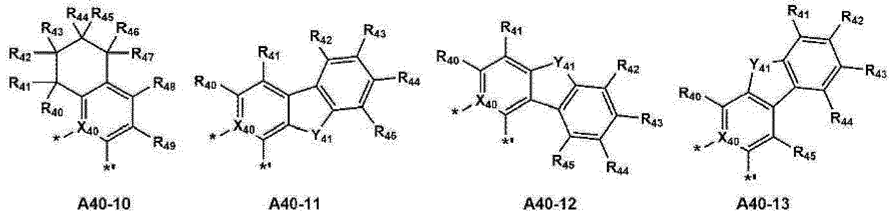 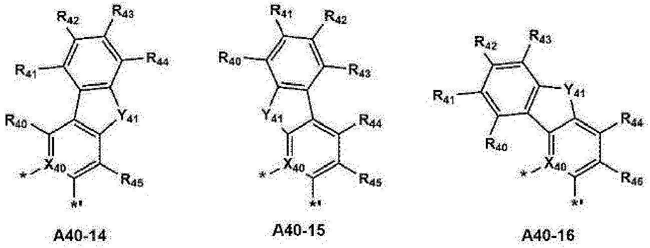 wherein, in Formulae A40-1 to A40-16,
X₄₀ and R₄₀ are respectively as described in claim 1,
Y₄₁ is a single bond, O, S, N(R₄₆), C(R₄₆)(R₄₇), or Si(R₄₆)(R₄₇),
R₄₁ to R₄₉ are each independently as described in connection with R₄₀ in claim 1,
* indicates a biding site to M₁, and
*' indicates a binding site to a neighboring atom.

6. The organometallic compound of any of claims 1-5, wherein Ar₁ is a group represented by one of Formulae Ar1-1 to Ar1-14: 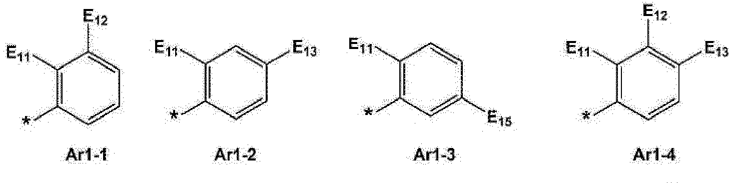 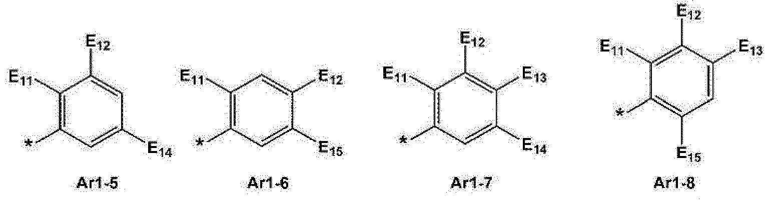 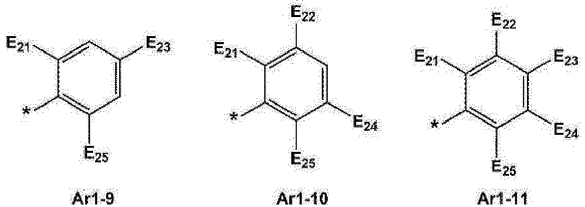 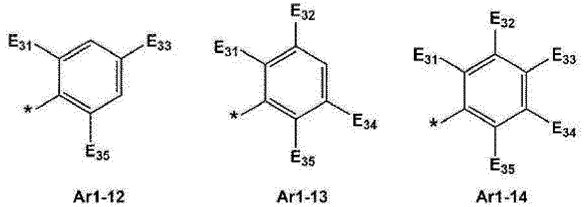
wherein, in Formulae Ar1-1 to Ar1-14,
E₁₁ is a C₁-C₆₀ alkyl group substituted with deuterium, or a substituted or unsubstituted C₁-C₆₀ aryl group,
E₂₁ is a C₁-C₆₀ alkyl group substituted with deuterium, or a substituted or unsubstituted C₁-C₆₀ aryl group,
E₂₁ and E₂₅ are different from each other,
E₃₁ and E₃₅ are each independently a C₁-C₆₀ alkyl group substituted with deuterium,
E₁₂ to E₁₅, E₂₂ to E₂₅, and E₃₂ to E₃₄ are each independently deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -B(Q₆)(Q₇), -P(Q₈)(Q₉), or -P(=O)(Q₈)(Q₉), and
* indicates a binding site to a neighboring atom; or
wherein Ar₁ is a group represented by one of Formulae Ar1 (1) to Ar1(104): 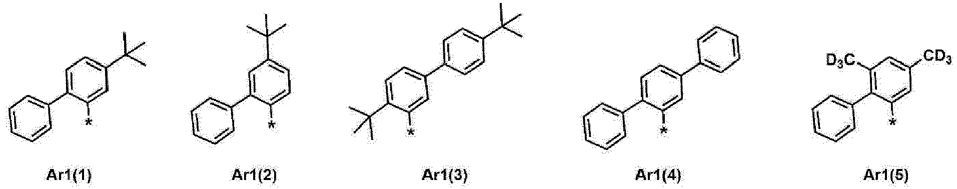 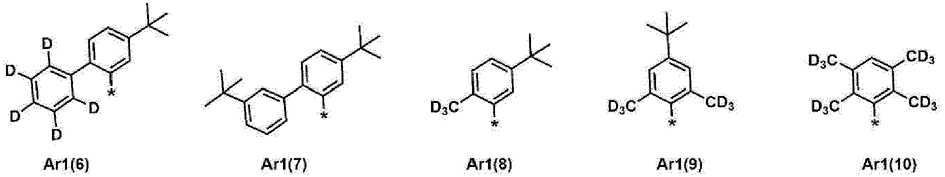 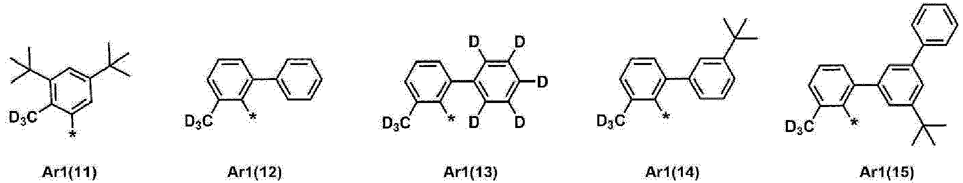 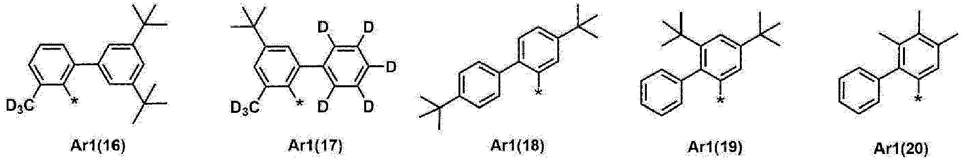 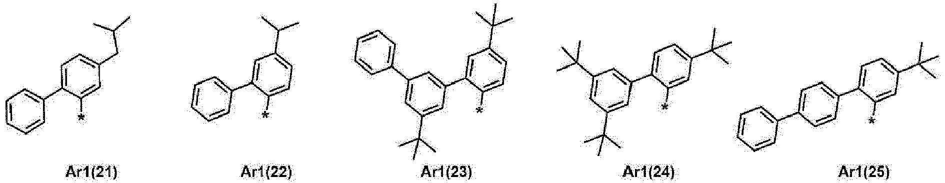 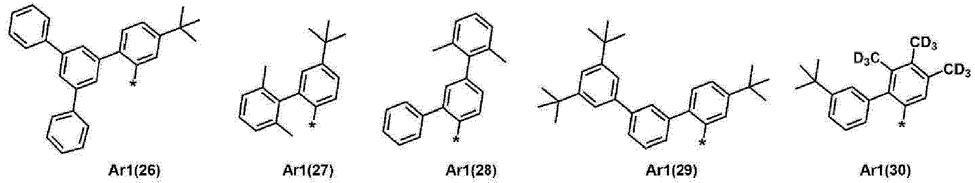 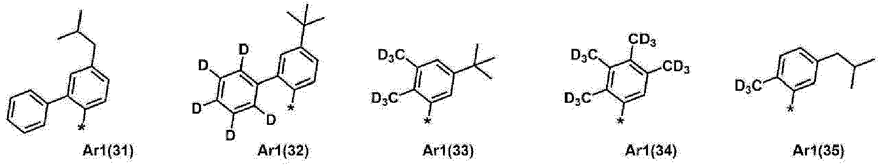 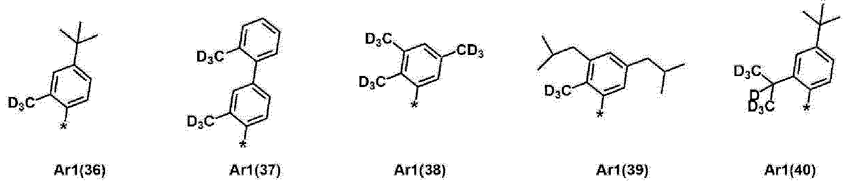 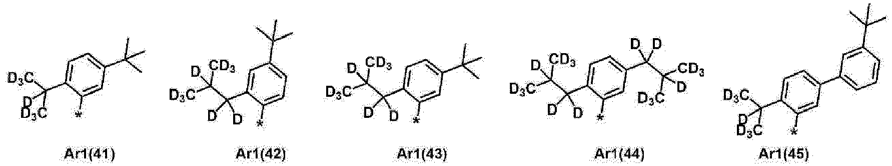 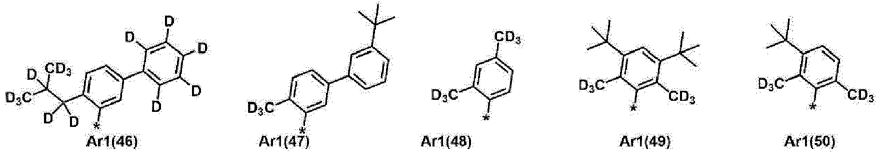 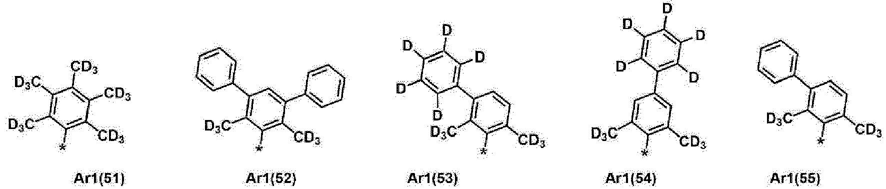 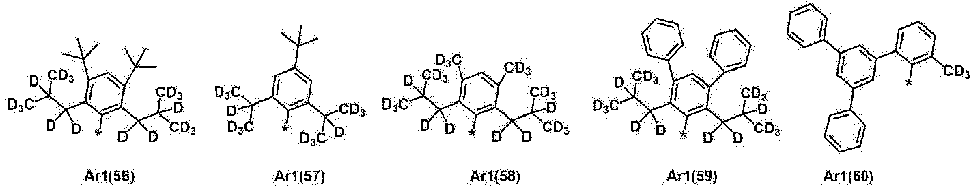 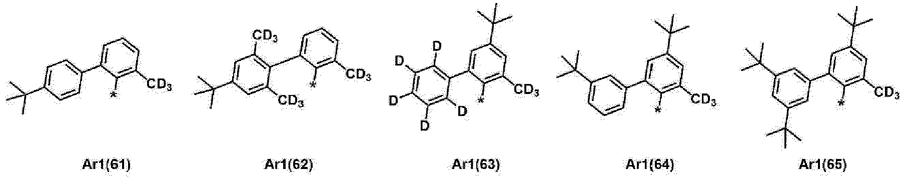 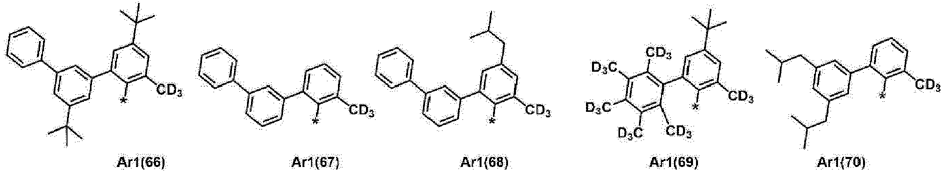 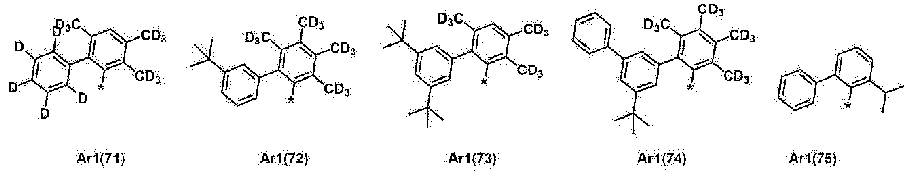 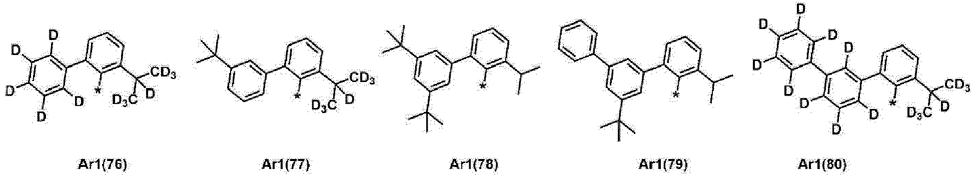 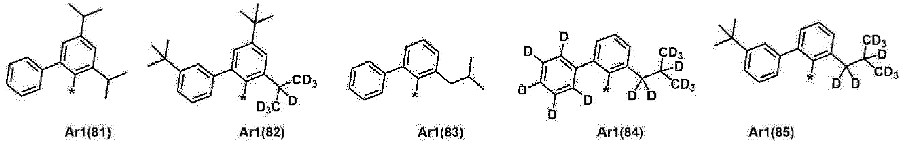 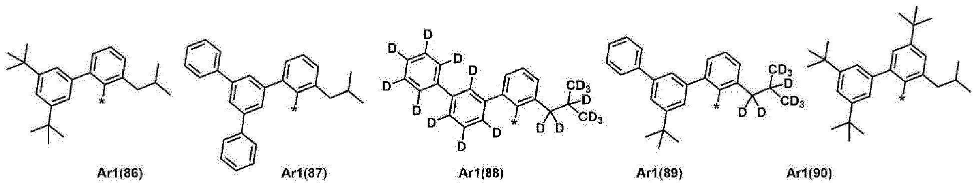 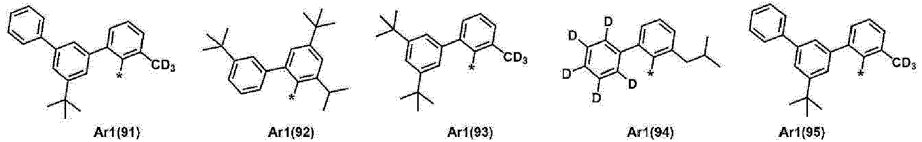 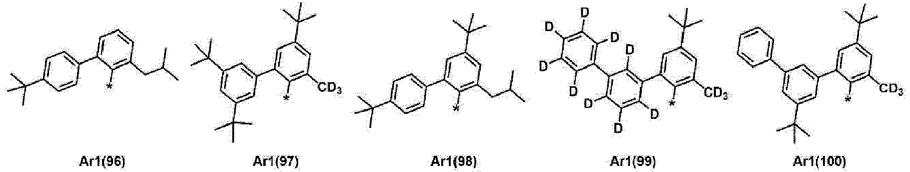 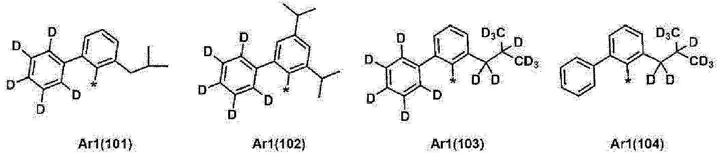
wherein, in Formulae Ar1(1) to Ar1(104),
* indicates a binding site to a neighboring atom.

7. The organometallic compound of any of claims 1-6, wherein Ar₁ has an asymmetric structure.

8. The organometallic compound of any of claims 1-7, wherein R₁ to R₄, R₁₁ to R₁₄, R₂₀, R₃₀, and R₄₀ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, or C₁-C₂₀ alkylthio group;
a C₁-C₂₀ alkyl group, a C₁-C₂₀ alkoxy group, or C₁-C₂₀ alkylthio group, each substituted with at least one of deuterium, -F, -Cl, -Br, -I, -SF₅, -CD₃, -CD₂H, -CDH₂, - CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
-N(Q₁)(Q₂), -Si(Q₃)(Q₄)(Q₅), -B(Q₆)(Q₇), -P(Q₈)(Q₉), or-P(=O)(Q₈)(Q₉), and
Q₁ to Q₉ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a see-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a see-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

9. The organometallic compound of any of claims 1-8, wherein the organometallic compound represented by Formula 1 is represented by Formula 11: 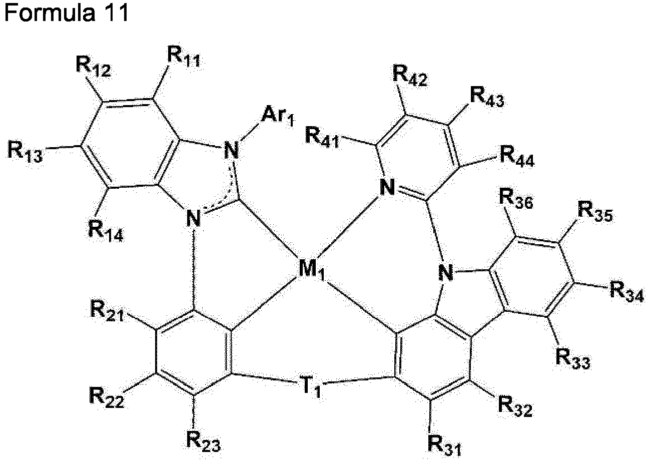 wherein, in Formula 11,
M₁, Ar₁, T₁, and R₁₁ to R₁₄ are respectively as those described in claim 1,
R₂₁ to R₂₃ are each independently as described in connection with R₂₀ in claim 1,
R₃₁ to R₃₆ are each independently as described in connection with R₃₀ in claim 1, and
R₄₁ to R₄₄ are each independently as described in connection with R₄₀ in claim 1.

10. The organometallic compound of any of claims 1-9, wherein the organometallic compound is electrically neutral.

11. The organometallic compound of any of claims 1-10, wherein the organometallic compound is one of Compounds 1 to 229:

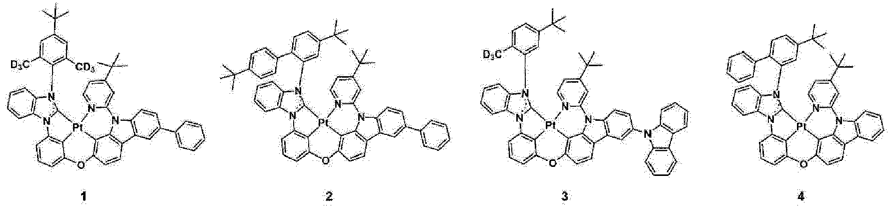

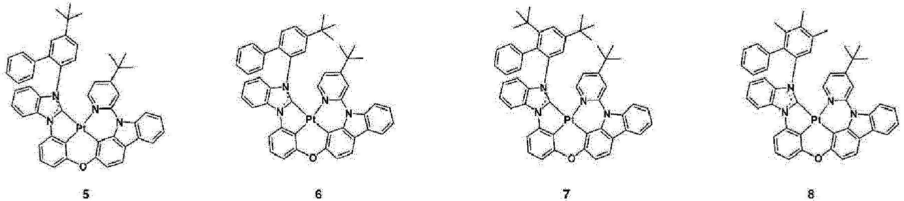

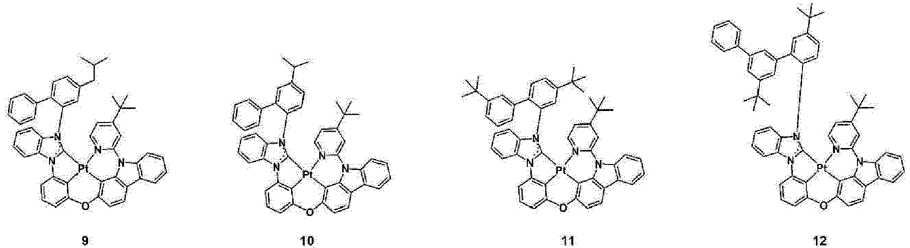

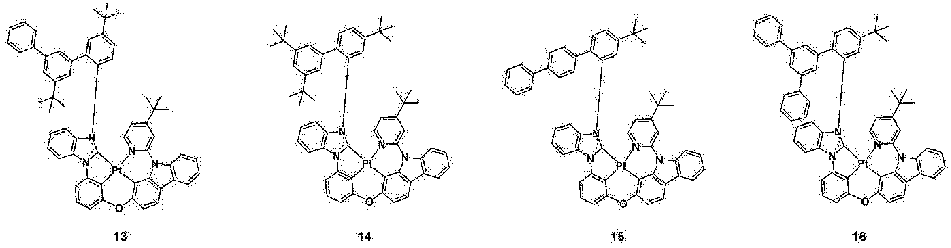

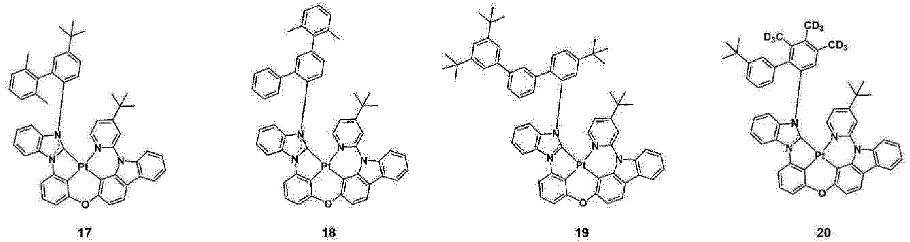

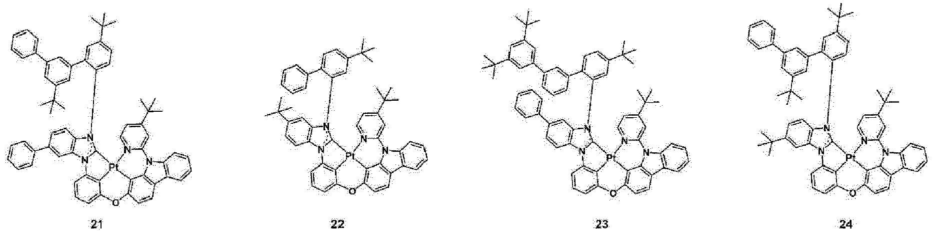

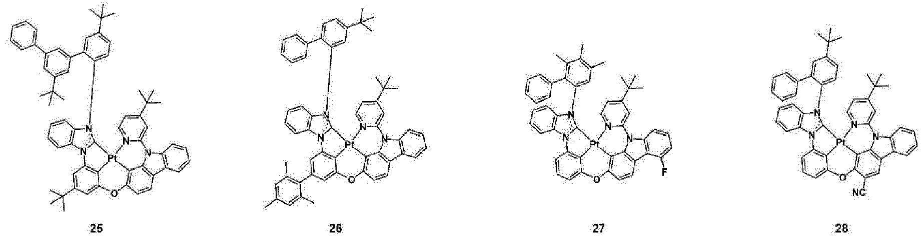

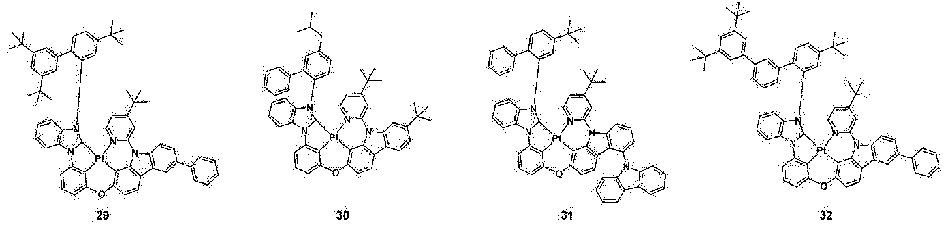

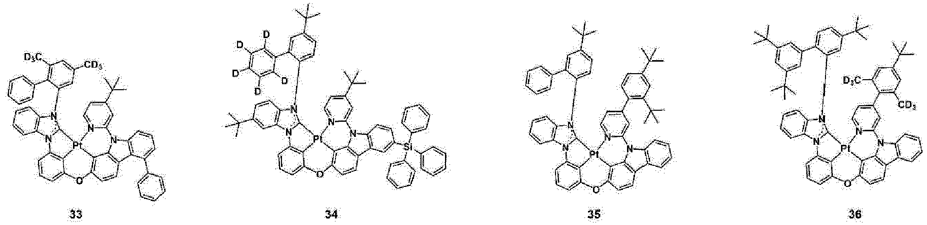

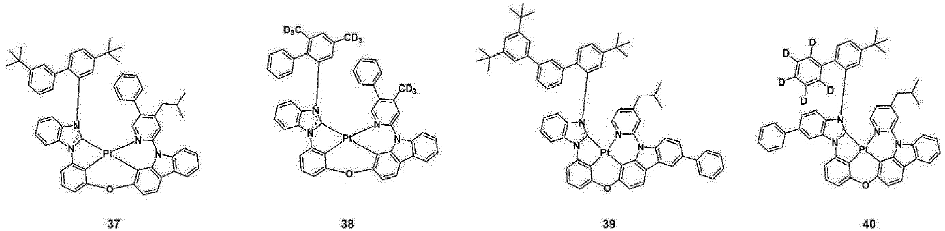

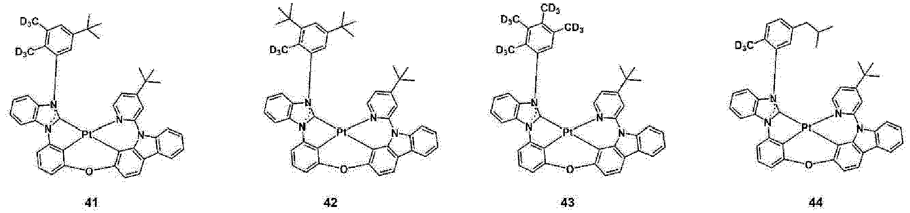

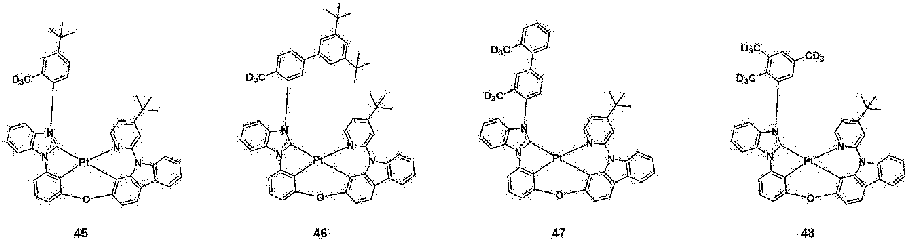

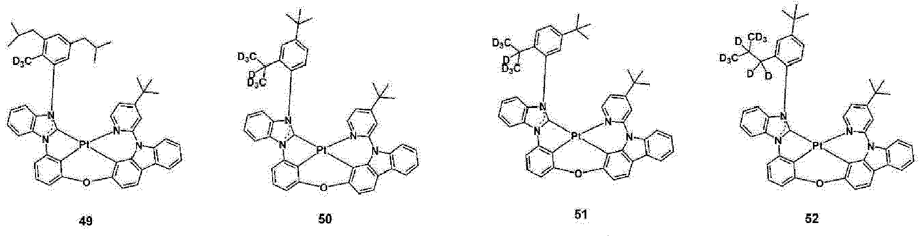

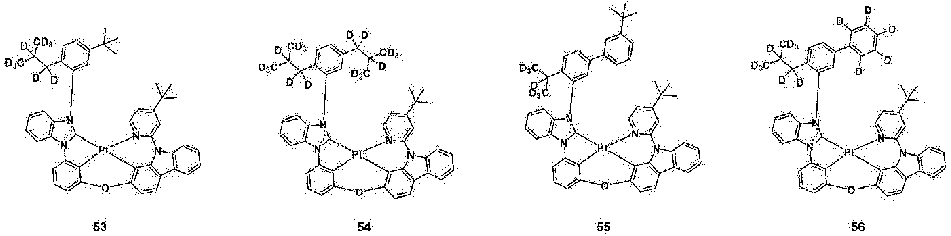

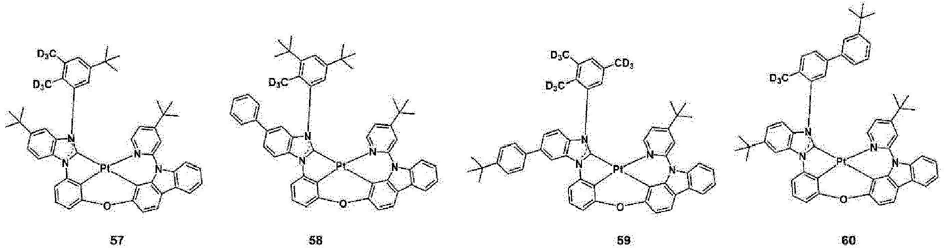

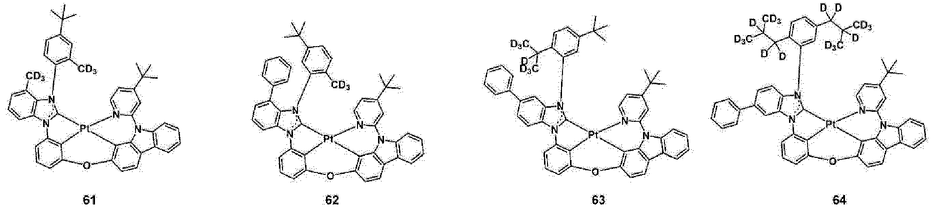

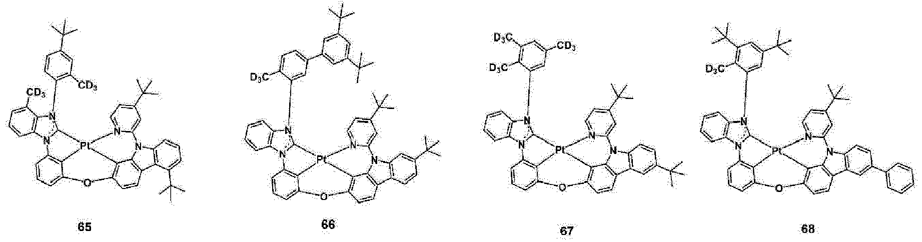

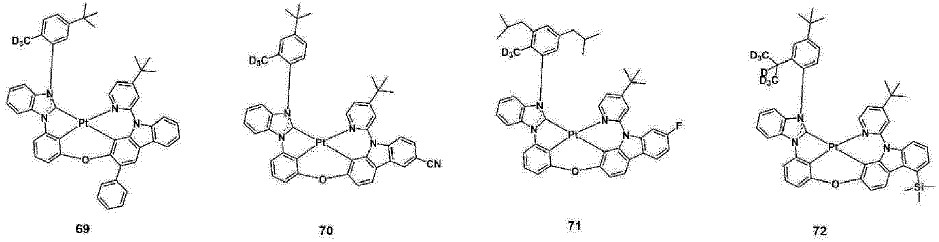

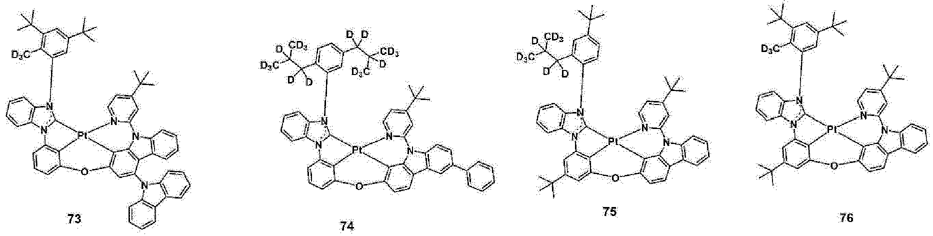

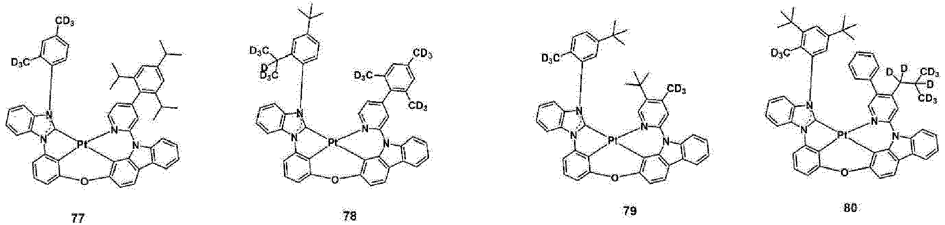

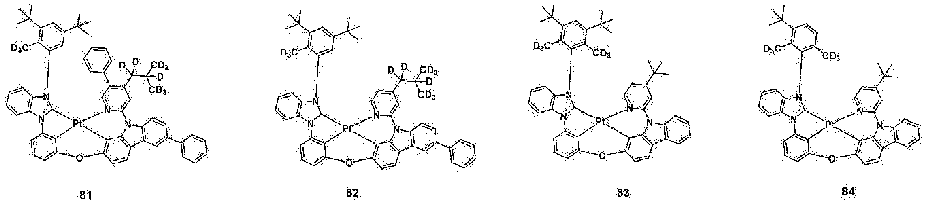

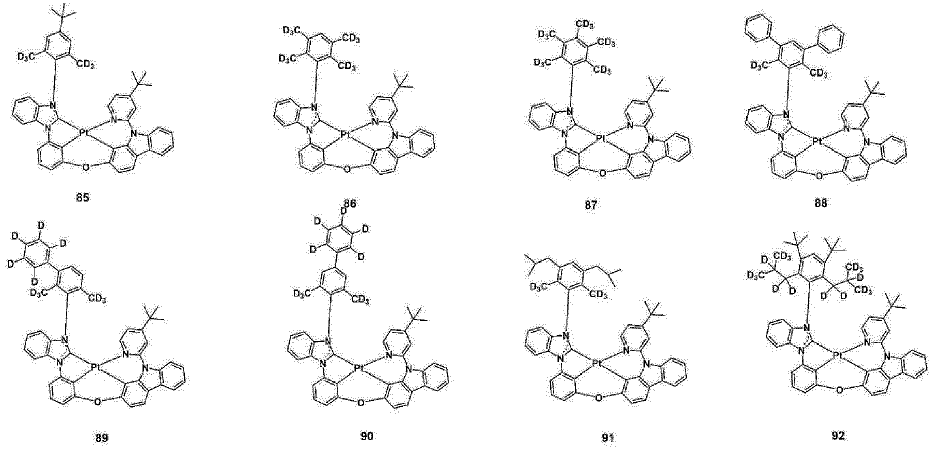

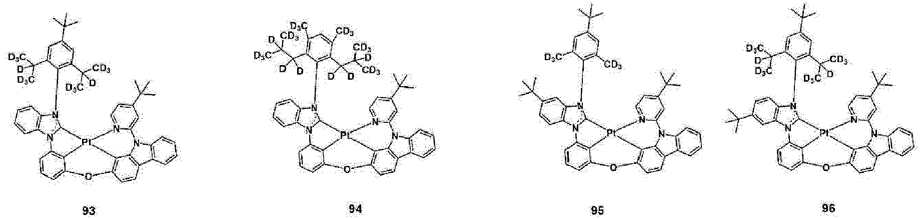

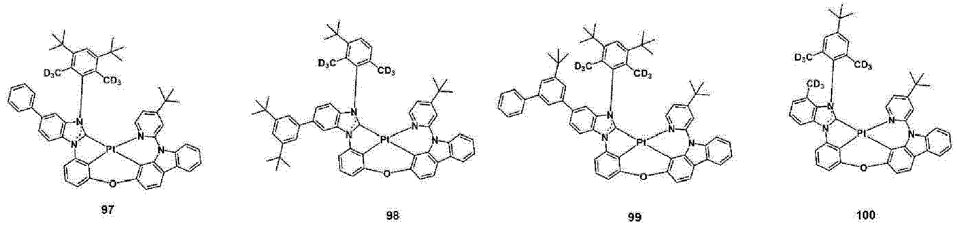

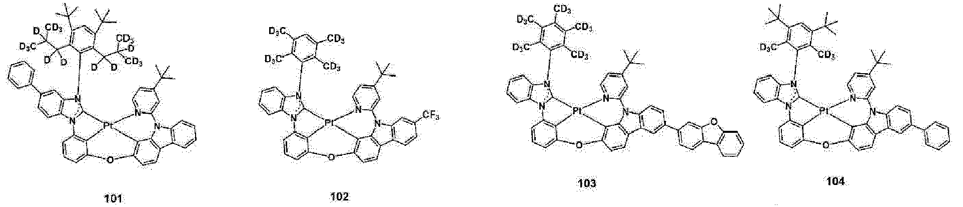

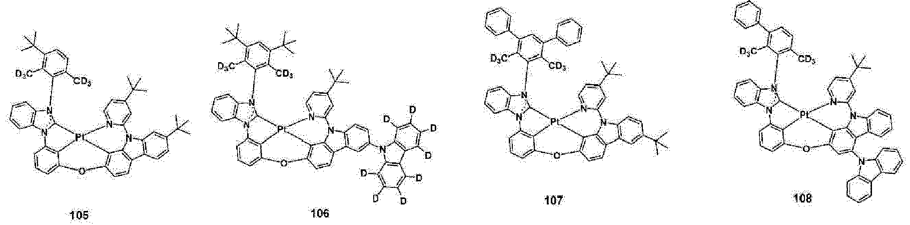

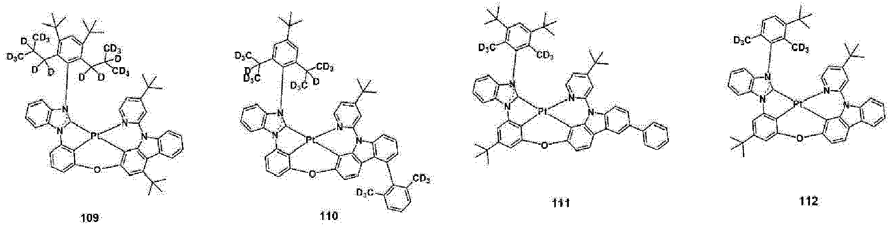

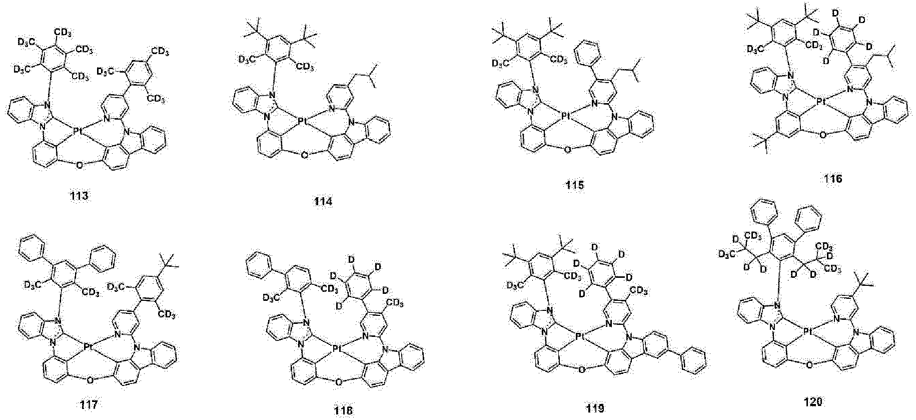

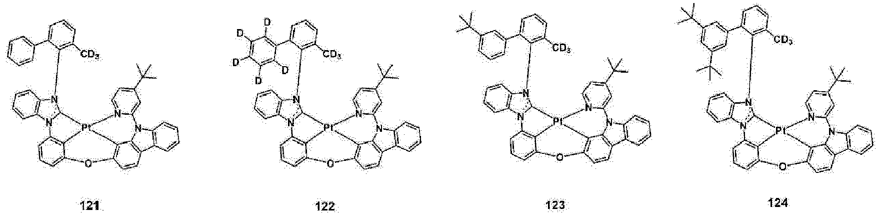

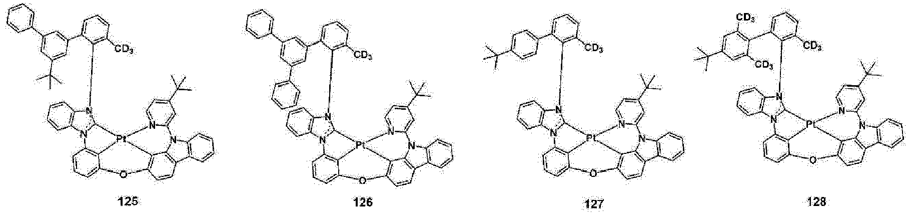

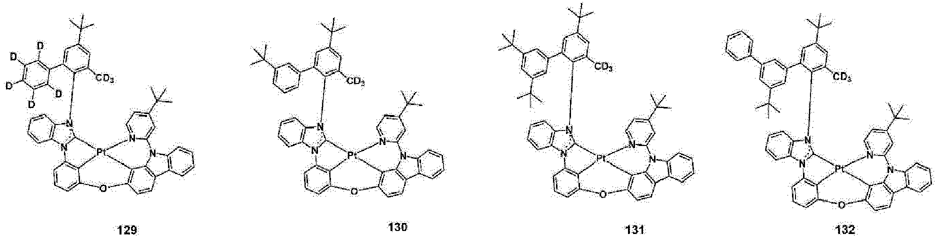

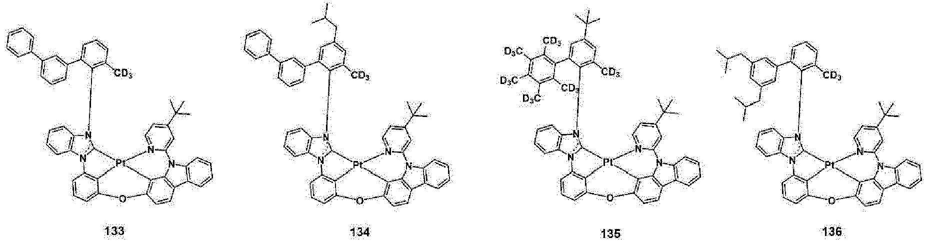

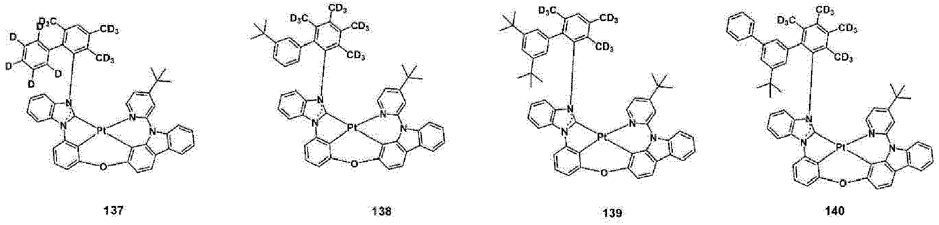

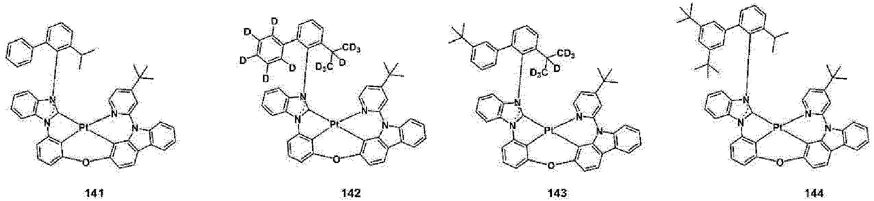

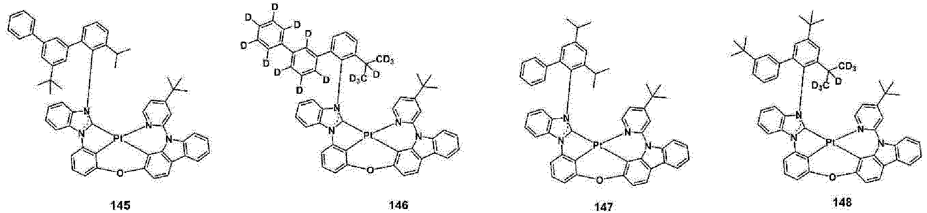

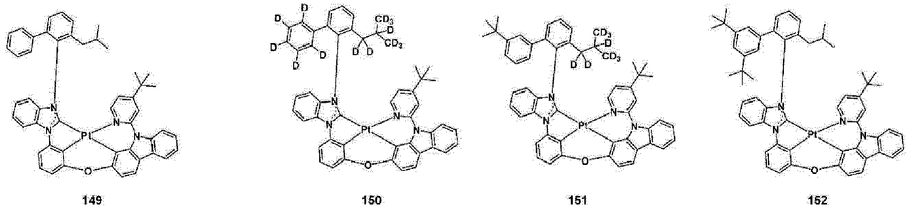

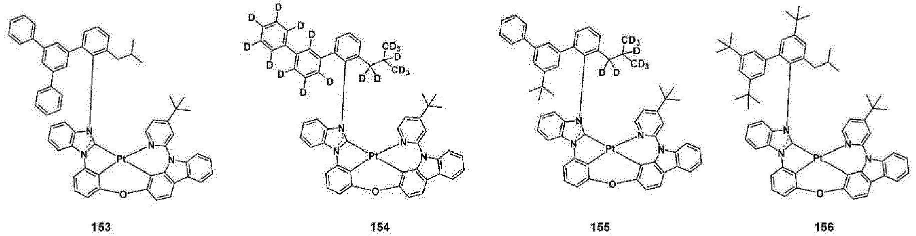

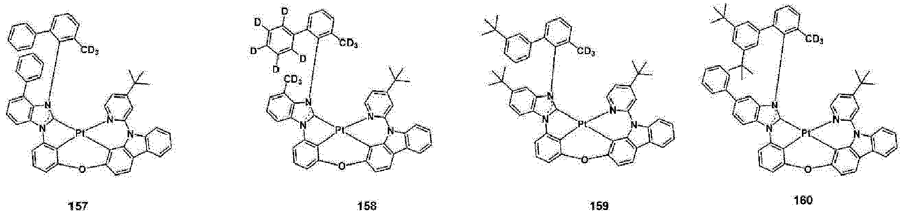

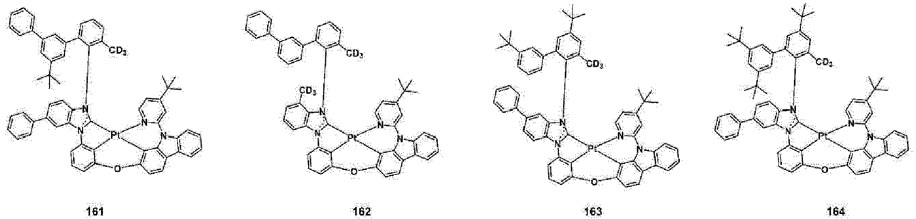

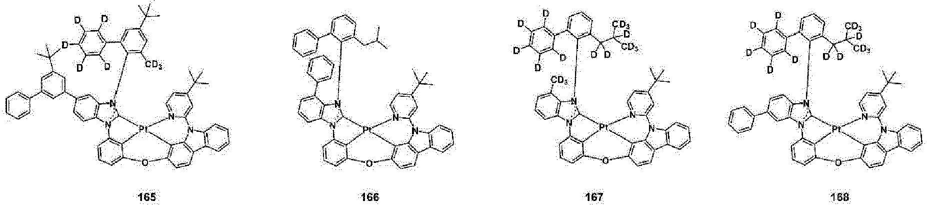

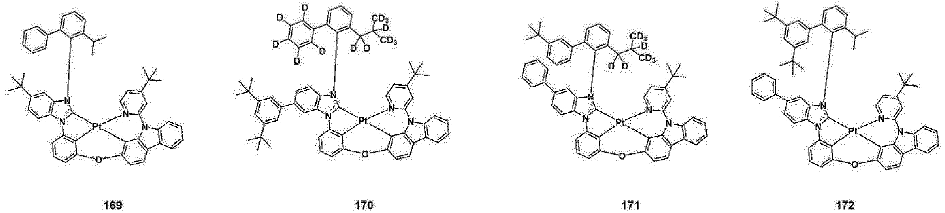

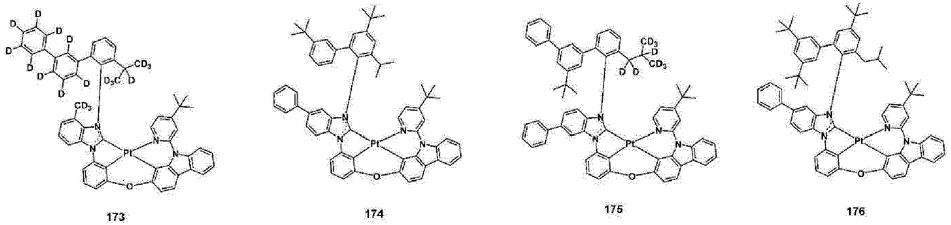

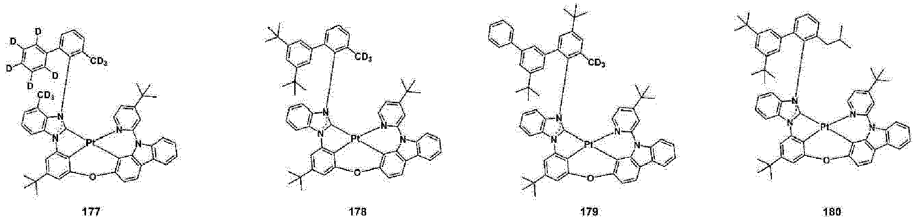

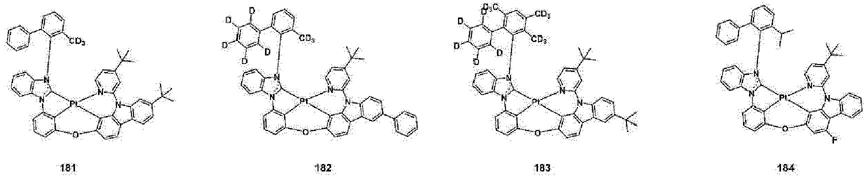

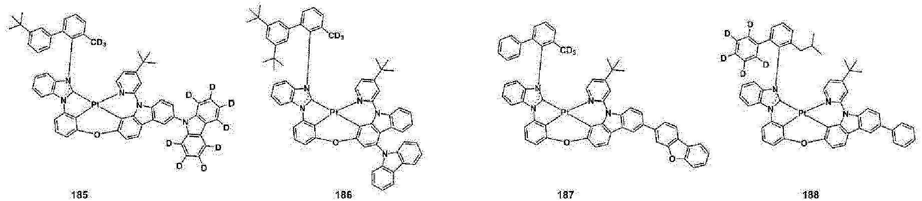

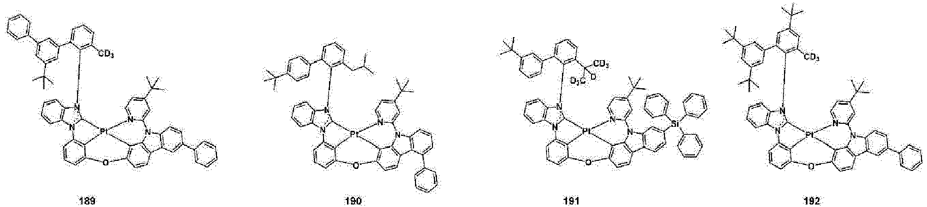

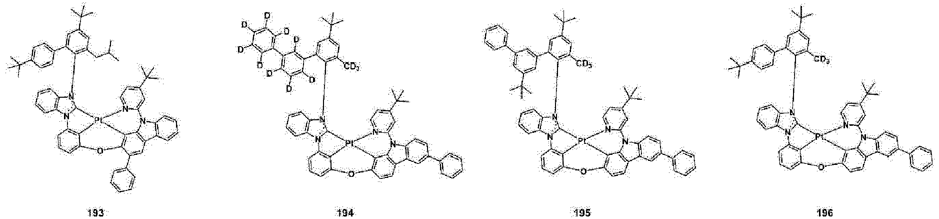

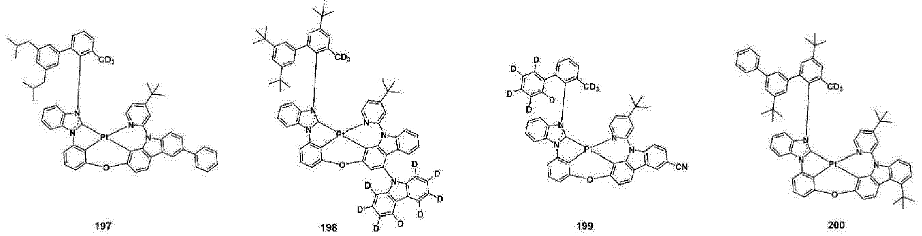

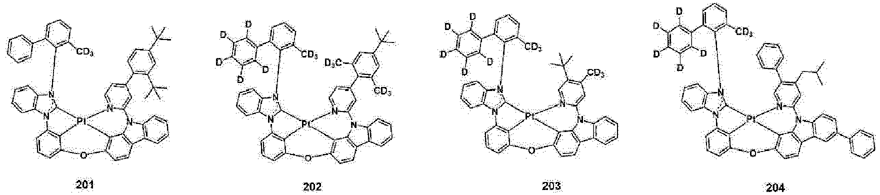

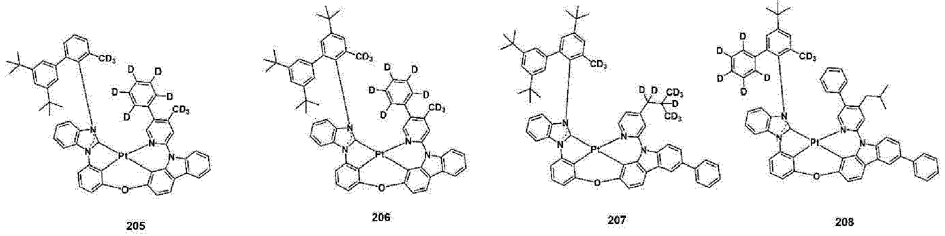

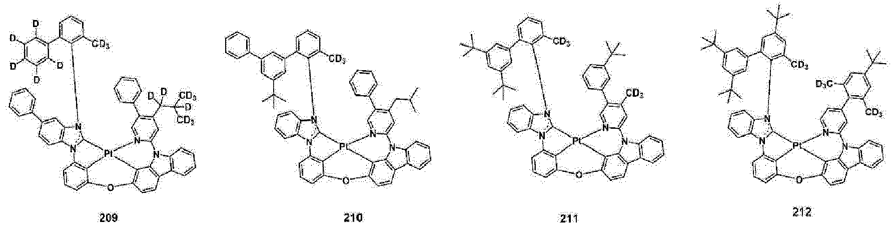

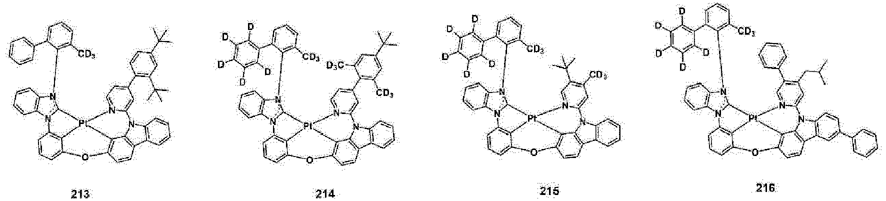

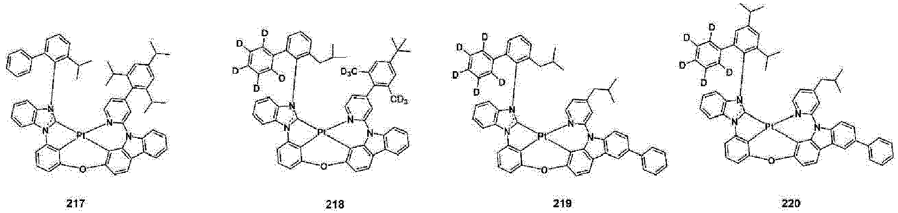

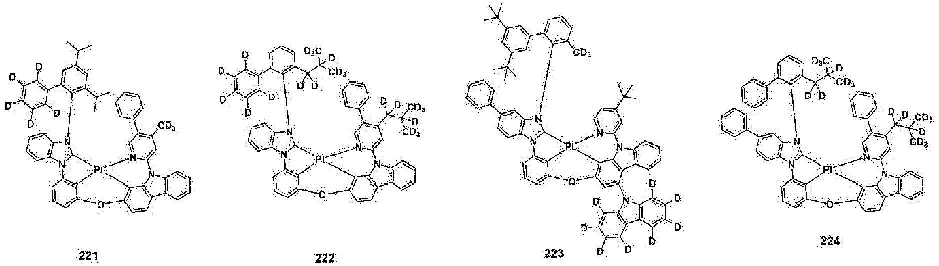

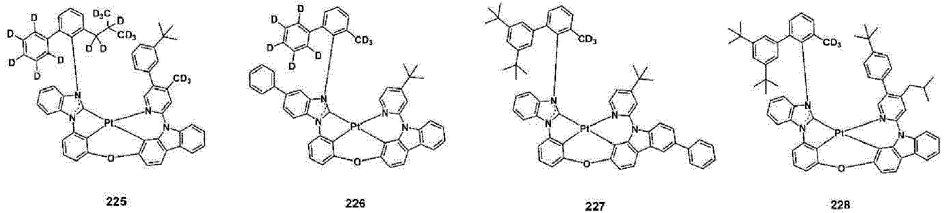

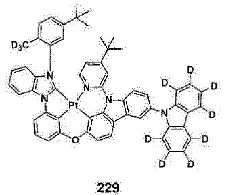

12. An organic light-emitting device comprising:
a first electrode;
a second electrode; and
an organic layer located between the first electrode and the second electrode,
wherein the organic layer comprises an emission layer, and
wherein the organic layer further comprises at least one of the organometallic compound of any of claims 1-11;
preferably wherein
the first electrode is an anode,
the second electrode is a cathode,
the organic layer further comprises a hole transport region located between the first electrode and the emission layer, and an electron transport region located between the emission layer and the second electrode,
the hole transport region comprises a hole injection layer, a hole transport layer, an electron blocking layer, or a combination thereof, and
the electron transport region comprises a hole blocking layer, an electron transport layer, an electron injection layer, or a combination thereof.

13. The organic light-emitting device of claim 12, wherein the emission layer comprises the at least one of the organometallic compound.

14. The organic light-emitting device of claim 13, wherein the emission layer emits blue light having a maximum emission wavelength of 410 nanometers to 490 nanometers; and/or
wherein the emission layer further comprises a host, wherein an amount of the host in the emission layer is greater than an amount of the organometallic compound in the emission layer; and/or
wherein a proportion of luminescent components emitted from the organometallic compound with respect to total luminescent components emitted from the emission layer is 80% or greater.

15. The organic light-emitting device of claims 13 or 14, wherein
the emission layer further comprises a fluorescent dopant,
the fluorescent dopant is different from the organometallic compound, and
a proportion of luminescent components emitted from the fluorescent dopant with respect to total luminescent components emitted from the emission layer is 80 % or more.

## Patentansprüche

1. Organometallische Verbindung dargestellt durch Formel 1:
Formel 1 M₁(L₁₁)ₙ₁₁(L₁₂)ₙ₁₂
wobei in Formel 1
M₁ ein Übergangsmetall der ersten Reihe des Periodensystems der Elemente, ein Übergangsmetall der zweiten Reihe des Periodensystems der Elemente oder ein Übergangsmetall der dritten Reihe des Periodensystems der Elemente ist,
L₁₁ ein Ligand dargestellt durch Formel 1-1 ist,
L₁₂ ein monodentater Ligand oder ein bidentater Ligand ist,
n11 1 ist,
n12 0, 1 oder 2 ist, 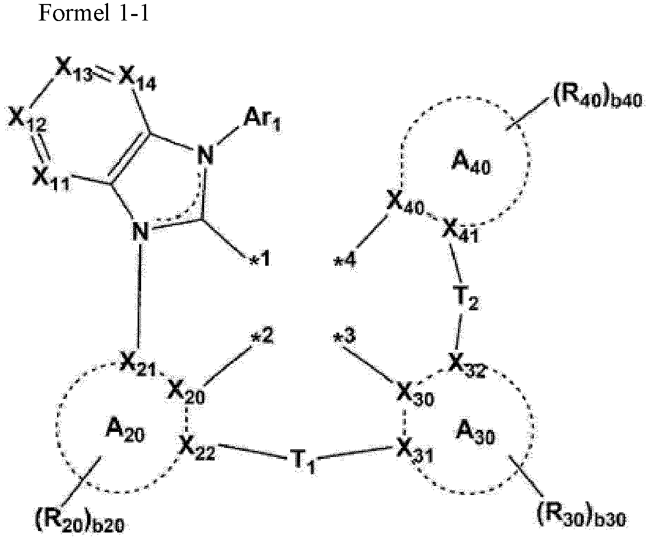
wobei in Formel 1-1
*' bis *⁴ jeweils eine Bindungsstelle zu M₁ angibt,
Ring A₂₀, Ring A₃₀ und Ring A₄₀ jeweils unabhängig eine carbocyclische C₅-C₃₀-Gruppe oder eine heterocyclische C₁-C₃₀-Gruppe sind,
T₁ eine Einfachbindung, *-N(R₁)-*', *-B(R₁)-*', *-P(R₁)-*', *-C(R₁)(R₂)-*', *-Si(R₁)(R₂)-*', *-Ge(R₁)(R₂)-*', *-S-*', *-Se-*', *-O-*', *-C(=O)-*', *-S(=O)-*', *-S(=O)₂-*', *-C(R₁)=C(R₂)-*', *-C(=S)-*' oder *-C≡C-*' ist,
T₂ eine Einfachbindung, *-N(R₃)-*', *-B(R₃)-*', *-P(R₃)-*', *-C(R₃)(R₄)-*', *-Si(R₃)(R₄)-*', *-Ge(R₃)(R₄)-*', *-S-*', *-Se-*', *-O-*', *-C(=O)-*', *-S(=O)-*', *-S(=O)₂-*', *-C(R₃)=C(R₄)-*', *-C(=S)-*' oder *-C≡C-*' ist,
X₁₁ C(R₁₁) oder N ist, X₁₂ C(R₁₂) oder N ist, X₁₃ C(R₁₃) oder N ist, und X₁₄ C(R₁₄) oder N ist,
X₂₀ C oder N ist, X₂₁ C oder N ist, und X₂₂ C oder N ist,
X₃₀ C oder N ist, X₃₁ C oder N ist, und X₃₂ C oder N ist,
X₄₀ C oder N ist, und X₄₁ C oder N ist, und
Ar₁ eine Gruppe dargestellt durch Formel 2 ist, 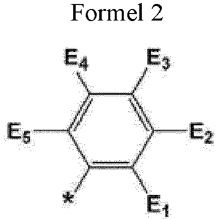
wobei in Formel 2
E₁ eine C₁-C₆₀-Alkylgruppe substituiert mit Deuterium oder eine substituierte oder unsubstituierte C₁-C₆₀-Arylgruppe ist,
E₂ bis E₅ jeweils unabhängig Wasserstoff, Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -N(Q₁)(Q₂), -Si(Q₃)(Q₄)(Q₅), - B(Q₆)(Q₇), -P(Q₈)(Q₉) oder -P(=O)(Q₈)(Q₉) sind,
zumindest eines von E₂ bis E₅ nicht Wasserstoff ist,
mit der Maßgabe, dass, wenn E₁ eine C₁-C₆₀-Alkylgruppe substituiert mit Deuterium ist und E₅ eine C₁-C₆₀-Alkylgruppe substituiert mit Deuterium ist, zumindest eines von E₂ bis E₄ nicht Wasserstoff ist,
mit der Maßgabe, dass, wenn E₁ eine substituierte oder unsubstituierte C₁-C₆₀-Arylgruppe ist, Ar₁ eine asymmetrische Struktur aufweist,
* und *' jeweils eine Bindungsstelle zu einem benachbarten Atom angeben,
R₁ bis R₄, R₁₁ bis R₁₄, R₂₀, R₃₀ und R₄₀ jeweils unabhängig Wasserstoff, Deuterium, -F, - Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -N(Q₁)(Q₂), -Si(Q₃)(Q₄)(Q₅), - B(Q₆)(Q₇), -P(Q₈)(Q₉) oder-P(=O)(Q₈)(Q₉) sind,
benachbarte zwei oder mehr von R₁ bis R₄, R₁₁ bis R₁₄, R₂₀, R₃₀ oder R₄₀ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr von R₂₀ in der Anzahl an b20 optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr von R₃₀ in der Anzahl an b30 optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr von R₄₀ in der Anzahl an b40 optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
b20, b30 und b40 jeweils unabhängig 1, 2, 3, 4, 5, 6, 7, 8, 9 oder 10 sind,
wenn b20 2 oder größer ist, zwei oder mehr von R₂₀ identisch oder verschieden voneinander sind, wenn b30 2 oder größer ist, zwei oder mehr von R₃₀ identisch oder verschieden voneinander sind, und wenn b40 2 oder mehr ist, zwei oder mehr von R₄₀ identisch oder verschieden voneinander sind,
zumindest ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten C₁-C₆₀-Heteroaryloxygruppe, der substituierten C₁-C₆₀-Heteroarylthiogruppe, der substituierten einwertigen nichtaromatischen kondensierten polycyclischen Gruppe und der substituierten einwertigen nichtaromatischen kondensierten heteropolycyclischen Gruppe wie folgt ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, ein C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe,
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, - N(Q₁₁)(Q₁₂), -Si(Q₁₃)(Q₁₄)(Q₁₅), -B(Q₁₆)(Q₁₇), -P(Q₁₈)(Q₁₉) oder-P(=O)(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, -N(Q₂₁)(Q₂₂), -Si(Q₂₃)(Q₂₄)(Q₂₅), -B(Q₂₆)(Q₂₇), - P(Q₂₈)(Q₂₉) oder-P(=O)(Q₂₈)(Q₂₉) oder einer Kombination davon; oder
-N(Q₃₁)(Q₃₂), -Si(Q₃₃)(Q₃₄)(Q₃₅), -B(Q₃₆)(Q₃₇), -P(Q₃₈)(Q₃₉) oder -P(=O)(Q₃₈)(Q₃₉), und
Q₁ bis Q₉, Q₁₁ bis Q₁₉, Q₂₁ bis Q₂₉ und Q₃₁ to Q₃₉ jeweils unabhängig Wasserstoff, Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe oder eine substituierte oder unsubstituierte einwertige nichtaromatische kondensierte heteropolycyclische Gruppe sind.

2. Organometallische Verbindung nach Anspruch 1, wobei M₁ Beryllium (Be), Magnesium (Mg), Aluminium (Al), Calcium (Ca), Titan (Ti), Mangan (Mn), Kobalt (Co), Kupfer (Cu), Zink (Zn), Gallium (Ga), Germanium (Ge), Zirkonium (Zr), Ruthenium (Ru), Rhodium (Rh), Palladium (Pd), Silber (Ag), Rhenium (Re), Platin (Pt) oder Gold (Au) ist.

3. Organometallische Verbindung nach Anspruch 1 oder 2, wobei Ring A₂₀ und Ring A₃₀ jeweils unabhängig eine Phenylgruppe, eine Naphthalengruppe, eine Anthracengruppe, eine Phenanthrengruppe, eine Triphenylengruppe, eine Pyrengruppe, eine Chrysengruppe, eine Cyclopentadiengruppe, eine 1,2,3,4-Tetrahydronaphthalengruppe, eine Furangruppe, eine Thiophengruppe, eine Silolgruppe, eine Indengruppe, eine Fluorengruppe, eine Indolgruppe, eine Carbazolgruppe, eine Benzofurangruppe, eine Dibenzofurangruppe, eine Benzothiophengruppe, eine Dibenzothiophengruppe, eine Benzosilolgruppe, eine Dibenzosilolgruppe, eine Azafluorengruppe, eine Azacarbazolgruppe, eine Azadibenzofurangruppe, eine Azadibenzothiophengruppe, eine Azadibenzosilolgruppe, eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrolgruppe, eine Pyrazolgruppe, eine Imidazolgruppe, eine Triazolgruppe, eine Tetrazolgruppe, eine Oxazolgruppe, eine Isoxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Indazolgruppe, eine Benzoxazolgruppe, eine Benzothiazolgruppe, eine Benzoxadiazolgruppe, eine Benzothiadiazolgruppe, eine Benzotriazolgruppe, eine Diazaindengruppe, eine Triazaindengruppe, eine 5,6,7,8-Tetrahydroisochinolingruppe oder eine 5,6,7,8-Tetrahydrochinolingruppe sind, und
A₄₀ eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrrolgruppe, eine Azafluorengruppe, eine Azacarbazolgruppe, eine Azadibenzofurangruppe, eine Azadibenzothiophengruppe, eine Azadibenzosilolgruppe, eine 5,6,7,8-Tetrahydroisochinolingruppe oder eine 5,6,7,8-Tetrahydrochinolingruppe ist.

4. Organometallische Verbindung nach einem der Ansprüche 1-3, wobei Ring A₂₀ eine Gruppe dargestellt durch eine von Formel A20-1 bis A20-13 ist: 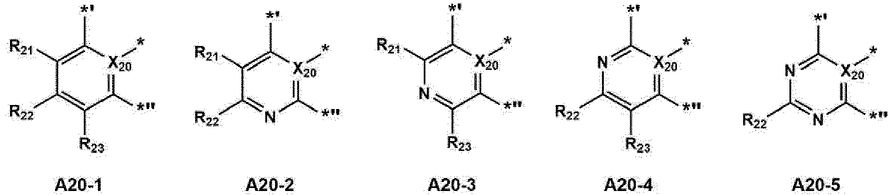 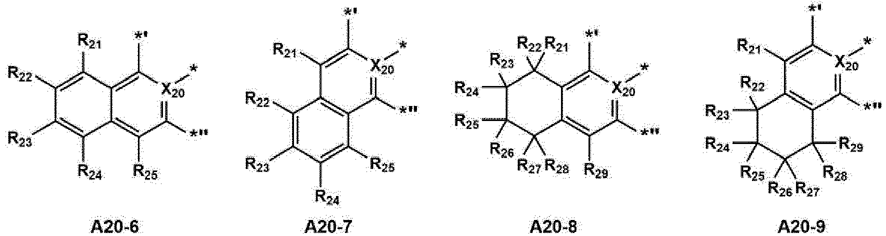 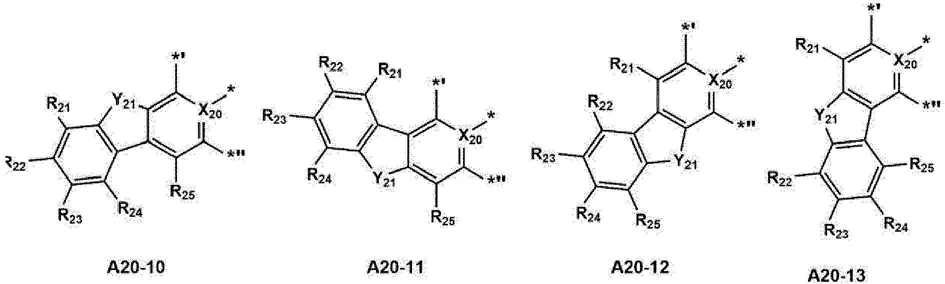 wobei in Formel A20-1 bis A20-13,
X₂₀ wie in Anspruch 1 beschrieben ist,
Y₂₁ eine Einfachbindung, O, S, N(R₂₆), C(R₂₆)(R₂₇) oder Si(R₂₆)(R₂₇) ist,
R₂₁ bis R₂₉ jeweils unabhängig wie in Anbindung mit R₂₀ in Anspruch 1 beschrieben sind,
* eine Bindungsstelle zu M₁ angibt, und
*' und *" jeweils eine Bindungsstelle zu einem benachbarten Atom angeben; und/oder
wobei A₃₀ eine Gruppe dargestellt durch eine von Formel A30-1 bis A30-12 ist: 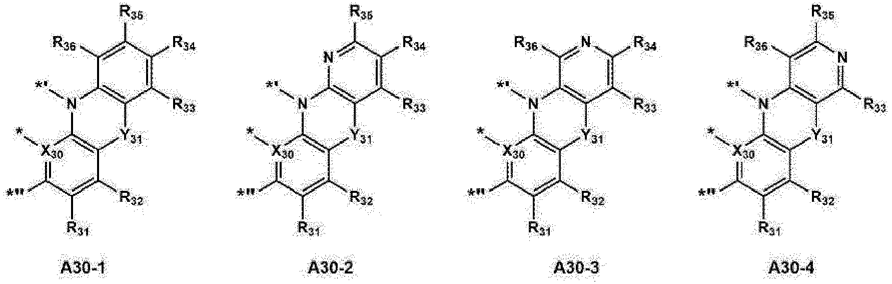 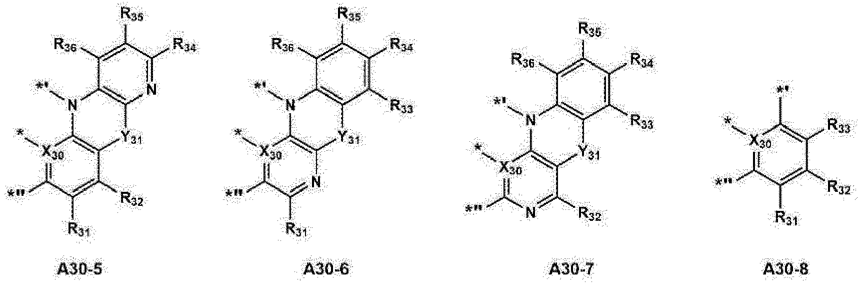 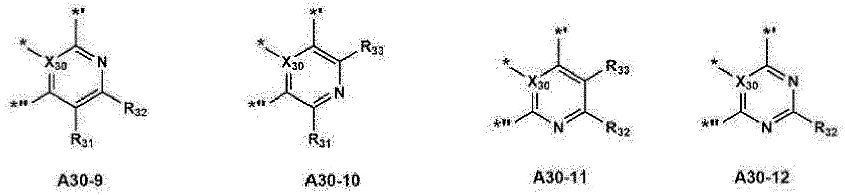
wobei in Formel A30-1 bis A30-12,
X₃₀ wie in Anspruch 1 beschrieben ist,
Y₃₁ eine Einfachbindung, O, S, N(R₃₇), C(R₃₇)(R₃₈) oder Si(R₃₇)(R₃₈) ist,
R₃₁ bis R₃₈ jeweils unabhängig wie in Anbindung mit R₃₀ in Anspruch 1 beschrieben sind,
* eine Bindungsstelle zu M₁ angibt, und
*' und *" jeweils eine Bindungsstelle zu einem benachbarten Atom angeben.

5. Organometallische Verbindung nach einem der Ansprüche 1-4, wobei A₄₀ eine Gruppe dargestellt durch eine von Formel A40-1 bis A40-16 ist: 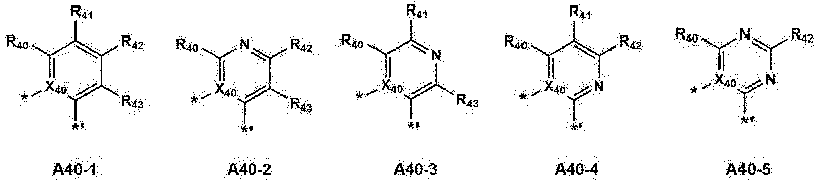 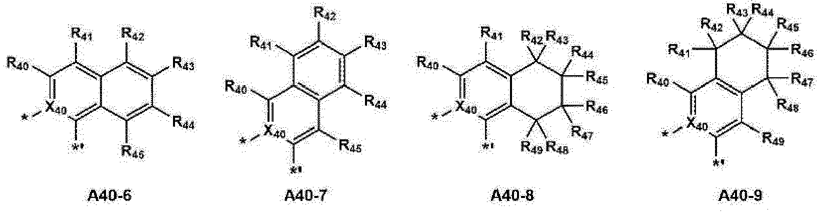 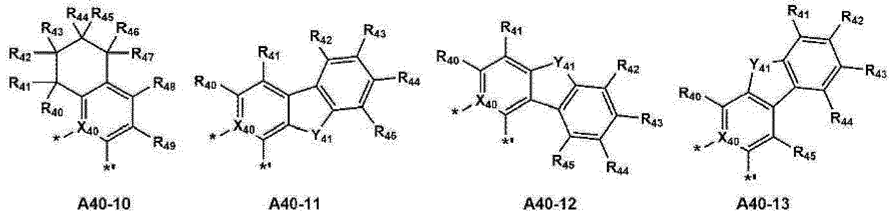 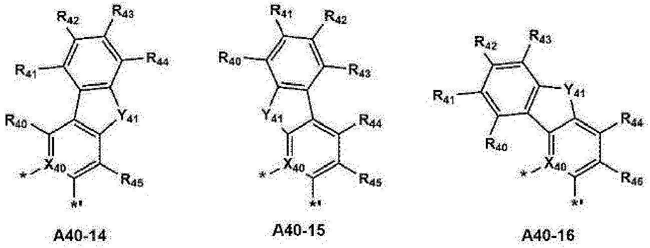 wobei in Formel A40-1 bis A40-16,
X₄₀ und R₄₀ jeweils wie in Anspruch 1 beschrieben sind,
Y₄₁ eine Einfachbindung, O, S, N(R₄₆), C(R₄₆)(R₄₇) oder Si(R₄₆)(R₄₇) ist,
R_{41 bis} R₄₉ jeweils unabhängig wie in Anbindung mit R₄₀ in Anspruch 1 beschrieben sind,
* eine Bindungsstelle zu M₁ angibt, und
*' eine Bindungsstelle zu einem benachbarten Atom angibt.

6. Organometallische Verbindung nach einem der Ansprüche 1-5, wobei An eine Gruppe dargestellt durch eine von Formel Ar1-1 bis Ar1-14 ist: 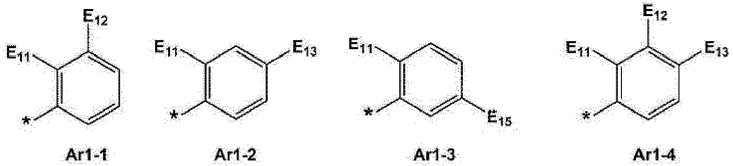 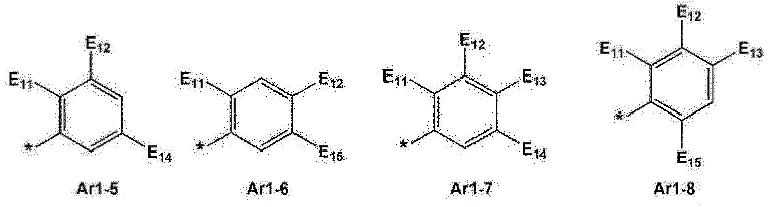 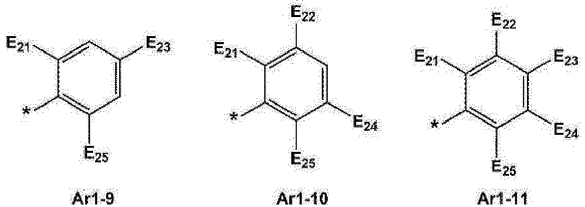 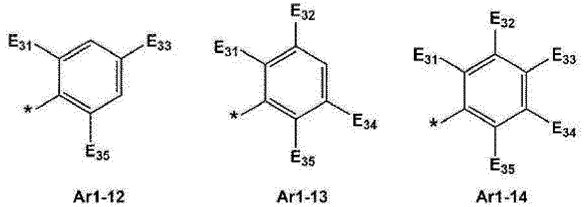 wobei in Formel Ar1-1 bis Ar1-14,
E₁₁ eine C₁-C₆₀-Alkylgruppe substituiert mit Deuterium oder eine substituierte oder unsubstituierte C₁-C₆₀-Arylgruppe ist,
E₂₁ eine C₁-C₆₀-Alkylgruppe substituiert mit Deuterium oder eine substituierte oder unsubstituierte C₁-C₆₀-Arylgruppe ist,
E₂₁ und E₂₅ unterschiedlich voneinander sind,
E₃₁ und E₃₅ jeweils unabhängig eine C₁-C₆₀-Alkylgruppe substituiert mit Deuterium sind,
E₁₂ bis E₁₅, E₂₂ bis E₂₅ und E₃₂ bis E₃₄ jeweils unabhängig Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -N(Q₁)(Q₂), -Si(Q₃)(Q₄)(Q₅), - B(Q₆)(Q₇), -P(Q₈)(Q₉) oder -P(=O)(Q₈)(Q₉) sind, und
* eine Bindungsstelle zu einem benachbarten Atom angibt; oder
wobei Ar₁ eine Gruppe dargestellt durch eine von Formel Ar1(1) bis Ar1(104) ist: 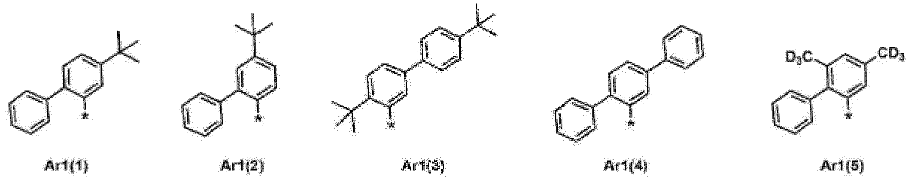 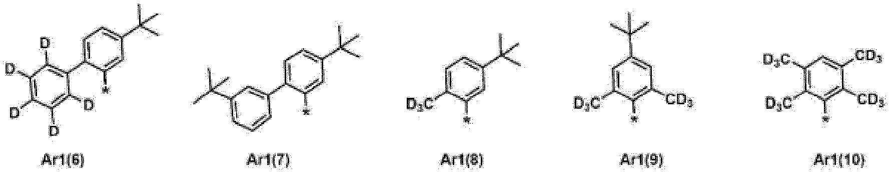 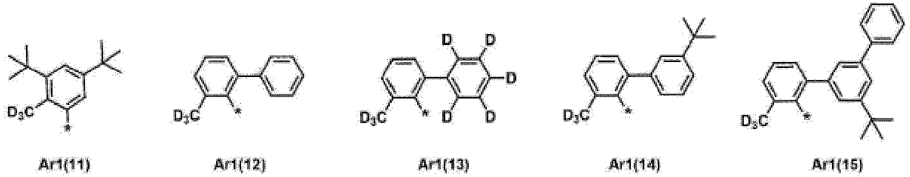 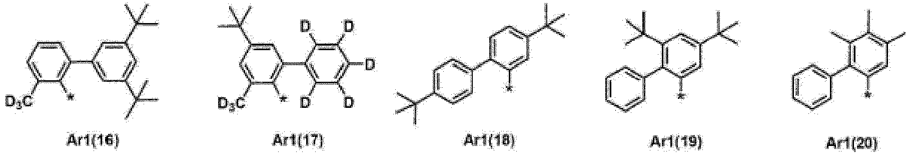 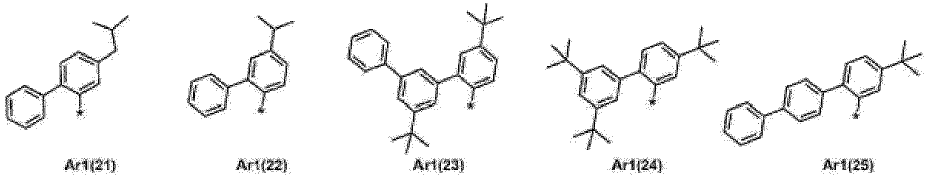 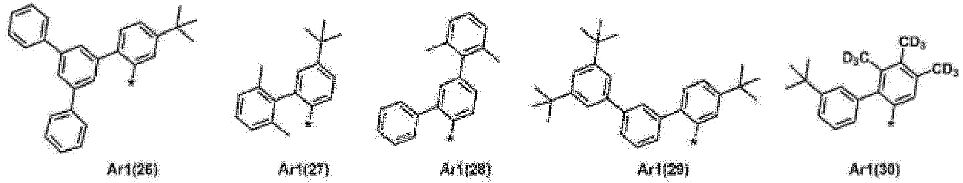 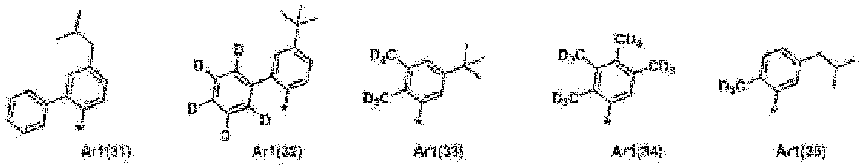 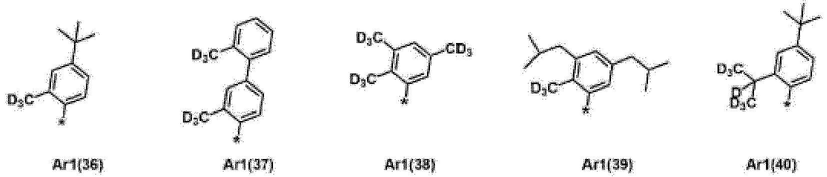 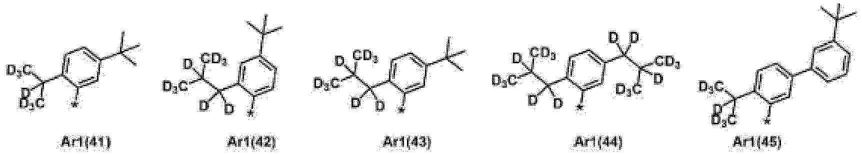 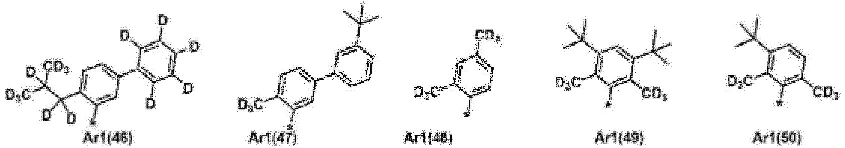 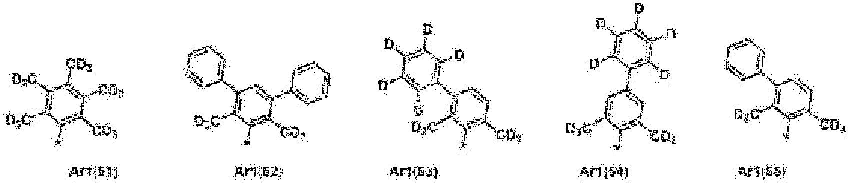 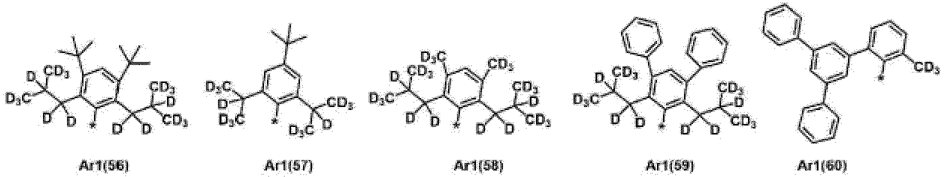 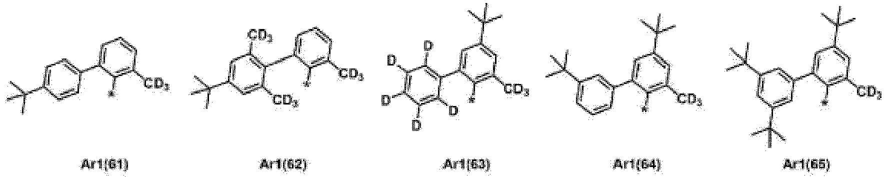 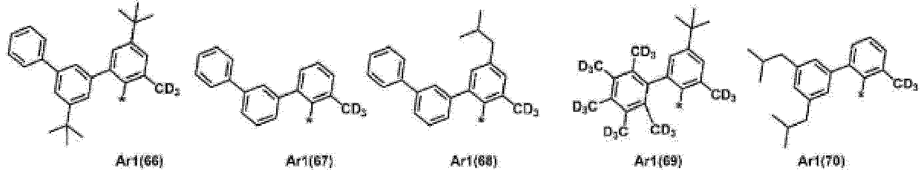 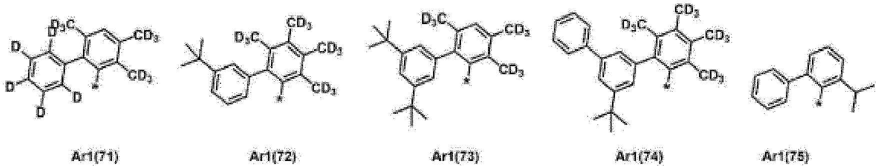 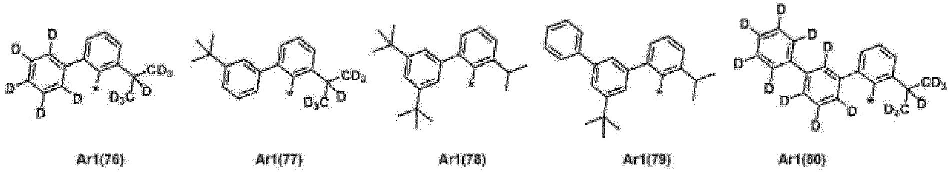 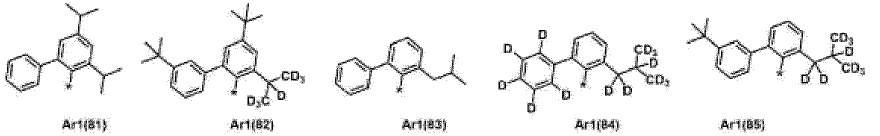 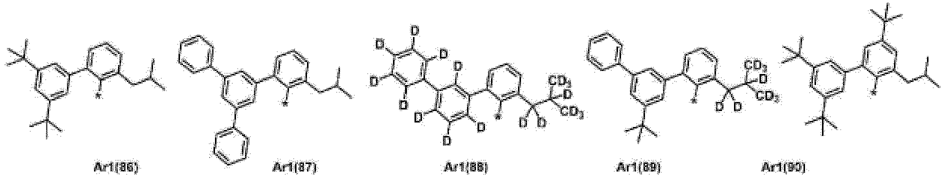 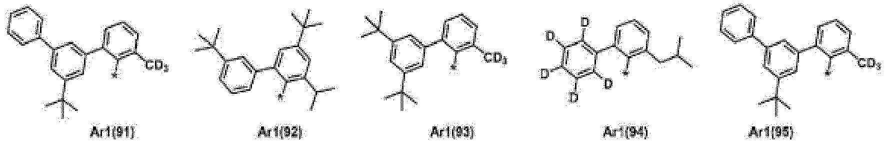 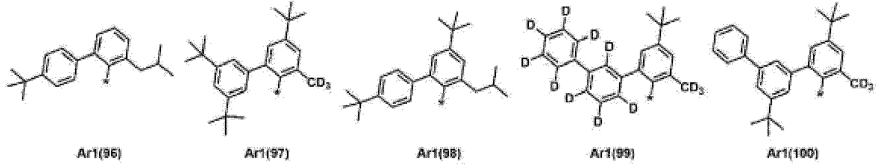 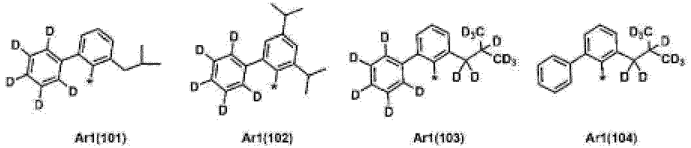
wobei in Formel Ar1(1) bis Ar1(104),
* eine Bindungsstelle zu einem benachbarten Atom angibt.

7. Organometallische Verbindung nach einem der Ansprüche 1-6, wobei Ar₁ eine asymmetrische Struktur aufweist.

8. Organometallische Verbindung nach einem der Ansprüche 1-7, wobei R₁ bis R₄, R₁₁ bis R₁₄, R₂₀, R₃₀ und R₄₀ jeweils unabhängig wie folgt sind:
Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, -SF₅, eine C₁-C₂₀-Alkylgruppe, eine C₁-C₂₀-Alkoxygruppe oder C₁-C₂₀-Alkylthiogruppe,
eine C₁-C₂₀-Alkylgruppe, eine C₁-C₂₀-Alkoxygruppe oder C₁-C₂₀-Alkylthiogruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantanylgruppe, einer Norbomanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe oder einer Kombination davon;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe oder eine Imidazopyrimidinylgruppe;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Auorenylgruppe, eine Phenanthrenylgruppe, eine Anthracenylgruppe, eine Auoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, ein Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe oder eine Imidazopyrimidinylgruppe, jeweils substituiert mit zumindest einem von Deuterium, -F, -Cl, -Br, -I, -SF₅, -CD₃, -CD₂H, - CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, C₁-C₂₀-Alkylthiogruppe, einer Cyclopentylgruppe, einer Cyclohexylgruppe, einer Cycloheptylgruppe, einer Cyclooctylgruppe, einer Adamantanylgruppe, einer Norbomanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyyrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe, einer Imidazopyrimidinylgruppe oder einer Kombination davon; oder
-N(Q₁)(Q₂), -Si(Q₃)(Q₄)(Q₅), -B(Q₆)(Q₇), -P(Q₈)(Q₉) oder-P(=O)(Q₈)(Q₉), und
Q₁ bis Q₉ jeweils unabhängig wie folgt sind:
-CH₃, -CD₃, -CD₂H, -CDH₂, -CH₂CH₃, -CH₂CD₃, -CH₂CD₂H, -CH₂CDH₂, -CHDCH₃,-CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit zumindest einem von Deuterium, einer C₁-C₁₀-Alkylgruppe, einer Phenylgruppe oder einer Kombination davon.

9. Organometallische Verbindung nach einem der Ansprüche 1-8, wobei die organometallische Verbindung dargestellt durch Formel 1 dargestellt ist durch Formel 11: 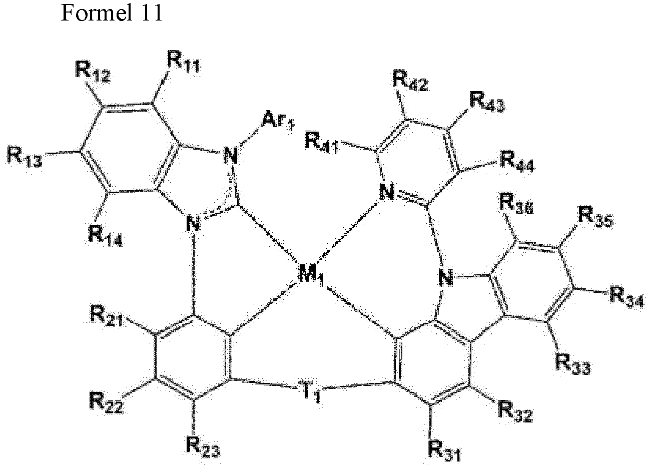 wobei in Formel 11
M₁, Ar₁, T₁ und R₁₁ bis R₁₄ jeweils wie diejenigen beschrieben in Anspruch 1 sind,
R₂₁ bis R₂₃ jeweils unabhängig wie beschrieben in Anbindung mit R₂₀ in Anspruch 1 sind,
R₃₁ bis R₃₆ jeweils unabhängig wie beschrieben in Anbindung mit R₃₀ in Anspruch 1 sind, und
R₄₁ bis R₄₄ jeweils unabhängig wie beschrieben in Anbindung mit R₄₀ in Anspruch 1 sind.

10. Organometallische Verbindung nach einem der Ansprüche 1-9, wobei die organometallische Verbindung elektrisch neutral ist.

11. Organometallische Verbindung nach einem der Ansprüche 1-10, wobei die organometallische Verbindung eine der Verbindungen 1 bis 229 ist:

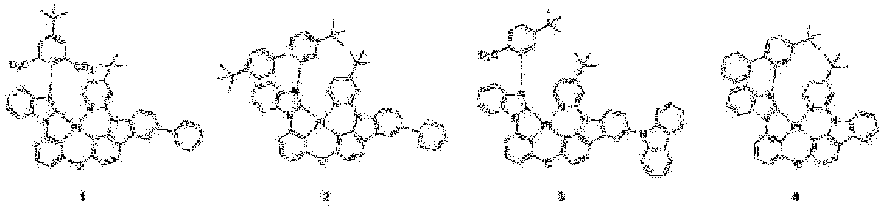

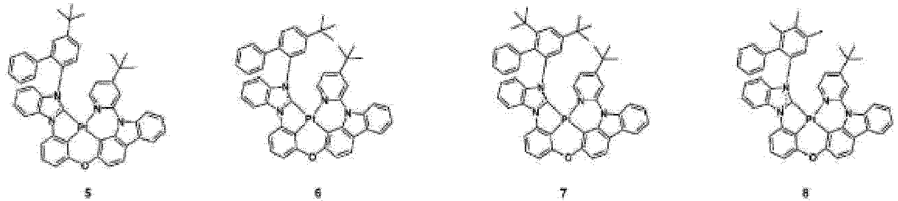

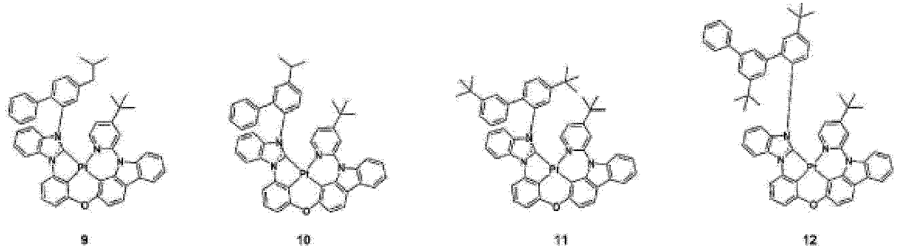

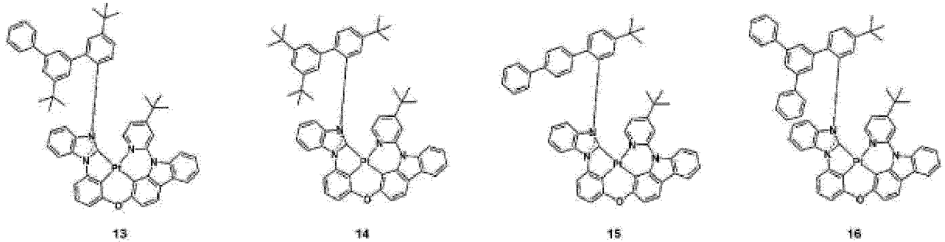

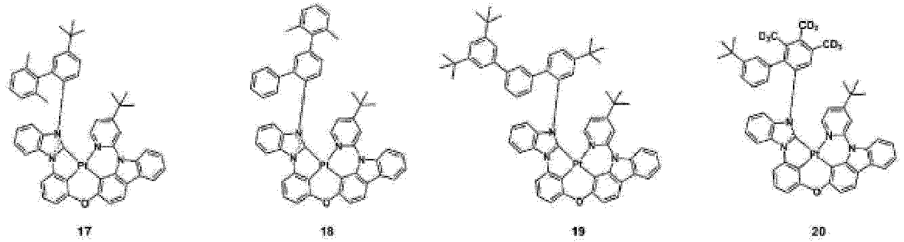

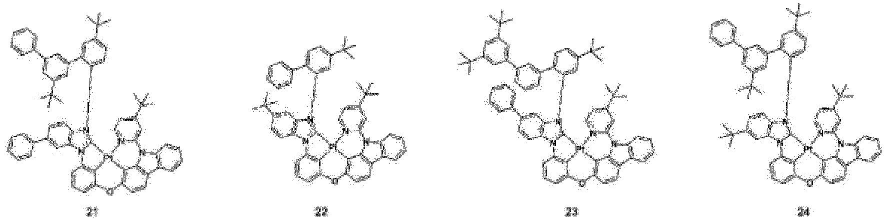

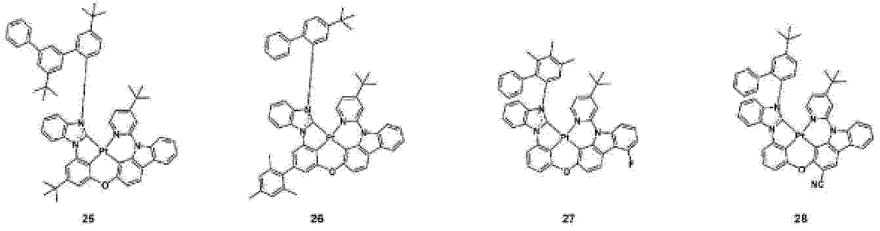

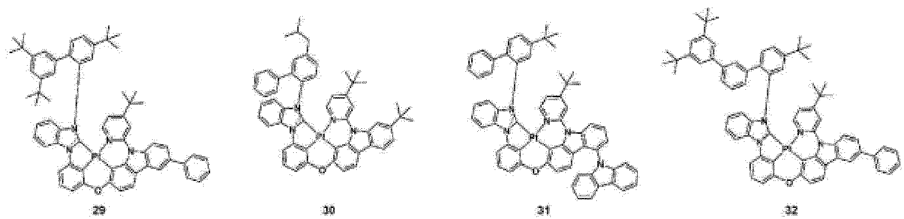

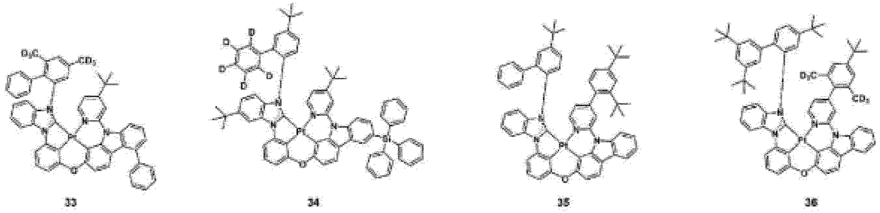

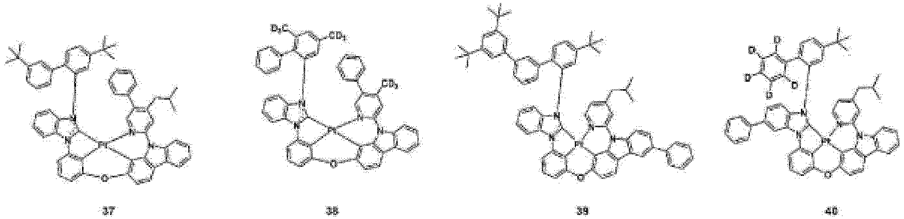

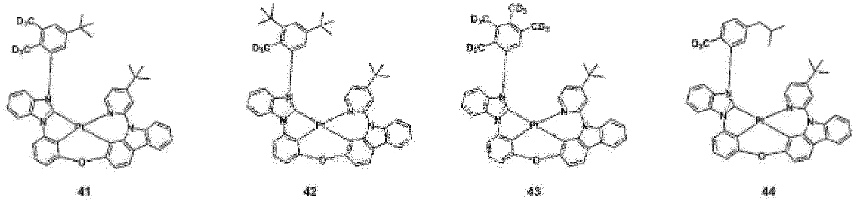

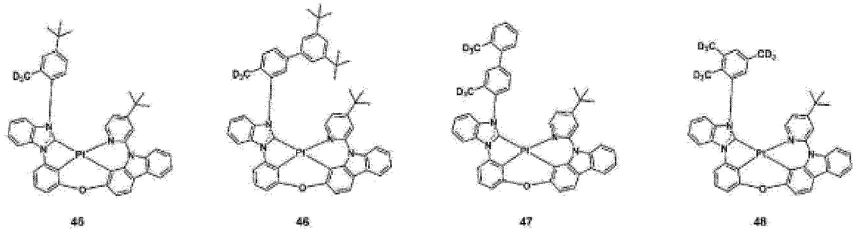

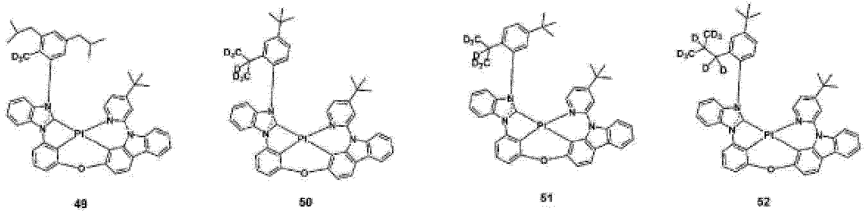

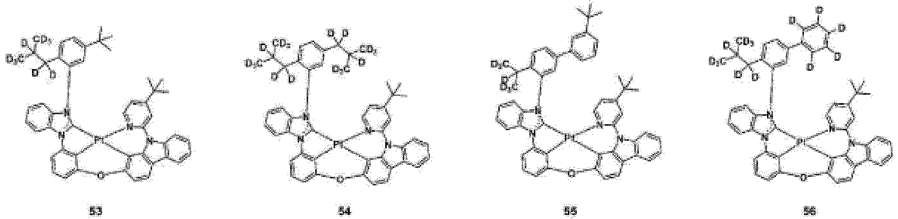

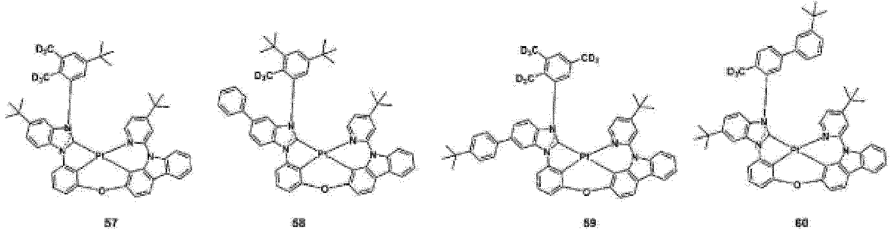

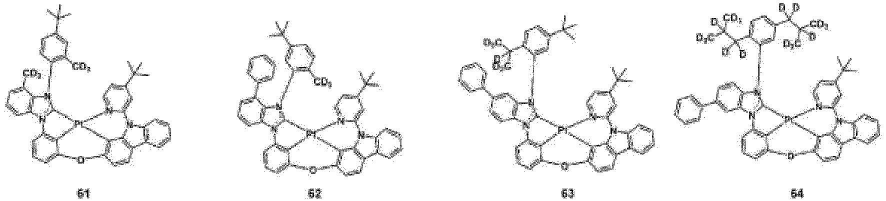

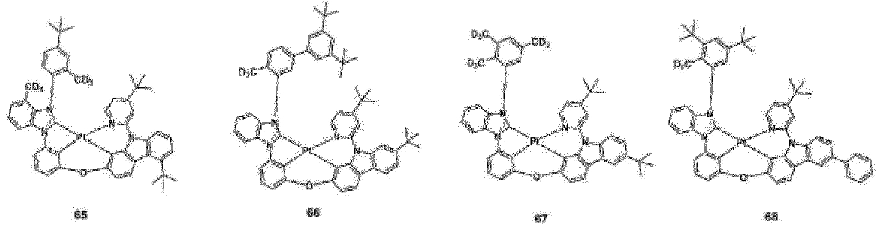

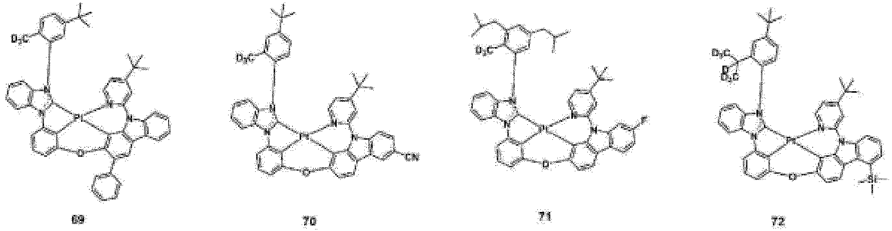

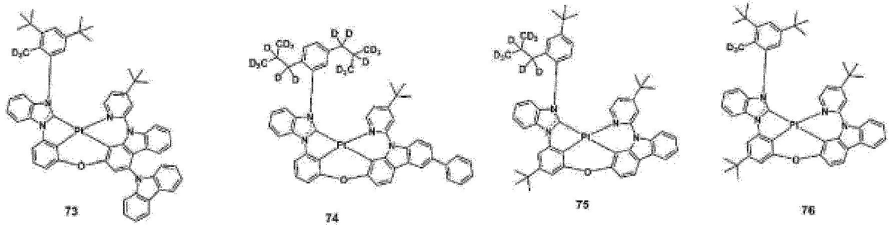

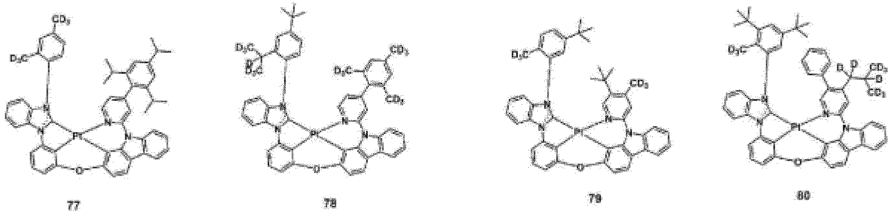

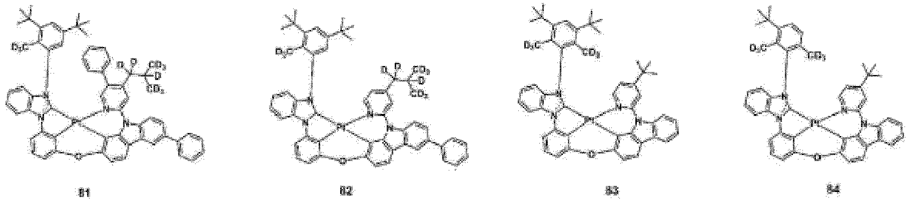

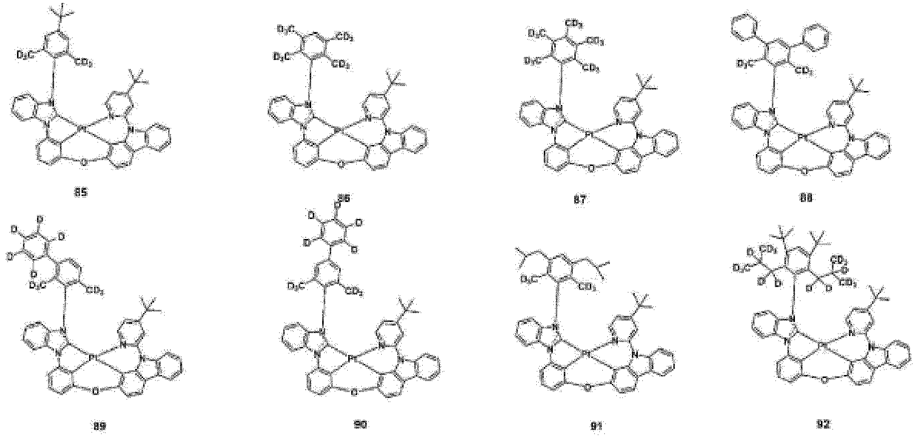

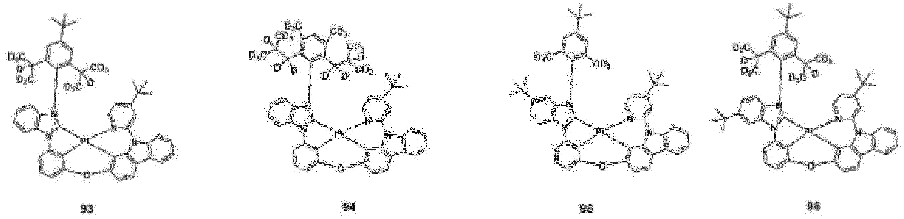

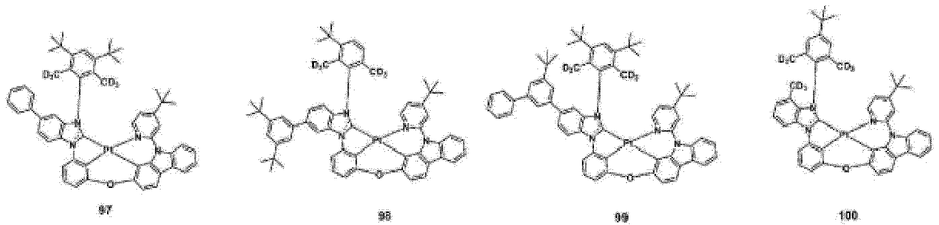

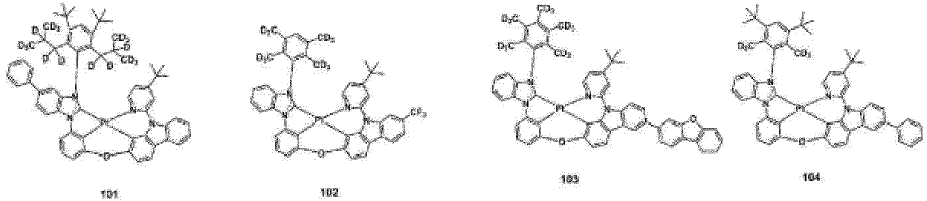

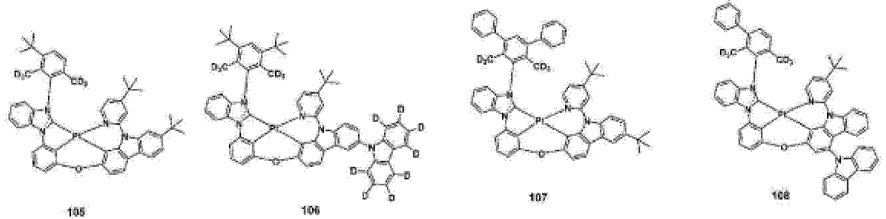

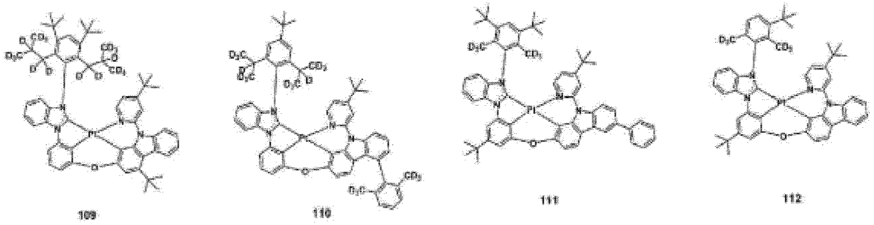

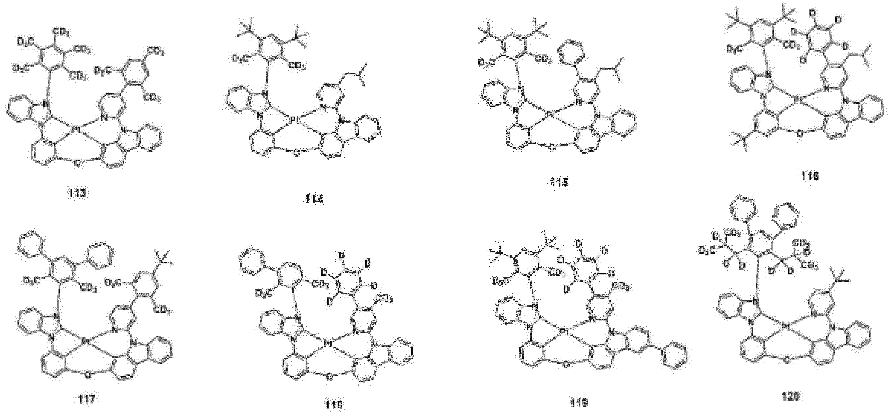

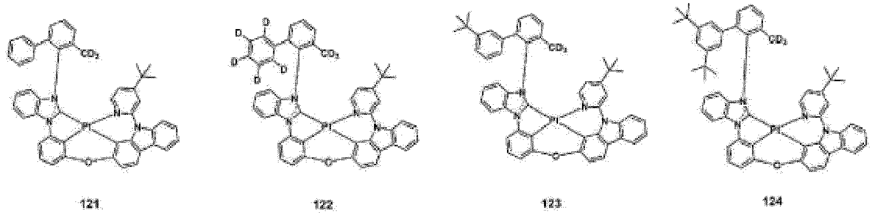

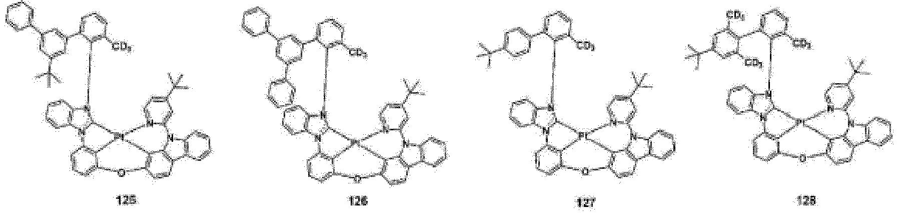

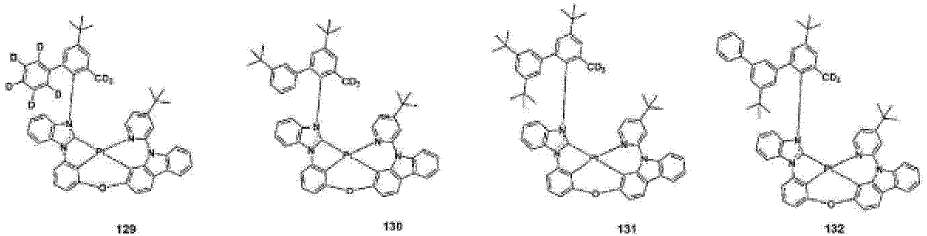

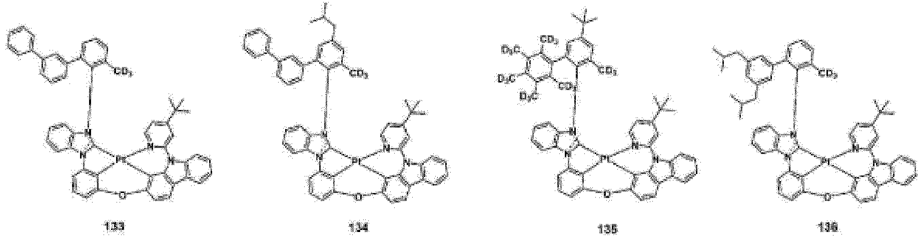

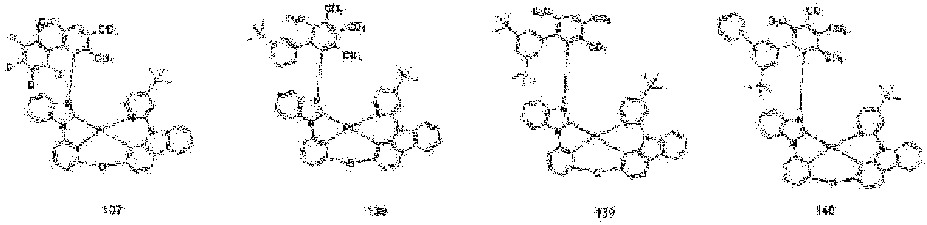

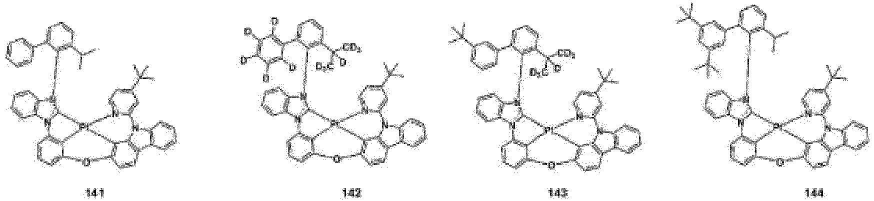

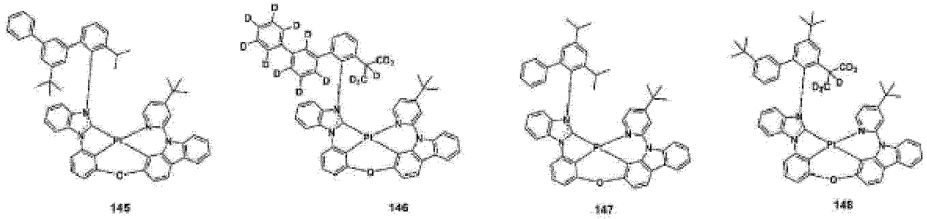

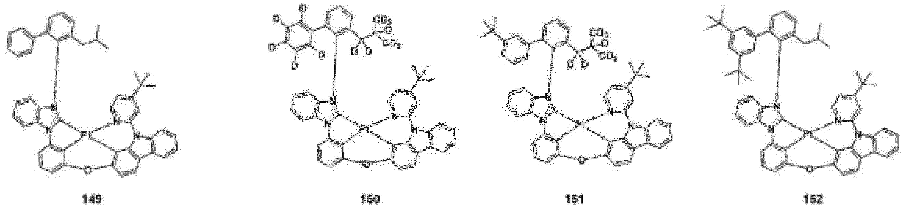

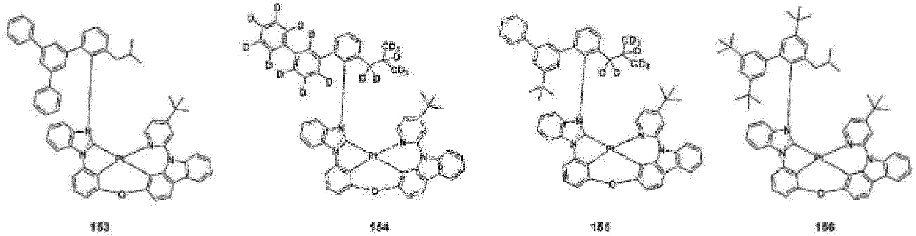

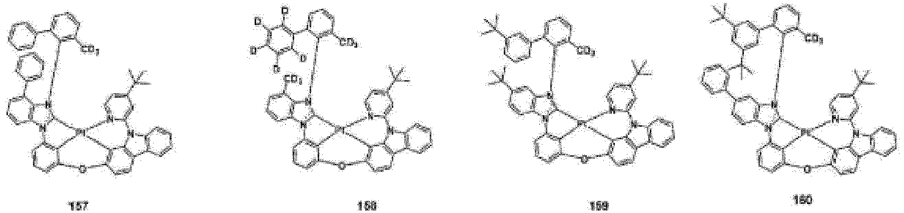

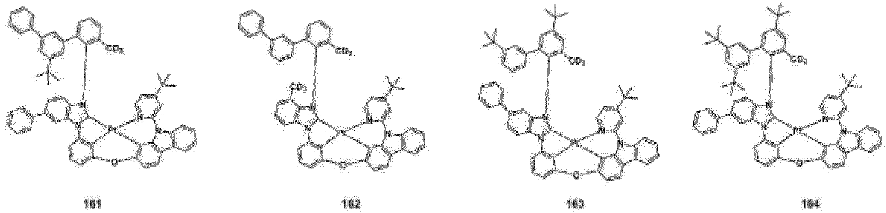

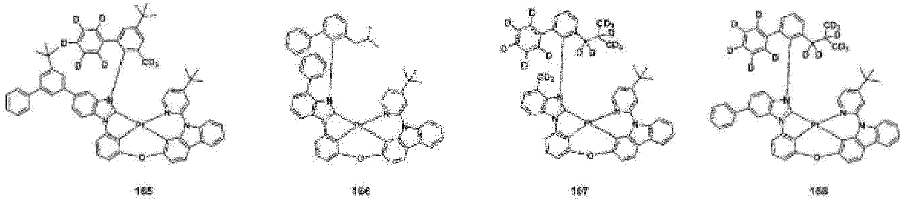

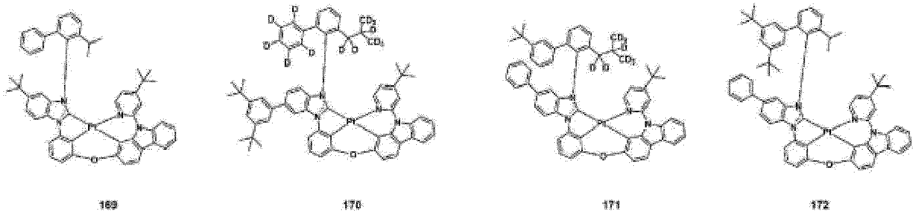

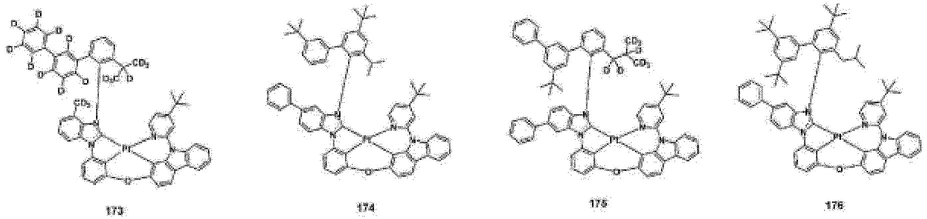

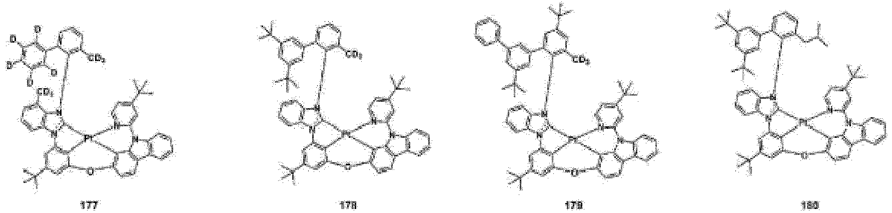

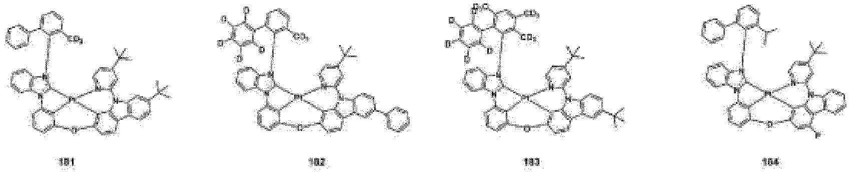

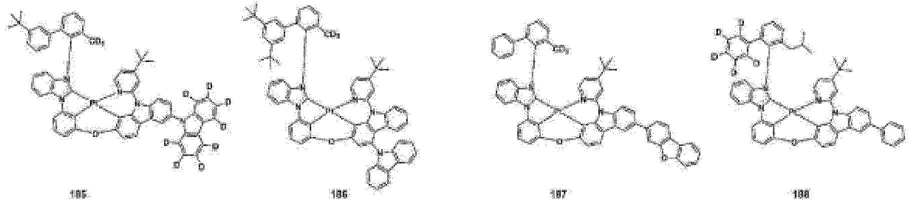

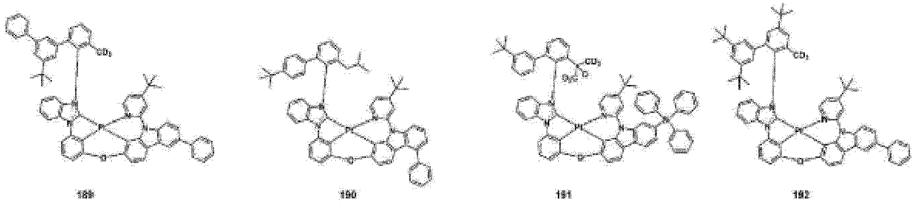

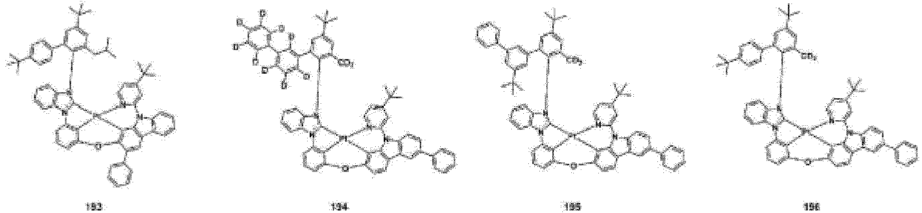

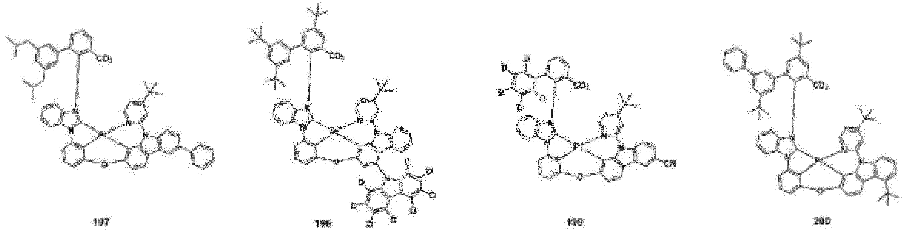

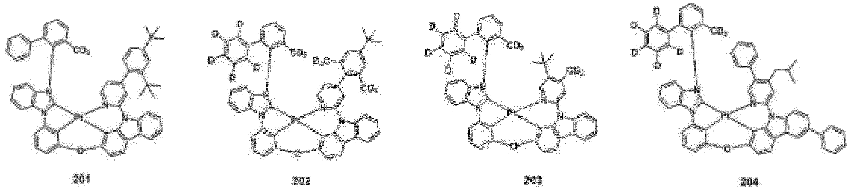

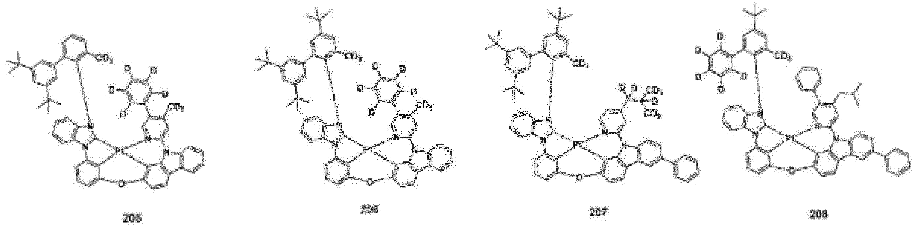

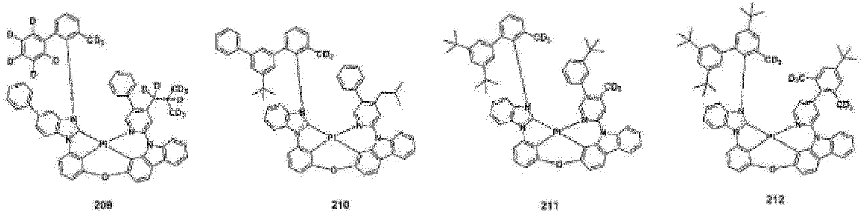

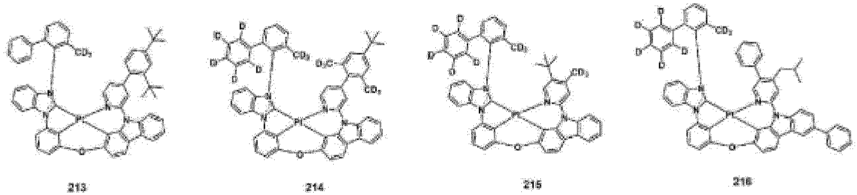

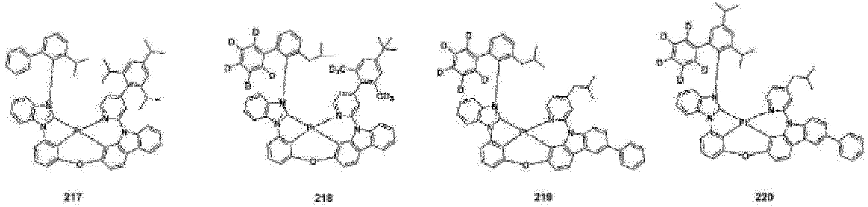

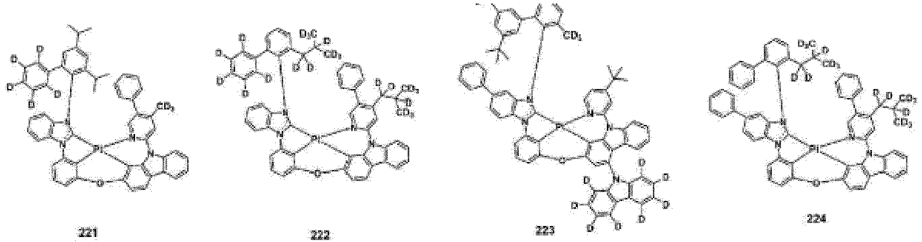

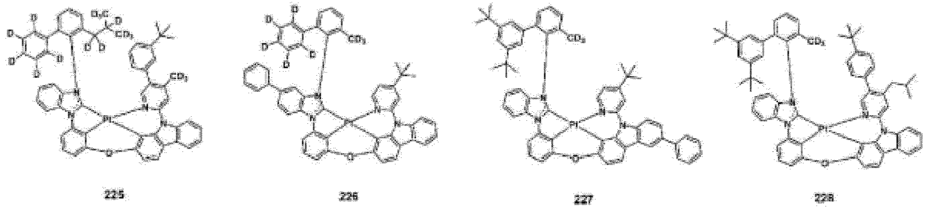

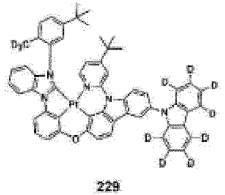

12. Organische lichtemittierende Vorrichtung, umfassend:
eine erste Elektrode;
eine zweite Elektrode; und
eine organische Schicht, die sich zwischen der ersten Elektrode und der zweiten Elektrode befindet, wobei die organische Schicht eine Emissionsschicht umfasst, und
wobei die organische Schicht ferner zumindest eine von den organometallischen Verbindungen nach einem der Ansprüche 1-11 umfasst;
wobei bevorzugt
die erste Elektrode eine Anode ist,
die zweite Elektrode eine Kathode ist,
die organische Schicht ferner eine Lochtransportregion, die sich zwischen der ersten Elektrode und der Emissionsschicht befindet, und eine Elektronentransportregion, die sich zwischen der Emissionsschicht und der zweiten Elektrode befindet, umfasst,
die Lochtransportregion eine Lochinjektionsschicht, eine Lochtransportschicht, eine Elektronenblockierschicht oder eine beliebige Kombination davon umfasst, und
die Elektronentransportregion eine Lochblockierschicht, eine Elektronentransportschicht, eine Elektroneninjektionsschicht oder eine Kombination davon umfasst.

13. Organische lichtemittierende Vorrichtung nach Anspruch 12, wobei die Emissionsschicht die zumindest eine organometallische Verbindung umfasst.

14. Organische lichtemittierende Vorrichtung nach Anspruch 13, wobei die Emissionsschicht blaues Licht mit einer maximalen Emissionswellenlänge von 410 Nanometern bis 490 Nanometern emittiert; und/oder
wobei die Emissionsschicht ferner einen Wirt umfasst, wobei eine Menge des Wirts in der Emissionsschicht größer als eine Menge der organometallischen Verbindung in der Emissionsschicht ist; und/oder
wobei ein Anteil an lumineszierenden Komponenten, der von der organometallischen Verbindung emittiert wird, in Bezug auf gesamte lumineszierende Komponenten, die von der Emissionsschicht emittiert werden, 80 % oder größer ist.

15. Organische lichtemittierende Vorrichtung nach Anspruch 13 oder 14, wobei die Emissionsschicht ferner einen fluoreszierenden Dotierstoff umfasst, sich der fluoreszierende Dotierstoff von der organometallischen Verbindung unterscheidet und ein Anteil an lumineszierenden Komponenten, der von dem fluoreszierenden Dotierstoff emittiert wird, in Bezug auf gesamte lumineszierende Komponenten, die von der Emissionsschicht emittiert werden, 80 % oder mehr ist.

## Revendications

1. Composé organométallique représenté par la Formule 1 :
Formule 1 M₁(L₁₁)ₙ₁₁(L₁₂)ₙ₁₂
dans lequel, dans la Formule 1,
M₁ est un métal de transition de la première rangée du tableau périodique des éléments, un métal de transition de la deuxième rangée du tableau périodique des éléments ou un métal de transition de la troisième rangée du tableau périodique des éléments,
L₁₁ est un ligand représenté par la Formule 1-1,
L₁₂ est un ligand monodenté ou un ligand bidenté,
n11 est 1,
n12 est 0, 1 ou 2, 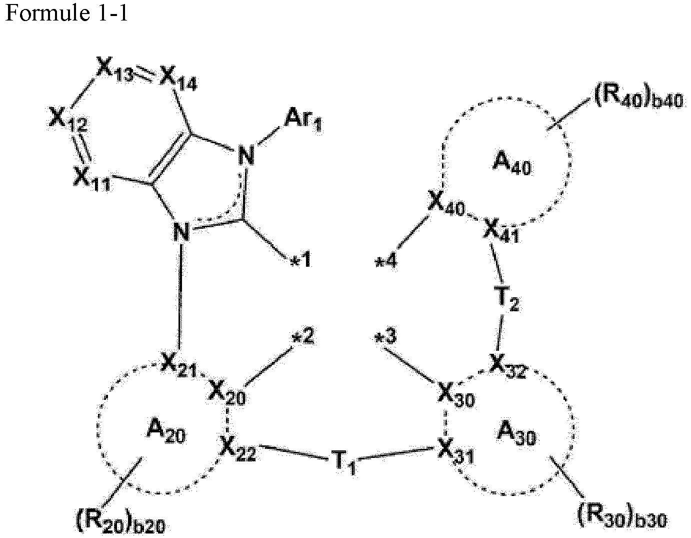
dans lequel, dans la Formule 1-1,
*¹ à *⁴ indiquent chacun un site de liaison à M₁,
le cycle A₂₀, le cycle A₃₀ et le cycle A₄₀ sont chacun indépendamment un groupe C₅-C₃₀ carbocyclique ou un groupe C₁-C₃₀ hétérocyclique,
T₁ est une liaison simple, *-N(R₁)-*', *-B(R₁)-*', *-P(R₁)-*', *-C(R₁)(R₂)-*', *-Si(R₁)(R₂)-*', *-Ge(R₁)(R₂)-*', *-S-*', *-Se-*', *-O-*', *-C(=O)-*', *-S(=O)-*', *-S(=O)₂-*', *-C(R₁)=C(R₂)-*', *-C(=S)-*' ou *-C=C-*',
T₂ est une liaison simple, *-N(R₃)-*', *-B(R₃)-*', *-P(R₃)-*', *-C(R₃)(R₄)-*', *-Si(R₃)(R₄)-*', *-Ge(R₃)(R₄)-*', *-S-*', *-Se-*', *-O-*', *-C(=O)-*', *-S(=O)-*', *-S(=O)₂-*', *-C(R₃)=C(R₄)-*', *-C(=S)-*' ou *-C=C-*',
X₁₁ est C(R₁₁) ou N, X₁₂ est C(R₁₂) ou N, X₁₃ est C(R₁₃) ou N et X₁₄ est C(R₁₄) ou N,
X₂₀ est C ou N, X₂₁ est C ou N et X₂₂ est C ou N,
X₃₀ est C ou N, X₃₁ est C ou N et X₃₂ est C ou N,
X₄₀ est C ou N et X₄₁ est C ou N, et
Ar₁ est un groupe représenté par la Formule 2, 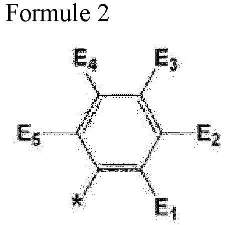
dans lequel, dans la Formule 2,
E₁ est un groupe C₁-C₆₀ alkyle substitué par du deutérium, ou un groupe C₁-C₆₀ aryle substitué ou non substitué,
E₂ à E₅ sont chacun indépendamment hydrogène, deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₇-C₆₀ alkyle aryle substitué ou non substitué, un groupe C₇-C₆₀ aryle alkyle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C₂-C₆₀ alkyle hétéroaryle substitué ou non substitué, un groupe C₂-C₆₀ hétéroaryle alkyle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), -P(Q₈)(Q₉), ou -P(=O)(Q₈)(Q₉),
au moins un parmi E₂ à E₅ n'est pas hydrogène,
à condition que lorsque E₁ est un groupe C₁-C₆₀ alkyle substitué par du deutérium et E₅ est un groupe C₁-C₆₀ alkyle substitué par du deutérium, au moins un parmi E₂ à E₄ n'est pas hydrogène,
à condition que lorsque E₁ est un groupe C₁-C₆₀ aryle substitué ou non substitué, Ar₁ comporte une structure asymétrique,
* et *' indiquent chacun un site de liaison à un atome voisin,
R₁ à R₄, R₁₁ à R₁₄, R₂₀, R₃₀, et R₄₀ sont chacun indépendamment hydrogène, deutérium, - F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₇-C₆₀ alkyle aryle substitué ou non substitué, un groupe C₇-C₆₀ aryle alkyle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C₂-C₆₀ alkyle hétéroaryle substitué ou non substitué, un groupe C₂-C₆₀ hétéroaryle alkyle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), -P(Q₈)(Q₉), ou - P(=O)(Q₈)(Q₉),
au moins deux éléments voisins parmi R₁ à R₄, R₁₁ à R₁₄, R₂₀, R₃₀ ou R₄₀ sont éventuellement liés ensemble pour former un groupe C₅-C₃₀ carbocyclique substitué ou non substitué ou un groupe C₁-C₃₀ hétérocyclique substitué ou non substitué,
au moins deux de R₂₀ dans le nombre de b20 sont éventuellement liés ensemble pour former un groupe C₅-C₃₀ carbocyclique substitué ou non substitué ou un groupe C₁-C₃₀ hétérocyclique substitué ou non substitué,
au moins deux de R₃₀ dans le nombre de b30 sont éventuellement liés ensemble pour former un groupe C₅-C₃₀ carbocyclique substitué ou non substitué ou un groupe C₁-C₃₀ hétérocyclique substitué ou non substitué,
au moins deux de R₄₀ dans le nombre de b40 sont éventuellement liés ensemble pour former un groupe C₅-C₃₀ carbocyclique substitué ou non substitué ou un groupe C₁-C₃₀ hétérocyclique substitué ou non substitué,
b20, b30 et b40 sont chacun indépendamment 1, 2, 3, 4, 5, 6, 7, 8, 9 ou 10,
lorsque b20 est 2 ou plus, au moins deux de R₂₀ sont identiques ou différents les uns des autres, lorsque b30 est 2 ou plus, au moins deux de R₃₀ sont identiques ou différents les uns des autres, et lorsque b40 est 2 ou plus, au moins deux de R₄₀ sont identiques ou différents les uns des autres,
au moins un substituant du groupe C₅-C₃₀ carbocyclique substitué, du groupe C₁-C₃₀ hétérocyclique substitué, du groupe C₁-C₆₀ alkyle substitué, du groupe C₂-C₆₀ alcényle substitué, du groupe C₂-C₆₀ alkynyle substitué, du groupe C₁-C₆₀ alkoxy substitué, du groupe C₁-C₆₀ alkylthio substitué, du groupe C₃-C₁₀ cycloalkyle substitué, du groupe C₁-C₁₀ hétérocycloalkyle substitué, du groupe C₃-C₁₀ cycloalcényle substitué, du groupe C₁-C₁₀ hétérocycloalcényle substitué, du groupe C₆-C₆₀ aryle substitué, du groupe C₇-C₆₀ alkyle aryle substitué, du groupe C₇-C₆₀ aryle alkyle substitué, du groupe C₆-C₆₀ aryloxy substitué, du groupe C₆-C₆₀ arylthio substitué, du groupe C₁-C₆₀ hétéroaryle substitué, du groupe C₂-C₆₀ alkyle hétéroaryle substitué, du groupe C₂-C₆₀ hétéroaryle alkyle substitué, du groupe C₁-C₆₀ hétéroaryloxy substitué, du groupe C₁-C₆₀ hétéroarylthio substitué, du groupe C₁-C₆₀ hétéroaryloxy substitué, du groupe C₁-C₆₀ hétéroarylthio substitué, du groupe polycyclique condensé non aromatique monovalent substitué et du groupe hétéropolycyclique condensé non aromatique monovalent substitué est :
deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alkynyle, un groupe C₁-C₆₀ alkoxy ou un groupe C₁-C₆₀ alkylthio ;
un groupe C₁-C₆₀ alkyle, un groupe C₂-C₆₀ alcényle, un groupe C₂-C₆₀ alkynyle, un groupe C₁-C₆₀ alkoxy ou un groupe C₁-C₆₀ alkylthio, chacun étant substitué par au moins un parmi deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₁-C₆₀ hétéroaryloxy, un groupe un C₁-C₆₀ hétéroarylthio, un groupe polycyclique condensé non aromatique monovalent, un groupe hétéropolycyclique condensé non aromatique monovalent, - N(Q₁₁)(Q₁₂), -Si(Q₁₃)(Q₁₄)(Q₁₅), -B(Q₁₃)(Q₁₄), -P(Q₁₈)(Q₁₉) ou -P(=O)(Q₁₈)(Q₁₉), ou une combinaison de ceux-ci ;
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₁-C₆₀ hétéroaryloxy, un groupe C₁-C₆₀ hétéroarylthio, un groupe polycyclique condensé non aromatique monovalent ou un groupe hétéropolycyclique condensé non aromatique monovalent ;
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₁-C₆₀ hétéroaryloxy, un groupe C₁-C₆₀ hétéroarylthio, un groupe polycyclique condensé non aromatique monovalent ou un groupe hétéropolycyclique condensé non aromatique monovalent, chacun étant substitué par au moins un élément parmi deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alkynyle, un groupe C₁-C₆₀ alkoxy, un groupe C₁-C₆₀ alkylthio, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₇-C₆₀ aryle alkyle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₂-C₆₀ hétéroaryle alkyle, un groupe C₁-C₆₀ hétéroaryloxy, un groupe C₁-C₆₀ hétéroarylthio, un groupe polycyclique condensé non aromatique monovalent ou un groupe hétéropolycyclique condensé non aromatique monovalent, -N(Q₂₁)(Q₂₂), -Si(Q₂₃)(Q₂₄)(Q₂₅), -B(Q₂₆)(Q₂₇), -P(Q₂₈)(Q₂₉) ou - P(=O)(Q₂₈)(Q₂₉), ou une combinaison de ceux-ci ; ou
-N(Q₃₁)(Q₃₂), -Si(Q₃₃)(Q₃₄)(Q₃₅), -B(Q₃₆)(Q₃₇), -P(Q₃₈)(Q₃₉) ou -P(=O)(Q₃₈)(Q₃₉), et
Q₁ à Q₉, Q₁₁, à Q₁₉, Q₂₁ à Q₂₉ et Q₃₁ à Q₃₉ sont chacun indépendamment hydrogène, deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle, un groupe C₇-C₆₀ alkyle aryle substitué ou non substitué, un groupe C₇-C₆₀ aryle alkyle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C₂-C₆₀ alkyle hétéroaryle substitué ou non substitué, un groupe C₂-C₆₀ hétéroaryle alkyle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué ou un groupe hétéropolycyclique condensé non aromatique monovalent substitué ou non substitué.

2. Composé organométallique selon la revendication 1, dans lequel M₁ est béryllium (Be), magnésium (Mg), aluminium (Al), calcium (Ca), titane (Ti), manganèse (Mn), cobalt (Co), cuivre (Cu), zinc (Zn), gallium (Ga), germanium (Ge), zirconium (Zr), ruthénium (Ru), rhodium (Rh), palladium (Pd), argent (Ag), rhénium (Re), platine (Pt) ou or (Au).

3. Composé organométallique selon la revendication 1 ou 2, dans lequel le cycle A₂₀ et le cycle A₃₀ sont chacun indépendamment choisis parmi un groupe phényle, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphthalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe tétrazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe indazole, un groupe benzoxazole, un groupe benzothiazole, un groupe benzoxadiazole, un groupe benzothiadiazole, un groupe benzotriazole, un groupe diazaindène, un groupe triazaindène, un groupe 5,6,7,8-tétrahydroisoquinoline ou un groupe 5,6,7,8-tétrahydroquinoline ; et
A₄₀ est un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe azafluorène, un groupe azacarbazole, un groupe azadibenzofurane, un groupe azadibenzothiophène, un groupe azadibenzosilole, un groupe 5,6,7,8-tétrahydroisoquinoline ou un groupe 5,6,7,8-tétrahydroquinoline.

4. Composé organométallique selon l'une quelconque des revendications 1 à 3, dans lequel le cycle A₂₀ est un groupe représenté par l'une des Formules A20-1 à A20-13 : 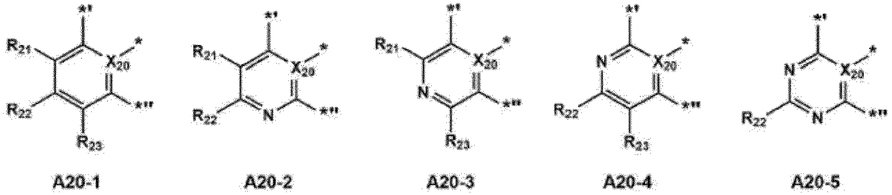 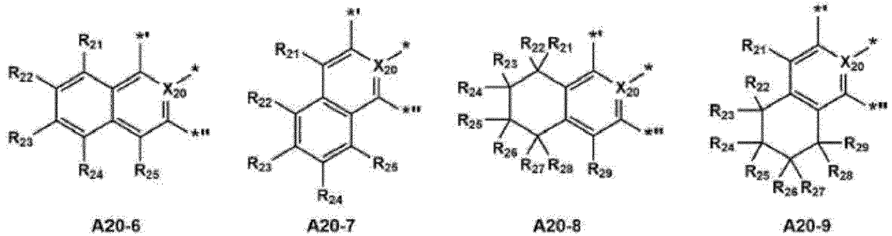 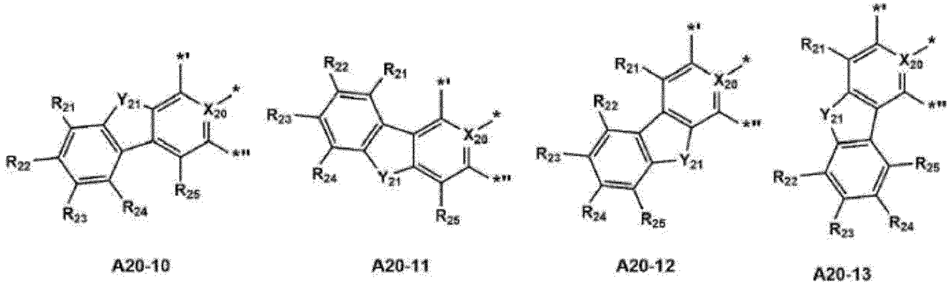 dans lequel, dans les Formules A20-1 à A20-13,
X₂₀ est tel que décrit selon la revendication 1,
Y₂₁ est une liaison simple, O, S, N(R₂₆), C(R₂₆)(R₂₇) ou Si(R₂₆)(R₂₇),
R₂₁ à R₂₉ sont chacun indépendamment tels que décrits en relation avec R₂₀ selon la revendication 1,
* indique un site de liaison à M₁, et
*' et *" indiquent chacun un site de liaison à un atome voisin ; et/ou
dans lequel A₃₀ est un groupe représenté par l'une des Formules A30-1 à A30-12 : 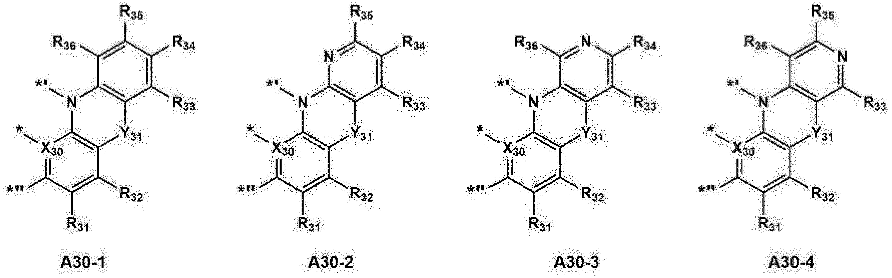 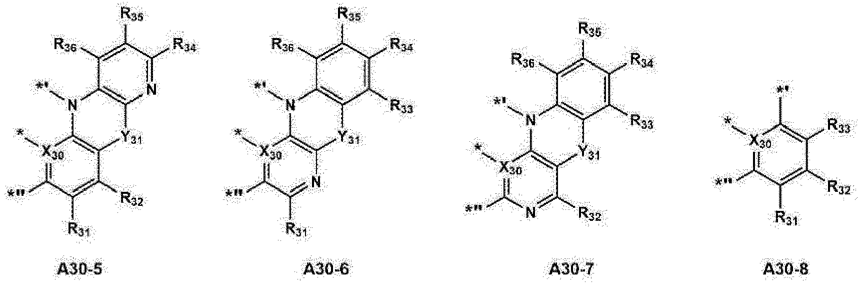 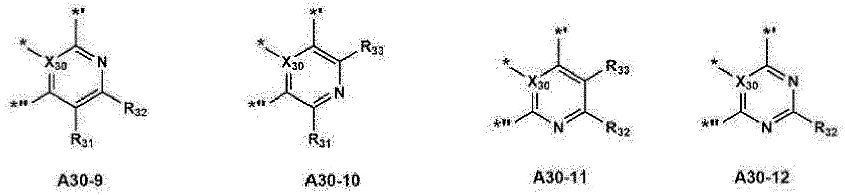
dans lequel, dans les Formules A30-1 à A30-12,
X₃₀ est tel que décrit selon la revendication 1,
Y₃₁ est une liaison simple, O, S, N(R₃₇), C(R₃₇)(R₃₈) ou Si(R₃₇)(R₃₈),
R₃₁ à R₃₈ sont chacun indépendamment tels que décrits en relation avec R₃₀ selon la revendication 1,
* indique un site de liaison à M₁, et
*' et *" indiquent chacun un site de liaison à un atome voisin.

5. Composé organométallique selon l'une quelconque des revendications 1 à 4, dans lequel le cycle A₄₀ est un groupe représenté par l'une des Formules A40-1 à A40-16 : 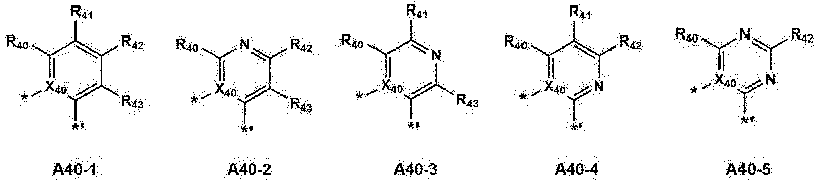 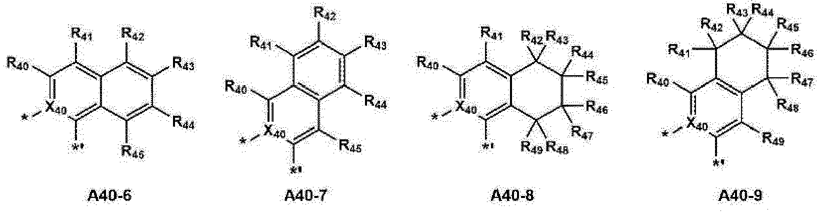 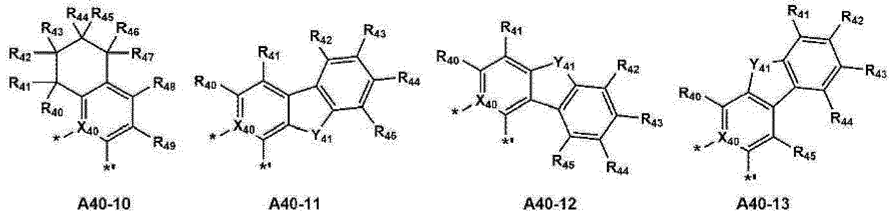 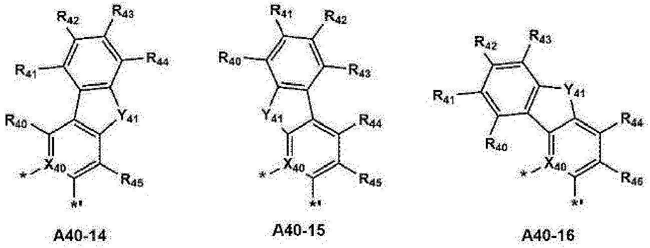 dans lequel, dans les Formules A40-1 à A40-16,
X₄₀ et R₄₀ sont respectivement tels que décrits selon la revendication 1,
Y₄₁ est une liaison simple, O, S, N(R₄₆), C(R₄₆)(R₄₇) ou Si(R₄₆)(R₄₇),
R₄₁ à R₄₉ sont chacun indépendamment tels que décrits en relation avec R₄₀ selon la revendication 1,
* indique un site de liaison à M₁, et
*' indique un site de liaison à un atome voisin.

6. Composé organométallique selon l'une quelconque des revendications 1 à 5, dans lequel Ar₁ est un groupe représenté par l'une des Formules Ar1-1 à Ar1-14 : 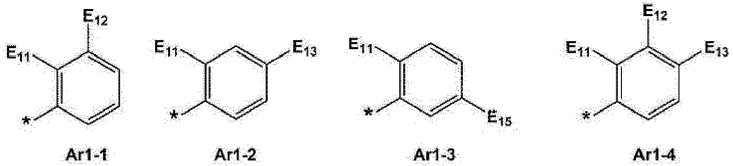 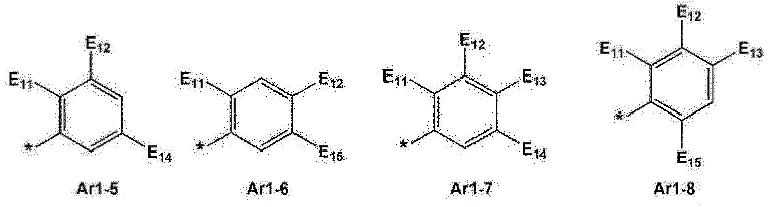 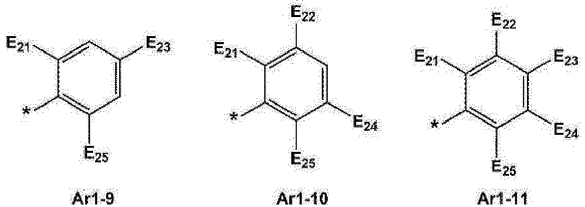 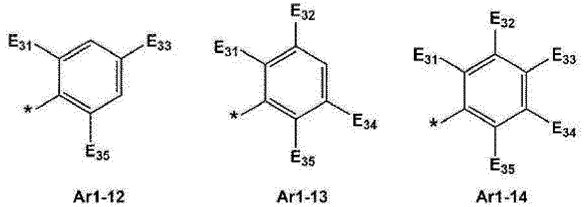 dans lequel, dans les Formules Ar1-1 à Ar1-14,
E₁₁ est un groupe C₁-C₆₀ alkyle substitué par du deutérium, ou un groupe C₁-C₆₀ aryle substitué ou non substitué,
E₂₁ est un groupe C₁-C₆₀ alkyle substitué par du deutérium, ou un groupe C₁-C₆₀ aryle substitué ou non substitué,
E₂₁ et E₂₅ sont différents l'un de l'autre,
E₃₁ et E₃₅ sont chacun indépendamment un groupe C₁-C₆₀ alkyle substitué par du deutérium,
E₁₂ à E₁₅, E₂₂ à E₂₅ et E₃₂ à E₃₄ sont chacun indépendamment deutérium, -F, -Cl, -Br, -I, - SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₇-C₆₀ alkyle aryle substitué ou non substitué, un groupe C₇-C₆₀ aryle alkyle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C₂-C₆₀ alkyle hétéroaryle substitué ou non substitué, un groupe C₂-C₆₀ hétéroaryle alkyle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), -P(Q₈)(Q₉) ou - P(=O)(Q₈)(Q₉), et
* indique un site de liaison à un atome voisin ; ou
dans lequel Ar₁ est un groupe représenté par l'une des Formules Ar1(1) à Ar1(104) : 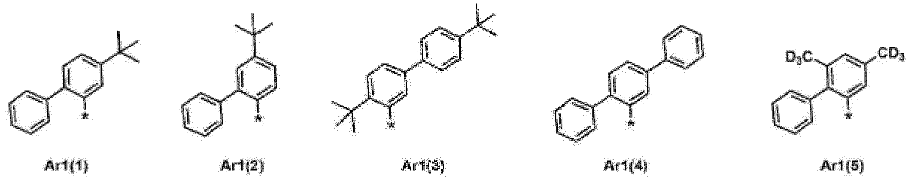 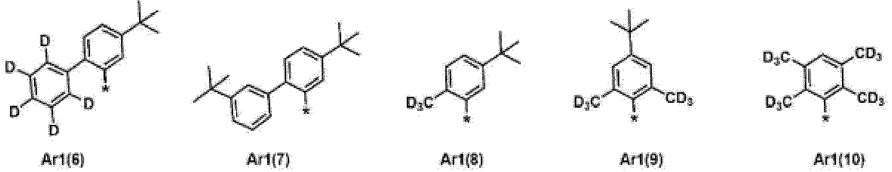 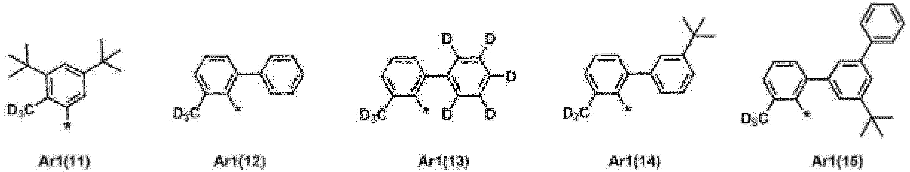 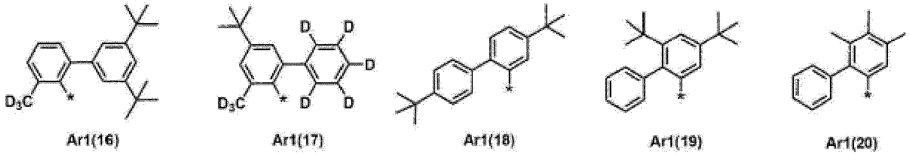 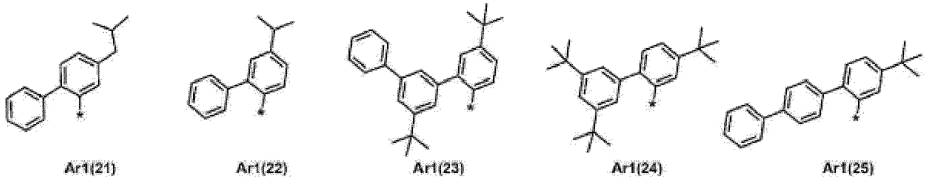 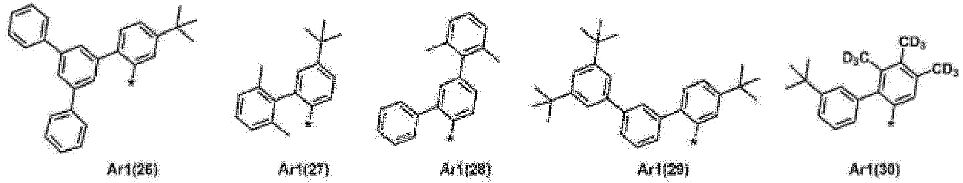 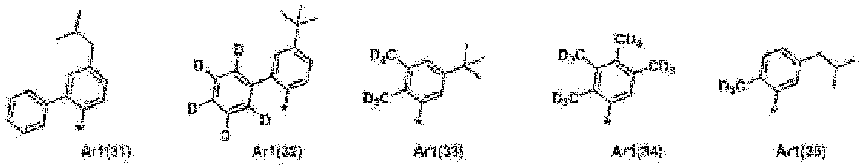 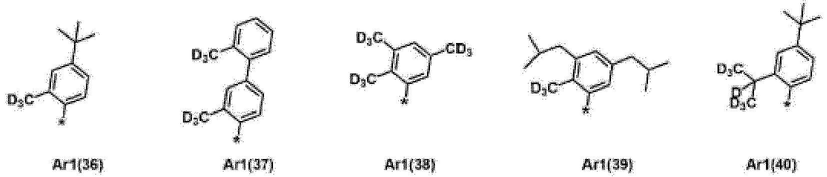 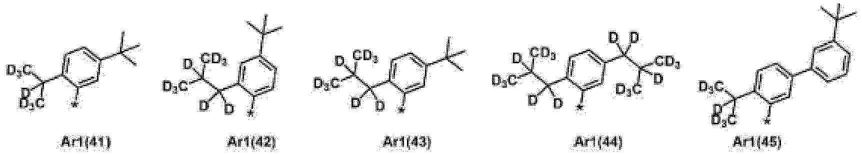 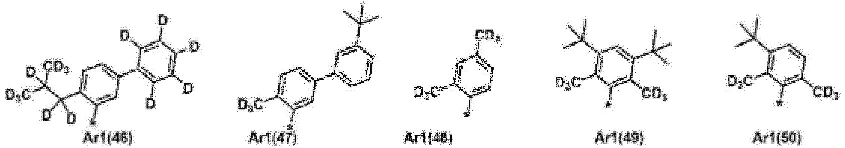 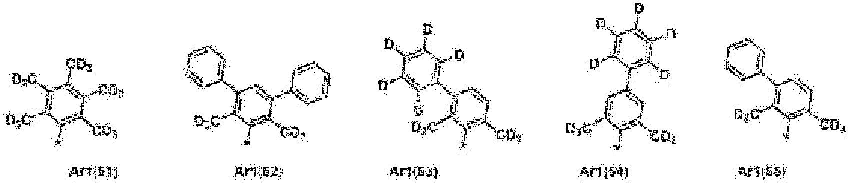 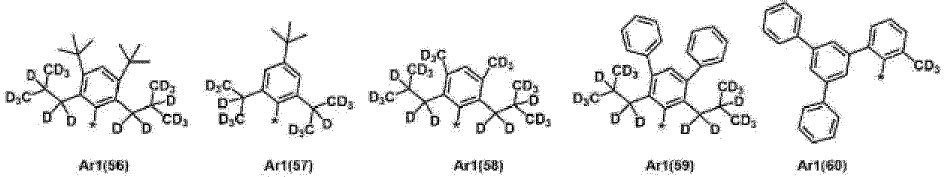 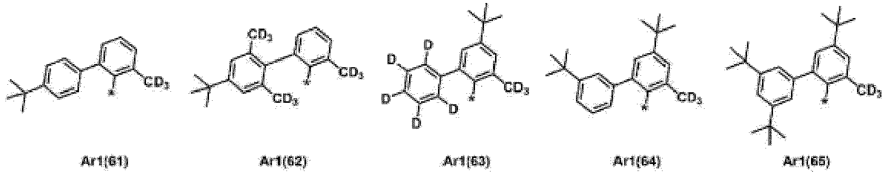 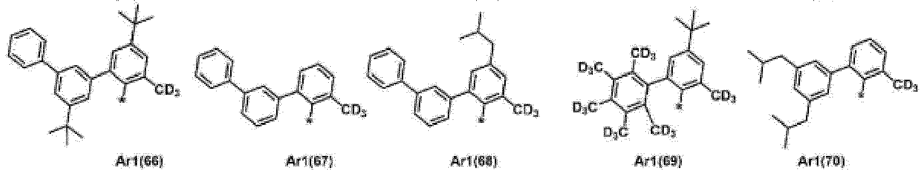 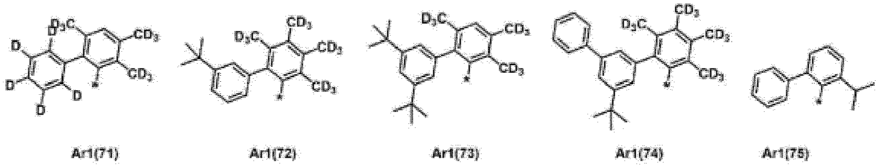 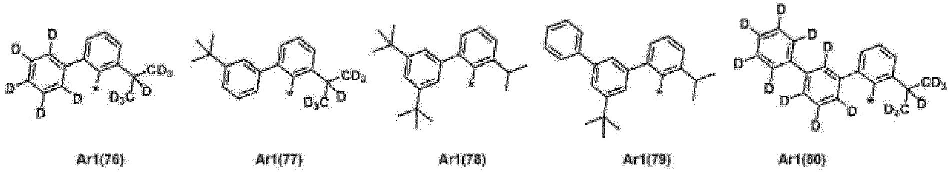 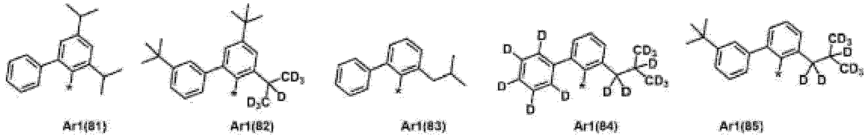 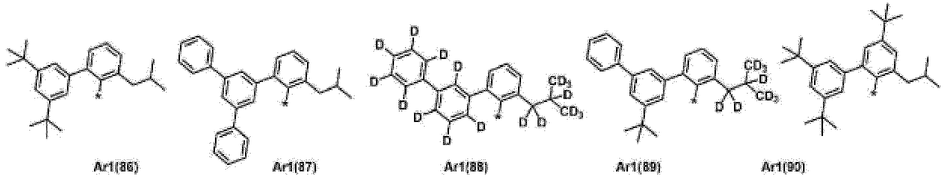 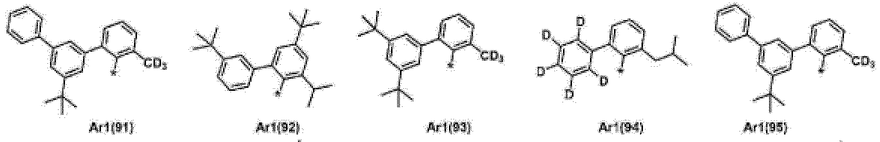 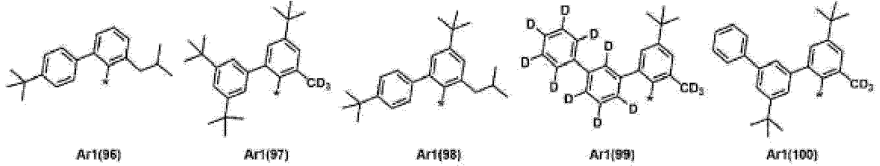 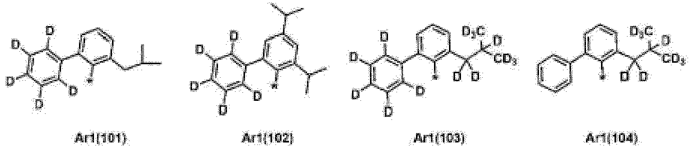
dans lequel, dans les Formules Ar1(1) à Ar1(104),
* indique un site de liaison à un atome voisin.

7. Composé organométallique selon l'une quelconque des revendications 1 à 6, dans lequel Ar₁ comporte une structure asymétrique.

8. Composé organométallique selon l'une quelconque des revendications 1 à 7, dans lequel R₁ à R₄, R₁₁ à R₁₄, R₂₀, R₃₀ et R₄₀ sont chacun indépendamment :
hydrogène, deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe C₁-C₂₀ alkyle, un groupe C₁-C₂₀ alkoxy ou un groupe C₁-C₂₀ alkylthio ;
un groupe C₁-C₂₀ alkyle, un groupe C₁-C₂₀ alkoxy ou un groupe C₁-C₂₀ alkylthio, chacun étant substitué par au moins un élément parmi deutérium, -F, -Cl, -Br, -I, -SF₅, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci , un groupe acide phosphorique ou un sel de celui-ci, un groupe alkyle C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle, ou une combinaison de ceux-ci ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle ou un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle ou un groupe imidazopyrimidinyle, chacun étant substitué par au moins un élément parmi deutérium, -F, -Cl, - Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₂₀ alkyle, un groupe C₁-C₂₀ alkoxy, un groupe C₁-C₂₀ alkylthio, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, ou une combinaison de ceux-ci ; ou
-N(Q₁)(Q₂), -Si(Q₃)(Q₄)(Q₅), -B(Q₆)(Q₇), -P(Q₈)(Q₉) ou -P(=O)(Q₈)(Q₉), et
Q₁ à Q₉ sont chacun indépendamment :
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H ou -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphthyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphthyle, chacun étant substitué par au moins un élément parmi deutérium, un groupe C₁-C₁₀ alkyle, un groupe phényle, ou une combinaison de ceux-ci.

9. Composé organométallique selon l'une quelconque des revendications 1 à 8, ledit composé organométallique représenté par la Formule 1 étant représenté par la Formule 11 : 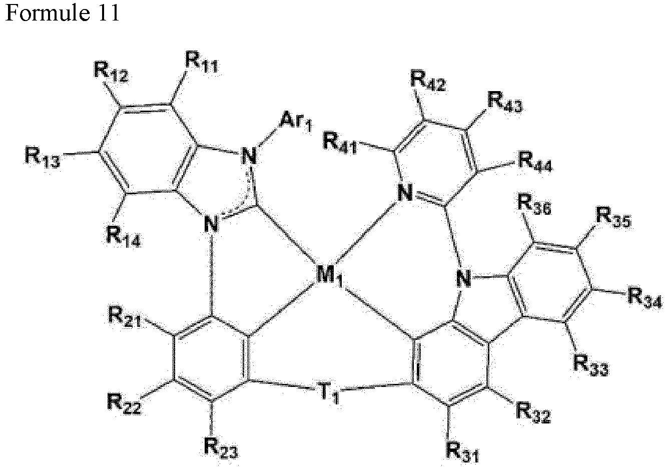 dans lequel, dans la Formule 11,
M₁, Ar₁, T₁ et R₁₁ à R₁₄ sont respectivement tels que décrits selon la revendication 1,
R₂₁ à R₂₃ sont chacun indépendamment tels que décrits en relation avec R₂₀ selon la revendication 1,
R₃₁ à R₃₆ sont chacun indépendamment tels que décrits en relation avec R₃₀ selon la revendication 1, et
R₄₁ à R₄₄ sont chacun indépendamment tels que décrits en relation avec R₄₀ selon la revendication 1.

10. Composé organométallique selon l'une quelconque des revendications 1 à 9, ledit composé organométallique étant électriquement neutre.

11. Composé organométallique selon l'une quelconque des revendications 1 à 10, ledit composé organométallique étant l'un des composés 1 à 229 :

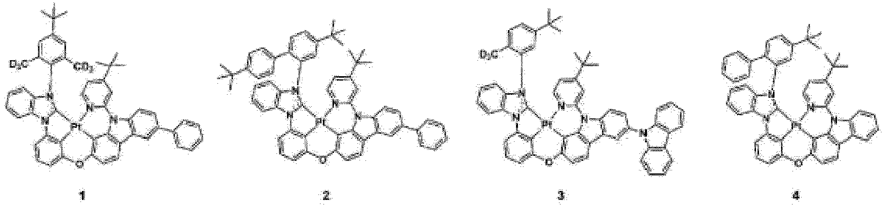

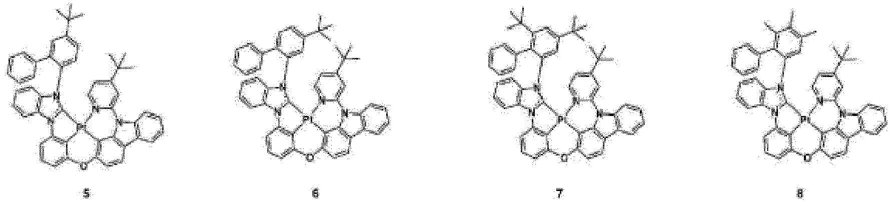

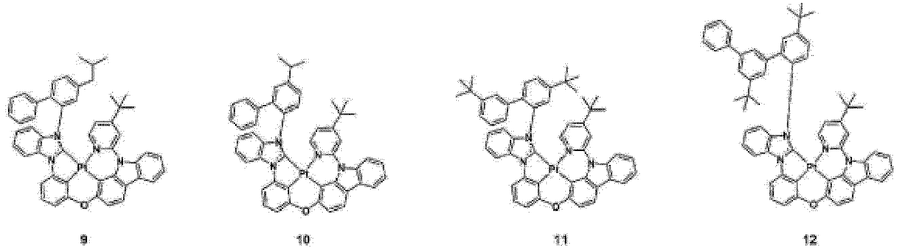

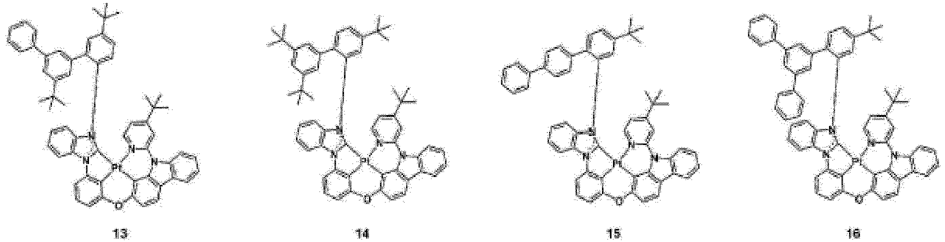

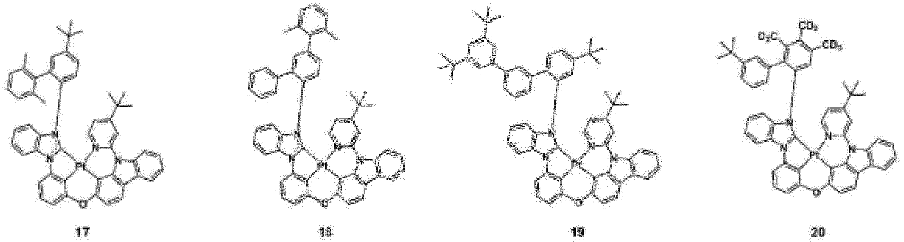

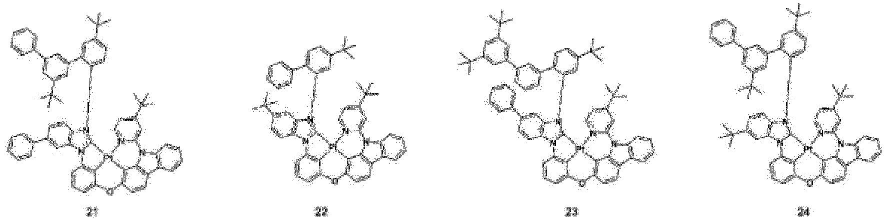

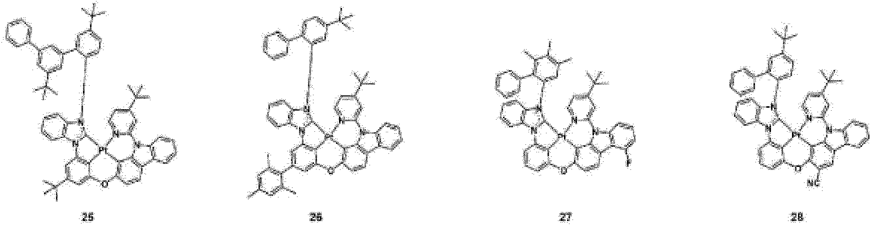

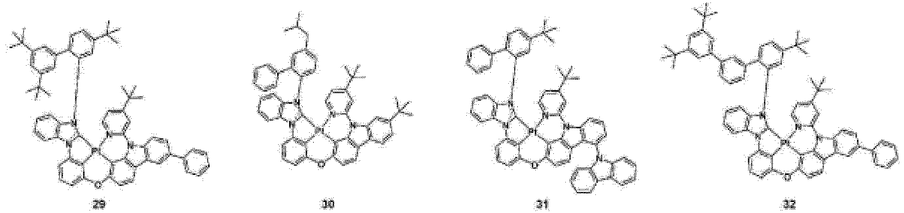

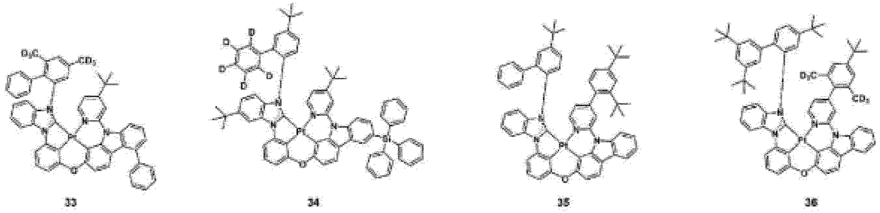

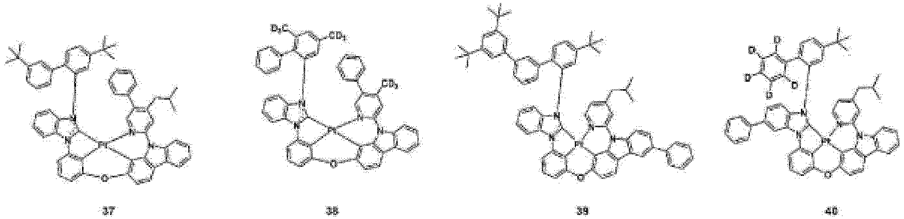

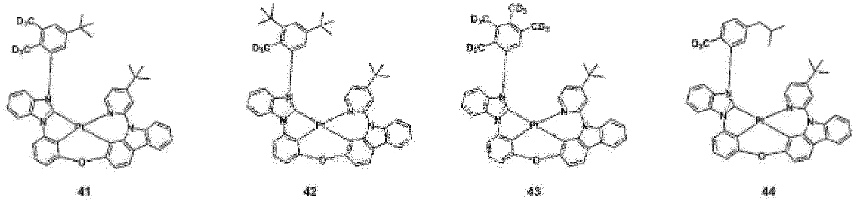

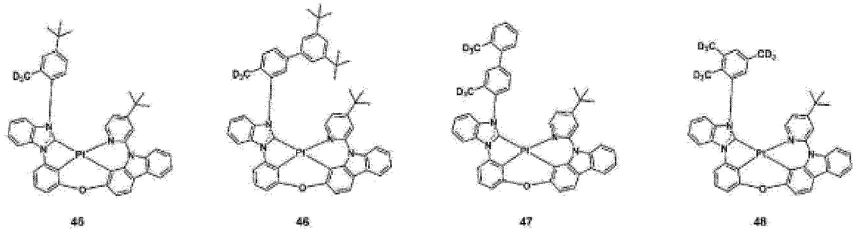

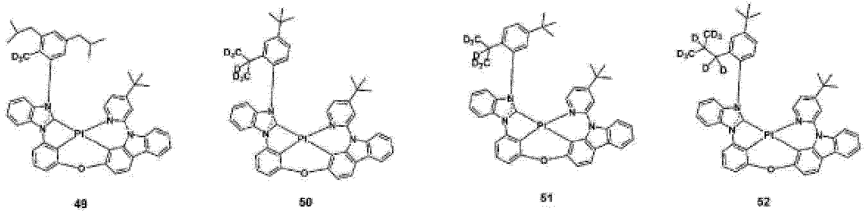

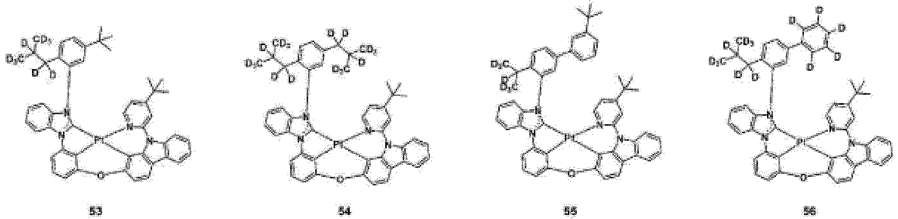

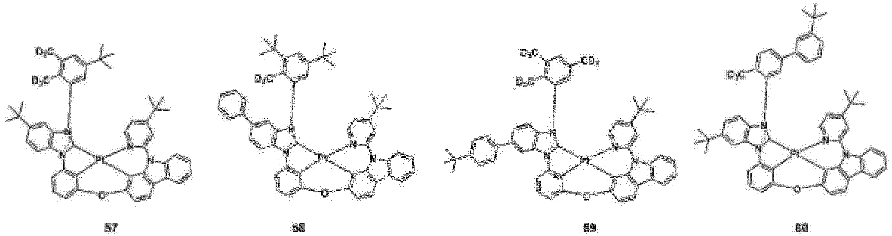

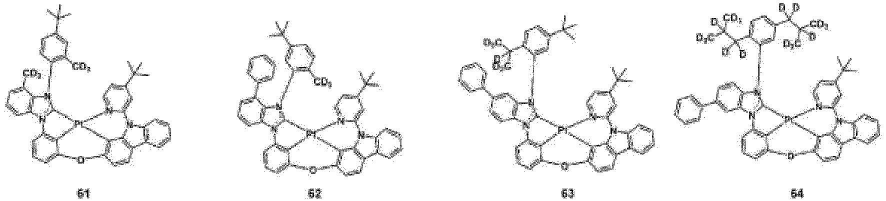

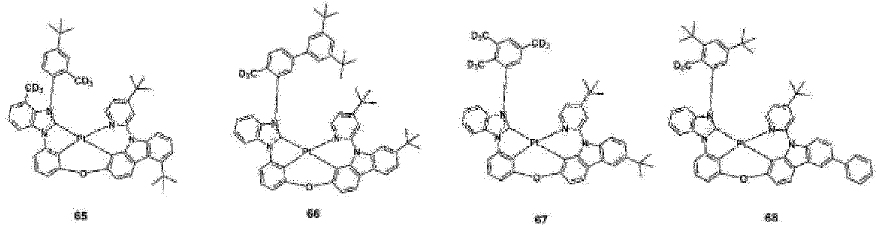

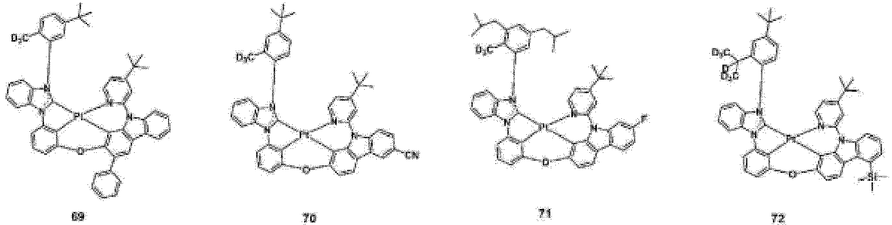

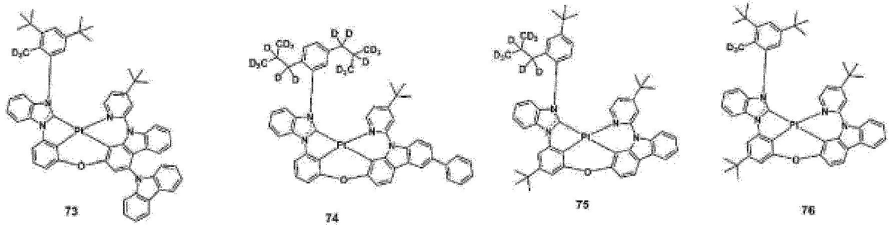

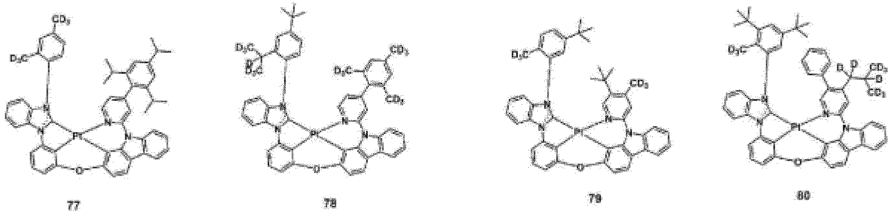

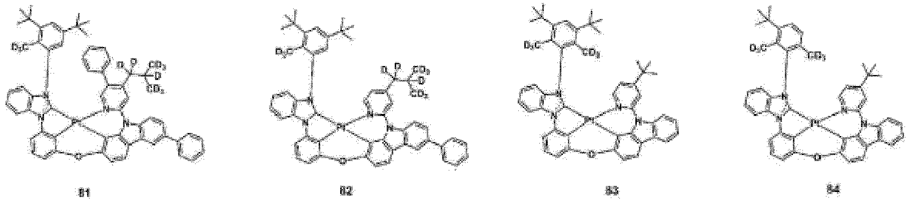

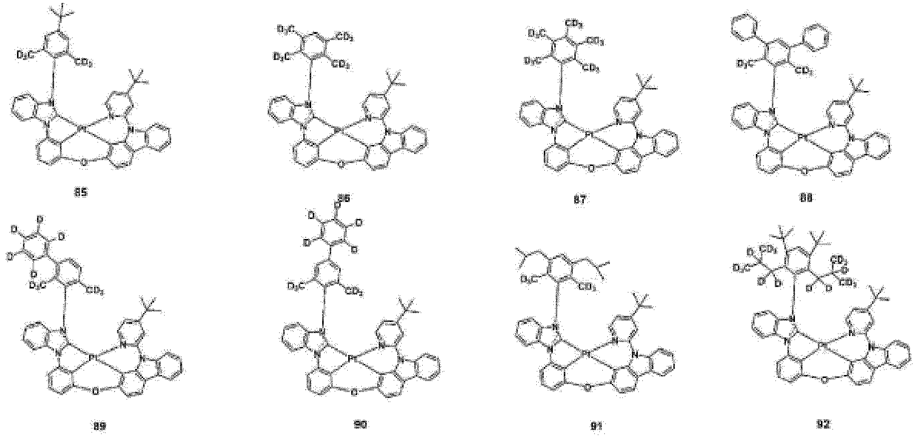

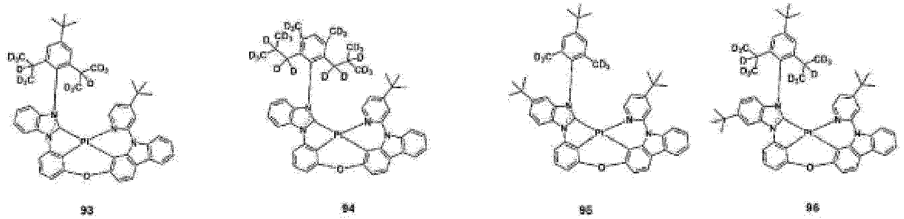

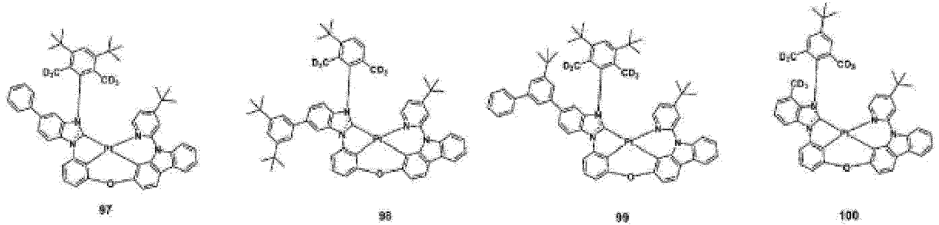

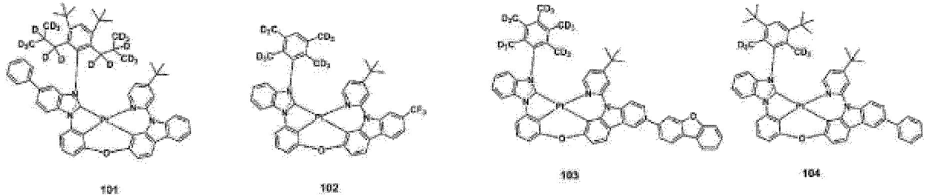

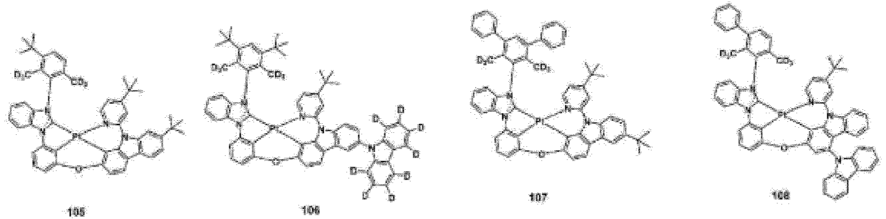

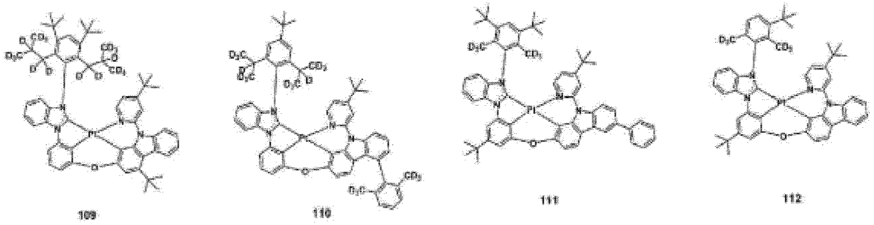

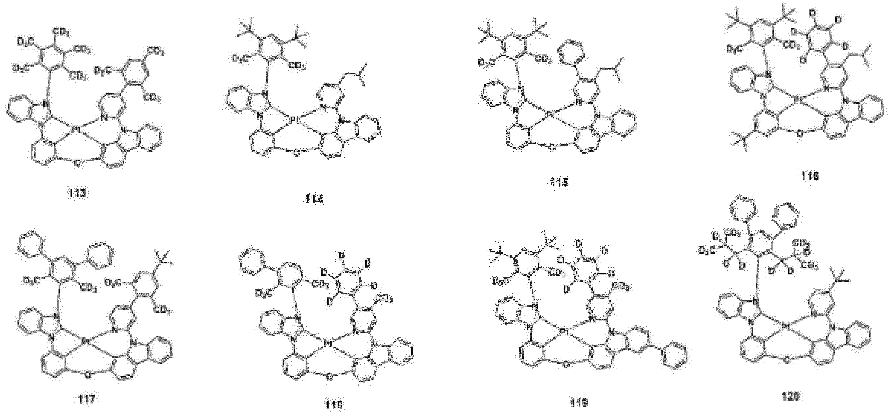

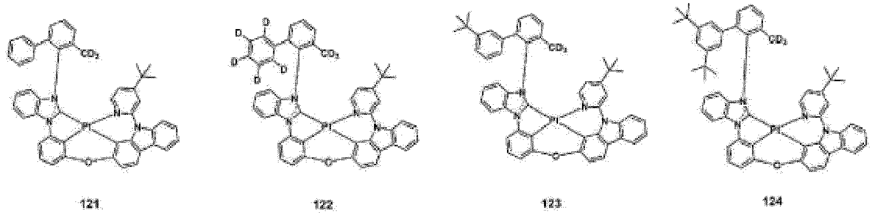

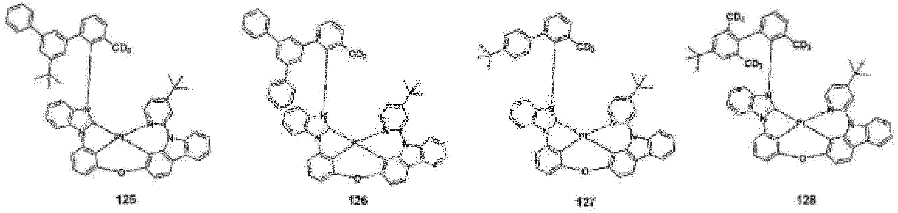

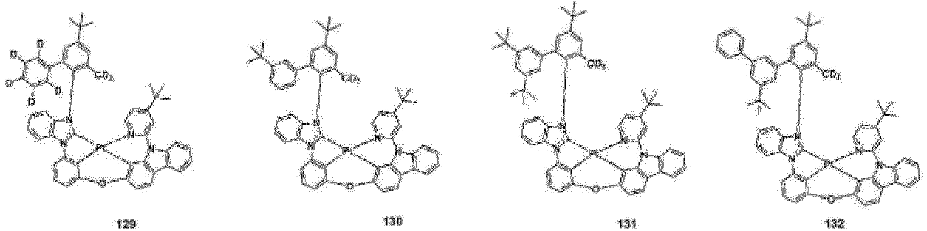

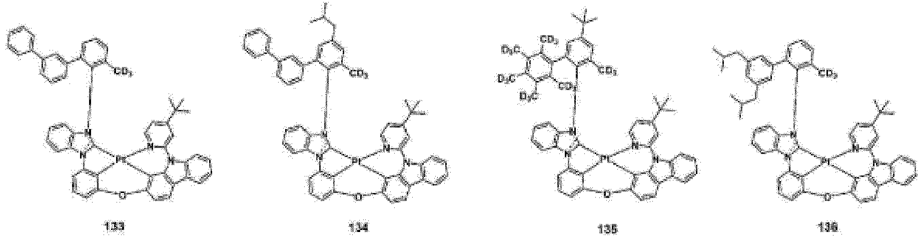

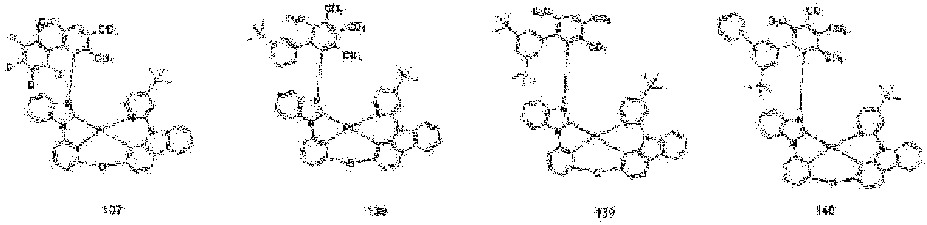

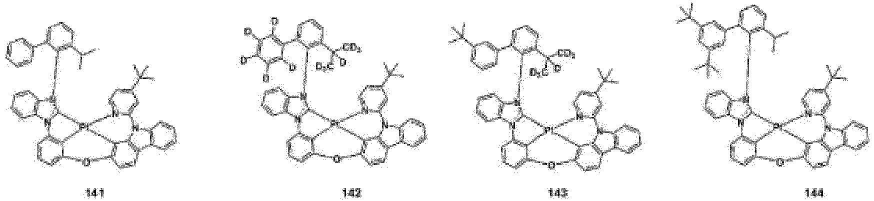

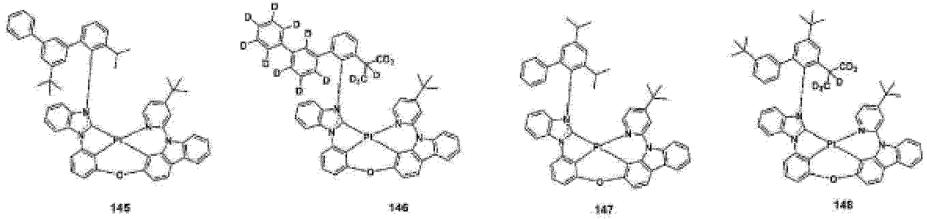

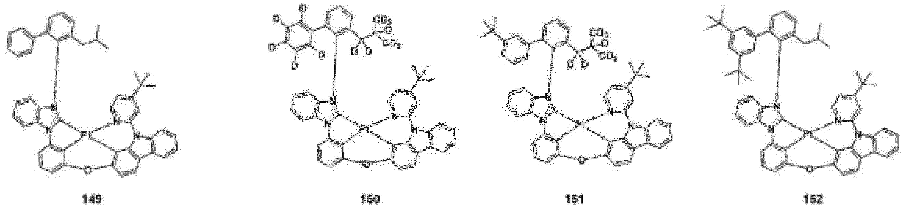

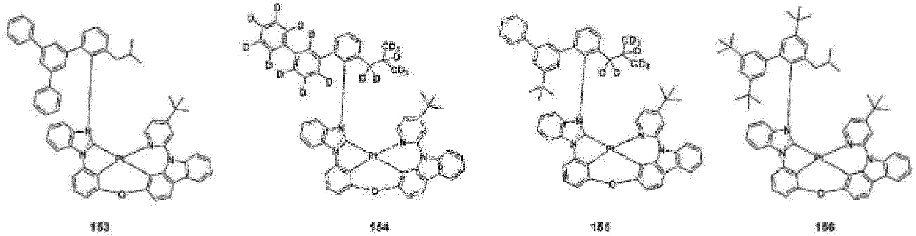

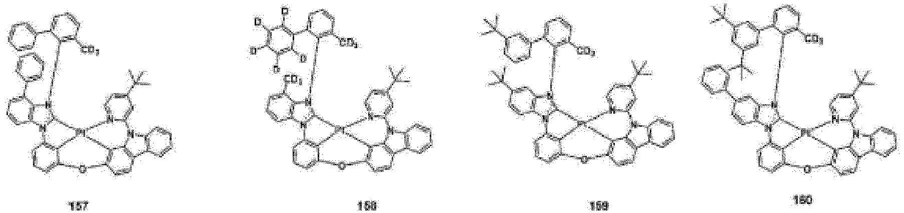

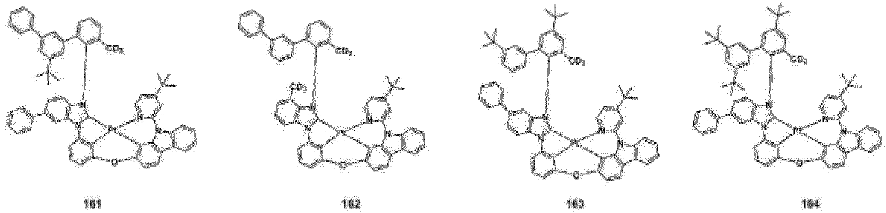

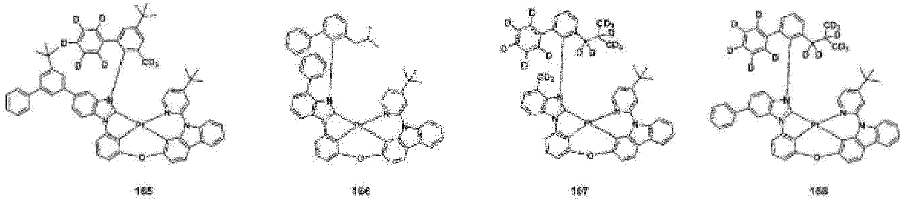

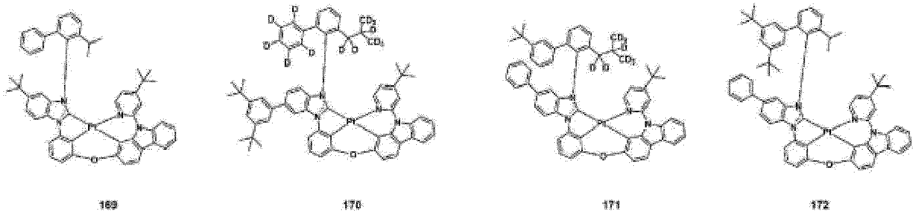

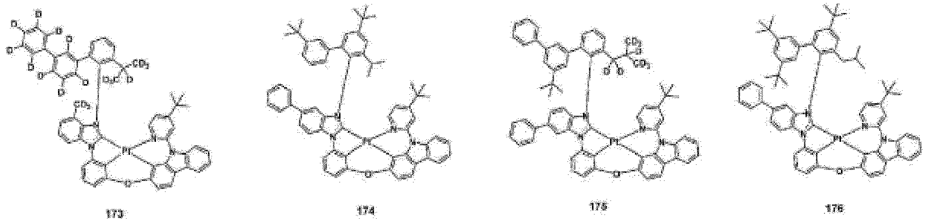

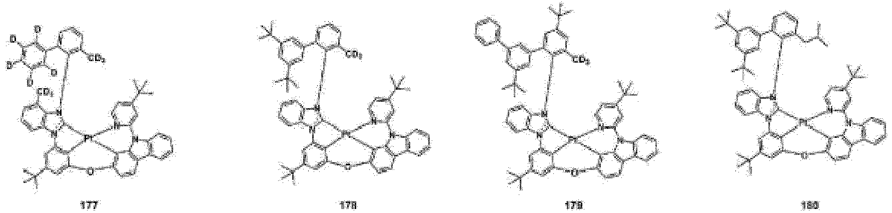

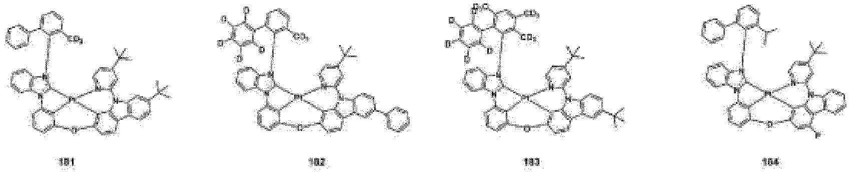

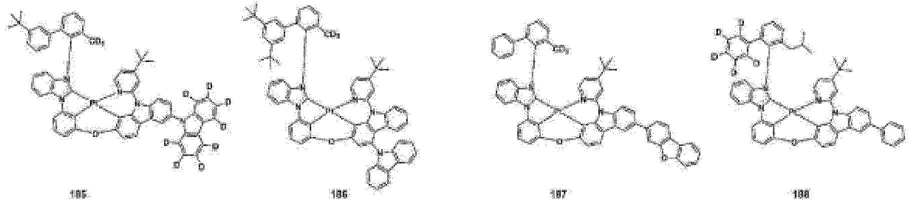

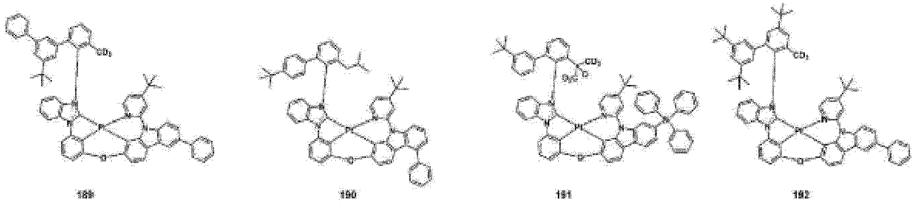

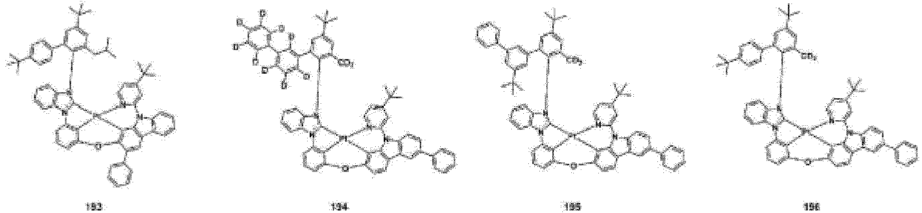

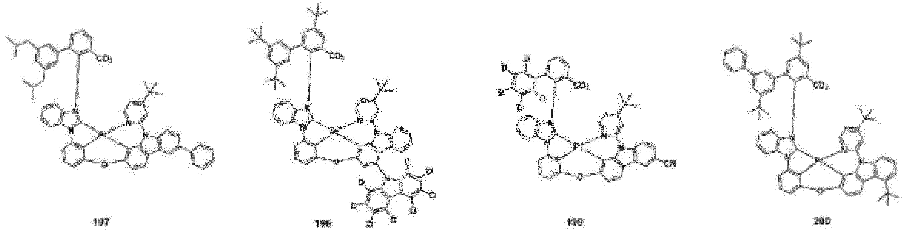

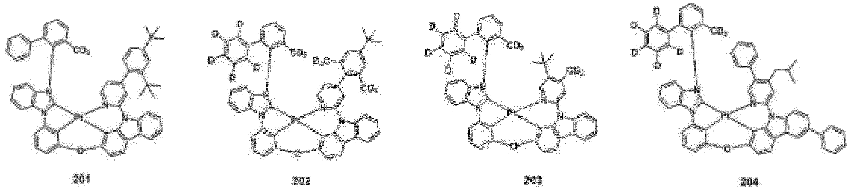

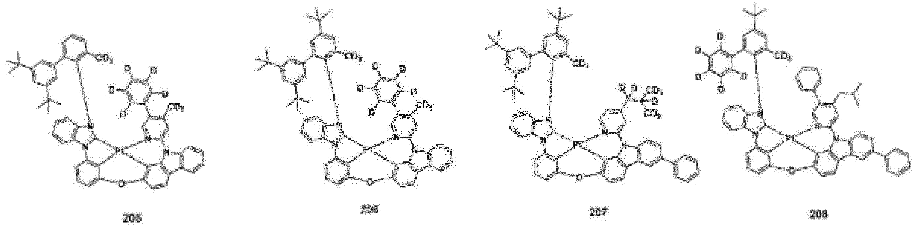

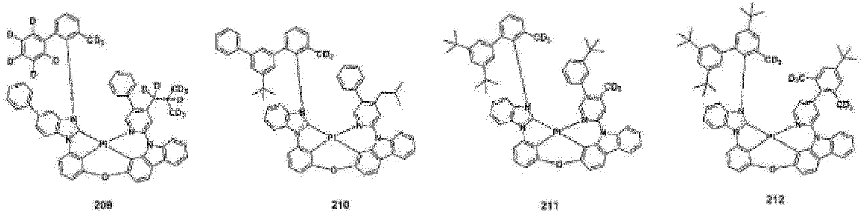

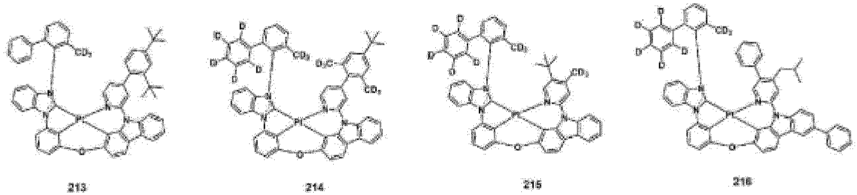

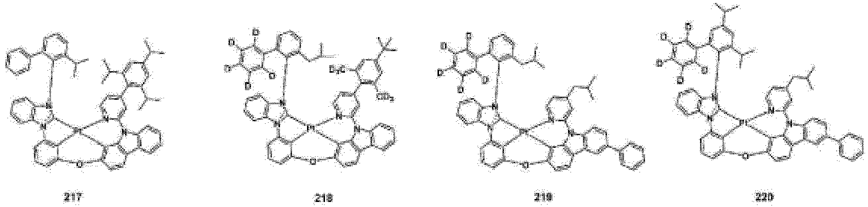

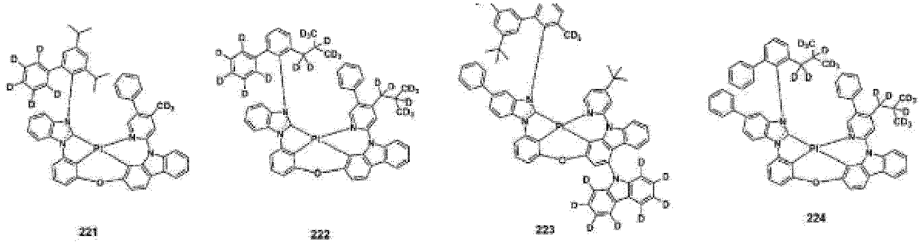

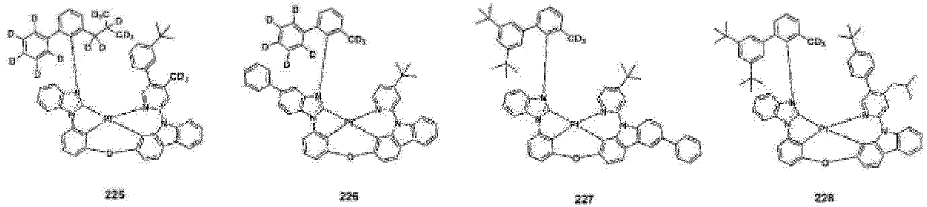

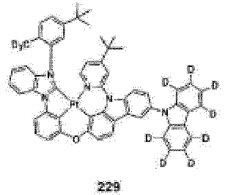

12. Dispositif électroluminescent organique comprenant :
une première électrode ;
une deuxième électrode ; et
une couche organique située entre la première électrode et la deuxième électrode,
dans lequel la couche organique comprend une couche d'émission, et
dans lequel la couche organique comprend en outre au moins un des composés organométalliques selon l'une quelconque des revendications 1 à 11 ;
de préférence dans lequel
la première électrode est une anode,
la deuxième électrode est une cathode,
la couche organique comprend en outre une région de transport de trous située entre la première électrode et la couche d'émission, et une région de transport d'électrons située entre la couche d'émission et la deuxième électrode,
la région de transport de trous comprend une couche d'injection de trous, une couche de transport de trous, et une couche de blocage d'électrons, ou une combinaison de celles-ci, et
la région de transport d'électrons comprend une couche de blocage de trous, une couche de transport d'électrons, une couche d'injection d'électrons, ou une combinaison de celles-ci.

13. Dispositif électroluminescent organique selon la revendication 12, dans lequel la couche d'émission comprend au moins un des composés organométalliques.

14. Dispositif électroluminescent organique selon la revendication 13, dans lequel la couche d'émission émet une lumière bleue comportant une longueur d'ondes d'émission maximale de 410 nanomètres à 490 nanomètres ; et/ou
dans lequel la couche d'émission comprend en outre un hôte, dans lequel une quantité de l'hôte dans la couche d'émission est supérieure à une quantité du composé organométallique dans la couche d'émission ; et/ou
dans lequel une proportion de composants luminescents émis par le composé organométallique par rapport à la totalité des composants luminescents émis par la couche d'émission est égale ou supérieure à 80 %.

15. Dispositif électroluminescent organique selon la revendication 13 ou 14, dans lequel
la couche d'émission comprend en outre un dopant fluorescent,
le dopant fluorescent est différent du composé organométallique, et
une proportion de composants luminescents émis par le dopant fluorescent par rapport à la totalité des composants luminescents émis par la couche d'émission est égale ou supérieure à 80 %.
